(19) Europäisches Patentamt / European Patent Office / Office européen des brevets

(11) **EP 3 051 705 A1**

(12) **EUROPEAN PATENT APPLICATION**
published in accordance with Art. 153(4) EPC

(43) Date of publication:
**03.08.2016 Bulletin 2016/31**

(51) Int Cl.:
*H03M 13/19* (2006.01)　　*H03M 13/27* (2006.01)

(21) Application number: **14849252.3**

(22) Date of filing: **12.09.2014**

(86) International application number:
**PCT/JP2014/074195**

(87) International publication number:
**WO 2015/045896 (02.04.2015 Gazette 2015/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.09.2013　JP 2013199084**

(71) Applicant: **Sony Corporation**
**Tokyo 108-0075 (JP)**

(72) Inventors:
• **SHINOHARA, Yuji**
**Tokyo 108-0075 (JP)**
• **YAMAMOTO, Makiko**
**Tokyo 108-0075 (JP)**

(74) Representative: **Witte, Weller & Partner**
**Patentanwälte mbB**
**Postfach 10 54 62**
**70047 Stuttgart (DE)**

(54) **DATA PROCESSING DEVICE AND DATA PROCESSING METHOD**

(57) The present technology relates to a data processing device and a data processing method that make it possible to ensure good communication quality in a data transmission using LDPC codes. In group-wise interleave, an LDPC code whose code length is 64800 bits and code rate is 10/15, 11/15, 12/15, or 13/15 is interleaved in a 360-bit group unit. In group-wise deinterleave, a sequence of the LDPC code after group-wise interleave obtained from data transmitted from a transmitting device to the original sequence. The present technology can be applied, for example, to data transmission or the like using the LDPC codes.

FIG.112

EP 3 051 705 A1

# EP 3 051 705 A1

**Description**

Technical Field

The present technology relates to a data processing device and a data processing method. In particular, the present technology relates to a data processing device and a data processing method that make it possible to ensure good communication quality in a data transmission using LDPC codes.

Background Art

Some of the information to be published in this specification and drawings, Samsung Electronics Co. to conduct joint development with Sony Corporation, Ltd. (hereinafter, referred to as Samsung) is one that has received the offer from the (explicitly in the drawings).

LDPC (Low Density Parity Check) code has high error correction capabilities, and is widely used in recent years in a transmission system including a digital broadcasting such as DVB (Digital Video Broadcasting)-S.2, DVB-T.2, DVB-C.2 in Europe, and ATSC (Advanced Television Systems Committee)3.0 in the United States (for example, refer to Non-Patent Document 1).

Recent studies has revealed that as the code length of the LDPC code is prolonged, the LDPC code achieves the performance as close as the Shannon limit similar to the turbo code or the like. Also, the LDPC code has a property that the minimum distance is proportional to the code length. As the advantageous features of the LDPC code, the block error probability characteristic is good, and a so-called error floor phenomenon that is observed in the decoding characteristic of the turbo code or the like is less likely to occur.

Non-Patent Document 1: DVB-S.2 : ETSI EN 302 307 V1.2.1 (2009-08)

Summary of Invention

Problem to be solved by the Invention

Data transmission using an LDPC code, for example, LDPC codes, is a symbol of QPSK (Quadrature Phase Shift Keying) orthogonal modulation such as (digital modulation) (is symbolized), the symbol, the signal points of orthogonal modulation it is mapped to be transmitted.

The data transmission using the LDPC code as described above, it is becoming spread worldwide and is requested to ensure a satisfactory communication quality.

The present technology has been made in view of such circumstances, and, in the data transmission using the LDPC code, is to ensure good communication quality.

Means for solving the Problem

The first data processing device/data processing method of the present technology includes a group-wise interleave unit/step of performing group-wise interleave of interleaving in a 360-bit group unit an LDPC code whose code length is 64800 bits and code rate is 10/15, 11/15, 12/15 or 13/15, the (i + 1)th bit group from the beginning of the LDPC code of the 64800 bits being as a bit group i, and in the group-wise interleave, a sequence of bit group 0 to 179 of the 64800 bits of the LDPC code being interleaved into the following sequence of the bit group:

> 90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

The first data processing device/data processing method of the present technology performs group-wise interleave of interleaving in a 360-bit group unit the LDPC code whose code length is 64800 bits and code rate is 10/15, 11/15, 12/15 or 13/15. In the group-wise interleave, the sequence of the 64800 bits of the LDPC code bit group 0 to 179 is interleaved into the following sequence of the bit group:

> 90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

The second data processing device/data processing method of the present technology includes a group-wise interleave unit of performing group-wise interleave of interleaving in a 360-bit group unit an LDPC code whose code length is 64800 bits and code rate is 10/15, 11/15, 12/15 or 13/15, and a group-wise deinterleave unit/step of returning a sequence of the LDPC code after the group-wise interleave obtained from data transmitted from a transmitting device to the original sequence, the (i + 1)th bit group from the beginning of the LDPC code of the 64800 bits being as a bit group i, and in the group-wise interleave, a sequence of bit group 0 to 179 of the 64800 bits of the LDPC code being interleaved into the following sequence of the bit group:

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

The second data processing device/data processing method of the present technology includes a group-wise interleave unit of performing group-wise interleave of interleaving in a 360-bit group unit an LDPC code whose code length is 64800 bits and code rate is 10/15, 11/15, 12/15 or 13/15, and of returning the sequence of the LDPC code after the group-wise interleave obtained from data transmitted from a transmitting device to the original sequence, the (i + 1)th bit group from the beginning of the LDPC code of the 64800 bits being as a bit group i, and in the group-wise interleave, a sequence of bit group 0 to 179 of the 64800 bits of the LDPC code being interleaved into the following sequence of the bit group:

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

The data processing apparatus may be an independent apparatus or may be an internal block making up one device.

Effects of the Invention

According to the present technology, in the data transmission using the LDPC code, it is possible to ensure good communication quality.

Here, the effects described in are not necessarily limited, it may be any of the effects described in the present disclosure.

Brief Description of Drawings

[Fig. 1] A diagram illustrating a parity check matrix H of an LDPC code.
[Fig. 2] A flowchart illustrating a decoding procedure of an LDPC code.
[Fig. 3] A diagram illustrating an example of an LDPC code of the parity check matrix.
[Fig. 4] A diagram illustrating a Tanner graph of the parity check matrix.
[Fig. 5] A diagram showing a variable node.

[Fig. 6] A diagram showing a check node.

[Fig. 7] A diagram illustrating an example configuration of an embodiment of a transmission system to which the present technology is applied.

[Fig. 8] A block diagram showing a configuration example of the transmitting apparatus 11.

[Fig. 9] A block diagram showing a configuration example of the bit interleaver 116.

[Fig. 10] A diagram illustrating a parity check matrix [Fig. 11] A diagram illustrating a parity matrix.

[Fig. 12] A diagram illustrating a parity check matrix of an LDPC code prescribed in the standard of the DVB-T.2.

[Fig. 13] A diagram illustrating a parity check matrix of an LDPC code prescribed in the standard of the DVB-T.2.

[Fig. 14] A diagram illustrating a Tanner graph for decoding of LDPC codes.

[Fig. 15] A diagram showing a parity matrix $H_T$ having a staircase structure and a diagram illustrating a Tanner graph corresponding to the parity matrix $H_T$.

[Fig. 16] A diagram illustrating a parity matrix $H_T$ of the parity check matrix H corresponding to the LDPC code after the parity interleave.

[Fig. 17] A flowchart for explaining the processing performed by a bit interleaver 116 and a mapper 117.

[Fig. 18] A block diagram showing a configuration example of an LDPC encoder 115.

[Fig. 19] A flowchart illustrating a process of the LDPC encoder 115.

[Fig. 20] A diagram illustrating an example of a parity check matrix initial value table of a code rate of 1/4 and a code length of 16200.

[Fig. 21] A diagram for explaining a method of determining a parity check matrix H from the parity check matrix initial value table.

[Fig. 22] A diagram showing a parity check matrix initial value table of a first new LDPC code whose code length N is 64k bits and code rate r is 7/15.

[Fig. 23] A diagram showing a parity check matrix initial value table of a first new LDPC code whose code length N is 64k bits and code rate r is 7/15.

[Fig. 24] A diagram showing a parity check matrix initial value table of a first new LDPC code whose code length N is 64k bits and code rate r is 7/15.

[Fig. 25] A diagram showing a parity check matrix initial value table of a first new LDPC code whose code length N is 64k bits and code rate r is 9/15.

[Fig. 26] A diagram showing a parity check matrix initial value table of a first new LDPC code whose code length N is 64k bits and code rate r is 9/15.

[Fig. 27] A diagram showing a parity check matrix initial value table of a first new LDPC code whose code length N is 64k bits and code rate r is 9/15.

[Fig. 28] A diagram showing a parity check matrix initial value table of a first new LDPC code whose code length N is 64k bits and code rate r is 11/15.

[Fig. 29] A diagram showing a parity check matrix initial value table of a first new LDPC code whose code length N is 64k bits and code rate r is 11/15.

[Fig. 30] A diagram showing a parity check matrix initial value table of a first new LDPC code whose code length N is 64k bits and code rate r is 11/15.

[Fig. 31] A diagram showing a parity check matrix initial value table of a first new LDPC code whose code length N is 64k bits and code rate r is 13/15.

[Fig. 32] A diagram showing a parity check matrix initial value table of a first new LDPC code whose code length N is 64k bits and code rate r is 13/15.

[Fig. 33] A diagram showing a parity check matrix initial value table of a first new LDPC code whose code length N is 64k bits and code rate r is 13/15.

[Fig. 34] A diagram showing a parity check matrix initial value table of a first new LDPC code whose code length N is 16k bits and code rate r is 6/15.

[Fig. 35] A diagram showing a parity check matrix initial value table of a first new LDPC code whose code length N is 16k bits and code rate r is 8/15.

[Fig. 36] A diagram showing a parity check matrix initial value table of a first new LDPC code whose code length N is 16k bits and code rate r is 10/15.

[Fig. 37] A diagram showing a parity check matrix initial value table of a first new LDPC code whose code length N is 16k bits and code rate r is 12/15.

[Fig. 38] A diagram showing a parity check matrix initial value table of a first other new LDPC code whose code length N is 16k bits and code rate r is 10/15.

[Fig. 39] A diagram showing a parity check matrix initial value table of a first other new LDPC code whose code length N is 16k bits and code rate r is 12/15.

[Fig. 40] A diagram showing a parity check matrix initial value table of a second new LDPC code whose code length N is 64k bits and code rate r is 6/15.

[Fig. 41] A diagram showing a parity check matrix initial value table of a second new LDPC code whose code length N is 64k bits and code rate r is 6/15.

[Fig. 42] A diagram showing a parity check matrix initial value table of a second new LDPC code whose code length N is 64k bits and code rate r is 8/15.

[Fig. 43] A diagram showing a parity check matrix initial value table of a second new LDPC code whose code length N is 64k bits and code rate r is 8/15.

[Fig. 44] A diagram showing a parity check matrix initial value table of a second new LDPC code whose code length N is 64k bits and code rate r is 8/15.

[Fig. 45] A diagram showing a parity check matrix initial value table of a second new LDPC code whose code length N is 64k bits and code rate r is 10/15.

[Fig. 46] A diagram showing a parity check matrix initial value table of a second new LDPC code whose code length N is 64k bits and code rate r is 10/15.

[Fig. 47] A diagram showing a parity check matrix initial value table of a second new LDPC code whose code length N is 64k bits and code rate r is 10/15.

[Fig. 48] A diagram showing a parity check matrix initial value table of a second new LDPC code whose code length N is 64k bits and code rate r is 12/15.

[Fig. 49] A diagram showing a parity check matrix initial value table of a second new LDPC code whose code length N is 64k bits and code rate r is 12/15.

[Fig. 50] A diagram showing a parity check matrix initial value table of a second new LDPC code whose code length N is 64k bits and code rate r is 12/15.

[Fig. 51] A diagram showing a parity check matrix initial value table of a second new LDPC code whose code length N is 16k bits and code rate r is 7/15.

[Fig. 52] A diagram showing a parity check matrix initial value table of a second new LDPC code whose code length N is 16k bits and code rate r is 9/15.

[Fig. 53] A diagram showing a parity check matrix initial value table of a second new LDPC code whose code length N is 16k bits and code rate r is 11/15.

[Fig. 54] A diagram showing a parity check matrix initial value table of a second new LDPC code whose code length N is 16k bits and code rate r is 13/15.

[Fig. 55] A diagram illustrating an example of a Tanner graph of an ensemble of a degree sequence in which a column weight is 3 and a row weight is 6.

[Fig. 56] A diagram showing an example of the Tanner graph of a multi-edge type ensemble.

[Fig. 57] A diagram showing a minimum cycle length and a performance threshold of the parity check matrix of the first new LDPC code whose code length N is 64k bits and code rate r is 7/15, 9/15, 11/15 or 13/15.

[Fig. 58] A diagram showing a minimum cycle length and a performance threshold of the parity check matrix of the first new LDPC code whose code length N is 64k bits and code rate r is 7/15, 9/15, 11/15 or 13/15.

[Fig. 59] A diagram showing a minimum cycle length and a performance threshold of the parity check matrix of the first new LDPC code whose code length N is 64k and code rate r is 7/15, 9/15, 11/15 or 13/15.

[Fig. 60] A diagram showing a simulation result of measurement of BER/FER about the first new LDPC code whose code length N is 64k bits and code rate r is 7/15.

[Fig. 61] A diagram showing a simulation result of measurement of BER/FER about the first new LDPC code whose code length N is 64k bits and code rate r is 9/15.

[Fig. 62] A diagram showing a simulation result of measurement of BER/FER about the first new LDPC code whose code length N is 64k bits and code rate r is 11/15.

[Fig. 63] A diagram showing a simulation result of measurement of BER/FER about the first new LDPC code whose code length N is 64k bits and code rate r is 13/15.

[Fig. 64] A diagram showing a minimum cycle length and a performance threshold of the parity check matrix of the first new LDPC code whose code length N is 16k bits and code rate r is 6/15, 8/15, 10/15 or 12/15.

[Fig. 65] A diagram illustrating the parity check matrix of the first new LDPC code whose code length N is 16k bits and code rate r is 6/15, 8/15, 10/15 or 12/15.

[Fig. 66] A diagram illustrating the parity check matrix of the first new LDPC code whose code length N is 16k bits and code rate r is 6/15, 8/15, 10/15 or 12/15.

[Fig. 67] A diagram showing a simulation result of measurement of BER/FER about the first new LDPC code whose code length N is 64k bits and code rate r is 6/15.

[Fig. 68] A diagram showing a simulation result of measurement of BER/FER about the first new LDPC code whose code length N is 64k bits and code rate r is 8/15.

[Fig. 69] A diagram showing a simulation result of measurement of BER/FER about the first new LDPC code whose code length N is 64k bits and code rate r is 10/15.

[Fig. 70] A diagram showing a simulation result of measurement of BER/FER about the first new LDPC code whose code length N is 64k bits and code rate r is 12/15.

[Fig. 71] A diagram showing a minimum cycle length and a performance threshold of the parity check matrix of the first other new LDPC code whose code length N is 16k bits and code rate r is 10/15.

[Fig. 72] A diagram showing a minimum cycle length and a performance threshold of the parity check matrix of the first other new LDPC code whose code length N is 16k bits and code rate r is 10/15.

[Fig. 73] A diagram showing a minimum cycle length and a performance threshold of the parity check matrix of the first other new LDPC code whose code length N is 16k bits and code rate r is 10/15.

[Fig. 74] A diagram showing a simulation result of measurement of BER/FER about the first other new LDPC code whose code length N is 16k bits and code rate r is 10/15.

[Fig. 75] A diagram showing a simulation result of measurement of BER/FER about the first other new LDPC code whose code length N is 16k bits and code rate r is 12/15.

[Fig. 76] A diagram illustrating the parity check matrix of the first other new LDPC code whose code length N is 16k bits and code rate r is 12/15.

[Fig. 77] A diagram illustrating the parity check matrix of the first other new LDPC code whose code length N is 16k bits and code rate r is 12/15.

[Fig. 78] A diagram showing a simulation result of measurement of BER/FER about the first other new LDPC code whose code length N is 16k bits and code rate r is 12/15.

[Fig. 79] A diagram illustrating the parity check matrix of the second new LDPC code whose code length N is 64k bits and code rate r is 6/15, 8/15, 10/15, 12/15.

[Fig. 80] A diagram illustrating the parity check matrix of the second new LDPC code whose code length N is 64k bits and code rate r is 6/15, 8/15, 10/15, 12/15.

[Fig. 81] A diagram showing a simulation result of measurement of BER/FER about the second new LDPC code whose code length N is 64k bits and code rate r is 6/15.

[Fig. 82] A diagram showing a simulation result of measurement of BER/FER about the second new LDPC code whose code length N is 64k bits and code rate r is 8/15.

[Fig. 83] A diagram showing a simulation result of measurement of BER/FER about the second new LDPC code whose code length N is 64k bits and code rate r is 10/15.

[Fig. 84] A diagram showing a simulation result of measurement of BER/FER about the second new LDPC code whose code length N is 64k bits and code rate r is 12/15.

[Fig. 85] A diagram illustrating the parity check matrix of the second new LDPC code whose code length N is 16k bits and code rate r is 7/15, 9/15, 11/15, 13/15.

[Fig. 86] A diagram illustrating the parity check matrix of the second new LDPC code whose code length N is 16k bits and code rate r is 7/15, 9/15, 11/15, 13/15.

[Fig. 87] A diagram showing a simulation result of measurement of BER/FER about the second new LDPC code whose code length N is 16k bits and code rate r is 7/15.

[Fig. 88] A diagram showing a simulation result of measurement of BER/FER about the second new LDPC code whose code length N is 16k bits and code rate r is 9/15.

[Fig. 89] A diagram showing a simulation result of measurement of BER/FER about the second new LDPC code whose code length N is 16k bits and code rate r is 11/15.

[Fig. 90] A diagram showing a simulation result of measurement of BER/FER about the second new LDPC code whose code length N is 16k bits and code rate r is 13/15.

[Fig. 91] A diagram showing illustrative types of the constellation.

[Fig. 92] A diagram showing an example of a constellation for eight code rates r of the LDPC code when the modulation scheme is 16QAM.

[Fig. 93] A diagram showing an example of a constellation for eight code rates r of the LDPC code when the modulation scheme is 64QAM.

[Fig. 94] A diagram showing an example of a constellation for eight code rates r of the LDPC code when the modulation scheme is 256QAM.

[Fig. 95] A diagram showing an example of a constellation for eight code rates r of the LDPC code when the modulation scheme is 1024QAM.

[Fig. 96] A diagram showing a simulation result of measurement of BER where UC, 1D NUC or 2D NUC is used as constellation when the modulation scheme is 16QAM.

[Fig. 97] A diagram showing a simulation result of measurement of BER where UC, 1D NUC or 2D NUC is used as constellation when the modulation scheme is 64QAM.

[Fig. 98] A diagram showing a simulation result of measurement of BER where UC, 1D NUC or 2D NUC is used as constellation when the modulation scheme is 256QAM.

[Fig. 99] A diagram showing a simulation result of measurement of BER where UC, 1D NUC or 2D NUC is used as constellation when the modulation scheme is 1024QAM.

[Fig. 100] A diagram showing coordinates of the signal points of UC commonly used for eight code rates r of the LDPC code when the modulation scheme is QPSK.

[Fig. 101] A diagram showing coordinates of the signal points of 2D NUC commonly used for eight code rates r of the LDPC code when the modulation scheme is 16QAM.

[Fig. 102] A diagram showing coordinates of the signal points of 2D NUC commonly used for eight code rates r of the LDPC code when the modulation scheme is 64QAM.

[Fig. 103] A diagram showing coordinates of the signal points of 2D NUC commonly used for eight code rates r of the LDPC code when the modulation scheme is 256QAM.

[Fig. 104] A diagram showing coordinates of the signal points of 1D NUC commonly used for eight code rates r of the LDPC code when the modulation scheme is 1024QAM.

[Fig. 105] A diagram showing a relationship between a real part $Re(z_q)$ and an imaginary part $Im(z_q)$ of a complex number as a coordinate of a symbol y and a signal point $z_q$ of 1D NUC corresponding to the symbol y.

[Fig. 106] A block diagram showing a configuration example of a block interleaver 25.

[Fig. 107] A diagram showing a column number C of parts 1 and 2 for a combination of a code length N and a modulation scheme and part column lengths R1 and R2.

[Fig. 108] A diagram for illustrating a block interleave performed in the block interleaver 25.

[Fig. 109] A diagram for illustrating group-wise interleave performed in a group-wise interleaver 24.

[Fig. 110] A diagram showing a first example of a GW pattern for the LDPC code whose code length N is 64k bits.

[Fig. 111] A diagram showing a second example of the GW pattern for the LDPC code whose code length N is 64k bits.

[Fig. 112] A diagram showing a third example of the GW pattern for the LDPC code whose code length N is 64k bits.

[Fig. 113] A diagram showing a fourth example of the GW pattern for the LDPC code whose code length N is 64k bits.

[Fig. 114] A diagram showing a first example of a GW pattern for the LDPC code whose code length N is 16k bits.

[Fig. 115] A diagram showing a second example of the GW pattern for the LDPC code whose code length N is 16k bits.

[Fig. 116] A diagram showing a third example of the GW pattern for the LDPC code whose code length N is 16k bits.

[Fig. 117] A diagram showing a fourth example of the GW pattern for the LDPC code whose code length N is 16k bits.

[Fig. 118] A block diagram showing a configuration example of the receiving device 12.

[Fig. 119] A block diagram showing a configuration example of a bit deinterleaver 165.

[Fig. 120] A flowchart illustrating processes performed by a demapper 164, the bit deinterleaver 165, and an LDPC decoder 166.

[Fig. 121] A diagram showing an example of the parity check matrix of the LDPC code.

[Fig. 122] A diagram illustrating a matrix (conversion parity check matrix) obtained by applying row permutation and column permutation to the parity check matrix.

[Fig. 123] A diagram illustrating the conversion parity check matrix divided into 5 x 5 units.

[Fig. 124] A block diagram showing a configuration example of a decoding device, which collectively performs P node operations.

[Fig. 125] A block diagram showing a configuration example of the LDPC decoder 166.

[Fig. 126] A block diagram showing a configuration example of a block deinterleaver 54.

[Fig. 127] A block diagram showing other configuration example of the bit deinterleaver 165.

[Fig. 128] A block diagram showing a first configuration example of a receiving system to which the receiving device 12 may be applied.

[Fig. 129] A block diagram showing a second configuration example of the receiving system to which the receiving device 12 may be applied.

[Fig. 130] A block diagram showing a third configuration example of the receiving system to which the receiving device 12 may be applied.

[Fig. 131] A block diagram showing a configuration example of one embodiment of a computer to which the present technology is applied.

Modes for Carrying Out the Invention

Hereinafter, embodiments of the present technology will be described. Before that, an LDPC code will be described.

<LDPC code>

The LDPC code is a linear code and is not necessarily required to be a binary code; however, it is herein described supposing that this is the binary code.

The greatest characteristic of the LDPC code is that a parity check matrix defining the LDPC code is sparse. Herein, the sparse matrix is the matrix in which the number of elements "1" of the matrix is very small (most of elements are 0).

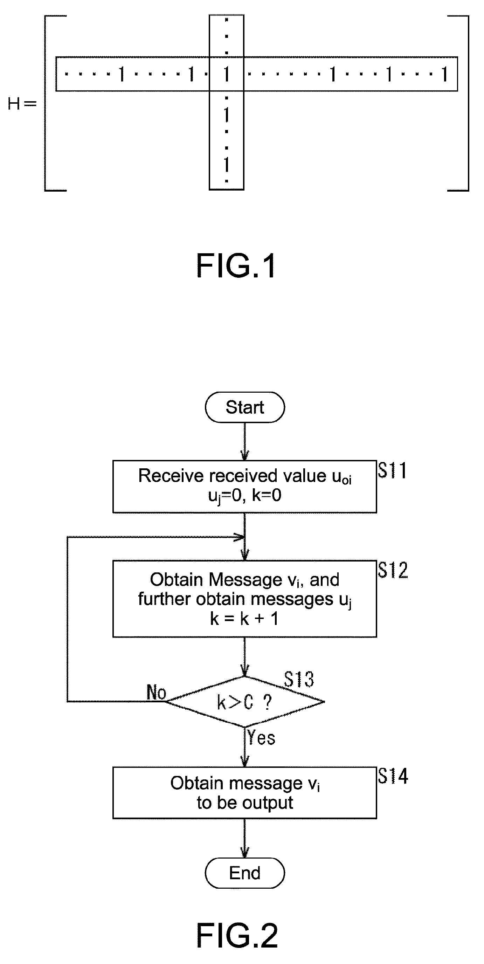

Fig. 1 is a view showing an example of a parity check matrix H of the LDPC code.

In the parity check matrix H in Fig. 1, a weight of each column (column weight) (the number of "1") is "3" and the weight of each row (row weight) is "6".

In encoding by the LDPC code (LDPC encoding), a code word (LDPC code) is generated by generation of a generator matrix G based on the parity check matrix H and multiplication of the generator matrix G by a binary information bit, for example.

Specifically, an encoding device, which performs the LDPC encoding, first calculates the generator matrix G satisfying an equation $GH^T = 0$ between the same and a transposed matrix $H^T$ of the parity check matrix H. Herein, when the generator matrix G is a K $\times$ N matrix, the encoding device multiplies a bit column (vector u) of K bits by the generator matrix G to generate a code word c (= uG) configured of N bits. The code word (LDPC code) generated by the encoding device is received on a receiving side through a predetermined communication channel.

Decoding of the LDPC code may be performed by an algorithm suggested by Gallager as probabilistic decoding being a message passing algorithm by belief propagation on a so-called Tanner graph configured of a variable node (also referred to as a message node) and a check node. Hereinafter, the variable node and the check node are appropriately and simply referred to as a node.

Fig. 2 is a flowchart showing a procedure of the decoding of the LDPC code.

A real value (received LLR) representing likelihood of a value to be "0" of an i-th code bit of the LDPC code (one cord word) received on the receiving side by a log likelihood ratio is hereinafter appropriately referred to as a received value $u_{0i}$. A message output from the check node is set to $u_j$ and the message output from the variable node is set to $v_i$.

First, in the decoding of the LDPC code, as shown in Fig. 2, the LDPC code is received, the message (check node message) $u_j$ is initialized to "0", and a variable k being an integer as a counter of a repetitive process is initialized to "0" at step S11 and the procedure shifts to step S12. At step S12, the message (variable node message) $v_i$ is obtained by an operation (variable node operation) represented in equation (1) based on the received value $u_{0i}$ obtained by receiving the LDPC code and the message $u_j$ is obtained by an operation (check node operation) represented in equation (2) based on the message $v_i$.

[Equation 1]

$$v_i = u_{0i} + \sum_{j=1}^{d_v - 1} u_j \qquad (1)$$

[Equation 2]

$$\tanh\left(\frac{u_j}{2}\right) = \prod_{i=1}^{d_c - 1} \tanh\left(\frac{v_i}{2}\right) \qquad (2)$$

Herein, $d_v$ and $d_c$ in equations (1) and (2) are parameters indicating the numbers of "1" in a vertical direction (column) and a horizontal direction (row) of the parity check matrix H, which may be optionally selected. For example, it is set that $d_v = 3$ and $d_c = 6$ in the case of the LDPC code ((3, 6) LDPC code) for the parity check matrix H in which the column weight is 3 and the row weight is 6 as shown in Fig. 1.

In the variable node operation in equation (1) and the check node operation in equation (2), the message input from an edge (line connecting the variable node and the check node to each other) from which the message is to be output is not a target of the operation, so that a range of the operation is 1 to $d_v$-1 or 1 to $d_c$-1. Also, a table of a function $R(v_1, v_2)$ represented in equation (3) defined by one output with respect to two inputs $v_1$ and $v_2$ is created in advance and this is continuously (recursively) used as represented in equation (4) for actually performing the check node operation in equation (2).

[Equation 3]

$$x = 2\tanh^{-1}\{\tanh(v_1/2)\tanh(v_2/2)\} = R(v_1, v_2) \qquad (3)$$

$$u_j = R(v_1, R(v_2, R(v_3, \cdots R(v_{d_c-2}, v_{d_c-1}))))$$

$$(4)$$

At step S12, the variable k is incremented by 1 and the procedure shifts to step S13. At step S13, it is judged whether the variable k is larger than a predetermined number of times of repetitive decoding C. When it is judged that the variable k is not larger than C at step S13, the procedure returns to step S12 and a similar process is hereinafter repeatedly performed.

Also, when it is judged that the variable k is larger than C at step S13, the procedure shifts to step S14 to perform an operation represented in equation (5), so that the message $v_i$ as a decoding result to be finally output is obtained to be output and a decoding process of the LDPC code is finished.

[Equation 5]

$$v_i = u_{0i} + \sum_{j=1}^{d_v} u_j$$

$$(5)$$

Herein, different from the variable node operation in equation (1), the operation in equation (5) is performed using the messages $u_j$ from all the edges connected to the variable node.

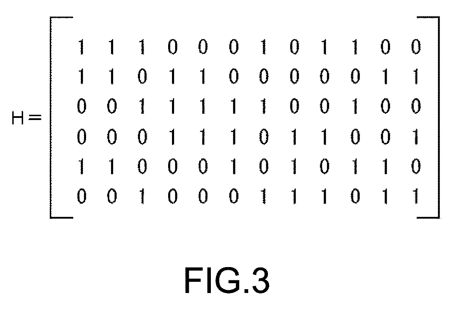

Fig. 3 is a view showing an example of the parity check matrix H of the (3, 6) LDPC code (code rate 1/2 and code length 12).

In the parity check matrix H in Fig. 3, the weight of the column is 3 and the weight of the row is 6 as in Fig. 1.

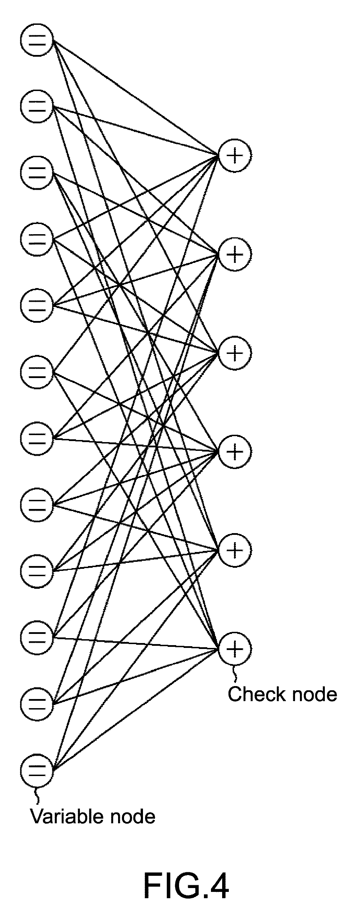

Fig. 4 is a view showing the Tanner graph of the parity check matrix H in Fig. 3.

Herein, in Fig. 4, the check node is represented by plus "+" and the variable node is represented by equal "=". The check node and the variable node correspond to the row and the column of the parity check matrix H, respectively. A connection between the check node and the variable node is the edge, which corresponds to the element "1" of the parity check matrix.

That is to say, when a j-th row i-th column element of the parity check matrix is 1, in Fig. 4, an i-th variable node (node of "=") from the top and a j-th check node (node of "+") from the top are connected to each other by the edge. The edge indicates that the code bit corresponding to the variable node has a constraint condition corresponding to the check node.

In a sum product algorithm being the decoding method of the LDPC code, the variable node operation and the check node operation are repeatedly performed.

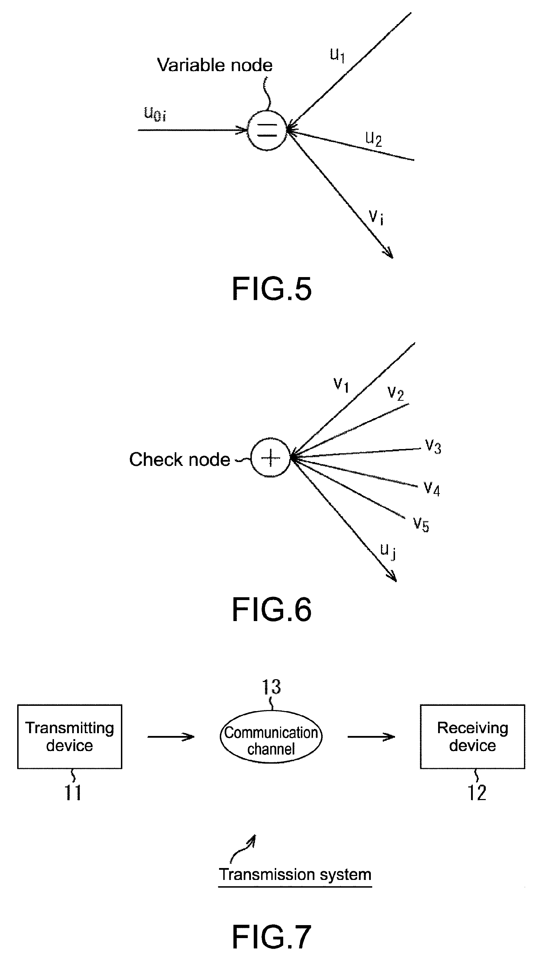

Fig. 5 is a view showing the variable node operation performed in the variable node.

In the variable node, the message $v_i$ corresponding to the edge to be calculated is obtained by the variable node operation in equation (1) using the messages $u_i$ and $u_2$ from other edges connected to the variable node and the received value $u_{0i}$. The message corresponding to another edge is similarly obtained.

Fig. 6 illustrates the check node operation performed in the check node.

Herein, the check node operation in equation (2) may be rewritten as equation (6) using relationship of an equation $a \times b = \exp\{\ln(|a|)+\ln(|b|)\} \times \text{sign}(a) \times \text{sign}(b)$. Sign(x) is 1 when x => 0 is satisfied and -1 when x < 0 is satisfied.

[Equation 6]

$$u_j = 2\tanh^{-1}\left(\prod_{i=1}^{d_c-1} \tanh\left(\frac{v_i}{2}\right)\right)$$

$$= 2\tanh^{-1}\left[\exp\left\{\sum_{i=1}^{d_c-1} \ln\left(\left|\tanh\left(\frac{v_i}{2}\right)\right|\right)\right\} \times \prod_{i=1}^{d_c-1} \mathrm{sign}\left(\tanh\left(\frac{v_i}{2}\right)\right)\right]$$

$$= 2\tanh^{-1}\left[\exp\left\{-\left(\sum_{i=1}^{d_c-1} -\ln\left(\tanh\left(\frac{|v_i|}{2}\right)\right)\right)\right\}\right] \times \prod_{i=1}^{d_c-1} \mathrm{sign}(v_i)$$

$$(6)$$

When a function ($\varphi$)(x) is defined by an equation $\varphi(x) = \ln(\tan h(x/2))$ when x => 0 is satisfied, an equation $\varphi^{-1}(x) = 2\tan h^{-1}(e^{-x})$ is satisfied, so that equation (6) may be deformed to equation (7).

[Equation 7]

$$u_j = \phi^{-1}\left(\sum_{i=1}^{d_c-1} \phi(|v_i|)\right) \times \prod_{i=1}^{d_c-1} \mathrm{sign}(v_i)$$

$$(7)$$

In the check node, the check node operation in equation (2) is performed according to equation (7).

That is to say, in the check node, the message $u_j$ corresponding to the edge to be calculated is obtained by the check node operation in equation (7) using messages $v_1$, $v_2$, $v_3$, $v_4$, and $v_5$ from other edges connected to the check node as illustrated in Fig. 6. The message corresponding to another edge is similarly obtained.

The function $\varphi(x)$ in equation (7) may be represented by an equation $\varphi(x) = \ln((e^x+1)/(e^x-1))$ and $\varphi(x) = \varphi^{-1}(x)$ when x > 0 is satisfied. When the functions $\varphi(x)$ and $\varphi^{-1}(x)$ are implemented in hardware, there is a case in which they are implemented using LUT (look up table), and the same LUT is used for both of them.

<Configuration example of transmission system to which the present technology is applied>

Fig. 7 illustrates a configuration example of one embodiment of a transmission system (the term "system" is intended to mean a logical assembly of a plurality of devices and it does not matter whether the devices of each configuration are in the same housing) to which the present technology is applied.

In Fig. 7, the transmission system is configured of a transmitting device 11 and a receiving device 12.

The transmitting device 11 transmits (broadcasts) (transmits) a program of television broadcasting. That is to say, the transmitting device 11 encodes target data to be transmitted such as image data and audio data as the program, for example, into an LDPC code and transmits the same through a communication channel 13 such as a satellite circuit, a terrestrial wave, and a cable (wire circuit).

The receiving device 12 receives the LDPC code transmitted from the transmitting device 11 through the communication channel 13 and decodes the same to the target data to output.

Herein, it is known that the LDPC code used in the transmission system in Fig. 7 exhibits an extremely high ability in an AWGN (additive white Gaussian noise) communication channel.

However, a burst error and erasure might occur in the communication channel 13 such as the terrestrial wave. For example, especially when the communication channel 13 is a terrestrial wave, in an OFDM (orthogonal frequency division multiplexing) system, there is a case in which power of a specific symbol reaches 0 (erasure) according to delay of an echo (a path other than a main path) in a multipath environment in which a D/U (desired to undesired ratio) is 0 dB (power of undesired (= echo) is equal to power of desired (= main path)).

There is a case in which the power of all the symbols of the OFDM at a specific time reaches 0 (erasure) by a Doppler frequency when the D/U is 0 dB also in a flutter (communication channel in which a Doppler frequency-shifted echo whose delay is 0 is added).

Further, the burst error might occur due to a wiring status from a receiver (not shown) such as an antenna, which receives a signal from the transmitting device 11, to the receiving device 12 and instability of a power supply of the receiving device 12 on a side of the receiving device 12.

On the other hand, in decoding of the LDPC code, a variable node operation in equation (1) including addition of (a received value $u_{0i}$ of) a code bit of the LDPC code is performed as illustrated above in Fig. 5 in a variable node corresponding to a column of a parity check matrix H and eventually the code bit of the LDPC code, so that, when the error occurs in the code bit used in the variable node operation, accuracy of an obtained message is deteriorated.

In the decoding of the LDPC code, a check node operation in equation (7) is performed in the check node using the message obtained in the variable node connected to the check node, so that decoding performance is deteriorated when the number of check nodes, in which (the code bits of the LDPC code corresponding to) a plurality of variable nodes connected thereto have the error (including the erasure) at the same time, increases.

That is to say, when the erasure occurs in two or more of the variable nodes connected to the check node at the same time, the check node returns the message indicating that probability that the value is 0 and the probability that the value is 1 are equal to all the variable nodes, for example. In this case, the check node, which returns the message of the equal probability, does not contribute to a single decoding process (one set of the variable node operation and the check node operation), and as a result, this requires a large number of repetitions of the decoding process, so that the decoding performance is deteriorated and further, power consumption of the receiving device 12, which decodes the LDPC code, increases.

Therefore, the transmission system in Fig. 7 is configured to improve resistance to burst error and erasure while maintaining performance in the AWGN communication channel (AWGN channel).

[Configuration example of transmitting device 11]

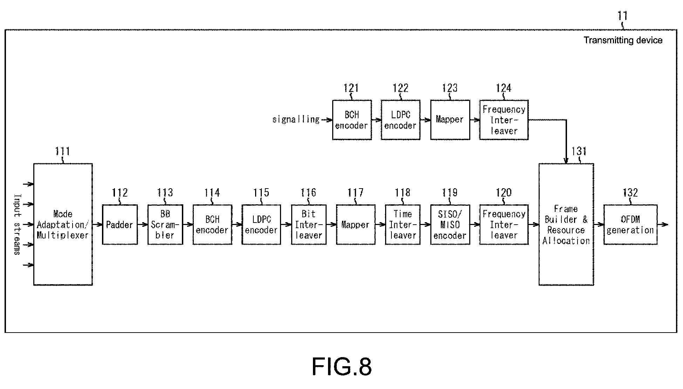

Fig. 8 is a block diagram showing a configuration example of the transmitting device 11 in Fig. 7.

In the transmitting device 11, one or more input streams as the target data are supplied to a mode adaptation/multiplexer 111.

The mode adaptation/multiplexer 111 selects a mode, multiplexes the one or more input streams supplied thereto, and supplies the data obtained as a result to a padder 112.

The padder 112 performs necessary zero padding (null insertion) to the data from the mode adaptation/multiplexer 111 and supplies the data obtained as a result to a BB scrambler 113.

The BB scrambler 113 applies BB scramble (Base-Band Scrambling) to the data from the padder 112 and supplies the data obtained as a result to a BCH encoder 114.

The BCH encoder 114 performs BCH encoding of the data from the BB scrambler 113 and supplies the data obtained as a result to an LDPC encoder 115 as LDPC target data being a target of LDPC encoding.

The LDPC encoder 115 performs the LDPC encoding of the LDPC target data from the BCH encoder 114 according to a parity check matrix in which a parity matrix being a part corresponding to a parity bit of the LDPC code has a stepwise structure and outputs the LDPC code in which an information bit is the LDPC target data.

That is to say, the LDPC encoder 115 performs the LDPC encoding to encode the LDPC target data into the LDPC code (corresponding to the parity check matrix) such as the LDPC code specified in a predetermined standard such as a DVB-S.2 standard, a DVB-T.2 standard and a DVB-C.2 standard or the LDPC code expected to be specified by ATSC3.0 (corresponding to the parity check matrix), for example, and outputs the LDPC code obtained as a result.

In the LDPC code specified in the DVB-T.2 standard or the LDPC code expected to be specified by ATSC3.0 is an IRA (irregular repeat-accumulate) code and the parity matrix in the parity check matrix of the LDPC code has the stepwise structure. The parity matrix and the stepwise structure are described later. The IRA code is described in "Irregular Repeat-Accumulate Codes, " H. Jin, A. Khandekar, and R. J. McEliece, in Proceedings of 2nd International Symposium on Turbo Codes and Related Topics, pp. 1-8, Sept. 2000, for example.

The LDPC code output by the LDPC encoder 115 is supplied to a bit interleaver 116.

The bit interleaver 116 performs bit interleave to be described later of the LDPC code from the LDPC encoder 115 and supplies the LDPC code after the bit interleave to a mapper 117.

The mapper 117 maps the LDPC code from the bit interleaver 116 onto a signal point indicating one symbol of orthogonal modulation in units of one or more code bits of the LDPC code (symbol unit) to perform the orthogonal modulation (multilevel modulation).

That is to say, the mapper 117 maps the LDPC code from the bit interleaver 116 onto the signal point defined by a modulation scheme for performing the orthogonal modulation of the LDPC code on an IQ plane (IQ constellation) defined by an I axis representing an I component in phase with a carrier wave and a Q axis representing a Q component orthogonal to the carrier wave and performs the orthogonal modulation.

If the number of signal points prescribed by orthogonal modulation of a modulation scheme which is performed by the mapper 117 is $2^m$, the mapper 117 maps the LDPC code from the bit interleaver 116 in a symbol unit onto the signal point indicating the symbol of the 2m signal points as the m code bit of the LDPC code for a symbol (1 symbol).

Herein, the modulation scheme of the orthogonal modulation performed by the mapper 117 includes the modulation scheme including the modulation scheme specified in the DVB-T.2 standard, for example, the modulation scheme expected to be specified by ATSC3.0, and other modulation schemes, that is to say, BPSK (Binary Phase Shift Keying), QPSK (quadrature phase shift keying), 8PSK (Phase-Shift Keying), 16APSK (Amplitude Phase-Shift Keying), 32APSK, 16QAM (quadrature amplitude modulation), 16QAM, 64QAM, 256QAM, 1024QAM, 4096QAM, 4PAM (Pulse Amplitude Modulation) and the like, for example. The modulation scheme with which the orthogonal modulation is performed by the mapper 117 is set in advance according to operation of an operator of the transmitting device 11, for example.

The data (symbol mapped onto the signal point) obtained by the process by the mapper 117 is supplied to a time interleaver 118.

The time interleaver 118 performs time interleave (interleave in a time direction) in a symbol unit of the data from the mapper 117 and supplies the data obtained as a result to a SISO/MISO (Single Input Single Output/Multiple Input Single Output) encoder 119.

The SISO/MISO encoder 119 applies time-space encoding to the data from the time interleaver 118 to supply to a frequency interleaver 120.

The frequency interleaver 120 performs frequency interleave (interleave in a frequency direction) for the unit of the data from the SISO/MISO encoder 119 in a symbol unit, and supplies it to a frame builder & resource allocation 131.

On the other hand, control data for transmission control (signaling) such as Base Band Signaling, BB Header and the like is supplied to the BCH encoder 121, for example.

The BCH encoder 121 performs the BCH encoding of the control data supplied thereto in the same manner as the BCH encoder 114 and supplies the data obtained as a result to an LDPC encoder 122.

The LDPC encoder 122 performs the LDPC encoding of the data from the BCH encoder 121 as the LDPC target data in the same manner as the LDPC encoder 115 and supplies the LDPC code obtained as a result to a mapper 123.

The mapper 123 maps the LDPC code from the LDPC encoder 122 onto the signal point indicating one symbol of the orthogonal modulation in units of one or more code bits of the LDPC code (symbol unit) to perform the orthogonal modulation and supplies the data obtained as a result to a frequency interleaver 124 in the same manner as the mapper 117.

The frequency interleaver 124 performs the frequency interleave of the data from the mapper 123 in a symbol unit to supply to the frame builder & resource allocation 131 in the same manner as the frequency interleaver 120.

The frame builder & resource allocation 131 inserts a pilot symbol into a required position of the data (symbol) from the frequency interleavers 120 and 124 and constitutes a frame configured of a predetermined number of symbols (for example, a PL (Physical Layer) frame, a T2 frame, a C2 frame and the like) from the data (symbol) obtained as a result to supply to an OFDM generation 132.

The OFDM generation 132 generates an OFDM signal corresponding to the frame from the frame from the frame builder & resource allocation 131 and transmits the same through the communication channel 13 (Fig. 7).

The transmitting device 11 may be configured without including some of the blocks shown in Fig. 8, e.g., the time interleaver 118, the SISO/MISO encoder 119, the frequency interleaver 120, and frequency interleaver 124.

<Configuration example of bit interleaver 116>

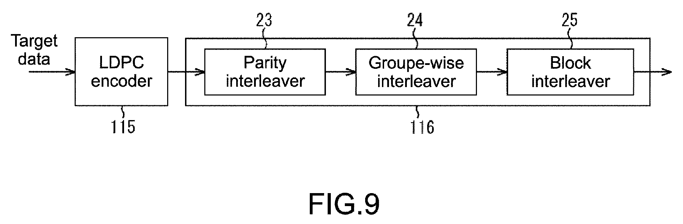

Fig. 9 is block diagram showing a configuration example of the bit interleaver 116 in Fig. 8.

The bit interleaver 116 has a function to interleave the data, and is configured of a parity interleaver 23, a group-wise interleaver 24, and a block interleaver 25.

The parity interleaver 23 performs parity interleave to interleave the parity bit of the LDPC code from the LDPC encoder 115 to a position of another parity bit and supplies the LDPC code after the parity interleave to the group-wise interleaver 24.

The group-wise interleaver 24 performs group-wise interleave of the LDPC code from the parity interleaver 23 and supplies the LDPC code after the group-wise interleave to the block interleaver 25.

Here, in the group-wise interleave, the LDPC code for one code is divided into a 360-bit unit equal to the number of columns P being the unit of the cyclic structure as described later from the beginning. One division, i.e., 360-bit, is considered as a bit group. The LDPC code from the parity interleaver 23 is interleaved in a bit group unit.

When the group-wise interleave is performed, the bit error rate can be improved as compared with the case that no group-wise interleave is performed. As a result, in the data transmission, it is possible to ensure good communication quality.

The block interleaver 25 performs the block interleave for demultiplexing the LDPC code from the group-wise interleaver 24, symbolizes the LDPC code for one code into the m bit symbol in a mapping unit, and supplies it to the mapper 117 (Fig. 8).

Here, there is a storage region where columns for storing a predetermined number of bits in a column (vertical) direction are arranged in equal numbers to the bit numbers m of the symbol in a row (horizontal) direction. In the block interleave, the LDPC code from the group-wise interlever 24 is written in the column direction and read in the row direction, thereby symbolizing the LDPC code for one code into the m bit symbol.

<Parity check matrix of LDPC code>

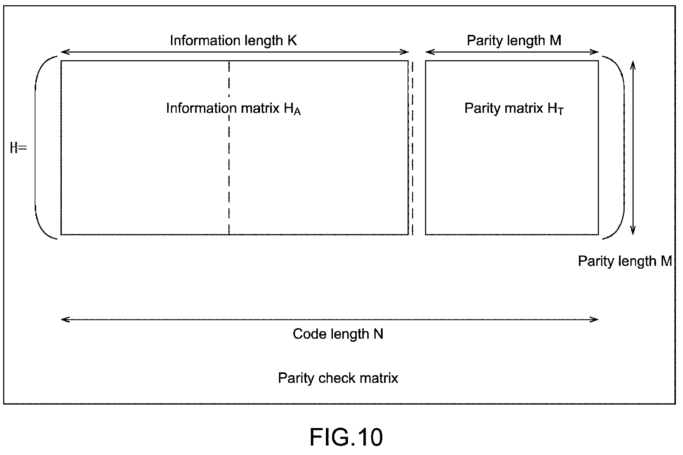

Fig. 10 shows the parity check matrix H used by the LDPC encoder 115 in Fig. 8.

The parity check matrix H has an LDGM (low-density generation matrix) structure and this may be represented by an equation $H = [H_A|H_T]$ (a matrix in which a left element is an element of an information matrix $H_A$ and a right element is an element of a parity matrix $H_T$) by the information matrix $H_A$ of a part corresponding to the information bit and the parity matrix $H_T$ corresponding to the parity bit out of the code bits of the LDPC code.

Herein, the number of information bits and the number of parity bits out of the code bits of one LDPC code (one code word) are referred to as an information length K and a parity length M, respectively, and the number of code bits of one LDPC code is referred to as a code length N (= K + M).

The information length K and the parity length M of the LDPC code of a certain code length N are determined according to the code rate. The parity check matrix H is an M x N (row x column) matrix. The information matrix $H_A$ is an M x K matrix and the parity matrix $H_T$ is an M x M matrix.

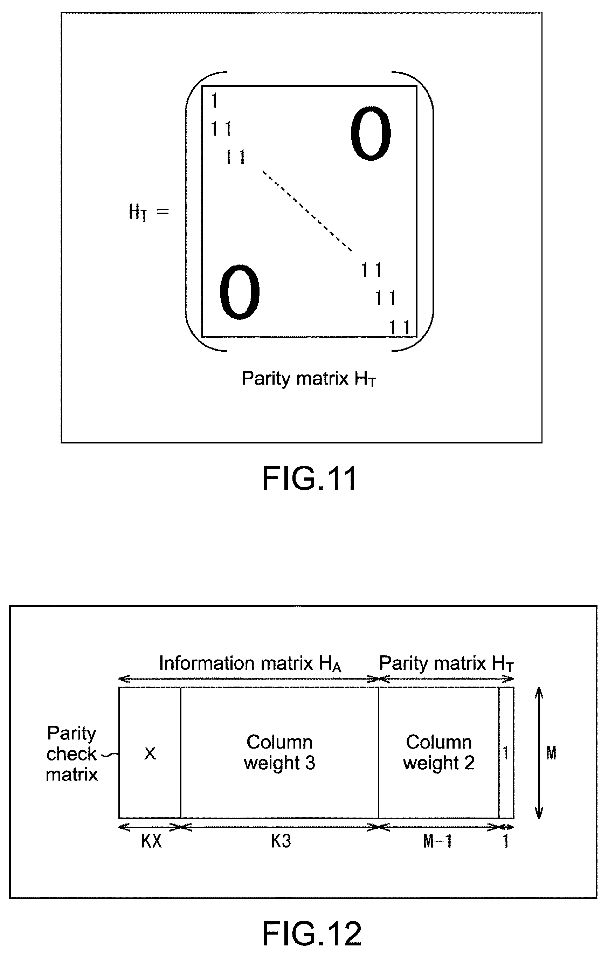

Fig. 11 is a drawing showing an example of the parity matrix $H_T$ of the parity check matrix H used for the LDPC encoding by the LDPC encoder 115 in Fig. 8.

The parity matrix $H_T$ of the parity check matrix H used for the LDPC encoding by the LDPC encoder 115 is similar to the parity matrix $H_T$ of the parity check matrix H of the LDPC code specified in the DVB-T.2 standard.

The parity matrix $H_T$ of the parity check matrix H of the LDPC code specified in the DVB-T.2 standard has a lower bidiagonal matrix in which elements of 1 are arranged in a so-called stepwise manner as shown in Fig. 11. A row weight of the parity matrix $H_T$ is 1 for a first row and 2 for all other rows. A column weight is 1 for a last column and 2 for all other columns.

As described above, the LDPC code of the parity check matrix H in which the parity matrix $H_T$ has the stepwise structure may be easily generated using the parity check matrix H.

That is to say, the LDPC code (one code word) is represented by a row vector c and a column vector obtained by transposing the row vector is represented as $c^T$. A part of the information bit of the row vector c, which is the LDPC code, is represented by a row vector A and a part of the parity bit is represented by a row vector T.

In this case, the row vector c may be represented by an equation c = [A|T] (row vector in which a left element is an element of the row vector A and a right element is an element of the row vector T) by the row vector A as the information bit and the row vector T as the parity bit.

The parity check matrix H and the row vector c = [A|T] as the LDPC code are required to satisfy an equation $Hc^T = 0$ and it is possible to sequentially obtain (in order) the row vector T as the parity bit configuring the row vector c = [A|T] satisfying such equation $Hc^T = 0$ by setting the element of each row to 0 in order from the element of a first row of the column vector $Hc^T$ in the equation $Hc^T = 0$ when the parity matrix $H_T$ of the parity check matrix $H = [H_A|H_T]$ has the stepwise structure illustrated in Fig. 11.

Fig. 12 is a view illustrating the parity check matrix H of the LDPC code specified in the DVB-T.2 standard.

The column weight is X for first to KX-th columns, the column weight is 3 for next K3 columns, the column weight is 2 for next M-1 columns, and the column weight is 1 for a last column in the parity check matrix H of the LDPC code specified in the DVB-T.2 standard.

Herein, KX + K3 + M - 1 + 1 equals to the code length N.

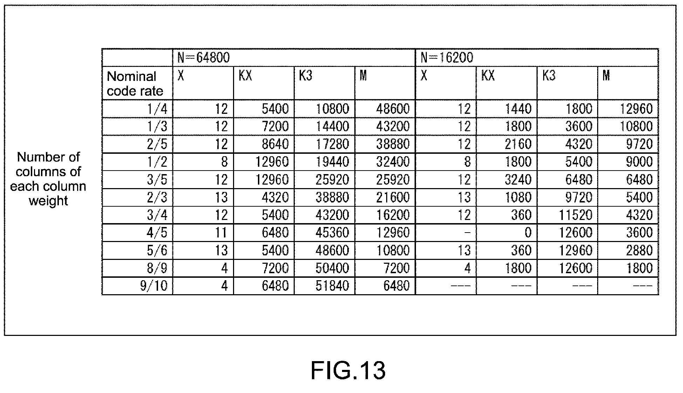

Fig. 13 is a view showing the numbers of columns KX, K3, and M and the column weight X for each code rate r of the LDPC code specified in the DVB-T.2 standard.

The LDPC codes whose code lengths N are 64800 bits and 16200 bits are specified in the DVB-T.2 standard.

For the LDPC code whose code length N is 64800 bits, 11 code rates (nominal rates) 1/4, 1/3, 2/5, 1/2, 3/5, 2/3, 3/4, 4/5, 5/6, 8/9, and 9/10 are specified, and for the LDPC code whose code length N is 16200 bits, 10 code rates 1/4, 1/3, 2/5, 1/2, 3/5, 2/3, 3/4, 4/5, 5/6, and 8/9 are specified.

The code length N of 64800 bits is hereinafter also referred to as 64k bits and the code length of 16200 bits is also referred to as 16k bits.

As for the LDPC code, it is known that a bit error rate of the code bit corresponding to the column whose column weight is larger of the parity check matrix H is lower.

In the parity check matrix H specified in the DVB-T.2 standard illustrated in Figs. 12 and 13, the column weight of the column closer to a top (leftmost) column tends to be larger, therefore, as for the LDPC code corresponding to the parity check matrix H, the code bit closer to a top code bit closer to a top code bit tends to be more tolerant to error (resistant to error) and the code bit closer to a last code bit tends to be less tolerant to error.

<Parity interleave>

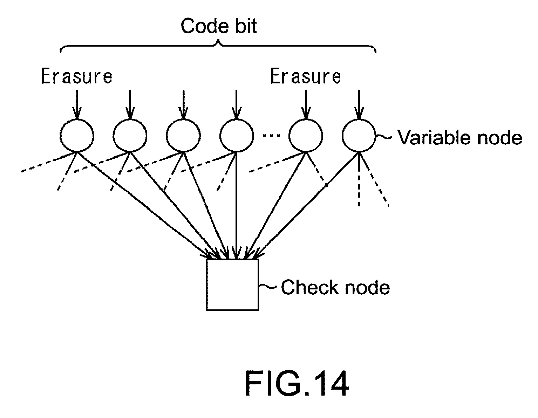

Referring to Fig. 14 to Fig. 16, the parity interleave by the parity interleaver 23 in Fig. 9 is described.

Fig. 14 shows (a part of) a Tanner graph of the parity check matrix of the LDPC code.

The check node returns the message indicating that the probability that the value is 0 and the probability that the value is 1 are equal to all the variable nodes connected to the check node when the error such as the erasure occurs in a plurality (for example, two) of (code bits corresponding to the) variable nodes connected to the check node at the same time as illustrated in Fig. 14. Therefore, when the erasure and the like occur at the same time in a plurality of variable nodes connected to the same check node, the decoding performance is deteriorated.

The LDPC code specified in the DVB-S.2 standard output by the LDPC encoder 115 in Fig. 8 is the IRA code and the parity matrix $H_T$ of the parity check matrix H has the stepwise structure as illustrated in Fig. 11.

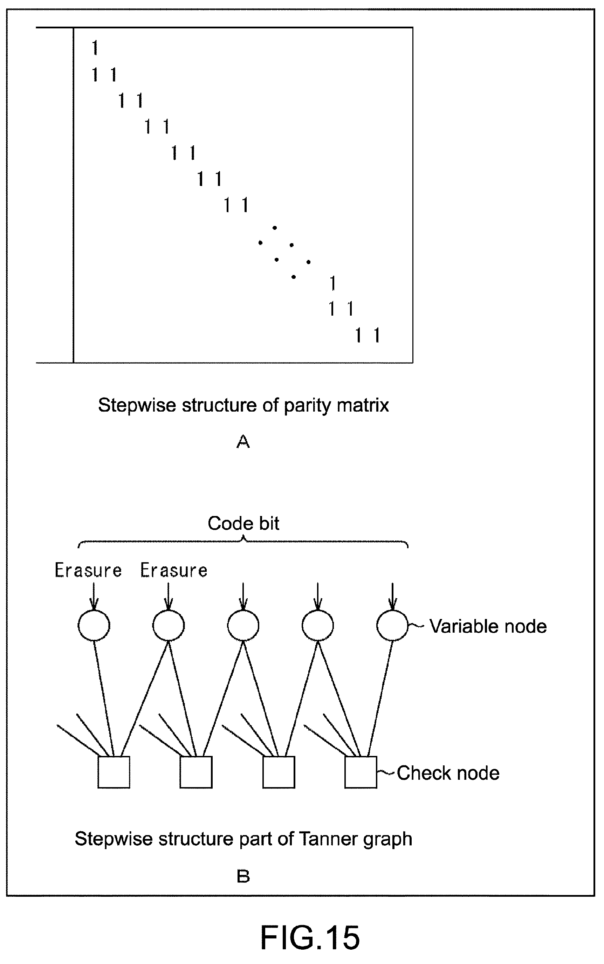

Fig. 15 shows the parity matrix $H_T$ having the stepwise structure and the Tanner graph corresponding to the parity matrix $H_T$, as shown in Fig. 11.

Fig. 15A shows the parity matrix $H_T$ having the stepwise structure and Fig. 15B shows the Tanner graph corresponding to the parity matrix $H_T$ in Fig. 15A.

In the parity matrix $H_T$ having the stepwise structure, the elements of 1 are adjacent to each other in each row (except the first row). Therefore, in the Tanner graph of the parity matrix $H_T$, two adjacent variable nodes corresponding to the columns of the two adjacent elements whose value is 1 of the parity matrix $H_T$ are connected to the same check node.

Therefore, when the error occurs in the parity bits corresponding to the above-described adjacent two variable nodes at the same time due to the burst error, the erasure and the like, the check node connected to the two variable nodes (the variable nodes, which obtain the message using the parity bits) corresponding to the two parity bits in which the error occurs returns the message indicating that the probability that the value is 0 and the probability that the value is 1 are equal to the variable nodes connected to the check node, whereby the decoding performance is deteriorated. When a burst length (the number of parity bits in which the error is successively occurs) increases, the number of check nodes, which return the message of the equal probability, increases and the decoding performance is further deteriorated.

Then, the parity interleaver 23 (Fig. 9) performs the parity interleave to interleave the parity bit of the LDPC code from the LDPC encoder 115 to the position of another parity bit in order to prevent the above-described deterioration in decoding performance.

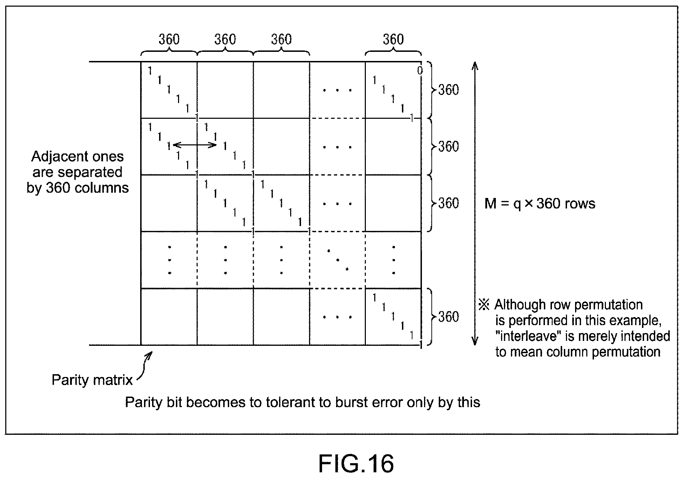

Fig. 16 shows the parity matrix $H_T$ of the parity check matrix H corresponding to the LDPC code after the parity interleave performed by the parity interleaver 23 in Fig. 9.

Herein, the information matrix $H_A$ of the parity check matrix H corresponding to the LDPC code output by the LDPC encoder 115 has a cyclic structure, similar to the information matrix of the parity check matrix H corresponding to the LDPC code specified in the DVB-T.2 standard.

The term "cyclic structure" is intended to mean a structure in which a certain column is identical to a column obtained by a cyclic shift of another column and includes a structure in which a position of 1 in each row of P columns is set to a position obtained by the cyclic shift of a first column of the P columns in the column direction by a value proportional to a value q obtained by dividing the parity length M for each P columns, for example. Hereinafter, P in the cyclic structure is appropriately referred to as the number of columns being a unit of the cyclic structure.

There are two types of LDPC codes whose code lengths N are 64800 bits and 16200 bits as the LDPC code specified in the DVB-T.2 standard as illustrated in Figs. 12 and 13, and the number of columns P being the unit of the cyclic structure is set to 360, which is one of submultiples other than 1 and M out of the submultiples of the parity length M for both of the two LDPC codes.

The parity length M is set to a value other than a prime number represented by an equation $M = q \times P = q \times 360$ using the value q different according to the code rate. Therefore, as the number of columns P being the unit of the cyclic structure, the value q also is another submultiple other than 1 and M out of the submultiples of the parity length M and this may be obtained by dividing the parity length M by the number of columns P being the unit of the cyclic structure (a product of P and q being the submultiples of the parity length M is the parity length M).

When the information length is K, an integer not smaller than 0 and smaller than P is x, and an integer not smaller than 0 and smaller than q is y, the parity interleaver 23 interleaves a $K + qx + y + 1$-th code bit out of the code bits of the N-bit LDPC code to a position of a $K + Py + x + 1$-th code bit as the parity interleave as described above.

Both the $K + qx + y + 1$-th code bit and the $K + Py + x + 1$-th code bit are the code bits after a $K + 1$-th code bit, so that they are the parity bits, therefore, the position of the parity bit of the LDPC code is moved by the parity interleave.

According to such parity interleave, (the parity bits corresponding to) the variable nodes connected to the same check node are apart from each other by the number of columns P being the unit of the cyclic structure, that is to say, herein 360 bits, so that a situation in which the error occurs in a plurality of variable nodes connected to the same check node at the same time may be avoided in a case in which the burst length is shorter than 360 bits, and as a result, the resistance to burst error may be improved.

The LDPC code after the parity interleave to interleave the $K + qx + y + 1$-th code bit to the position of the $K + Py + x + 1-th code bit is identical to the LDPC code of the parity check matrix obtained by performing column permutation to change the K + qx + y + 1-th column of the original parity check matrix H to the K + qx + x + 1-th column (hereinafter, also referred to as a conversion parity check matrix).

Also, a quasi-cyclic structure in units of P columns (360 columns in Fig. 16) appears in the parity matrix of the conversion parity check matrix as illustrated in Fig. 16.

Herein, the term "quasi-cyclic structure" is intended to mean a structure in which a portion except a part has the cyclic structure.

In the conversion parity check matrix obtained by applying the column permutation corresponding to the parity interleave to the parity check matrix of the LDPC code specified in the DVB-T.2 standard, one element 1 is lacking (there is an element 0) in a portion of 360 rows × 360 columns in a right corner of the conversion parity check matrix (a shift matrix to be described later), so that this does not have the (complete) cyclic structure and has the so-called quasi-cyclic structure in this point.

The conversion parity check matrix of the parity check matrix of the LDPC code output by the LDPC encoder 115 has a quasi-cyclic structure, similar to the conversion parity check matrix of the parity check matrix H of the LDPC code specified in the DVB-T.2 standard.

The conversion parity check matrix in Fig. 16 is the matrix obtained by applying permutation of the row (row permutation) for allowing the conversion parity check matrix to be configured of a constitutive matrix to be described later to the original parity check matrix H in addition to the column permutation corresponding to the parity interleave.

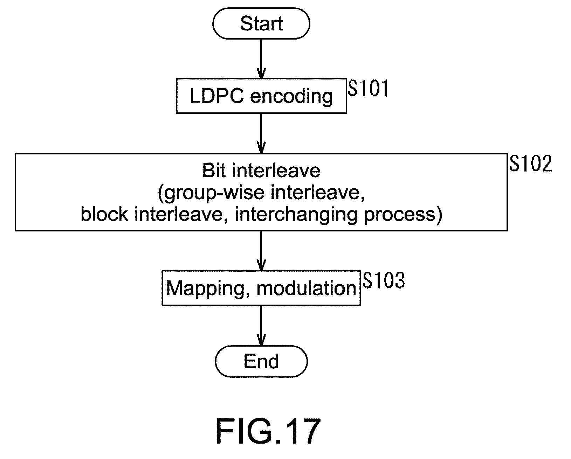

Fig. 17 is a flowchart for explaining the processing performed by the LDPC encoder 115, the bit interleaver 116 and the mapper 117 in Fig. 8.

The LDPC encoder 115 encodes the LDPC target data into the LDPC code at step S101 after waiting for supply of the LDPC target data from the BCH encoder 114 and supplies the LDPC code to the bit interleaver 116, then the process shifts to step S102.

The bit interleaver 116 performs the bit interleave of the LDPC code from the LDPC encoder 115 and supplies the symbol obtained by the bit interleave to the mapper 117 at step S102, then the process shifts to step S103.

That is to say, at step S102, in the bit interleaver 116 (Fig. 9), the parity interleaver 23 performs the parity interleave of the LDPC code from the LDPC encoder 115 and supplies the LDPC code after the parity interleave to the group-wise interleaver 24.

The group-wise interleaver 24 performs the group-wise interleave of the LDPC code from the parity interleaver 23 to supply to the block interleaver 25.

The block interleaver 25 performs the block interleave of the LDPC code after the group-wise interleave by the group-wise interleaver 24 and supplies the m bit symbol obtained as a result to the mapper 117.

The mapper 117 maps the symbol from the block interleaver 25 onto any of the 2m signal points defined by the modulation scheme of the orthogonal modulation performed by the mapper 117 to perform the orthogonal modulation and supplies the data obtained as a result to the time interleaver 118 at step S103.

As described above, it is possible to improve the error rate in a case in which a plurality of code bits of the LDPC code is transmitted as one symbol by performing the parity interleave and the group-wise interleave.

Herein, the parity interleaver 23, which is a block to perform the parity interleave, and the group-wise interleaver 24, which is a block to perform the group-wise interleave, are separately formed in Fig. 9 for convenience of description; however, the parity interleaver 23 and the group-wise interleaver 24 may be integrally formed.

That is to say, the parity interleave and the group-wise interleave may be performed by the writing and the reading of the code bit to and from the memory and may be represented by a matrix to convert the address at which the code bit is written (write address) to the address at which the code bit is read (read address).

Therefore, by obtaining the matrix obtained by multiplying the matrix representing the parity interleave by the matrix representing the group-wise interleave, it is possible to obtain a result of performing the parity interleave and performing the group-wise interleave of the LDPC code after the parity interleave by converting the code bit by the matrix.

It is also possible to integrally form the block interleaver 25 in addition to the parity interleaver 23 and the group-wise interleaver 24.

That is to say, the block interleave performed by the block interleaver 25 may also be represented by the matrix to convert the write address of the memory, which stores the LDPC code, to the read address.

Therefore, by obtaining the matrix obtained by multiplying the matrix representing the parity interleave, the matrix representing the group-wise interleave, and the matrix representing the block interleave together, it is possible to collectively perform the parity interleave, the group-wise interleave, and the block interleave by the matrix.

<Configuration example of LDPC encoder 115>

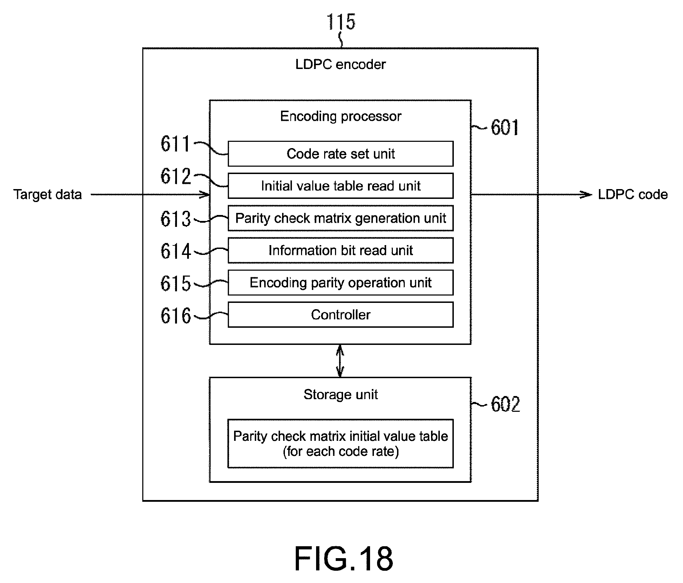

Fig. 18 is a block diagram illustrating a configuration example of the LDPC encoder 115 in Fig. 8.

The LDPC encoder 122 in Fig. 8 also is configured in the same manner.

As illustrated in Figs. 12 and 13, the LDPC codes of the two code lengths N of 64800 bits and 16200 bits are specified in the DVB-S.2 standard.

As for the LDPC code whose code length N is 64800 bits, 11 code rates 1/4, 1/3, 2/5, 1/2, 3/5, 2/3, 3/4, 4/5, 5/6, 8/9, and 9/10 are specified, and as for the LDPC code whose code length N is 16200 bits, 10 code rates 1/4, 1/3, 2/5, 1/2, 3/5, 2/3, 3/4, 4/5, 5/6 and 8/9 are specified (refer to Figs. 12 and 13).

The LDPC encoder 115 may perform the encoding (error correction encoding) by such LDPC code of each code rate whose code lengths N are 64800 bits or 16200 bits according to the parity check matrix H prepared for each code length N and each code rate, for example.

The LDPC encoder 115 is configured of an encoding processor 601 and a storage unit 602.

The encoding processor 601 is configured of a code rate set unit 611, an initial value table read unit 612, a parity check matrix generation unit 613, an information bit read unit 614, an encoding parity operation unit 615, and a controller 616, and this performs the LDPC encoding of the LDPC target data supplied to the LDPC encoder 115 and supplies the LDPC code obtained as a result to the bit interleaver 116 (Fig. 8).

That is to say, the code rate set unit 611 sets the code length N and the code rate of the LDPC code according to the operation of the operator and the like, for example.

The initial value table read unit 612 reads a parity check matrix initial value table to be described later corresponding to the code length N and the code rate set by the code rate set unit 611 from the storage unit 602.

The parity check matrix generation unit 613 generates the parity check matrix H by arranging the element 1 of the information matrix $H_A$ corresponding to the information length K (= code length N - parity length M) according to the code length N and the code rate set by the code rate set unit 611 with a period of 360 columns (the number of columns P being the unit of the cyclic structure) in the column direction based on the parity check matrix initial value table read by the initial value table read unit 612 and stores the same in the storage unit 602.

The information bit read unit 614 reads (extracts) the information bits as many as the information length K from the LDPC target data supplied to the LDPC encoder 115.

The encoding parity operation unit 615 reads the parity check matrix H generated by the parity check matrix generation unit 613 from the storage unit 602 and calculates the parity bit for the information bit read by the information bit read unit 614 based on a predetermined equation using the parity check matrix H, thereby generating the code word (LDPC code).

The controller 616 controls each block configuring the encoding processor 601.

A plurality of parity check matrix initial value tables and the like corresponding to a plurality of code rates and the like illustrated in Figs. 12 and 13 for each of the code lengths N such as 64800 bits and 16200 bits is stored in the storage unit 602, for example. The storage unit 602 temporarily stores the data required in the process of the encoding processor 601.

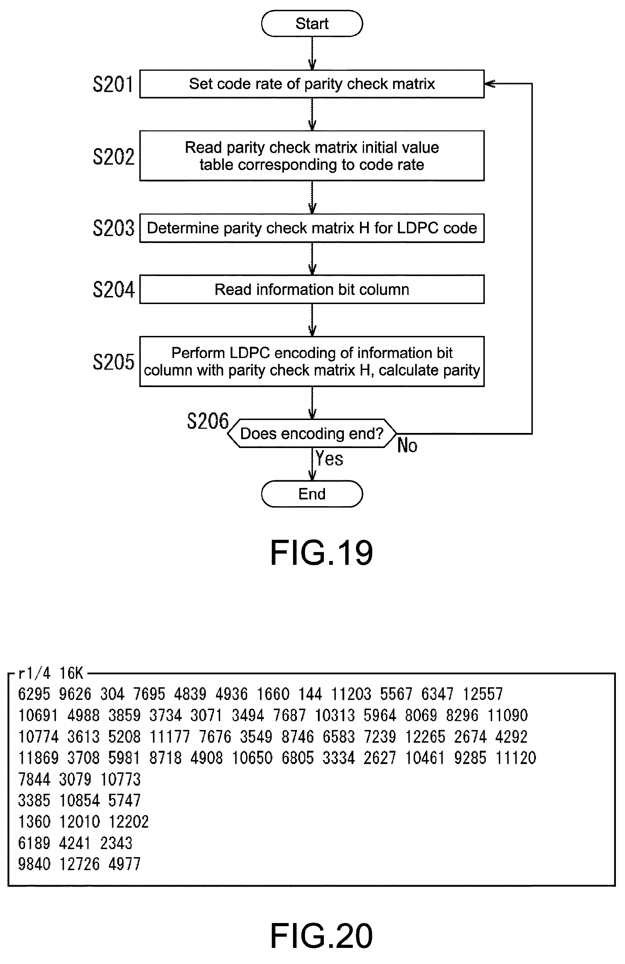

Fig. 19 is a flowchart illustrating the process of the LDPC encoder 115 in Fig. 18.

At step S201, the code rate set unit 611 determines (sets) the code length N and the code rate r with which the LDPC encoding is performed.

At step S202, the initial value table read unit 612 reads the parity check matrix initial value table determined in advance corresponding to the code length N and the code rate r determined by the code rate set unit 611 from the storage unit 602.

At step S203, the parity check matrix generation unit 613 obtains (generates) the parity check matrix H of the LDPC code whose code length N and the code rate r determined by the code rate set unit 611 using the parity check matrix initial value table read by the initial value table read unit 612 from the storage unit 602 and supplies the same to the storage unit 602 to store.

At step S204, the information bit read unit 614 reads the information bits of the information length K (= N x r) corresponding to the code length N and the code rate r determined by the code rate set unit 611 from the LDPC target data supplied to the LDPC encoder 115 and reads the parity check matrix H obtained by the parity check matrix generation unit 613 from the storage unit 602 to supply to the encoding parity operation unit 615.

At step S205, the encoding parity operation unit 615 sequentially calculates the parity bit of the code word c satisfying equation (8) using the information bit from the information bit read unit 614 and the parity check matrix H.

$$\mathrm{Hc}^{\mathrm{T}} \;=\; 0 \qquad\qquad \ldots \;(8)$$

In equation (8), c represents the row vector as the code word (LDPC code) and $c^T$ represents transposition of the row vector c.

Herein, as described above, when the part of the information bit and the part of the parity bit of the row vector c as the LDPC code (one code word) are represented by the row vector A and the row vector T, respectively, the row vector c may be represented by the equation c = [A|T] by the row vector A as the information bit and the row vector T as the parity bit.

The parity check matrix H and the row vector c = [A|T] as the LDPC code are required to satisfy the equation $Hc^T = 0$ and it is possible to sequentially obtain the row vector T as the parity bit configuring the row vector c = [A|T] satisfying such equation $Hc^T = 0$ by setting the element of each row to 0 in order from the element of the first row of the column vector $Hc^T$ in the equation $Hc^T = 0$ when the parity matrix $H_T$ of the parity check matrix H = [$H_A$|$H_T$] has the stepwise structure illustrated in Fig. 11.

When the encoding parity operation unit 615 obtains the parity bit T for the information bit A from the information bit read unit, this outputs the code word c = [A|T] represented by the information bit A and the parity bit T as a result of the LDPC encoding of the information bit A.

Thereafter, at step S206, the controller 616 judges whether to finish the LDPC encoding. At step S206, when it is judged that the LDPC encoding is not finished, that is to say, when there still is the LDPC target data to be LDPC encoded, for example, the process returns to step S201 (or step S204) and the processes at steps S201 (or step S204) to S206 are hereinafter repeated.

When it is judged that the LDPC encoding is finished at step S206, that is to say, there is no LDPC target data to be LDPC encoded, for example, the LDPC encoder 115 finishes the process.

In this manner, the parity check matrix initial value table corresponding to each code length N and each code rate r is prepared, and the LDPC encoder 115 performs the LDPC encoding with a predetermined code length N and a predetermined code rate r using the parity check matrix H generated from the parity check matrix initial value table corresponding to the predetermined code length N and the predetermined code rate r.

<Example of parity check matrix initial value table>

The parity check matrix initial value table is the table indicating the position of the element 1 of the information matrix $H_A$ (Fig. 10) corresponding to the information length K according to the code length N and code rate r is the LDPC code (LDPC code defined by the parity check matrix H) of the parity check matrix for each 360 columns (the number of columns P being the unit of the cyclic structure) and is created in advance for each parity check matrix H of each code length N and each code rate r.

Fig. 20 is a view illustrating an example of the parity check matrix initial value table.

That is to say, Fig. 20 illustrates the parity check matrix initial value table for the parity check matrix H whose code length N is 16200 bits and code rate (code rate in notation of DVB-T.2) r is 1/4 specified in the DVB.T-2 standard.

The parity check matrix generation unit 613 (Fig. 18) obtains the parity check matrix H in a following manner using the parity check matrix initial value table.

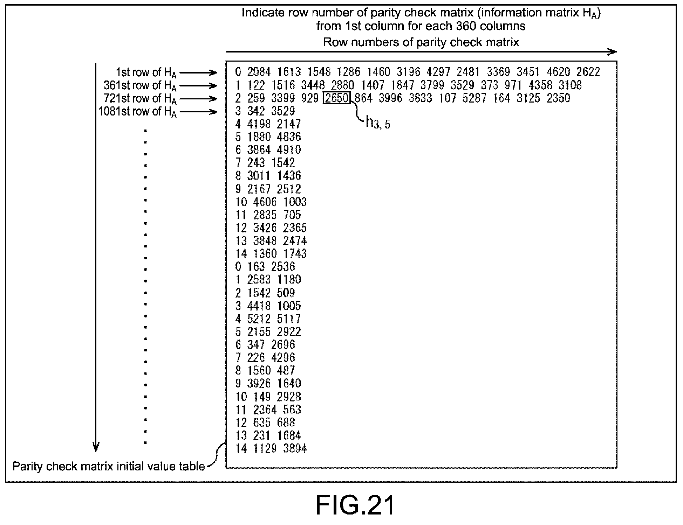

Fig. 21 illustrates a method of obtaining the parity check matrix H from the parity check matrix initial value table.

In other words, the parity check matrix initial value table in Fig. 21 illustrates the parity check matrix initial value table for the parity check matrix H whose code length N is 16200 bits and code rate r is 2/3 specified in the DVB.T-2 standard.

The parity check matrix initial value table is the table indicating the position of the element 1 of the information matrix $H_A$ (Fig. 10) corresponding to the information length K according to the code length N and code rate r is the LDPC code for each 360 columns (the number of columns P being the unit of the cyclic structure) as described above in which row numbers (the row number of the first row of the parity check matrix H is 0) of the elements of 1 of a 1 + 360 × (i - 1)-th column of the parity check matrix H as many as the number of column weights of the 1 + 360 × (i - 1)-th column are arranged in an i-th row.

Herein, the parity matrix $H_T$ (Fig. 10) corresponding to the parity length M of the parity check matrix H is determined as illustrated in Fig. 15, so that the information matrix $H_A$ (Fig. 10) corresponding to the information length K of the parity check matrix H is obtained according to the parity check matrix initial value table.

The number of rows k + 1 of the parity check matrix initial value table differs according to the information length K.

The information length K and the number of rows k + 1 of the parity check matrix initial value table satisfy relationship in equation (9).

$$K = (k+1) \times 360 \quad \dots \quad (9)$$

Herein, 360 in equation (9) is the number of columns P being the unit of the cyclic structure illustrated in Fig. 16.

In the parity check matrix initial value table in Fig. 21, 13 values are arranged in each of first to third rows and 3 values are arranged in each of fourth to k + 1-th rows (30th row in Fig. 21).

Therefore, the column weights of the parity check matrix H obtained from the parity check matrix initial value table in Fig. 21 are 13 from the first column to 1 + 360 × (3 - 1) -1-th column and 3 from the 1 + 360 × (3 - 1)-th column to a K-th column.

The first row of the parity check matrix initial value table in Fig. 21 is 0, 2084, 1613, 1548, 1286, 1460, 3196, 4297, 2481, 3369, 3451, 4620, and 2622 and this indicates that the element of the rows whose row numbers are 0, 2084, 1613, 1548, 1286, 1460, 3196, 4297, 2481, 3369, 3451, 4620, and 2622 is 1 (and other elements are 0) in the first column of the parity check matrix H.

Also, the second row of the parity check matrix initial value table in Fig. 21 is 1, 122, 1516, 3448, 2880, 1407, 1847, 3799, 3529, 373, 971, 4358, and 3108 and this indicates that the element of the rows whose row numbers are 1, 122, 1516, 3448, 2880, 1407, 1847, 3799, 3529, 373, 971, 4358, and 3108 are 1 in a 361 (= 1 + 360 × (2 - 1))-th column of the parity check matrix H.

As described above, the parity check matrix initial value table indicates the position of the element 1 of the information matrix $H_A$ of the parity check matrix H for each 360 columns.

The column other than the 1 + 360 × (i - 1)-th column of the parity check matrix H, that is to say, each column from a 2 + 360 × (i - 1)-th column to a 360 × i-th column is obtained by periodically performing the cyclic shift to the element 1 of the 1 + 360 × (i - 1)-th column determined by the parity check matrix initial value table downward (in a direction toward a lower part of the column) according to the parity length M to arrange.

That is to say, the 2 + 360 × (i - 1)-th column is obtained by the cyclic shift of the 1 + 360 × (i - 1)-th column downward by M/360 (= q) and a next 3 + 360 × (i - 1)-th column is obtained by the cyclic shift of the 1 + 360 × (i - 1)-th column downward by 2 × M/360 (= 2 × q) (the cyclic shift of the 2 + 360 × (i - 1)-th column downward by M/360(= q)), for example.

Herein, if an i-th row (i-th row from the top) j-th column (j-th column from left) value of the parity check matrix initial value table is represented as $h_{i, j}$ and the row number of a j-th element 1 of a w-th column of the parity check matrix H is represented as $H_{w-j}$, a row number $H_{w-j}$ of the element 1 of the w-th column being the column other than the 1 + 360 × (i - 1)-th column of the parity check matrix H may be obtained by equation (10).

$$H_{w-j} = \mathrm{mod}\{h_{i, j} + \mathrm{mod}((w-1), P) \times q, M\} \qquad (10)$$

Herein, mod (x, y) represents a remainder obtained when x is divided by y.

Also, P represents the above-described number of columns being the unit of the cyclic structure, which is set to 360 as described above in the DVB-S.2 standard, the DVB-T.2 standard and the DVB-C.2 standard, for example. Further, q represents a value M/360 obtained by dividing the parity length M by the number of columns P (= 360) being the unit of the cyclic structure.

The parity check matrix generation unit 613 (Fig. 18) specifies the row number of the element 1 of the 1 + 360 × (i - 1)-th column of the parity check matrix by the parity check matrix initial value table.

Further, the parity check matrix generation unit 613 (Fig. 18) obtains the row number $H_{w-j}$ of the element 1 of the w-th column being the column other than the 1 + 360 × (i - 1)-th column of the parity check matrix H according to equation (10) and generates the parity check matrix H in which an element of the row number obtained from above is 1.

<New LDPC code>

At present, the standard for terrestrial digital television broadcasting which is called as ATSC3.0 is planned.

A planned LDPC code (hereinafter also referred to as a "new LDPC code") such as ATSC3.0 and other data broadcasting will be described.

As for the new LDPC code, the parity matrix $H_T$ of the parity check matrix H has the stepwise structure (Fig. 11) as is the case with the LDPC code specified in DVB-T.2 from a viewpoint of maintaining compatibility with DVB-T.2 as far as possible.

Further, as for the new LDPC code, as is the case with the LDPC code specified in DVB-T.2, the information matrix $H_A$ of the parity check matrix H has the cyclic structure and the number of columns P being the unit of the cyclic structure is set to 360.

The LDPC encoder 115 (Fig. 8, Fig. 18) performs the LDPC encoding to the new LDPC encoding using the parity check matrix H obtained from the parity check matrix initial value table of the new LDPC encoding whose code length N is 16k bits or 64k bits and any of the code rates r of 6/15, 7/15, 8/15, 9/15, 10/15, 11/15, 12/15 or 13/15 as described below.

In this case, the parity check matrix initial value table is stored in the storage unit 602 of the LDPC encoder 115 (Fig. 8).

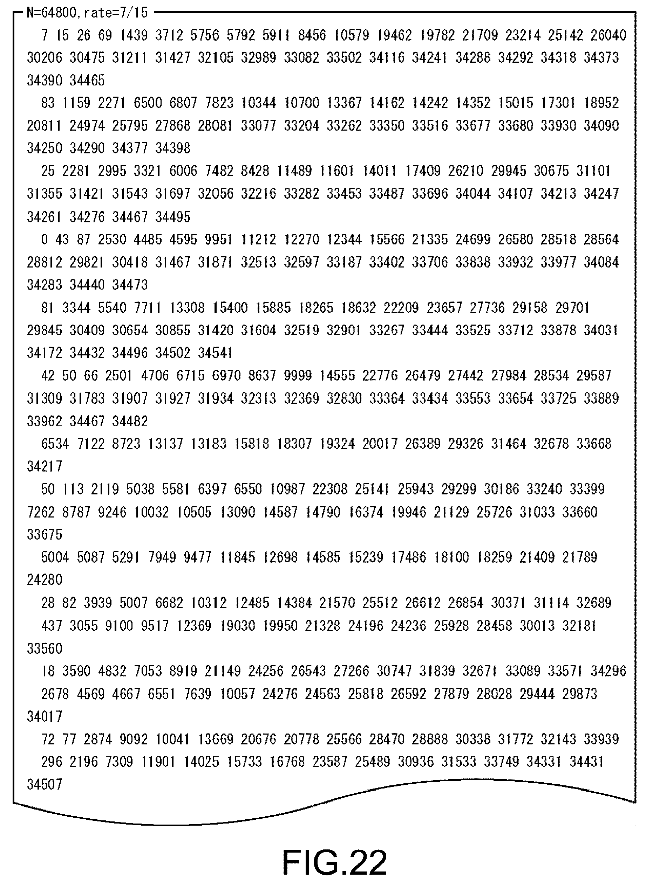

Fig. 22, Fig. 23 and Fig. 24 each is a diagram showing the parity check matrix initial value table of the parity check matrix H of a first new LDPC code whose code length N is 64k bits and code rate r is 7/15 (hereinafter also referred to as a "first new LDPC code of (64k, 7/15)).

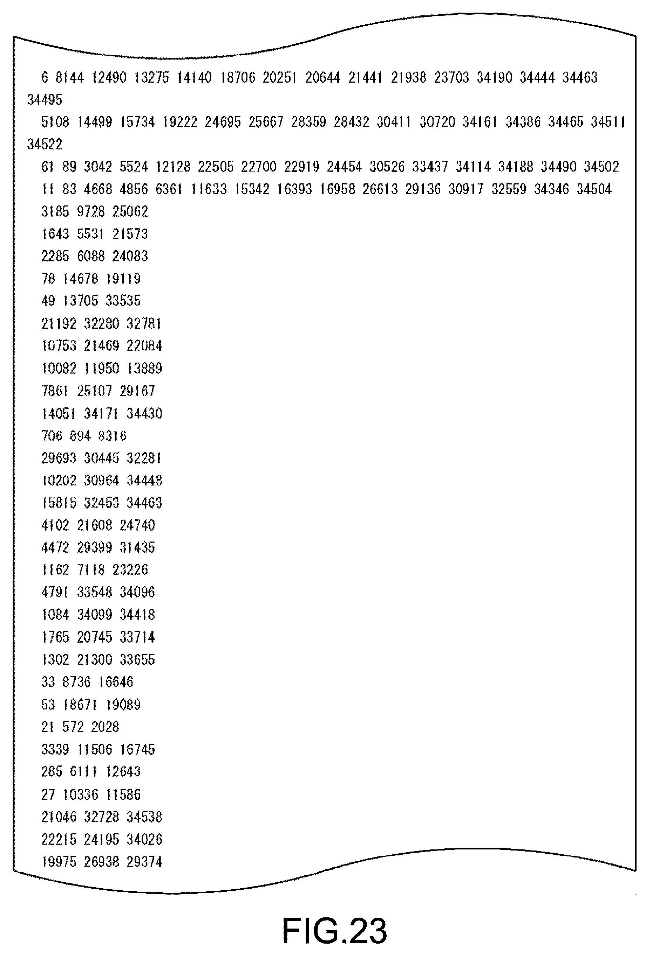

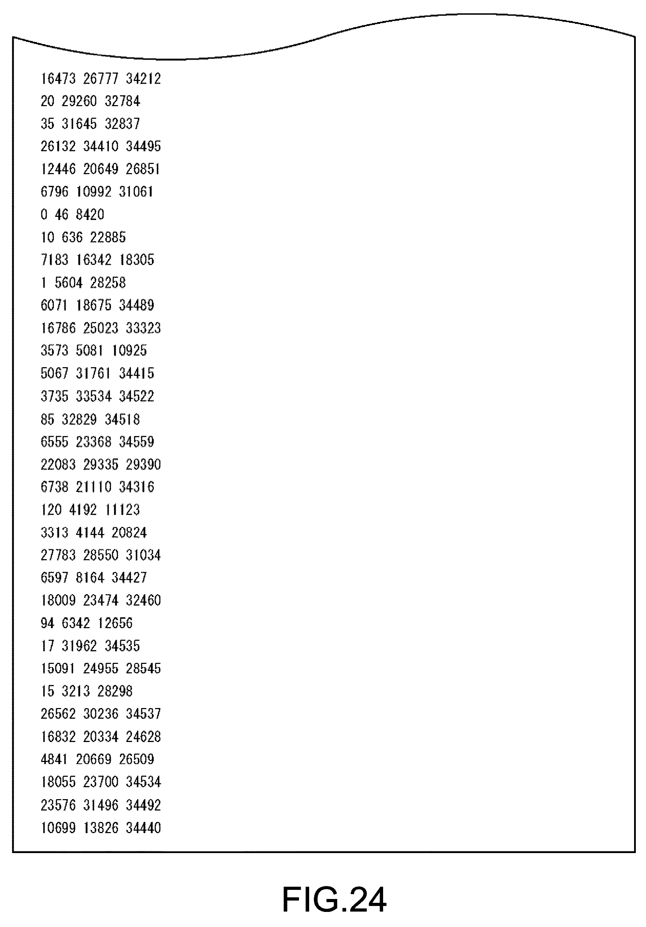

Fig. 23 follows Fig. 22. Fig. 24 follows Fig. 23.

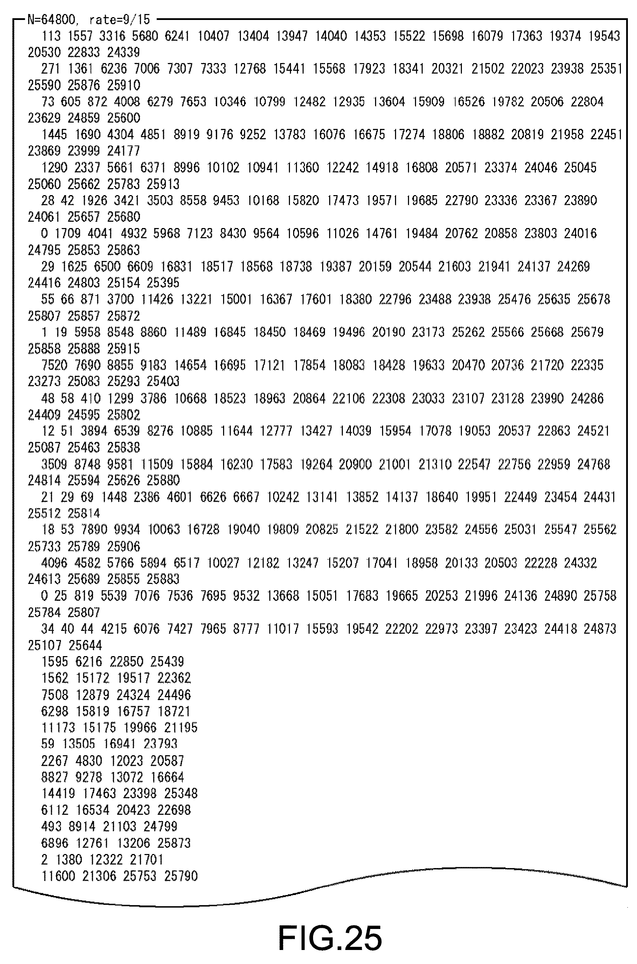

Fig. 25, Fig. 26 and Fig. 27 each is a diagram showing the parity check matrix initial value table of the parity check matrix H of a first new LDPC code whose code length N is 64k bits and code rate r is 9/15 (hereinafter also referred to as a "first new LDPC code of (64k, 9/15)).

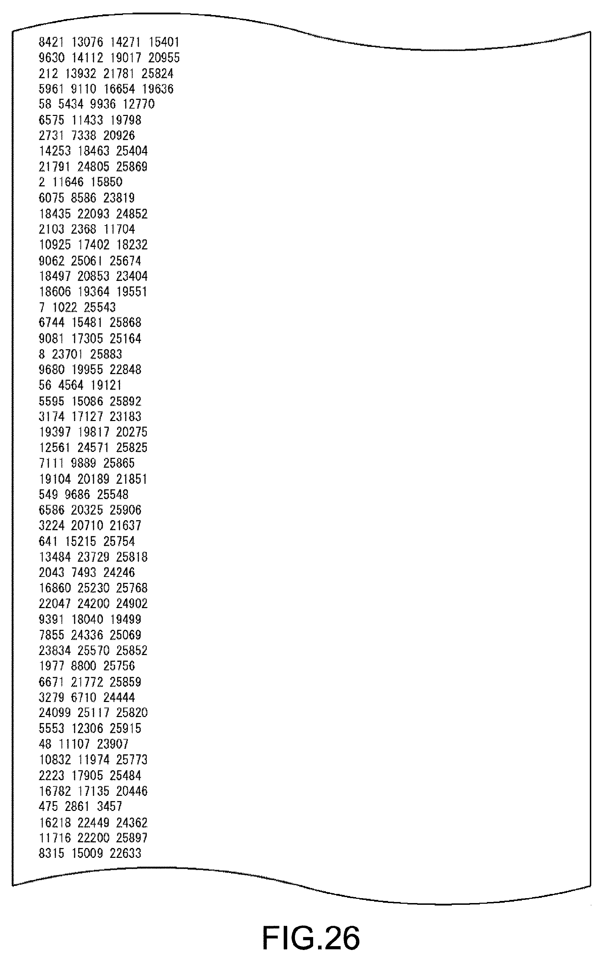

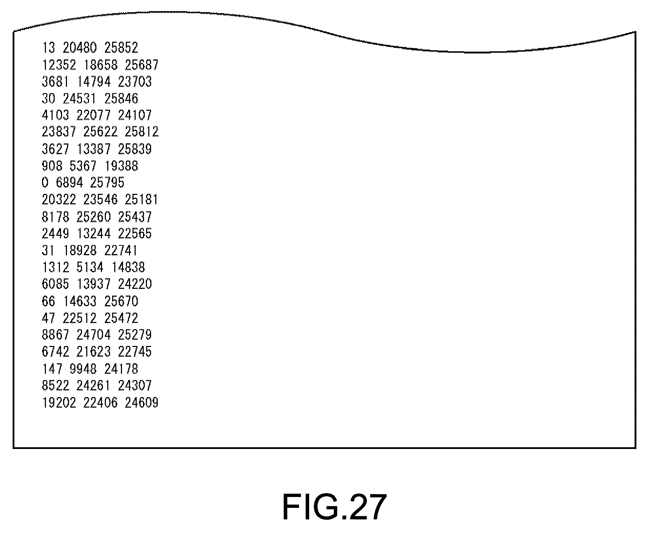

Fig. 26 follows Fig. 25. Fig. 27 follows Fig. 26.

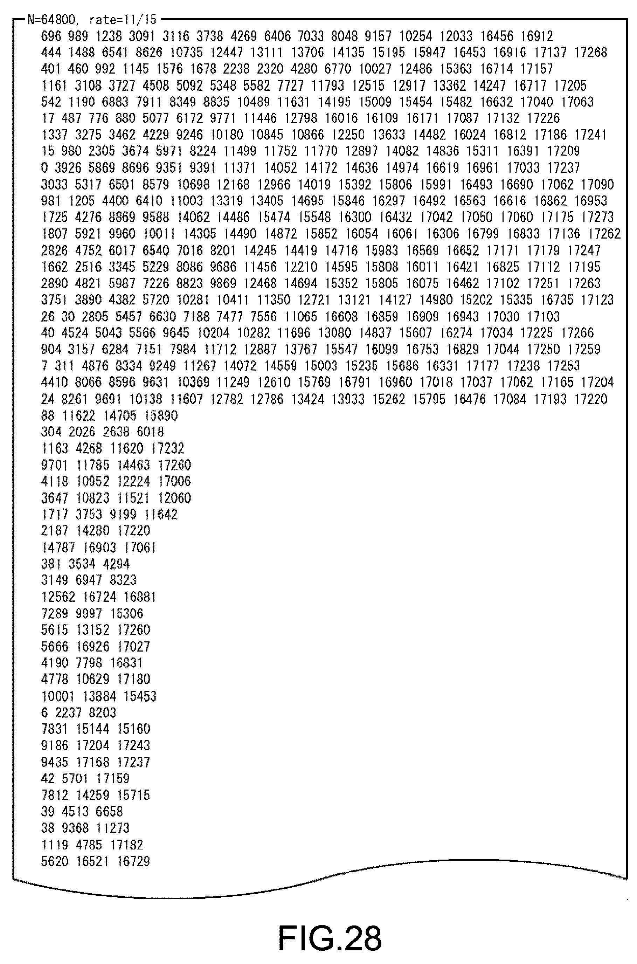

Fig. 28, Fig. 29 and Fig. 30 each is a diagram showing the parity check matrix initial value table of the parity check matrix H of a first new LDPC code whose code length N is 64k bits and code rate r is 11/15 (hereinafter also referred to as a "first new LDPC code of (64k, 11/15)).

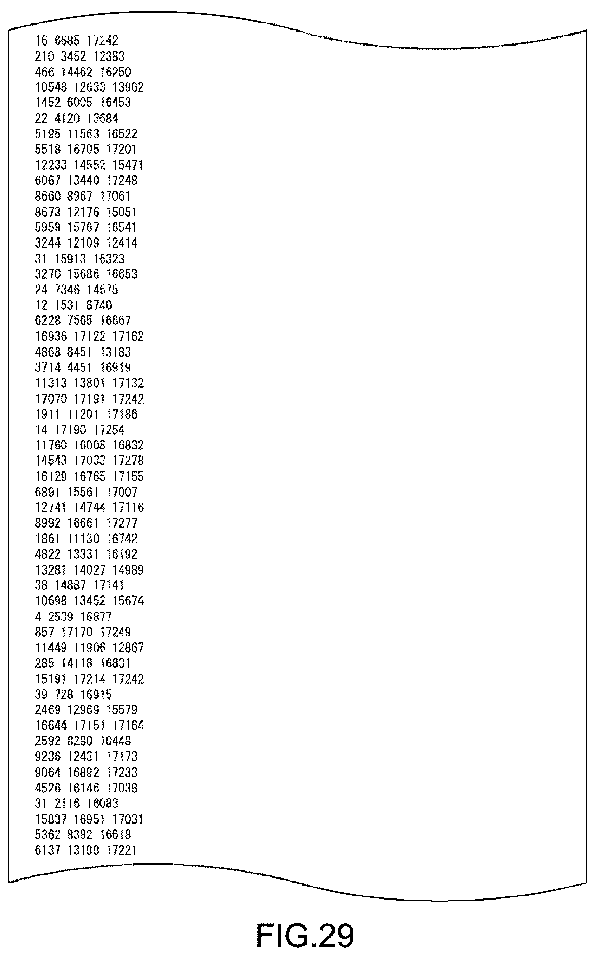

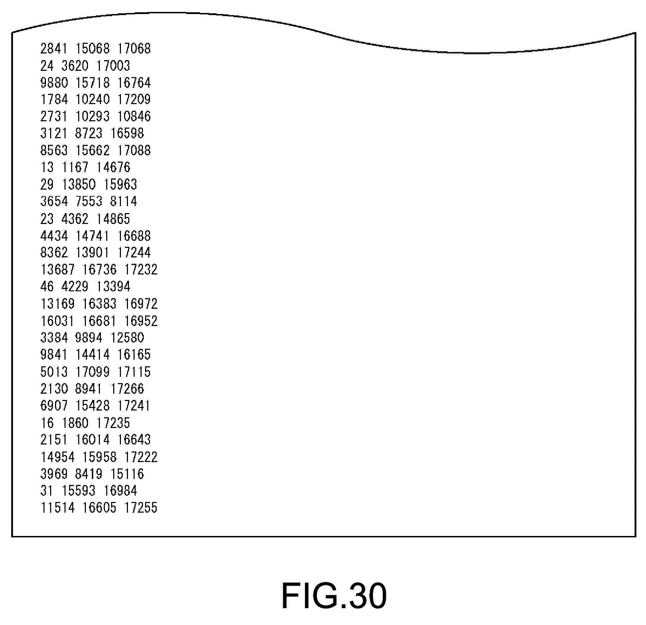

Fig. 29 follows Fig. 28. Fig. 30 follows Fig. 29.

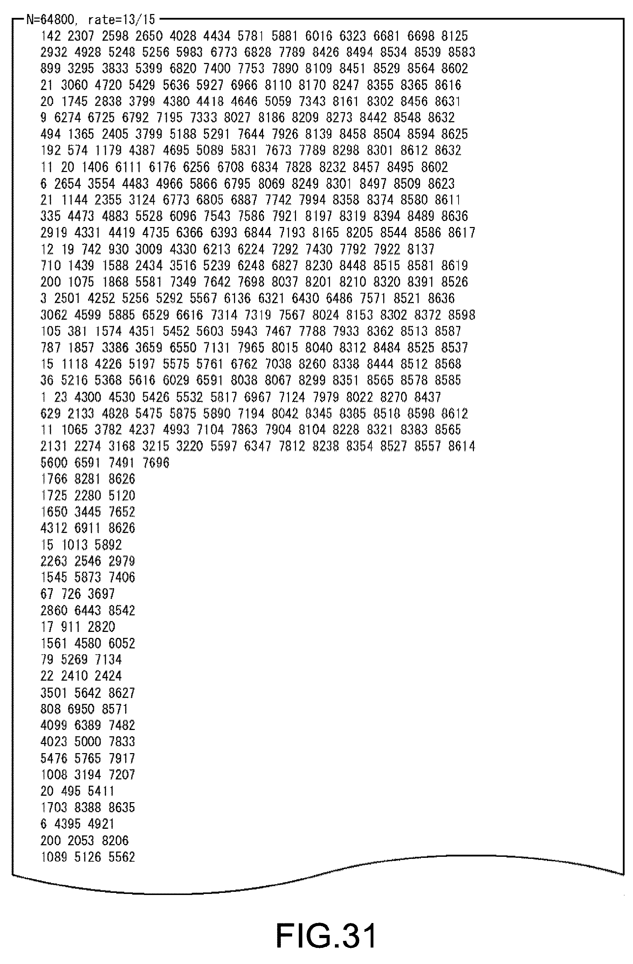

Fig. 31, Fig. 32 and Fig. 33 each is a diagram showing the parity check matrix initial value table of the parity check matrix H of a first new LDPC code whose code length N is 64k bits and code rate r is 13/15 (hereinafter also referred to as a "first new LDPC code of (64k, 13/15)).

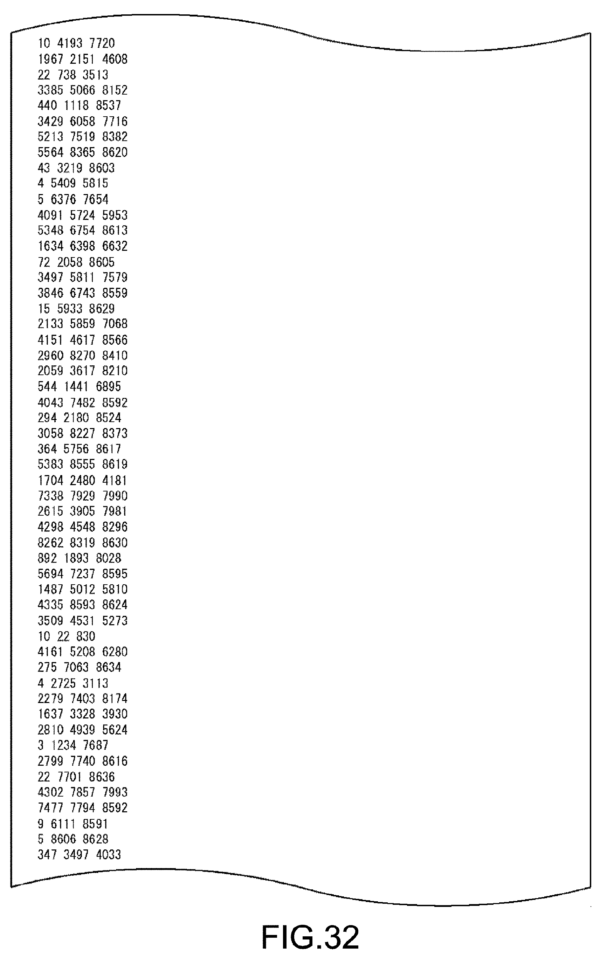

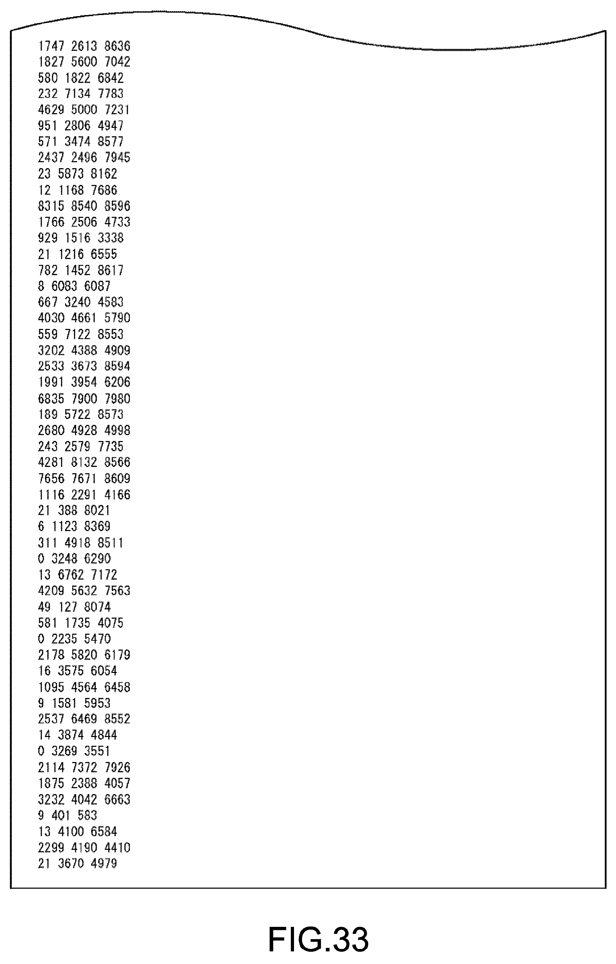

Fig. 32 follows Fig. 31. Fig. 33 follows Fig. 32.

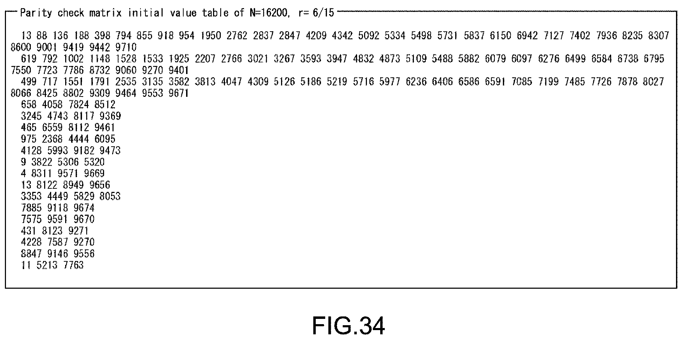

Fig. 34 is a diagram showing the parity check matrix initial value table of the parity check matrix H of a first new LDPC code whose code length N is 16k bits and code rate r is 6/15 (hereinafter also referred to as a "first new LDPC code of (16k, 6/15)).

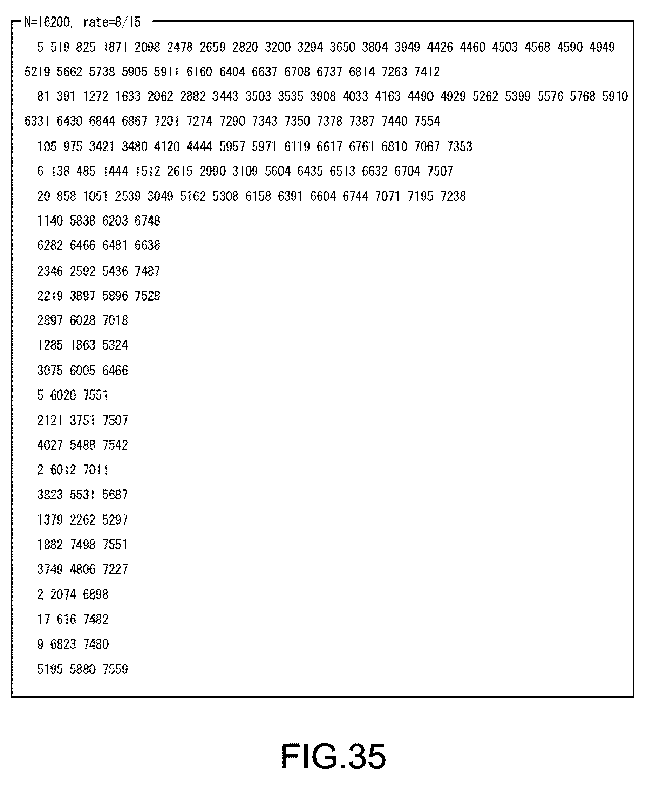

Fig. 35 is a diagram showing the parity check matrix initial value table of the parity check matrix H of a first new LDPC code whose code length N is 16k bits and code rate r is 8/15 (hereinafter also referred to as a "first new LDPC code of (16k, 8/15)).

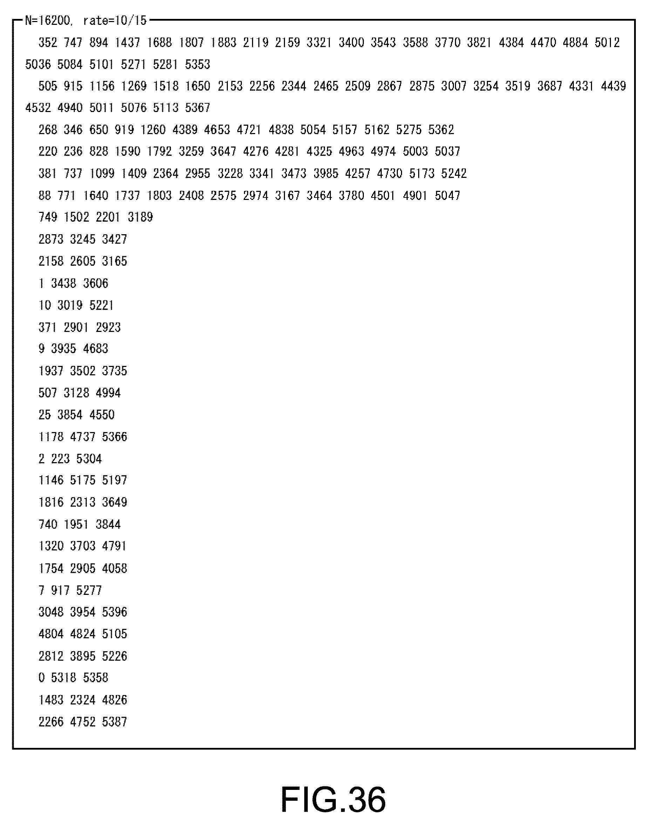

Fig. 36 is a diagram showing the parity check matrix initial value table of the parity check matrix H of a first new LDPC code whose code length N is 16k bits and code rate r is 10/15 (hereinafter also referred to as a "first new LDPC code of (16k, 10/15)).

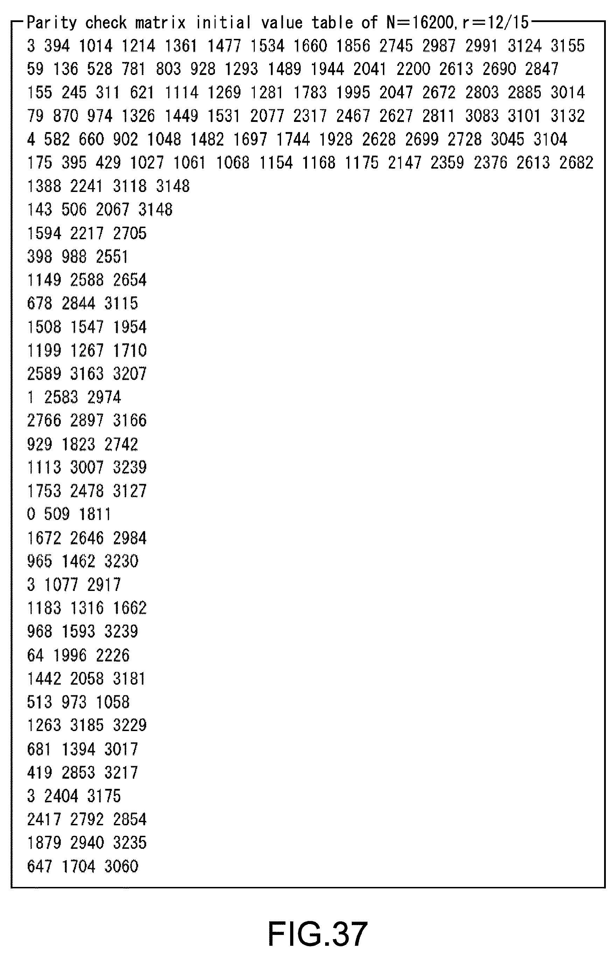

Fig. 37 is a diagram showing the parity check matrix initial value table of the parity check matrix H of a first new LDPC code whose code length N is 16k bits and code rate r is 12/15 (hereinafter also referred to as a "first new LDPC code of (16k, 12/15)).

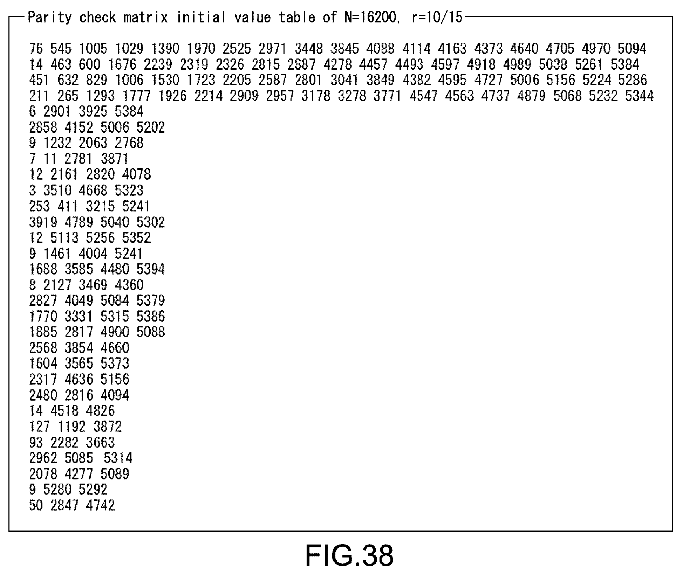

Fig. 38 is a diagram showing the parity check matrix initial value table of the parity check matrix H of a first other new LDPC code whose code length N is 16k bits and code rate r is 10/15 (hereinafter also referred to as a "first other new LDPC code of (16k, 10/15)).

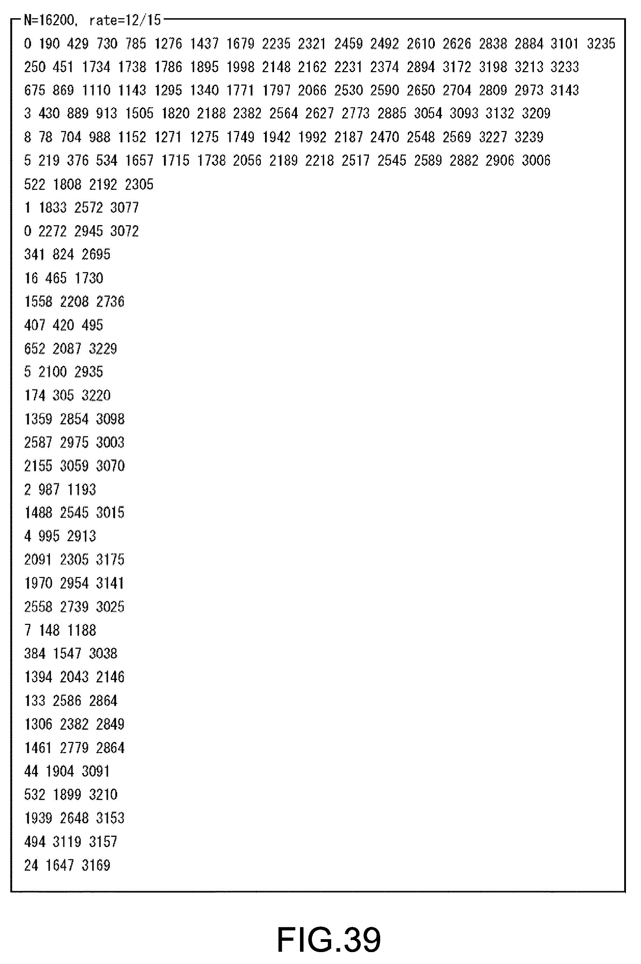

Fig. 39 is a diagram showing the parity check matrix initial value table of the parity check matrix H of a first other new LDPC code whose code length N is 16k bits and code rate r is 12/15 (hereinafter also referred to as a "first other new LDPC code of (16k, 12/15)).

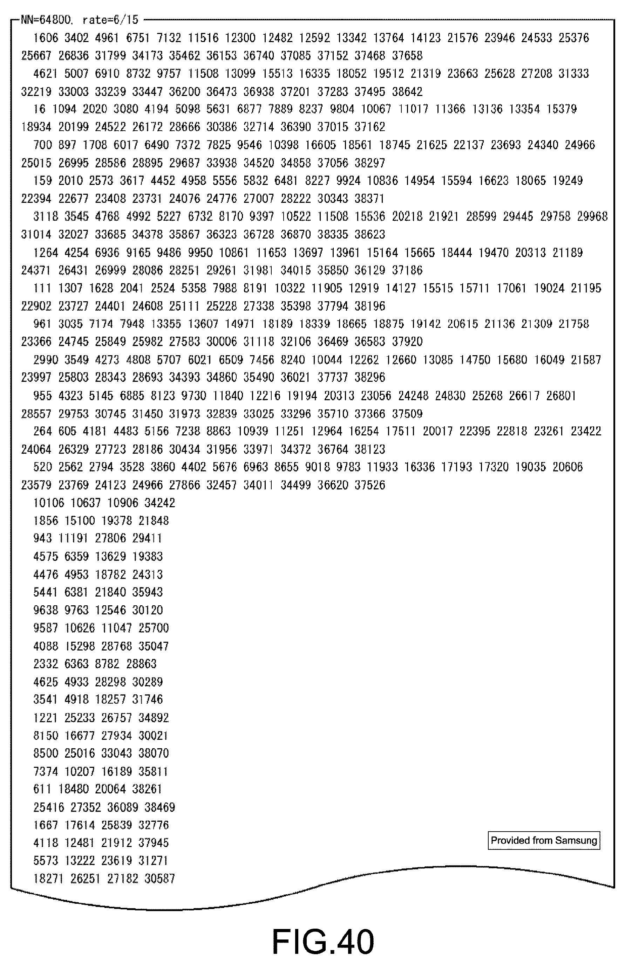

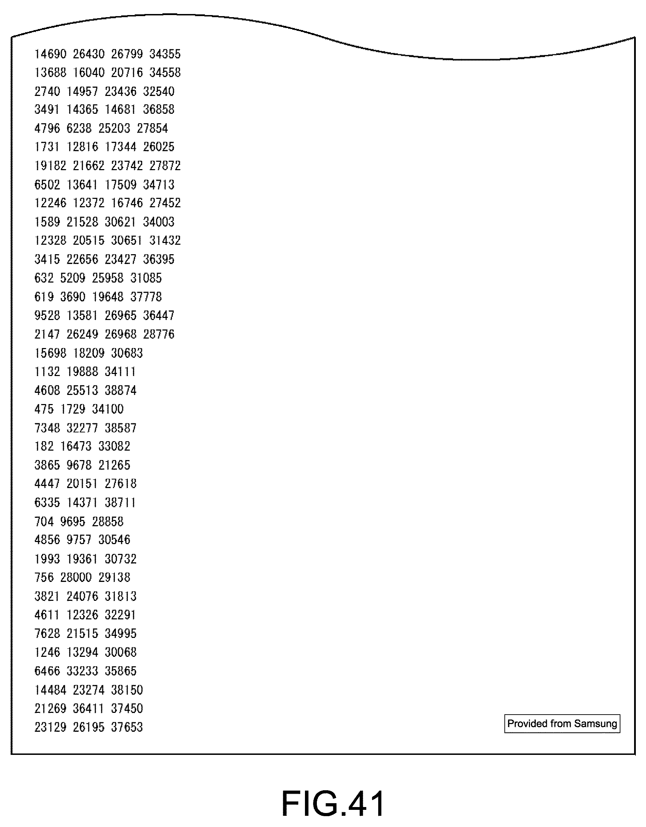

Fig. 40 and Fig. 41 each is a diagram showing the parity check matrix initial value table of the parity check matrix H of a second new LDPC code whose code length N is 64k bits and code rate r is 6/15 (hereinafter also referred to as a "second new LDPC code of (64k, 6/15)).

Fig. 41 follows Fig. 40.

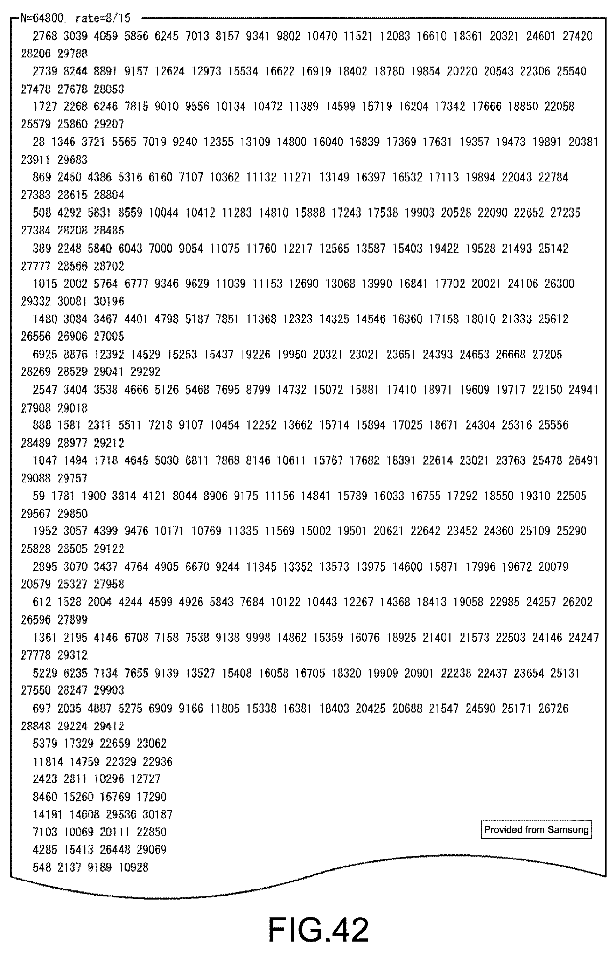

Fig. 42, Fig. 43 and Fig. 44 each is a diagram showing the parity check matrix initial value table of the parity check matrix H of a second new LDPC code whose code length N is 64k bits and code rate r is 8/15 (hereinafter also referred to as a "second new LDPC code of (64k, 8/15)).

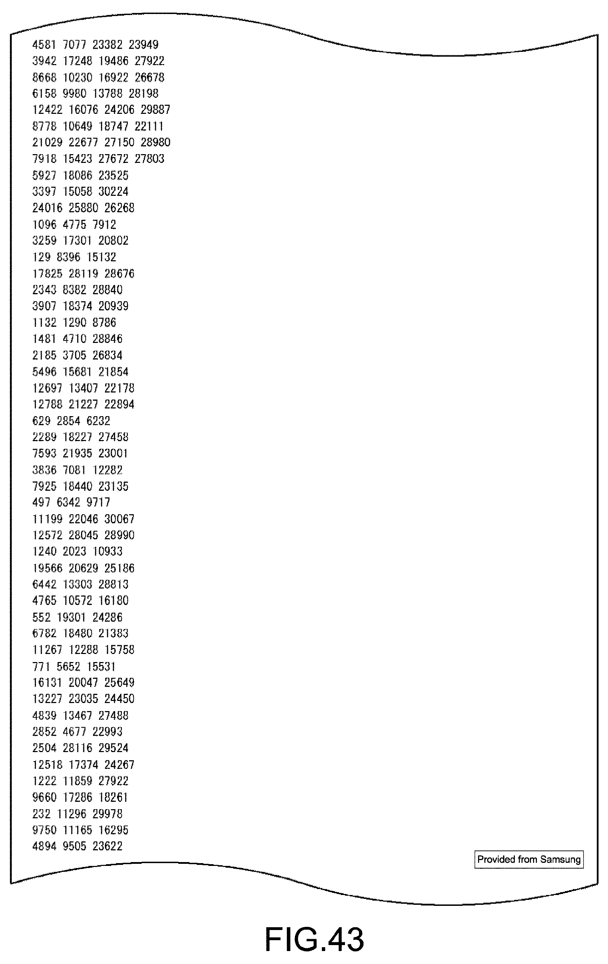

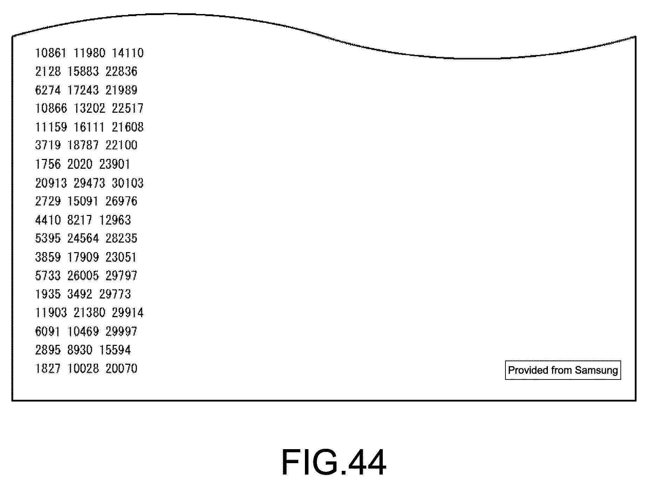

Fig. 43 follows Fig. 42. Fig. 44 follows Fig. 43.

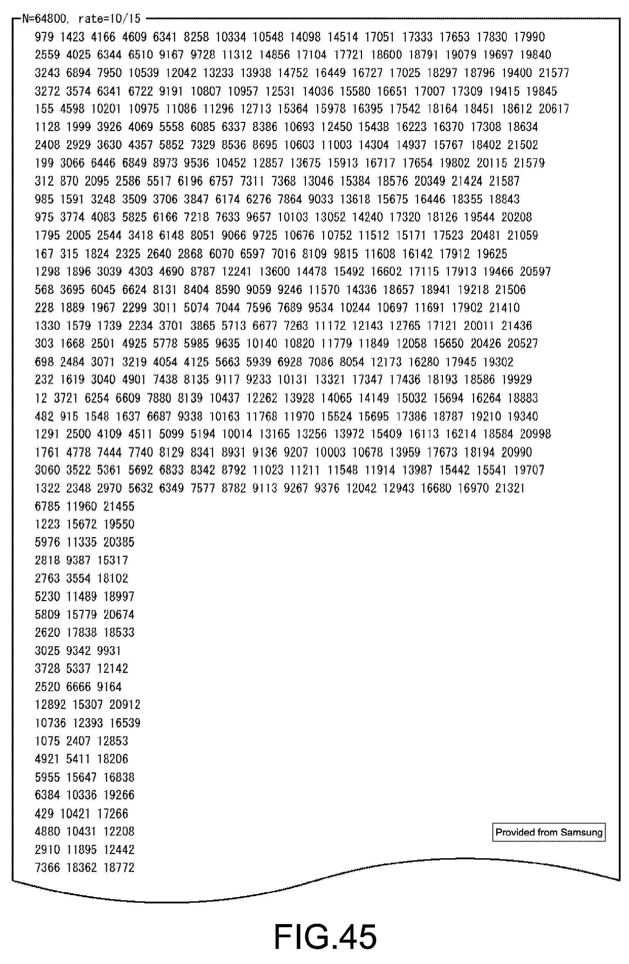

Fig. 45, Fig. 46 and Fig. 47 each is a diagram showing the parity check matrix initial value table of the parity check matrix H of a second new LDPC code whose code length N is 64k bits and code rate r is 10/15 (hereinafter also referred to as a "second new LDPC code of (64k, 10/15)).

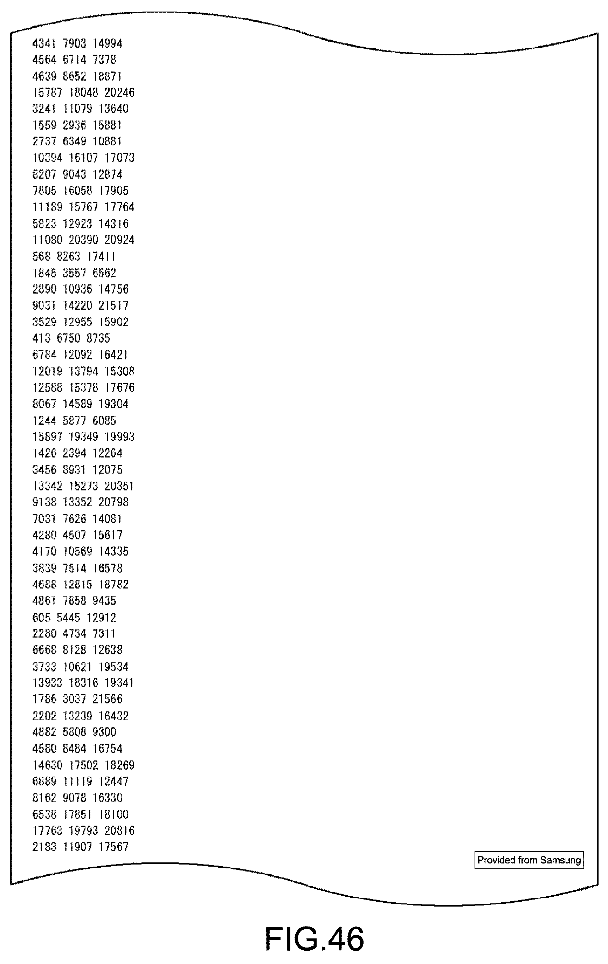

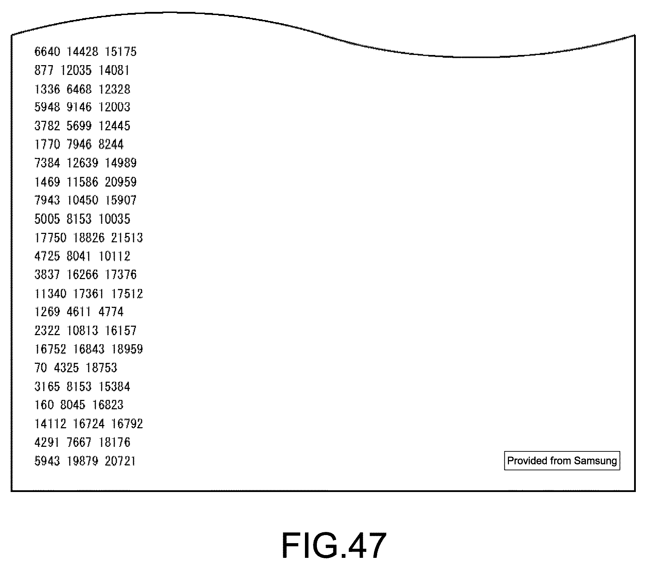

Fig. 46 follows Fig. 45. Fig. 47 follows Fig. 46.

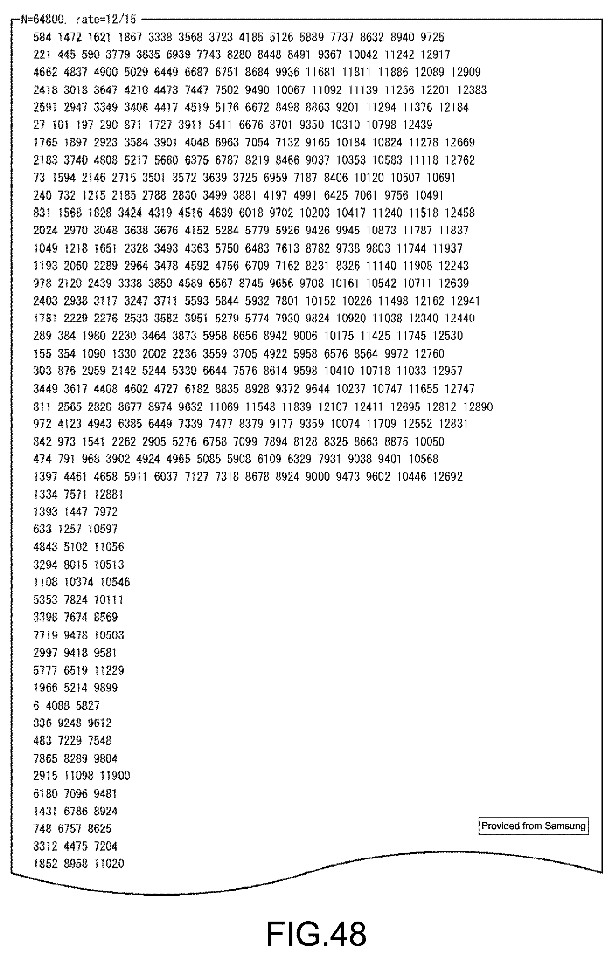

Fig. 48, Fig. 49 and Fig. 50 each is a diagram showing the parity check matrix initial value table of the parity check matrix H of a second new LDPC code whose code length N is 64k bits and code rate r is 12/15 (hereinafter also referred to as a "second new LDPC code of (64k, 12/15)).

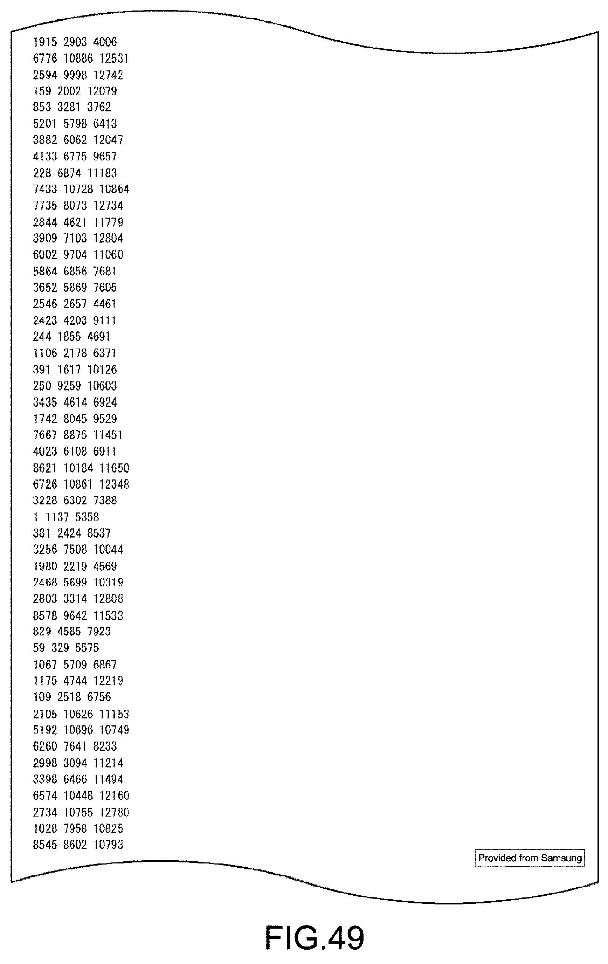

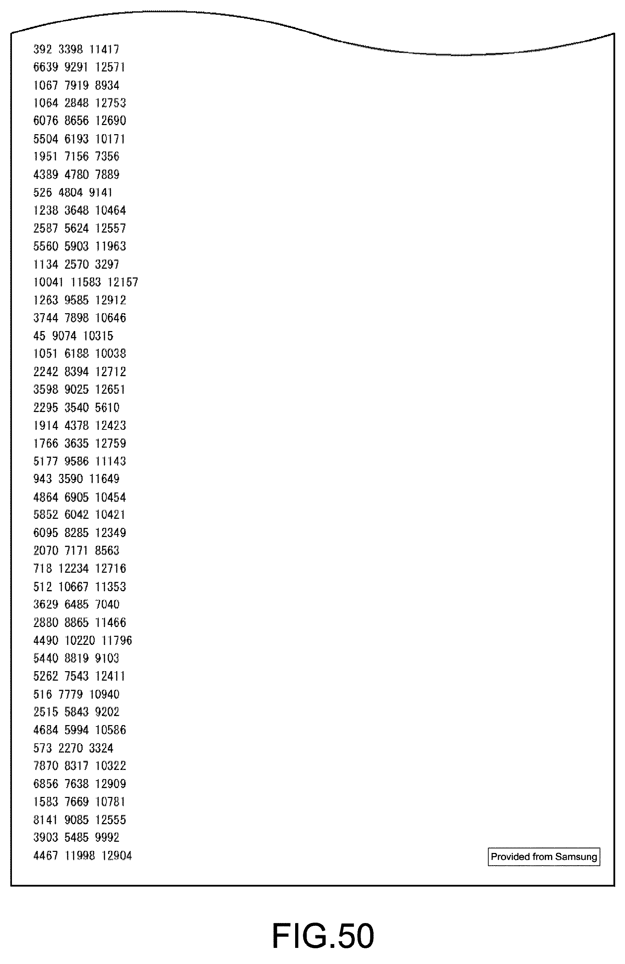

Fig. 49 follows Fig. 48. Fig. 50 follows Fig. 49.

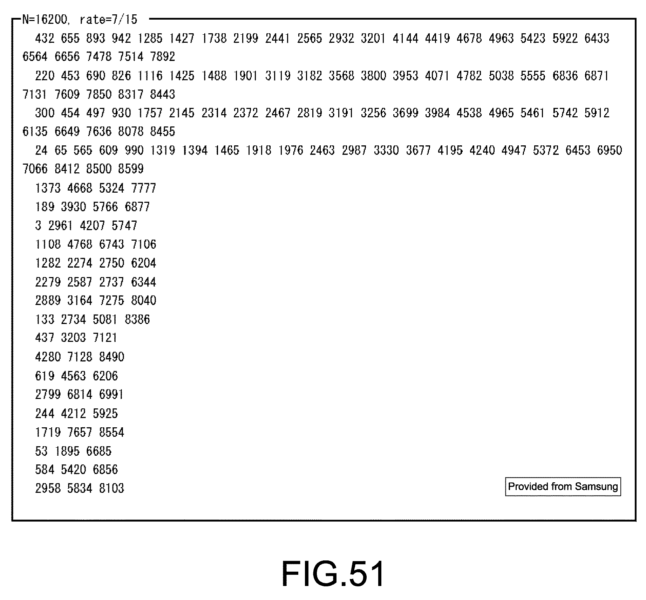

Fig. 51 is a diagram showing the parity check matrix initial value table of the parity check matrix H of a second new LDPC code whose code length N is 16k bits and code rate r is 7/15 (hereinafter also referred to as a "second new LDPC code of (16k, 7/15)).

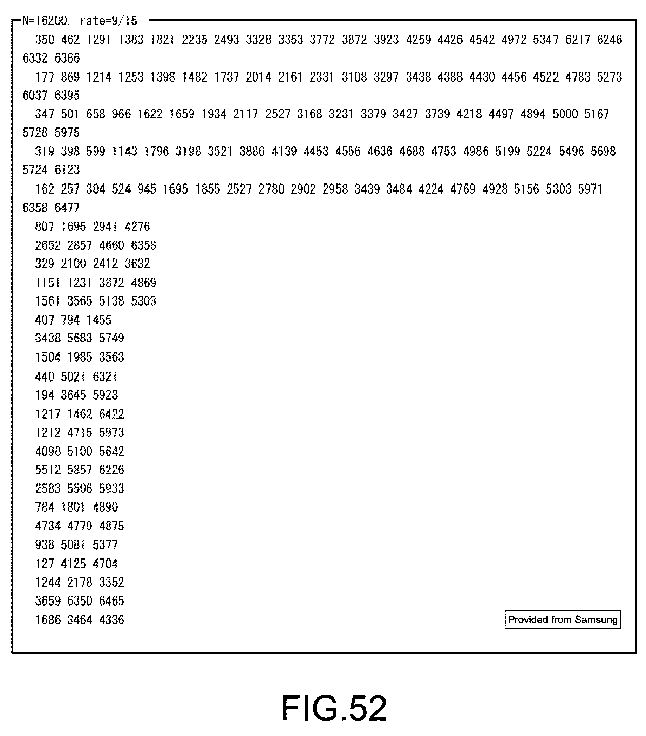

Fig. 52 is a diagram showing the parity check matrix initial value table of the parity check matrix H of a second new LDPC code whose code length N is 16k bits and code rate r is 9/15 (hereinafter also referred to as a "second new LDPC code of (16k, 9/15)).

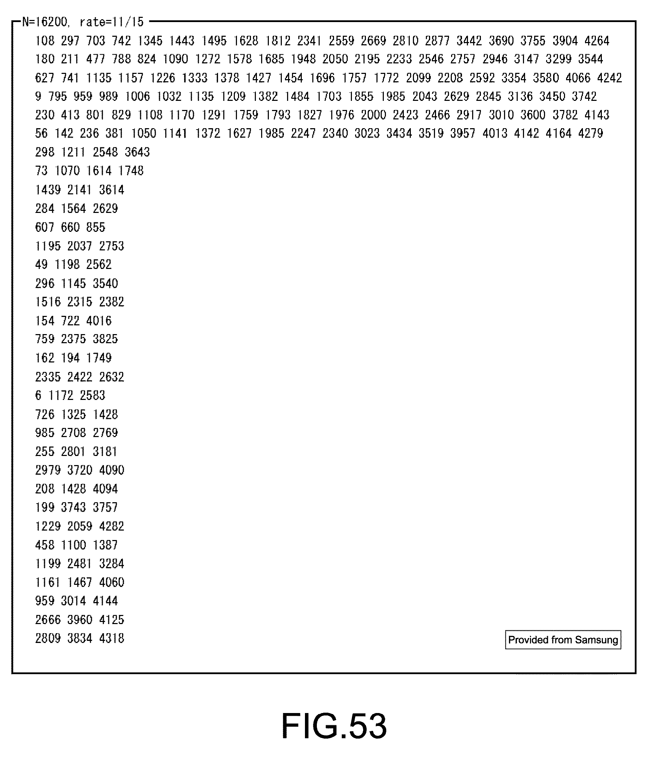

Fig. 53 is a diagram showing the parity check matrix initial value table of the parity check matrix H of a second new LDPC code whose code length N is 16k bits and code rate r is 11/15 (hereinafter also referred to as a "second new LDPC code of (16k, 11/15)).

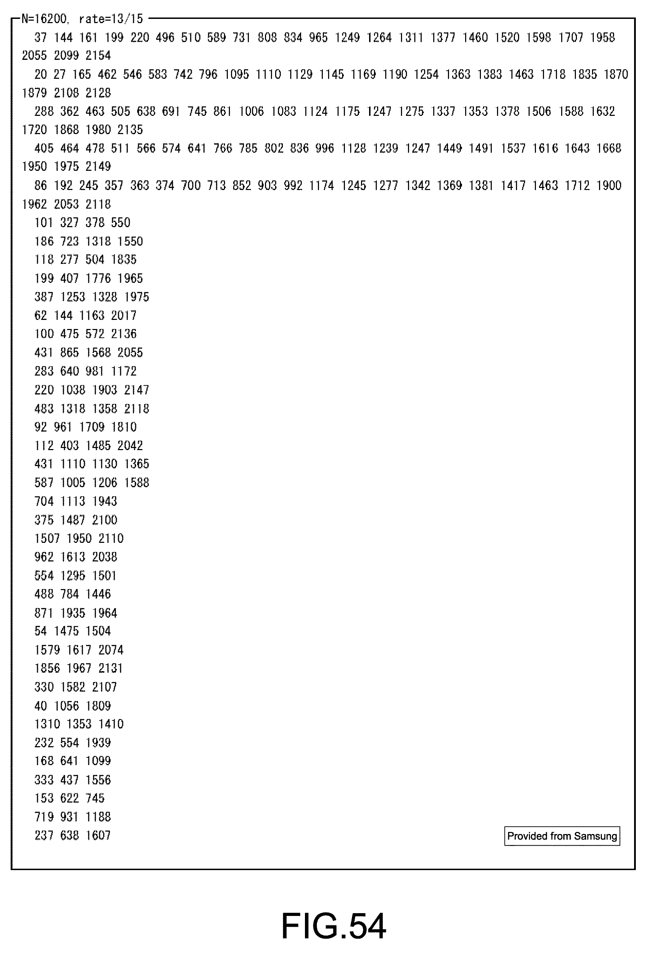

Fig. 54 is a diagram showing the parity check matrix initial value table of the parity check matrix H of a second new LDPC code whose code length N is 16k bits and code rate r is 13/15 (hereinafter also referred to as a "second new LDPC code of (16k, 13/15)).

(The parity check matrix initial value tables of the parity check matrices H of) the second new LDPC codes shown in Fig. 40 to Fig. 54 are provided from Samsung.

The first new LDPC codes and the first other new LDPC codes are high-performance LDPC codes.

Herein, the high-performance LDPC code is obtained from an appropriate parity check matrix H.

The term the "appropriate parity check matrix H" is intended to mean the parity check matrix, which satisfies a predetermined condition to make the BER (and FER) lower when the LDPC code obtained from the parity check matrix H is transmitted with low Es/No or Eb/No (signal power to noise power ratio per bit).

The appropriate parity check matrix H may be obtained by the simulation of the measurement of the BER at the time when the LDPC code obtained from the various parity check matrices satisfying the predetermined condition is transmitted with the low Es/No, for example.

The predetermined condition, which the appropriate parity check matrix H should satisfy, includes an excellent analysis result obtained by an analyzing method of performance of the code referred to as density evolution, absence of a loop of the elements of 1 referred to as cycle-4 and the like, for example.

Herein, it is known that the decoding performance of the LDPC code is deteriorated when the elements of 1 close up as the cycle-4 in the information matrix $H_A$, so that the absence of the cycle-4 is required as the predetermined condition, which the appropriate parity check matrix H should satisfy.

The predetermined condition, which the appropriate parity check matrix H should satisfy, may be appropriately determined from a viewpoint of improvement in the decoding performance of the LDPC code, facilitation (simplification) of the decoding process of the LDPC code and the like.

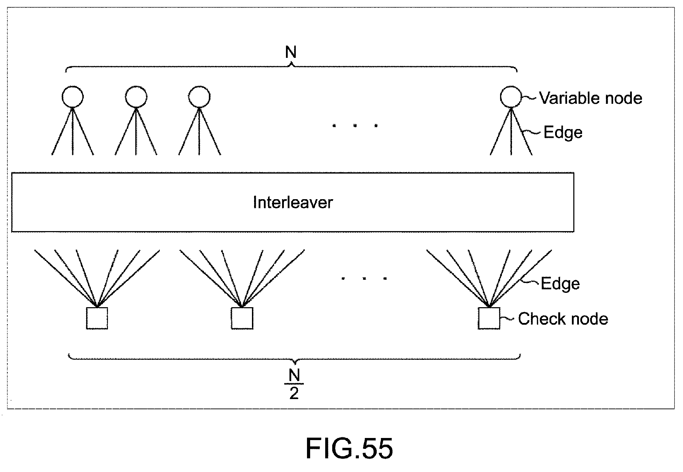

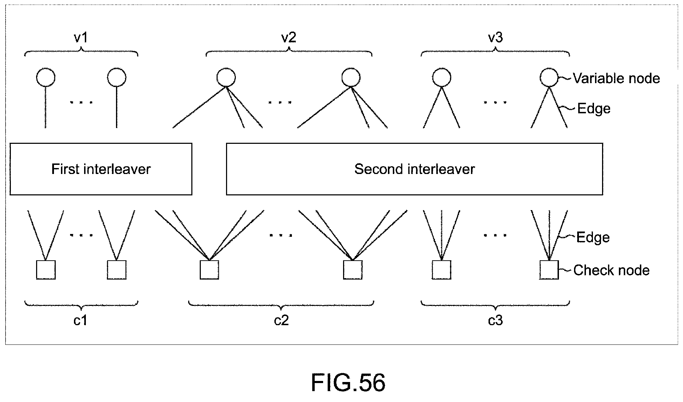

Fig. 55 and Fig. 56 are views illustrating the density evolution with which the analysis result as the predetermined condition, which the appropriate parity check matrix H should satisfy, is obtained.

The density evolution is the analyzing method of the code, which calculates an expected value of the error probability for an entire LDPC code (ensemble) whose code length N is ∞ characterized by a degree sequence to be described later.

For example, when a variance value of noise is set to be larger from 0 on the AWGN channel, the expected value of the error probability of a certain ensemble, which is initially 0, is no longer 0 when the variance value of the noise becomes a certain threshold or larger.

According to the density evolution, it is possible to determine whether performance of the ensemble (appropriateness of the parity check matrix) is excellent by comparing the threshold of the variance value of the noise (hereinafter, also referred to as a performance threshold) at which the expected value of the error probability is no longer 0.

It is possible to predict rough performance of a specific LDPC code by determining the ensemble to which the LDPC code belongs and performing the density evolution to the ensemble.

Therefore, when a high-performance ensemble is found, the high-performance LDPC code may be found from the LDPC codes belonging to the ensemble.

Herein, the above-described degree sequence indicates a ratio of the variable node and the check node having the weight of each value to the code length N of the LDPC code.

For example, a regular (3, 6) LDPC code whose code rate is 1/2 belongs to the ensemble characterized by the degree sequence in which the weight (column weight) of all the variable nodes is 3 and the weight (row weight) of all the check nodes is 6.

Fig. 55 shows the Tanner graph of such ensemble.

In the Tanner graph in Fig. 55, there are N (equal to the code length N) variable nodes represented by a circle (○) in the drawing and N/2 (equal to a product obtained by multiplying the code rate 1/2 by the code length N) check nodes represented by a square (□) in the drawing.

Three edges, the number of which is equal to the column weight, are connected to each variable node, so that there are a total of 3N edges connected to the N variable nodes.

Also, six edges the number of which is equal to the row weight, are connected to each check node, so that there are a total of 3N edges connected to the N/2 check nodes.

Further, there is one interleaver in the Tanner graph in Fig. 55.

The interleaver randomly rearranges the 3N edges connected to the N variable nodes and connects the rearranged edges to any of the 3N edges connected to the N/2 check nodes.

There are (3N) ! (= (3N) × (3N - 1) × ⋯ × 1) rearranging patterns of rearranging the 3N edges connected to the N variable nodes by the interleaver. Therefore, the ensemble characterized by the degree sequence in which the weight of all the variable nodes is 3 and the weight of all the check nodes is 6 is a set of (3N)! LDPC codes.

In the simulation for obtaining the high-performance LDPC code (appropriate parity check matrix), a multi-edge type ensemble is used in the density evolution.

In the multi-edge type, the interleaver through which the edge connected to the variable node and the edge connected to the check node pass is divided into a multi-edge one, so that the ensemble is more strictly characterized.

Fig. 56 shows an example of the Tanner graph of the multi-edge type ensemble.

In the Tanner graph in Fig. 56, there are two interleavers, which are a first interleaver and a second interleaver.

In the Tanner graph in Fig. 56, there are v1 variable nodes with one edge connected to the first interleaver and no edge connected to the second interleaver, v2 variable nodes with one edge connected to the first interleaver and two edges connected to the second interleaver, and v3 variable nodes with no edge connected to the first interleaver and two edges connected to the second interleaver.

Further, in the Tanner graph in Fig. 56, there are c1 check nodes with two edges connected to the first interleaver and no edge connected to the second interleaver, c2 check nodes with two edges connected to the first interleaver and two edges connected to the second interleaver, and c3 check nodes with no edge connected to the first interleaver and three edges connected to the second interleaver.

Herein, the density evolution and implementation thereof are described in "On the Design of Low-Density Parity-Check Codes within 0.0045 dB of the Shannon Limit", S. Y. Chung, G. D. Forney, T. J. Richardson, and R. Urbanke, IEEE Communications Leggers, VOL. 5, NO. 2, Feb 2001, for example.

In the simulation for obtaining (the parity check matrix initial value table of) the first new LDPC codes and the first other new LDPC code, the ensemble in which the performance threshold being Eb/No (signal power to noise power ratio per bit) at which the BER starts to decrease (to be lower) is a predetermined value or smaller is found by multi-edge type density evolution and the LDPC code to decrease the BER is selected as the high-performance LDPC code out of the LDPC codes belonging to the ensemble.

The parity check matrix initial value tables of the above-described first new LDPC codes and first other new LDPC codes are determined by the above simulation.

Accordingly, by the first new LDPC codes and the first other new LDPC codes obtained from the parity check matrix initial value tables, it is possible to ensure a good communication quality in the data transmission.

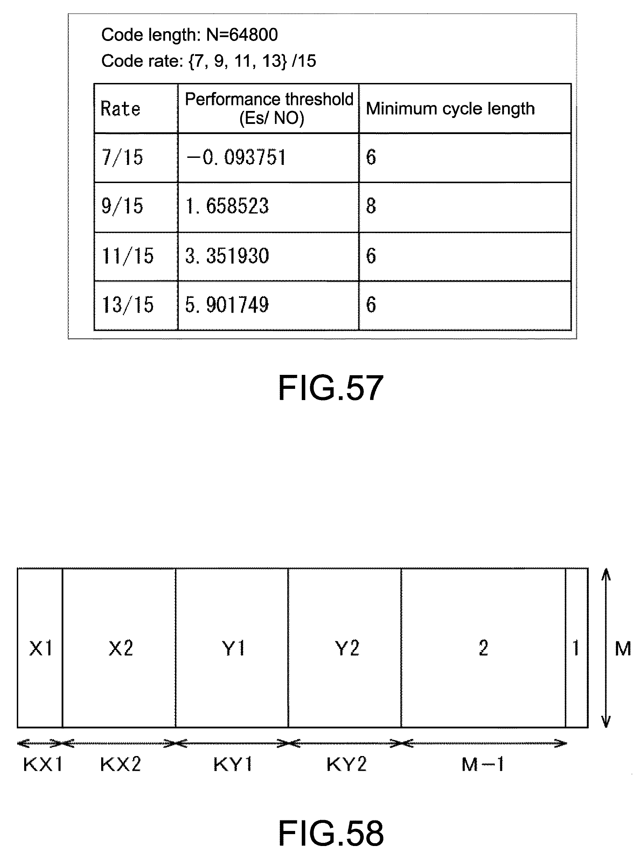

Fig. 57 is a view showing a minimum cycle length and a performance threshold of the parity check matrices H obtained from the parity check matrix initial value tables of the first new LDPC codes of (64k, 7/15), (64k, 9/15), (64k, 11/15) and (64k, 13/15) (hereinafter also referred to as "the parity check matrices H of the first new LDPC codes of (64k, 7/15), (64k, 9/15), (64k, 11/15) and (64k, 13/15)) shown in Fig. 22 to Fig. 33.

Here, the minimum cycle length (girth) means a minimum value of a length of a loop (loop length) configured of the elements of 1 in the parity check matrix H.

The parity check matrices H of the first new LDPC codes of (64k, 7/15), (64k, 9/15), (64k, 11/15) and (64k, 13/15) have no cycle-4 (the loop length of four, a loop of the elements of 1).

The performance threshold of the first new LDPC code of (64k, 7/15) is -0.093751, the performance threshold of the first new LDPC code of (64k, 9/15) is 1.658523, the performance threshold of the first new LDPC code of (64k, 11/15) is 3.351930 and the performance threshold of the first new LDPC code of (64k, 13/15) is 5.301749.

Fig. 58 is a view illustrating the parity check matrices H of the first new LDPC codes of (64k, 7/15), (64k, 9/15), (64k, 11/15) and (64k, 13/15) in Fig. 32 to Fig. 33.

The column weight is X1 for first to KX1-th columns of the parity check matrices H of the first new LDPC codes of (64k, 7/15), (64k, 9/15), (64k, 11/15) and (64k, 13/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 64800 bits of the first new LDPC codes of (64k, 7/15), (64k, 9/15), (64k, 11/15) and (64k, 13/15).

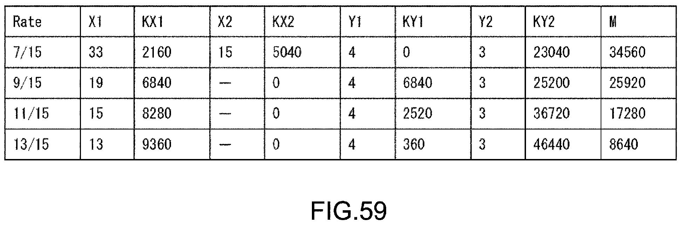

Fig. 59 is a view showing the numbers of columns KX1, KY2, KY1, KY2 and M, and the column weights X1, X2, Y1, and Y2 in Fig. 58 for the parity check matrices H of the first new LDPC codes of (64k, 7/15), (64k, 9/15), (64k, 11/15) and (64k, 13/15).

As for the parity check matrices H of the first new LDPC codes of (64k, 7/15), (64k, 9/15), (64k, 11/15) and (64k, 13/15), as is the case with the parity check matrix illustrated in Figs. 12 and 13, the column weight of the column closer to the top (left) column tends to be larger, so that the code bit closer to the top code bit of the new LDPC code tends to be more tolerant to error (have resistance to error).

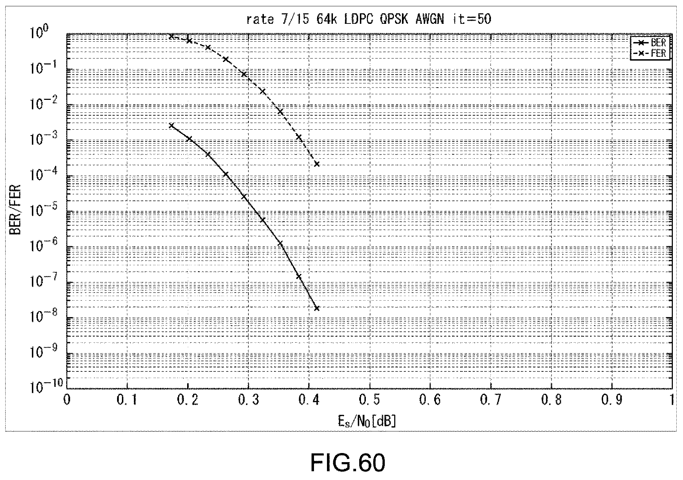

Fig. 60 is a view showing a simulation result of the BER/FER (bit error rate/frame error rate) of the first new LDPC code of (64k, 7/15) measured using the QPSK as the modulation scheme.

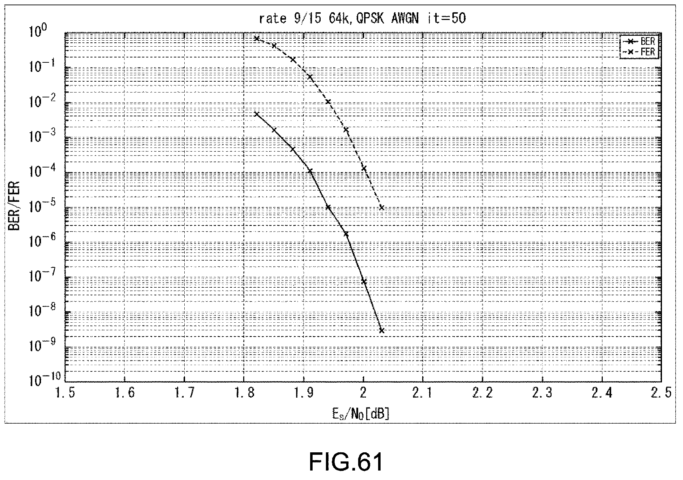

Fig. 61 is a diagram showing a simulation result of measurement of BER/FER about the first new LDPC code of (64k, 9/15) measured using the QPSK as the modulation scheme.

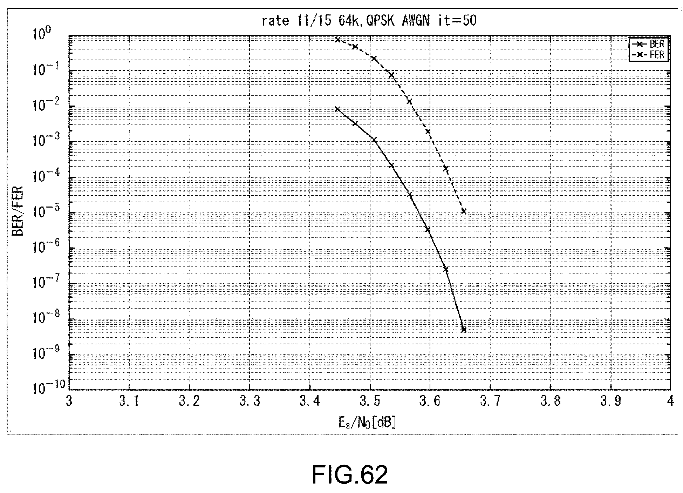

Fig. 62 is a view showing a simulation result of the BER/FER of the first new LDPC code of (64k, 11/15) measured using the QPSK as the modulation scheme.

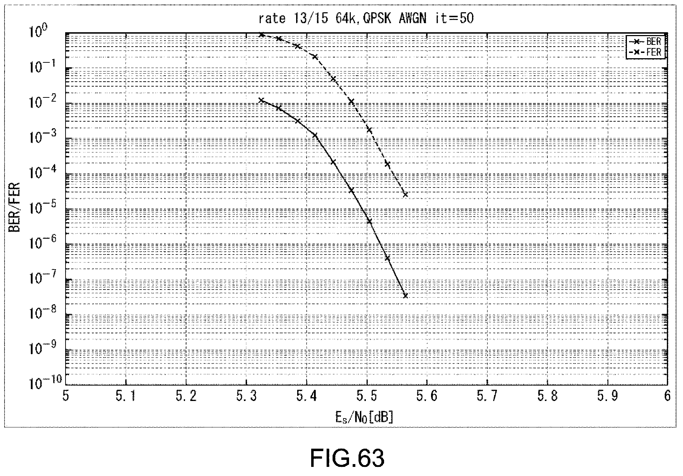

Fig. 63 is a view showing a simulation result of the BER/FER of the first new LDPC code of (64k, 13/15) measured using the QPSK as the modulation scheme.

In the simulation, the AWGN channel is supposed, and 50 times is adopted as the number of times of repetitive decoding C for decoding the LDPC code.

In Fig. 60 to Fig. 63, Es/No is plotted along the abscissa and the BER/FER is plotted along the ordinate. A solid line represents the BER, and a dotted line represents the FER.

According to Fig. 60 to Fig. 63, as for the first new LDPC codes of (64k, 7/15), (64k, 9/15), (64k, 11/15) and (64k, 13/15), excellent BER/FER are obtained. Accordingly, it can confirm that a good communication quality is ensured in the data transmission using the first new LDPC codes of (64k, 7/15), (64k, 9/15), (64k, 11/15) and (64k, 13/15).

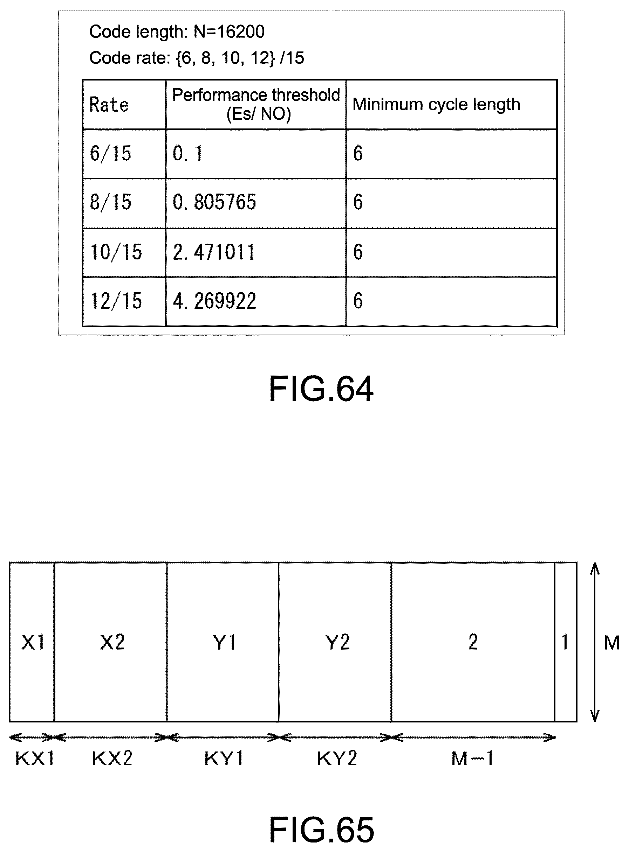

Fig. 64 is a view showing a minimum cycle length and a performance threshold of the parity check matrices H of the first new LDPC codes of (64k, 6/15), (64k, 8/15), (64k, 10/15) and (64k, 12/15) shown in Fig. 34 to Fig. 37.

The parity check matrices H of the first new LDPC codes of (16k, 6/15), (16k, 8/15), (16k, 10/15) and (16k, 12/15) have no cycle-4.

The performance threshold of the first new LDPC code of (16k, 6/15) is 0.01, the performance threshold of the first new LDPC code of (16k, 8/15) is 0.805765, the performance threshold of the first new LDPC code of (16k, 10/15) is 2.471011 and the performance threshold of the first new LDPC code of (16k, 12/15) is 4.269922.

Fig. 65 is a view illustrating the parity check matrices H of the first new LDPC codes of (16k, 6/15), (16k, 8/15), (16k, 10/15) and (16k, 12/15) in Fig. 34 to Fig. 37.

The column weight is X1 for first to KX1-th columns of the parity check matrices H of the first new LDPC codes of (16k, 6/15), (16k, 8/15), (16k, 10/15) and (16k, 12/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the first new LDPC codes of (16k, 6/15), (16k, 8/15), (16k, 10/15) and (16k, 12/15).

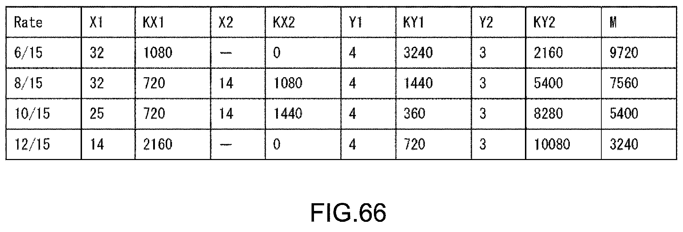

Fig. 66 is a view showing the numbers of columns KX1, KY2, KY1, KY2, and M, and the column weights X1, X2, Y1, and Y2 in Fig. 65 for the parity check matrices H of the first new LDPC codes of (16k, 6/15), (16k, 8/15), (16k, 10/15) and (16k, 12/15).

As for the parity check matrices H of the first new LDPC codes of (16k, 6/15), (16k, 8/15), (16k, 10/15) and (16k, 12/15), as is the case with the parity check matrix illustrated in Figs. 12 and 13, the column weight of the column closer to the top (left) column tends to be larger, so that the code bit closer to the top code bit of the new LDPC code tends to be more tolerant to error.

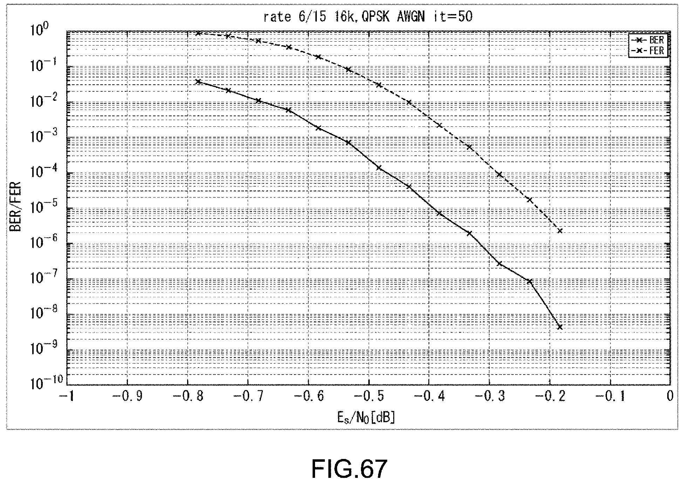

Fig. 67 is a view showing a simulation result of the BER/FER (bit error rate/frame error rate) of the first new LDPC code of (16k, 6/15) measured using the QPSK as the modulation scheme.

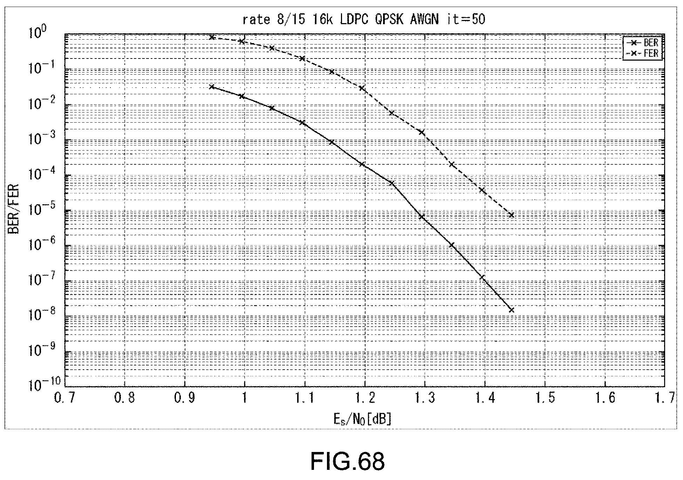

Fig. 68 is a view showing a simulation result of the BER/FER of the first new LDPC code of (16k, 8/15) measured using the QPSK as the modulation scheme.

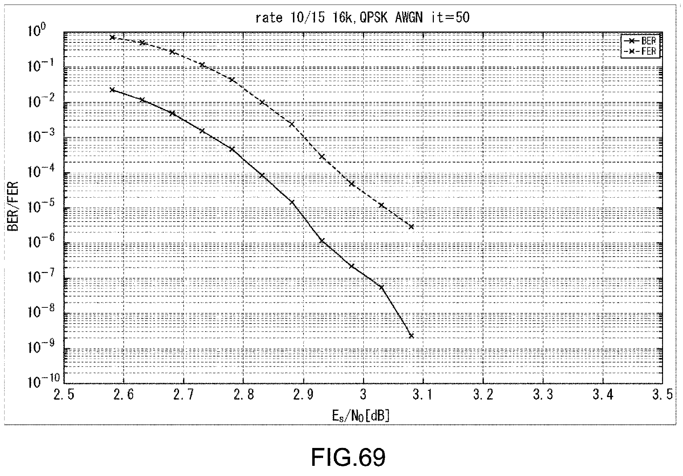

Fig. 69 is a view showing a simulation result of the BER/FER of the first new LDPC code of (16k, 10/15) measured using the QPSK as the modulation scheme.

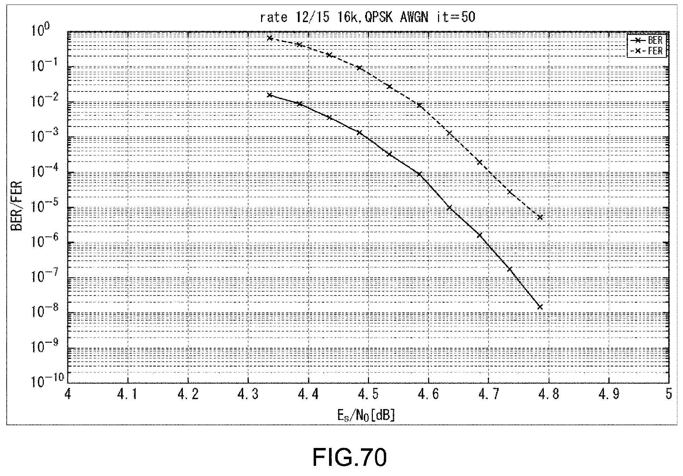

Fig. 70 is a view showing a simulation result of the BER/FER of the first new LDPC code of (16k, 12/15) measured using the QPSK as the modulation scheme.

In the simulation, the AWGN channel is supposed as the communication channel 13 (Fig. 7), and 50 times is adopted as the number of times of repetitive decoding C for decoding the LDPC code.

In Fig. 67 to Fig. 70, Es/No is plotted along the abscissa and the BER/FER is plotted along the ordinate. A solid line represents the BER, and a dotted line represents the FER.

According to Fig. 67 to Fig. 70, as for the first new LDPC codes of (16k, 6/15), (16k, 8/15), (16k, 10/15) and (16k, 12/15), excellent BER/FER are obtained. Accordingly, it can confirm that a good communication quality is ensured in the data transmission using the first new LDPC codes of (16k, 6/15), (16k, 8/15), (16k, 10/15) and (16k, 12/15).

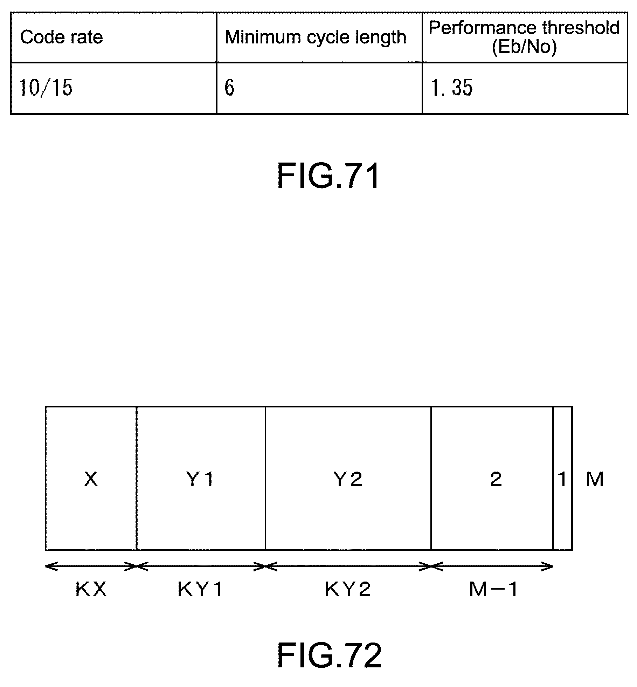

Fig. 71 is a view showing a minimum cycle length and a performance threshold of the parity check matrix H of the first new LDPC code of (16k, 10/15) shown in Fig. 38.

The parity check matrix H of the other first new LDPC code of (16k, 10/15) has no cycle-4.

The performance threshold of the first other new LDPC code of (16k, 10/15) is 1.35.

Fig. 72 is a view illustrating the parity check matrix H of the first other new LDPC code of (16k, 10/15) in Fig. 72.

The column weight is X for first to KX1-th columns of the parity check matrix H of the first other new LDPC code of (16k, 10/15), the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the first other new LDPC code of (16k, 10/15).

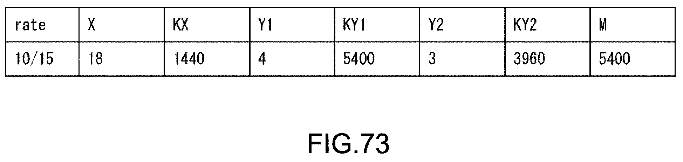

Fig. 73 is a view showing the numbers of columns KX, KY1, KY2, and M, and the column weights X1, X2, Y1, and Y2 in Fig. 72 for the code matrix H of the first other new LDPC code of (16k, 10/15).

As for the parity check matrix H of the first other new LDPC code of (16k, 10/15), as is the case with the parity check matrix illustrated in Figs. 12 and 13, the column weight of the column closer to the top (left) column tends to be larger, so that the code bit closer to the top code bit of the new LDPC code tends to be more tolerant to error.

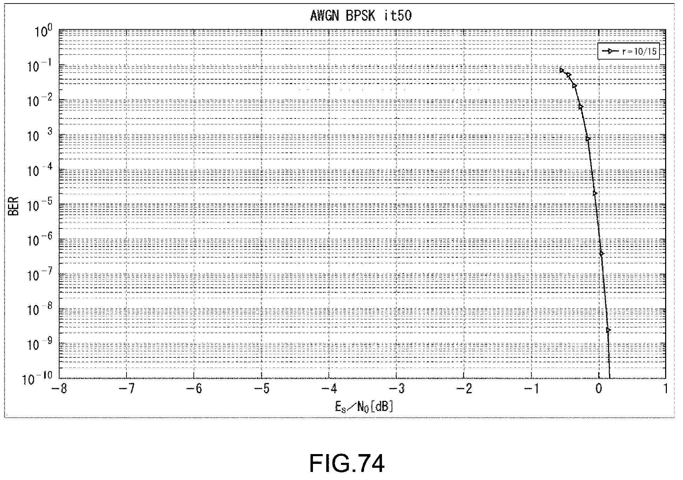

Fig. 74 is a view showing a simulation result of the BER of the first other new LDPC code of (16k, 10/15) measured using the BPSK as the modulation scheme.

In the simulation, the AWGN channel is supposed as the communication channel 13 (Fig. 7), and 50 times is adopted as the number of times of repetitive decoding C for decoding the LDPC code.

In Fig. 74, Es/No is plotted along the abscissa and the BER is plotted along the ordinate.

According to Fig. 74, as for the first other new LDPC code of (16k, 10/15), excellent BER is obtained. Accordingly, it can confirm that a good communication quality is ensured in the data transmission using the first other new LDPC code of (16k, 10/15).

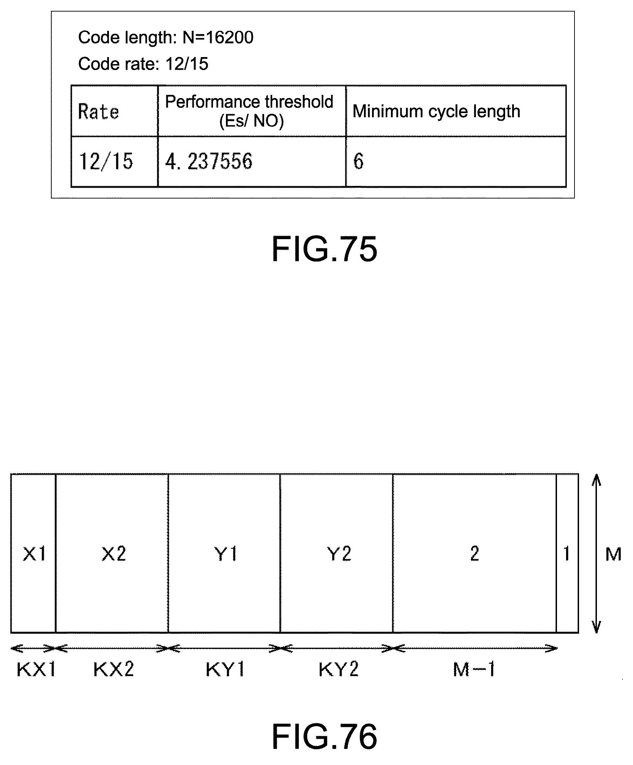

Fig. 75 is a view showing a minimum cycle length and a performance threshold of the parity check matrix H of the other first new LDPC code of (16k, 12/15) shown in Fig. 39.

The parity check matrices H of the first other new LDPC code of (16k, 12/15) has no cycle-4.

The performance threshold of the first other new LDPC code of (16k, 12/15) is 4.237556.

Fig. 76 is a view illustrating the parity check matrix H of the first other new LDPC code of (16k, 12/15) in Fig. 39.

The column weight is X1 for first to KX1-th columns of the parity check matrix H of the first other new LDPC code of (16k, 12/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the first other new LDPC code of (16k, 12/15).

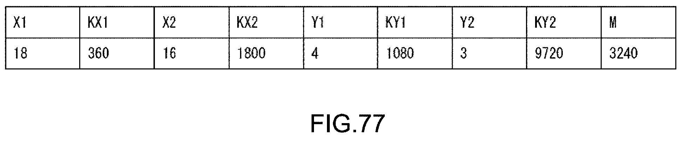

Fig. 77 is a view showing the numbers of columns KX1, KX2, KY1, KY2 and M, and the column weights X1, X2, Y1, and Y2 in Fig. 76 for the code matrix H of the first other new LDPC code of (16k, 12/15).

As for the parity check matrix H of the first other new LDPC code of (16k, 12/15), as is the case with the parity check matrix illustrated in Figs. 12 and 13, the column weight of the column closer to the top (left) column tends to be larger, so that the code bit closer to the top code bit of the new LDPC code tends to be more tolerant to error.

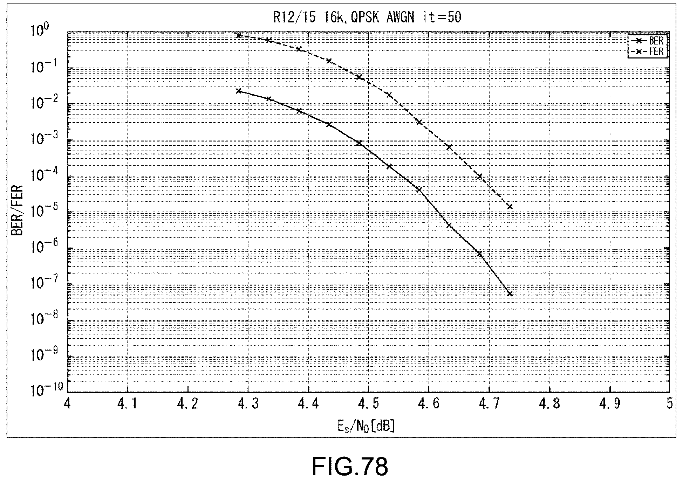

Fig. 78 is a view showing a simulation result of the BER/FER (bit error rate/frame error rate) of the first other new LDPC code of (16k, 12/15) measured using the QPSK as the modulation scheme.

In the simulation, the AWGN channel is supposed as the communication channel 13 (Fig. 7), and 50 times is adopted as the number of times of repetitive decoding C for decoding the LDPC code.

In Fig. 78, Es/No is plotted along the abscissa and the BER is plotted along the ordinate. A solid line represents the BER, and a dotted line represents the FER.

According to Fig. 78, as for the first other new LDPC code of (16k, 12/15), excellent BER/FER is obtained. Accordingly, it can confirm that a good communication quality is ensured in the data transmission using the first other new LDPC code of (16k, 12/15).

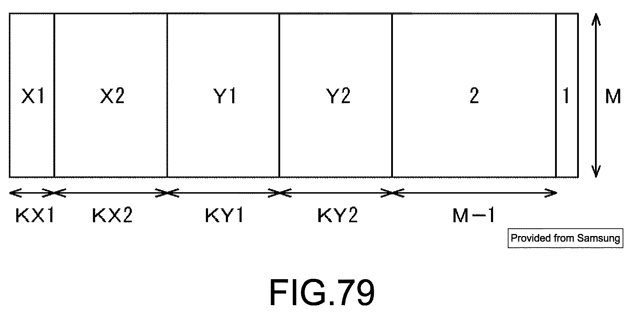

Fig. 79 is a view illustrating the parity check matrices H of the second new LDPC codes of (64k, 6/15), (64k, 8/15), (64k, 10/15) and (64k, 12/15) in Fig. 40 to Fig. 50.

The column weight is X1 for first to KX1-th columns of the parity check matrices H of the second new LDPC codes of (64k, 6/15), (64k, 8/15), (64k, 10/15) and (64k, 12/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 64800 bits of the second new LDPC codes of (64k, 6/15), (64k, 8/15), (64k, 10/15) and (64k, 12/15).

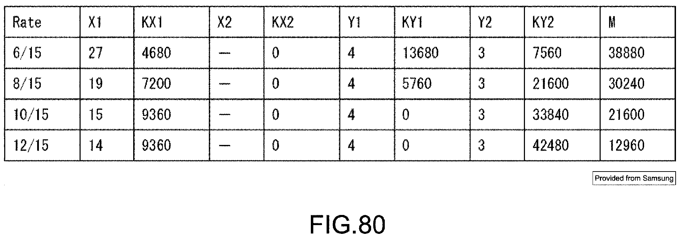

Fig. 80 is a view showing the numbers of columns KX1, KX2, KY1, KY2, and M, and the column weights X1, X2, Y1, and Y2 in Fig. 79 for the parity check matrices H of the second new LDPC codes of (64k, 6/15), (64k, 8/15), (64k, 10/15) and (64k, 12/15).

As for the parity check matrices H of the second new LDPC codes of (64k, 6/15), (64k, 8/15), (64k, 10/15) and (64k, 12/15), as is the case with the parity check matrix illustrated in Figs. 12 and 13, the column weight of the column closer to the top (left) column tends to be larger, so that the code bit closer to the top code bit of the new LDPC code tends to be more tolerant to error.

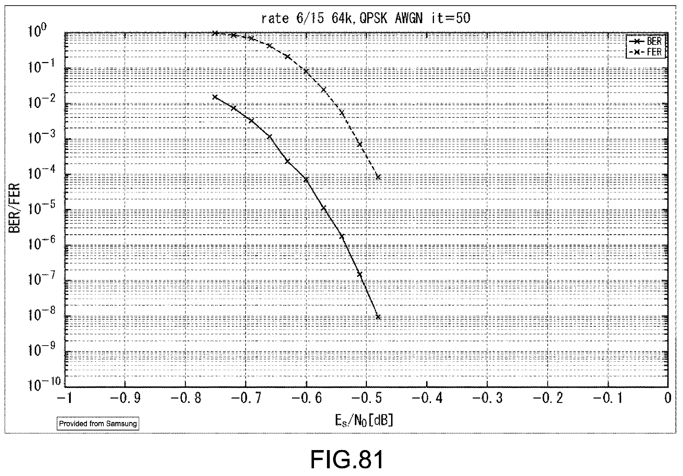

Fig. 81 is a view showing a simulation result of the BER/FER of the second new LDPC code of (64k, 6/15) measured using the QPSK as the modulation scheme.

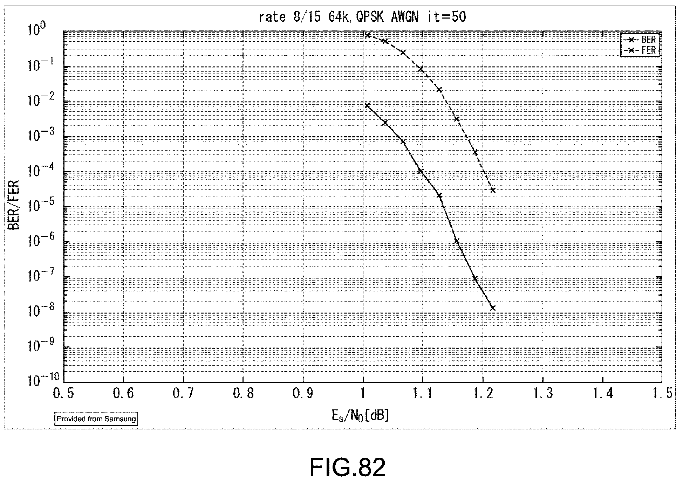

Fig. 82 is a view showing a simulation result of the BER/FER of the second new LDPC code of (64k, 8/15) measured using the QPSK as the modulation scheme.

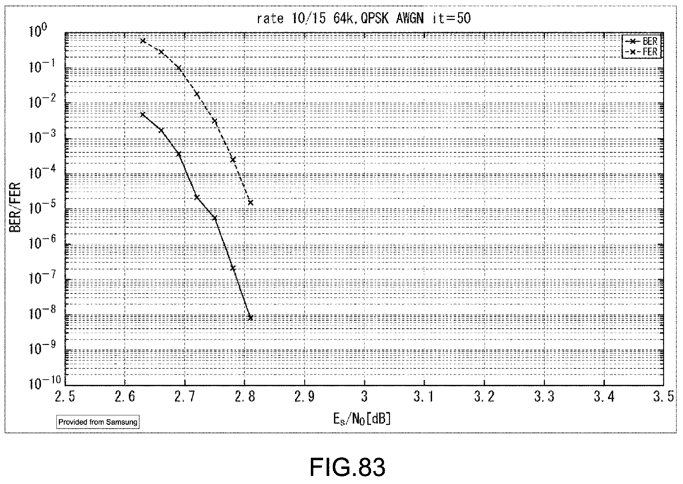

Fig. 83 is a view showing a simulation result of the BER/FER of the second new LDPC code of (64k, 10/15) measured using the QPSK as the modulation scheme.

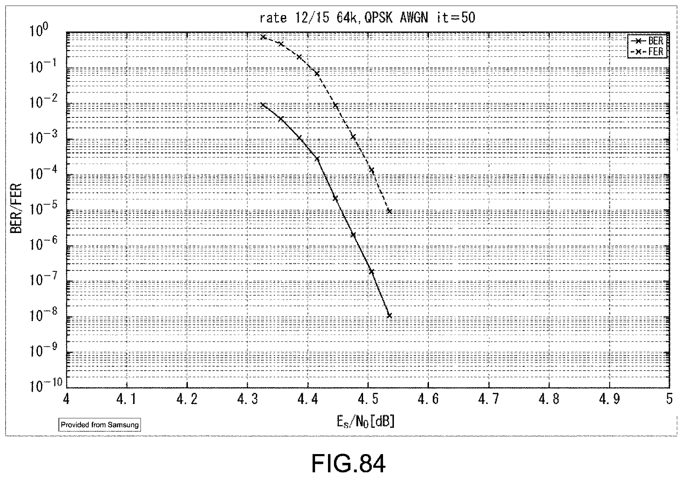

Fig. 84 is a view showing a simulation result of the BER/FER of the second new LDPC code of (64k, 12/15) measured using the QPSK as the modulation scheme.

In the simulation, the AWGN channel is supposed, and 50 times is adopted as the number of times of repetitive decoding C for decoding the LDPC code.

In Fig. 81 to Fig. 84, Es/No is plotted along the abscissa and the BER/FER is plotted along the ordinate. A solid line represents the BER, and a dotted line represents the FER.

According to Fig. 81 to Fig. 84, as for the second new LDPC codes of (64k, 6/15), (64k, 8/15), (64k, 10/15) and (64k, 12/15), excellent BER/FER are obtained. Accordingly, it can confirm that a good communication quality is ensured in the data transmission using the second new LDPC codes of (64k, 6/15), (64k, 8/15), (64k, 10/15) and (64k, 12/15).

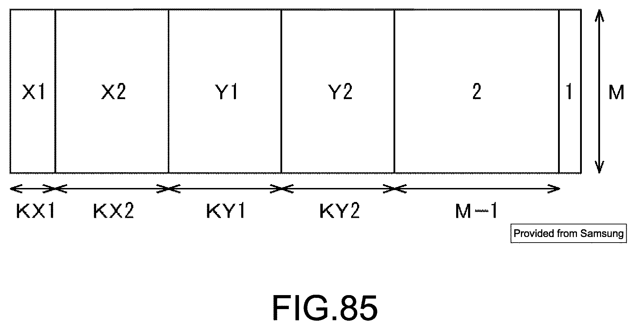

Fig. 85 is a view illustrating the parity check matrices H of the second new LDPC codes of (64k, 7/15), (64k, 9/15), (64k, 11/15) and (64k, 13/15) shown in Fig. 51 to Fig. 54.

The column weight is X1 for first to KX1-th columns of the parity check matrices H of the second new LDPC codes of (64k, 7/15), (64k, 9/15), (64k, 11/15) and (64k, 13/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the second new LDPC codes of (16k, 7/15), (16k, 9/15), (16k, 11/15) and (16k, 13/15).

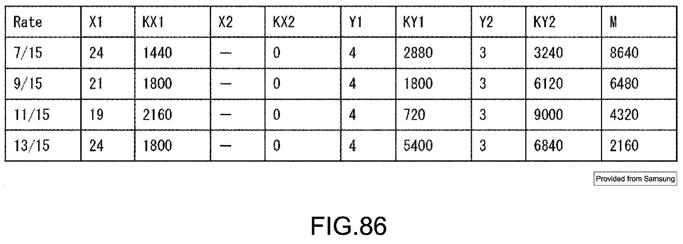

Fig. 86 is a view showing the numbers of columns KX1, KX2, KY1, KY2, and M, and the column weights X1, X2, Y1, and Y2 in Fig. 85 for the parity check matrices H of the second new LDPC codes of (16k, 7/15), (16k, 9/15), (16k, 11/15) and (16k, 13/15).

As for the parity check matrices H of the second new LDPC codes of (16k, 7/15), (16k, 9/15), (16k, 11/15) and (16k, 13/15), as is the case with the parity check matrix illustrated in Figs. 12 and 13, the column weight of the column closer to the top (left) column tends to be larger, so that the code bit closer to the top code bit of the new LDPC code tends to be more tolerant to error.

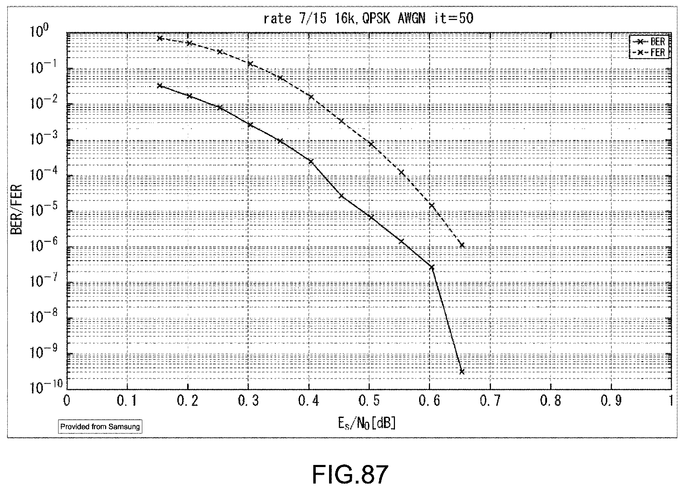

Fig. 87 is a view showing a simulation result of the BER/FER of the second new LDPC code of (16k, 7/15) measured using the QPSK as the modulation scheme.

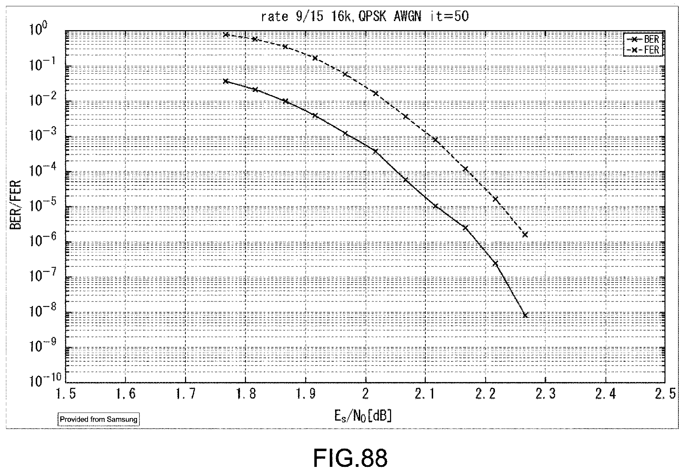

Fig. 88 is a view showing a simulation result of the BER/FER of the second new LDPC code of (16k, 9/15) measured using the QPSK as the modulation scheme.

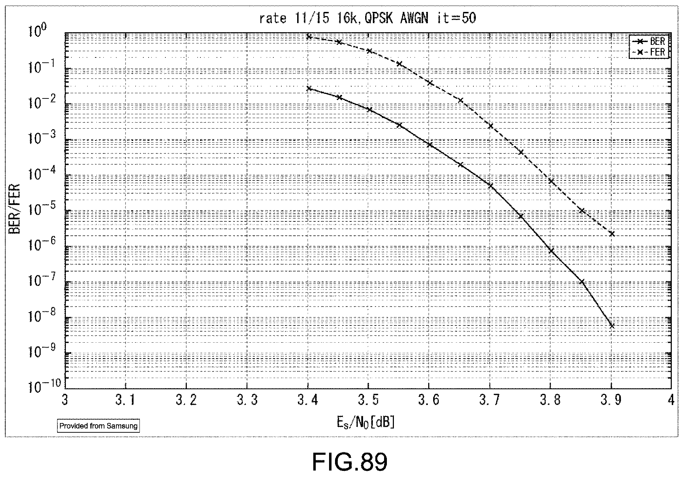

Fig. 89 is a view showing a simulation result of the BER/FER of the second new LDPC code of (16k, 11/15) measured using the QPSK as the modulation scheme.

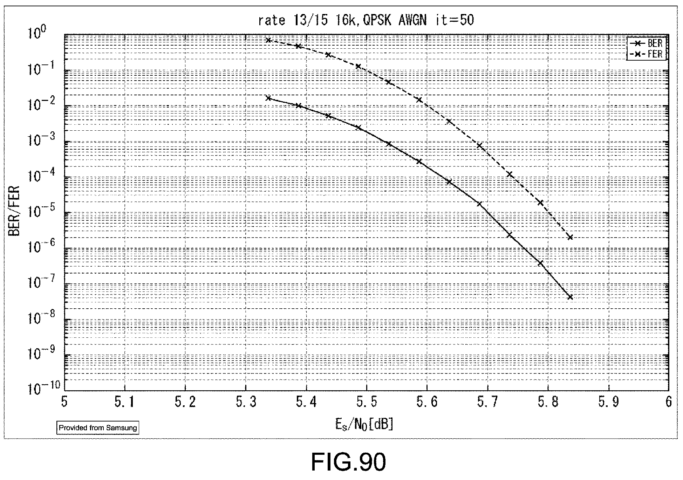

Fig. 90 is a view showing a simulation result of the BER/FER of the second new LDPC code of (16k, 13/15) measured using the QPSK as the modulation scheme.

In the simulation, the AWGN channel is supposed as the communication channel 13 (Fig. 7), and 50 times is adopted as the number of times of repetitive decoding C for decoding the LDPC code.

In Fig. 87 to Fig. 90, Es/No is plotted along the abscissa and the BER/FER is plotted along the ordinate. A solid line represents the BER, and a dotted line represents the FER.

According to Fig. 87 to Fig. 90, as for the second new LDPC codes of (16k, 7/15), (16k, 9/15), (16k, 11/15) and (16k, 13/15), excellent BER/FER are obtained. Accordingly, it can confirm that a good communication quality is ensured in the data transmission using the first new LDPC codes of (16k, 7/15), (16k, 9/15), (16k, 11/15) and (16k, 13/15).

Fig. 79 to Fig. 90 are data provided from Samsung.

<Constellation>

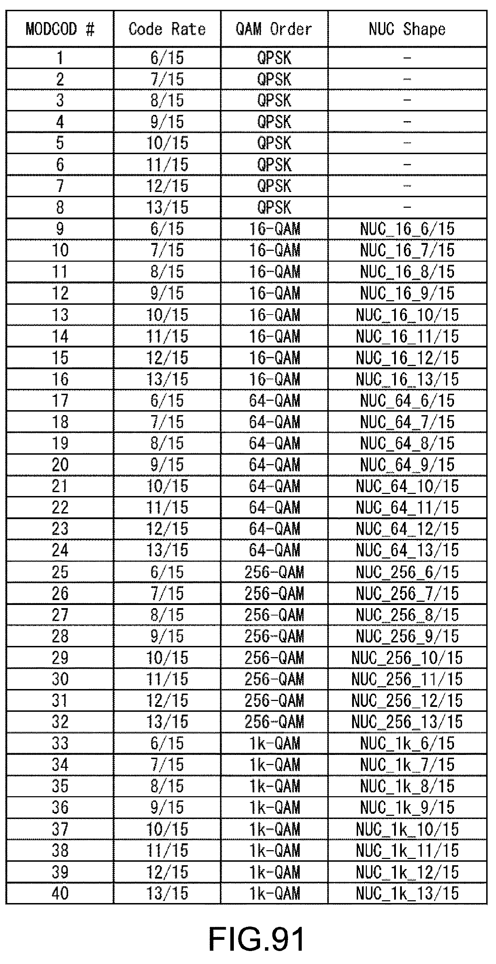

Fig. 91 is a diagram showing illustrative types of the constellation used in the transmission system in Fig. 7.

In the transmission system in Fig. 7, the constellation expected to be specified by ATSC3.0 may be used.

Fig. 91 shows illustrative types of the constellation expected to be used by ATSC3.0.

In the ATSC3.0, the constellation used in the MODCOD that is a combination of the modulation scheme and the LDPC code is set.

In the ATSC3.0, it is expected to use five modulation schemes, i.e., , QPSK, 16QAM, 64QAM, 256QAM and 1024QAM (1kQAM).

In the ATSC3.0, it is expected to use 16 types of the LDPC codes whose code rates r of eight types of 6/15, 7/15, 8/15, 9/15, 10/15, 11/15, 12/15 and 13/15 for each of two types of code lengths N of 16k bits and 64k bits.

In the ATSC3.0, 16 types of the LDPC codes are classified into 8 types (not depending on the code lengths N) by the code rates r, and it is expected that 40 (= 8 x 5) combinations of 8 types of the LDPC codes (each LDPC code whose code rate r is 6/15, 7/15, 8/15, 9/15, 10/15, 11/15, 12/15 or 13/15) and 5 types of the modulation schemes are used as a MODCOD capable of setting the constellation.

Accordingly, in the ATSC3.0, the MODCOD represents the combination of the 8 types of the code rates r of the LDPC codes and 5 types of the modulation schemes.

In Fig. 91, "NUC_16_6/15" described in the column "NUC Shape" represents the constellation used in the MODCOD corresponding to the row of the column "NUC

Shape".

Herein, for example, the "NUC_16_6/15" represents the constellation used in the MODCOD where the modulation scheme is 16QAM and code rate r is the LDPC code is 6/15.

As shown in Fig. 91, if the modulation scheme is QPSK, the same constellation is used for the 8 types of the code rates r of the LDPC code.

Also as shown in Fig. 91, if the modulation scheme is 16QAM, 64QAM, 256QAM or 1024QAM, different constellations are used for the 8 types of the code rates r of the LDPC code.

Accordingly, in the ATSC3.0, one constellation is prepared for QPSK, and eight constellations are prepared each for 16QAM, 64QAM, 256QAM and 1024QAM.

There are a UC (Uniform Constellation) where a constellation of signal points is uniform and a NUC (Non Uniform Constellation) where a constellation is not uniform.

Also, there are constellations called as 1D NUC (1-dimensional $M^2$ - QAM non-uniform constellation), 2D NUC (2-dimensional QQAM non-uniform constellation) and the like.

As the constellation of QPSK, UC is used. As the constellations of 16QAM, 64QAM and 256QAM, 2D NUC is used, for example. As the constellations of 1024QAM, 1D NUC is used, for example.

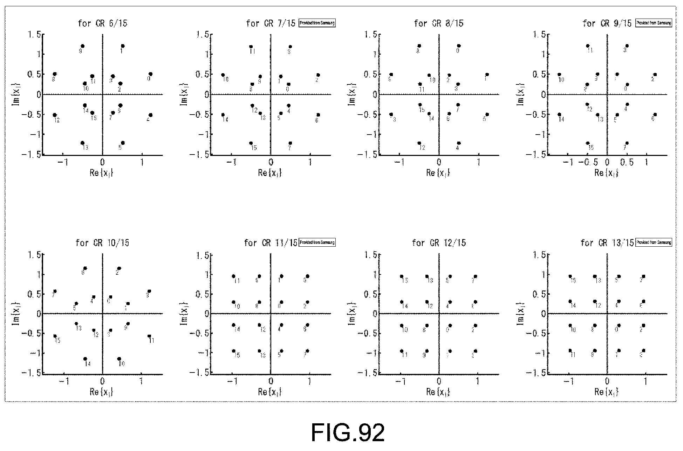

Fig. 92 is a diagram showing an example of the constellation for the eight code rates r of the LDPC code when the modulation scheme is 16QAM.

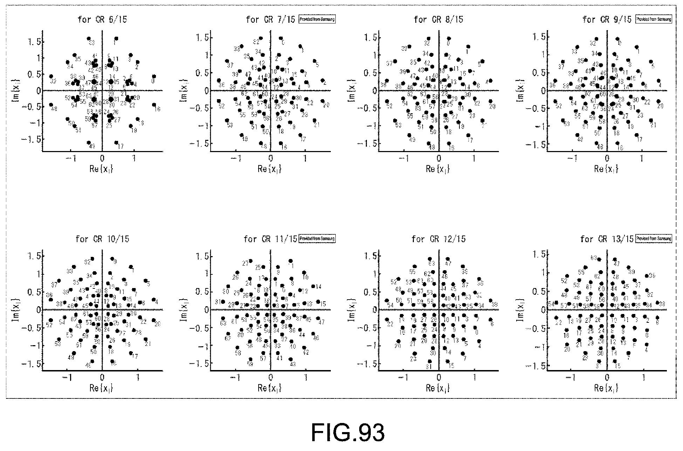

Fig. 93 is a diagram showing an example of the constellation for the eight code rates r of the LDPC code when the modulation scheme is 64QAM.

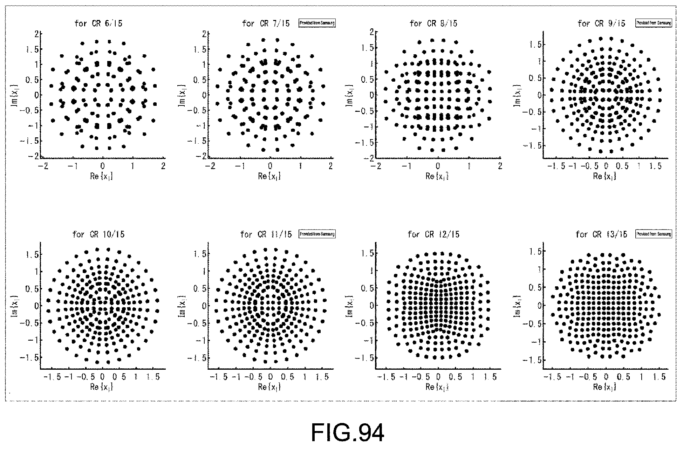

Fig. 94 is a diagram showing an example of the constellation for the eight code rates r of the LDPC code when the modulation scheme is 256QAM.

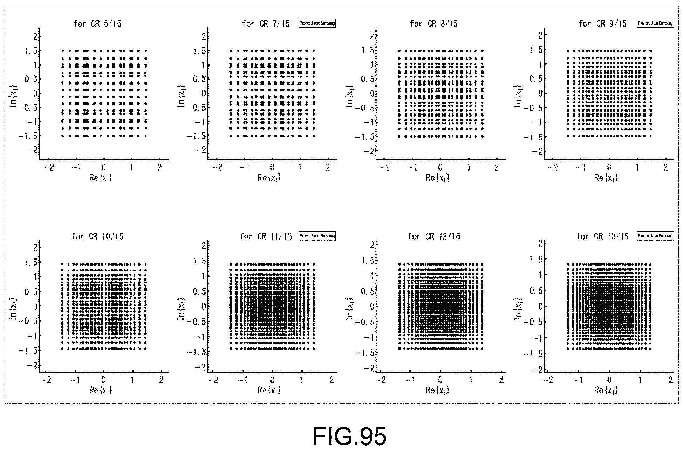

Fig. 95 is a diagram showing an example of the constellation for the eight code rates r of the LDPC code when the modulation scheme is 1024QAM.

In Fig. 92 to Fig. 95, each abscissa and each ordinate are an I axis and a Q axis, Re{xl} and Im{xl} represent a real part and an imaginary part of a signal point xl as a coordinates of the signal point xl.

In Fig. 92 to Fig. 95, the numerical values followed by "for CR" represent the code rates r of the LDPC code.

The constellations where the code rates r of the LDPC code are 7/15, 9/15, 11/15 and 13/15 are based on the data provided from Samsung.

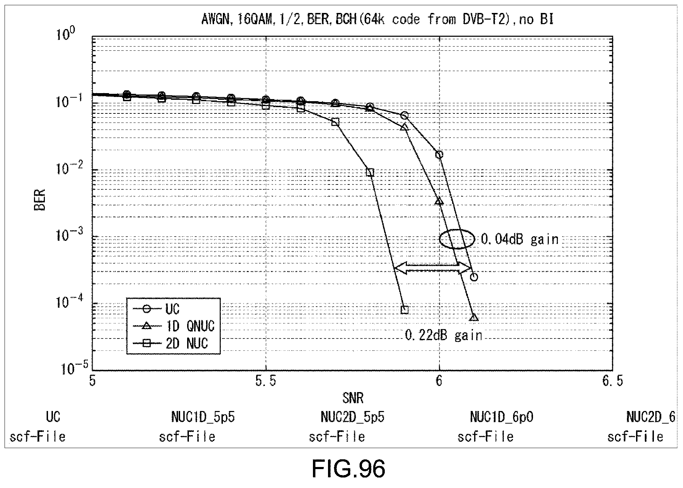

Fig. 96 is a view showing a simulation result of measurement of BER when UC, 1D NUC or 2D NUC is used as the constellation in the case of the modulation scheme of 16QAM.

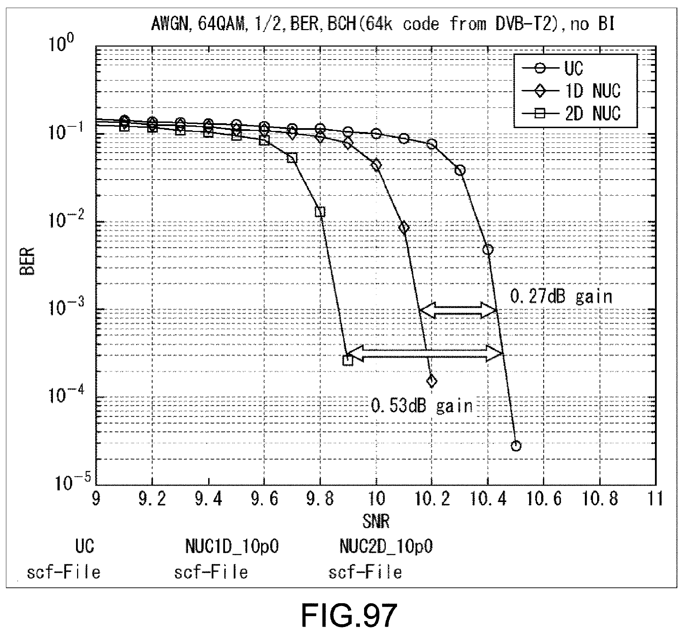

Fig. 97 is a view showing a simulation result of measurement of BER when UC, 1D NUC or 2D NUC is used as the constellation in the case of the modulation scheme of 64QAM.

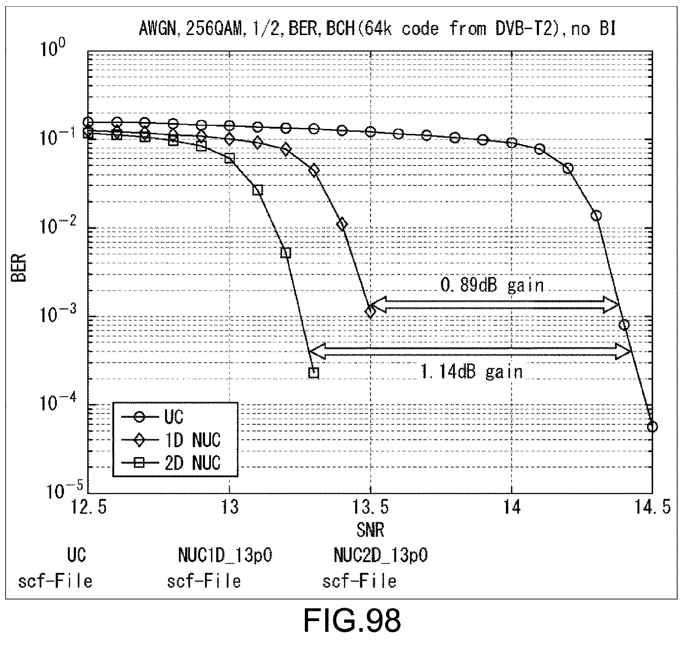

Fig. 98 is a view showing a simulation result of measurement of BER when UC, 1D NUC or 2D NUC is used as the constellation in the case of the modulation scheme of 256QAM.

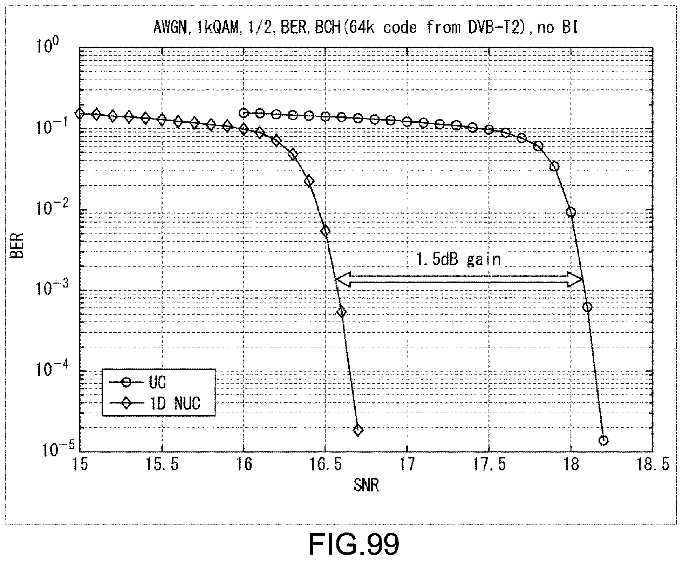

Fig. 99 is a view showing a simulation result of measurement of BER when UC, 1D NUC or 2D NUC is used as the constellation in the case of the modulation scheme of 1024QAM.

In Fig. 96 to Fig. 99, SNR (Signal to Noise Ratio) is plotted along the abscissa and the BER is plotted along the ordinate.

If the modulation scheme is 16QAM, 64QAM or 256QAM, as shown in Fig. 96 to Fig. 98, it can confirm that the BER is much improved by 1D NUC than by UC, and that the BER is further much improved by 2D NUC than by 1D NUC.

If the modulation scheme is 1024QAM, as shown in Fig. 99, it can confirm that the BER is much improved by 1D NUC than by UC.

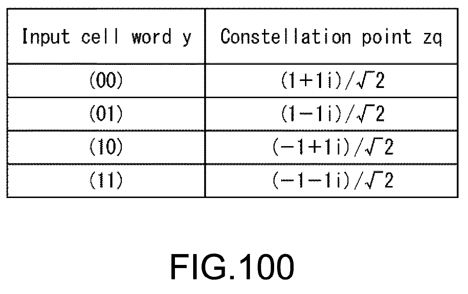

Fig. 100 is a diagram showing coordinates of the signal points of UC commonly used for eight code rates r (= 6/15, 7/15, 8/15, 9/15, 10/15, 11/15, 12, 15 and 13/15) of the LDPC code when the modulation scheme is QPSK.

In Fig. 100, "Input cell word y" represents 2-bit symbol of mapping by UC of the QPSK, and "Constellation point $z_q$" represents a coordinate of a signal point $z_q$. The index q of the signal point $z_q$ represents a discrete-time of symbols (a time interval between one symbol and the next symbol).

In Fig. 100, the coordinates of the signal point $z_q$ are represented by a complex number, and i represents the imaginary unit $(\sqrt{(-1)})$.

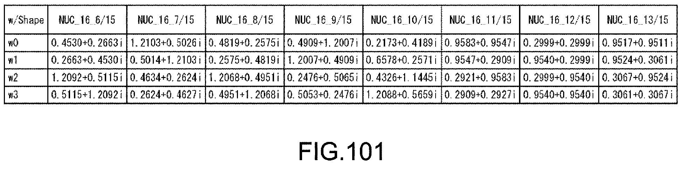

Fig. 101 is a diagram showing coordinates of the signal points of 2D NUC commonly used for eight code rates r of the LDPC code when the modulation scheme is 16QAM.

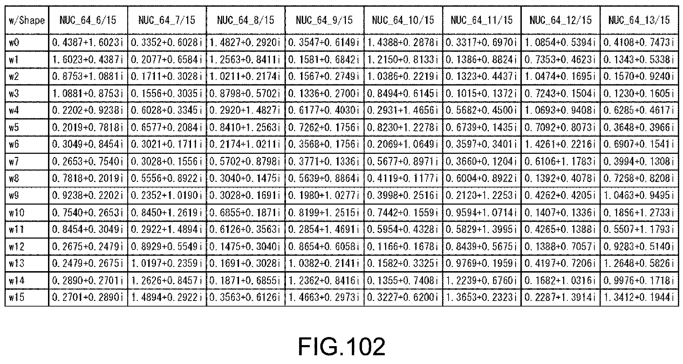

Fig. 102 is a diagram showing coordinates of the signal points of 2D NUC commonly used for eight code rates r of the LDPC code when the modulation scheme is 64QAM.

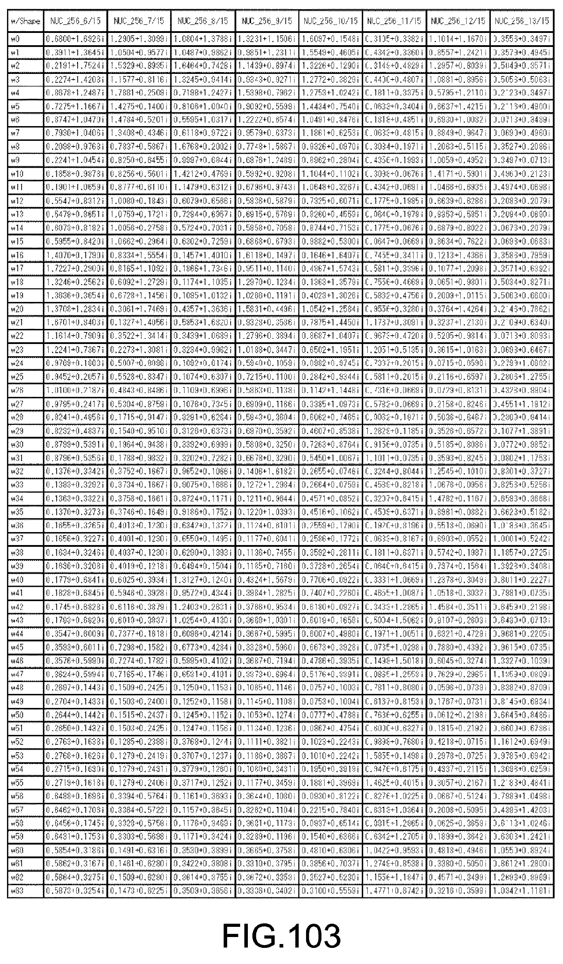

Fig. 103 is a diagram showing coordinates of the signal points of 2D NUC commonly used for eight code rates r of the LDPC code when the modulation scheme is 256QAM.

In Fig. 101 to Fig. 103, NUC_$2^m$_r represents a coordinate of a signal point of 2D NUC used if the modulation method is $2^m$QAM and the code rate of the LDPC code is r.

In Fig. 101 to Fig. 103, as in Fig. 100, the coordinate of the signal point $z_q$ is represented by a complex number, and i represents the imaginary unit.

In Fig. 101 to Fig. 103, w#k represents a coordinate of a signal point in a first quadrant of the constellation.

In 2D NUC, a signal point of a second quadrant of the constellation is arranged at a position where the signal point of the first quadrant is moved symmetrically with respect to the Q axis, and a signal point of a third quadrant of the constellation is arranged at a position where the signal point of the first quadrant is moved symmetrically with respect to the origin. A signal point of a fourth quadrant of the constellation is arranged at a position where the signal point of the first quadrant is moved symmetrically with respect to the I axis.

Herein, if the modulation scheme is $2^m$ QAM, m bits are taken as one symbol, and one symbol is mapped to signal points corresponding to the symbol.

The symbol of the m bit symbol is represented, for example, by 0 to $2^m$ -1 integer values. If b = $2^m/4$, the symbols y(0), y(1), ⋯, y (2m-1) represented by 0 to $2^m$-1 integer values may be classified into four: symbols y(0) to y(b-1), y(b) to y(2b-1), y(2b) to y(3b-1) and y(3b) to (4b-1).

In Fig. 101 to Fig. 103, the suffix k of w#k represents an integer value of 0 to b-1, and w#k represents the coordinate of the signal point corresponding to the symbol y(k) from the symbols y(0) to y(b-1).

The coordinate of the signal point corresponding to the symbol y(k+b) from the symbols y(b) to y(2b-1) is represented by -conj(w#k). The coordinate of the signal point corresponding to the symbol y(k+2b) from the symbols y(2b) to y(3b-1) is represented by conj(w#k). The coordinate of the signal point corresponding to the symbol y(k+3b) from the symbols y(3b) to y(4b-1) is represented by conj(w#k).

The conj(w#k) represents a complex conjugate of w#k.

For example, if the modulation scheme is 16QAM, m = 4 bit symbols; y(0), y(1), ⋯, y (15) are classified into four; symbols y(0) to y(3), y(4) to y(7), y(8) to y(11) and y(12) to y(15) as b = $2^4/4/4$ = 4.

For example, as the symbol y(12) from the symbols y(0) to y(15) is a symbol y(k+3b)y(0+3x4) from the symbols y(3b) to y(4b-1) and k = 0, the coordinate of the signal point corresponding to the symbol y(12) will be -w#k = -w0.

If the code rate r of the LDPC code, for example, is 9/15, according to Fig. 101, w0 of (NUC_16_9/15) where the modulation scheme is 16QAM and the code rate r is 9/15 is 0.4909 + 1.2007i. So, a coordinate -w0 of the signal point corresponding to the symbol y(12) is -(0.4909 + 1.2007i).

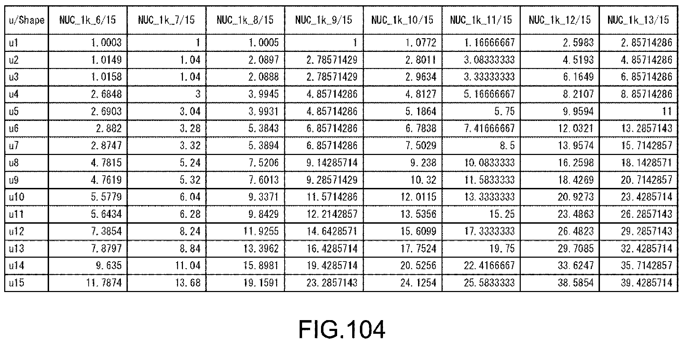

Fig. 104 is a diagram showing coordinates of the signal points of 1D NUC used for eight code rates r of the LDPC code when the modulation scheme is 1024QAM.

In Fig. 104, the columns of NUC_1k_r represent values of u#k of the coordinates of the signal points of 1D NUC used when the modulation scheme is 1024QAM and the code rate of the LDPC code is r.

u#k represents a real part $Re(z_q)$ and an imaginary part $Im(z_q)$ of the complex number as a coordinate of the signal point $z_q$ of 1D NUC.

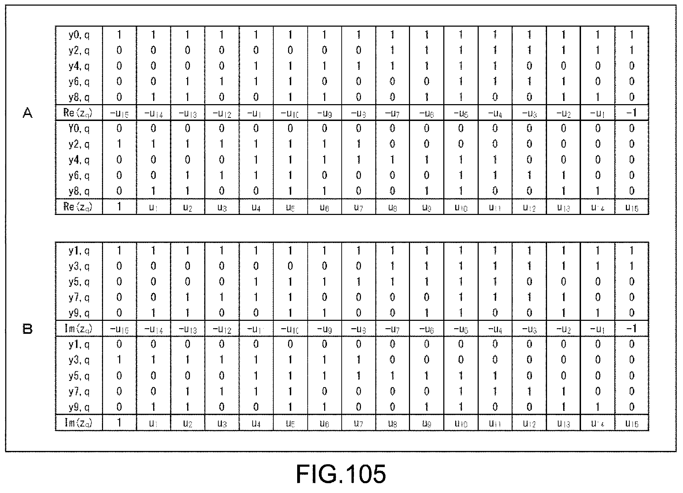

Fig. 105 is a diagram showing a relationship between the real part $Re(z_q)$ and the imaginary part $Im(z_q)$ of the complex number as the coordinate of the signal point $z_q$ of 1D NUC corresponding to the symbol y.

The 10-bit symbol y of 1024QAM is represented by $y_{0,q}$, $y_{1,q}$, $y_{2,q}$, $y_{3,q}$, $y_{4,q}$, $y_{5,q}$, $y_{6,q}$, $y_{7,q}$, $y_{8,q}$ and $y_{9,q}$ from the head bit (Most Significant Bit).

Fig. 105A represents a corresponding relationship between odd numbered 5-bit symbol y; $y_{0,q}$, $y_{2,q}$, $y_{4,q}$, $y_{6,q}$ and $y_{8,q}$ and the u#k representing the real part $Re(z_q)$ of (the coordinate) of the signal point $z_q$ corresponding to the symbol y.

Fig. 105B represents a corresponding relationship between even numbered 5-bit symbol y; $y_{1,q}$, $y_{3,q}$, $y_{5,q}$, $y_{7,q}$ and $y_{9,q}$ and the u#k representing the imaginary part $Im(z_q)$ of (the coordinate) of the signal point $z_q$ corresponding to the symbol y.

If the 10-bit symbol y = ($y_{0,q}$, $y_{1,q}$, $y_{2,q}$, $y_{3,q}$, $y_{4,q}$, $y_{5,q}$, $y_{6,q}$, $y_{7,q}$, $y_{8,q}$ and $y_{9,q}$) of 1024QAM is, for example, (0, 0, 1, 0, 0, 1, 1, 1, 0, 0), odd-numbered 5 bits ($y_{0,q}$, $y_{2,q}$, $y_{4,q}$, $y_{6,q}$ and $y_{8,q}$) are (0, 1, 0, 1, 0) and the even-numbered 5 bits ($y_{1,q}$, $y_{3,q}$, $y_{5,q}$, $y_{7,q}$ and $y_{9,q}$) are (0, 0, 1, 1, 0).

In Fig. 105A, the odd-numbered 5 bits (0, 1, 0, 1, 0) are correlated with u3, and therefore, the real part $Re(z_q)$ of the signal point $z_q$ corresponding to the symbol y = (0, 0, 1, 0, 0, 1, 1, 1, 0, 0) is u3.

In Fig. 105B, the even-numbered 5 bits (0, 1, 0, 1, 0) are correlated with u11, and therefore, the imaginary part $Im(z_q)$ of the signal point $z_q$ corresponding to the symbol y = (0, 0, 1, 0, 0, 1, 1, 1, 0, 0) is u11.

If the code rate r of the LDPC code, for example, is 7/15, according to Fig. 104 as described above, as to 1D NUC (NUC_1k_7/15) where the modulation scheme is 1024QAM and code rate r is the LDPC coding is 7/15, u3 is 1.04 and u11 is 6.28.

Accordingly, in the real part $Re(z_q)$ of the signal point $z_q$ corresponding to the symbol y = (0, 0, 1, 0, 0, 1, 1, 1, 0, 0), u3 = 1.04, in $Im(z_q)$, u11 = 6.28. As a result, the coordinate of the signal point $z_q$ corresponding to the symbol y = (0, 0, 1, 0, 0, 1, 1, 1, 0, 0) is represented by 1.04 + 6.28i.

The signal points of 1D NUC are arranged in a matrix on a straight line parallel to the I axis or a straight line parallel to the Q-axis. However, spaces between signal points are not constant. Upon transmission of (data mapped to) the signal points, the average power of the signal points on the constellation is normalized. Normalization is performed by multiplying each signal point $z_q$ on the constellation by a reciprocal $1 / (\sqrt{P_{ave}})$ of a square root $\sqrt{P_{ave}}$ of a root mean square value $P_{ave}$, where the root mean square of absolute values of (coordinates of) all signal points on the constellation is represented by $P_{ave}$.

By the constellations illustrated in Fig. 92 to Fig. 105, it can confirm that good error rates are obtained.

<Block interleaver 25>

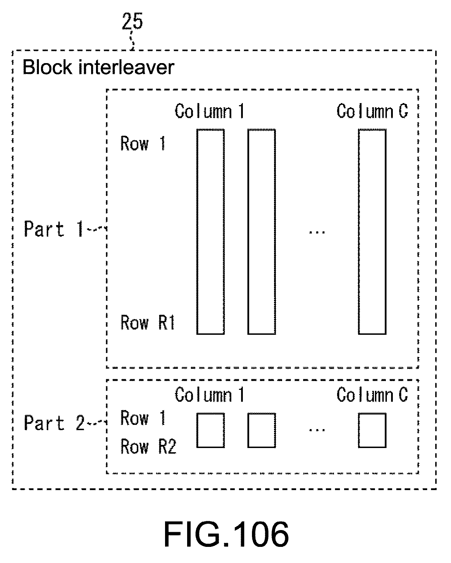

Fig. 106 is a block diagram showing a configuration example of a block interleaver 25 in Fig. 9.

The block interleaver 25 has a storage region called as Part 1 and a storage region called as Part 2.

The Parts 1 and 2 store one bit in a row (horizontal) direction. The number C of columns that are the storage regions for storing the predetermined number of bits in a column (vertical) direction are arranged. The number C is equal to the number of bits m of the symbols.

When the number of bits that are stored by the part 1 columns in the column direction (hereinafter, also referred to as a part-column length) is expressed as R1, and the part column length of the part 2 columns is expressed as R2, (R1 + R2) x C equals to the code length N of the target of the LDPC code to be block-interleaved (in the present embodiment, 64800 bits, or 16200 bits).

In addition, a part column length R1 is equal to a multiple of 360 bits that are the number of columns P being the unit of the cyclic structure. A part column length R2 is equal to a remainder when the sum of the part column length R1 of the part 1 and the part column length R2 of the part 2 (hereinafter also referred to as a column length) R1 + R2 is divided by 360 bits that are the number of columns P being the unit of the cyclic structure.

Here, the column length R1 + R2 is equal to a value when the code length N of the LDPC code to be block-interleaved is divided by the bit number m of symbols.

For example, concerning the LDPC code whose code length N is 16200 bits, if 16QAM is used as the modulation method, the bit number m of symbols is four bits, and the column length R1 + R2 will be 4050 (= 16200/4) bits.

Furthermore, as the remainder when the column length R1 + R2 = 4050 is divided by 360 bits that are the number of columns P being the unit of the cyclic structure is 90, the part column length R2 will be 90 bits.

The part column length R1 of the part 1 will be R1 + R2 - R2 = 4050-90 = 3960 bits.

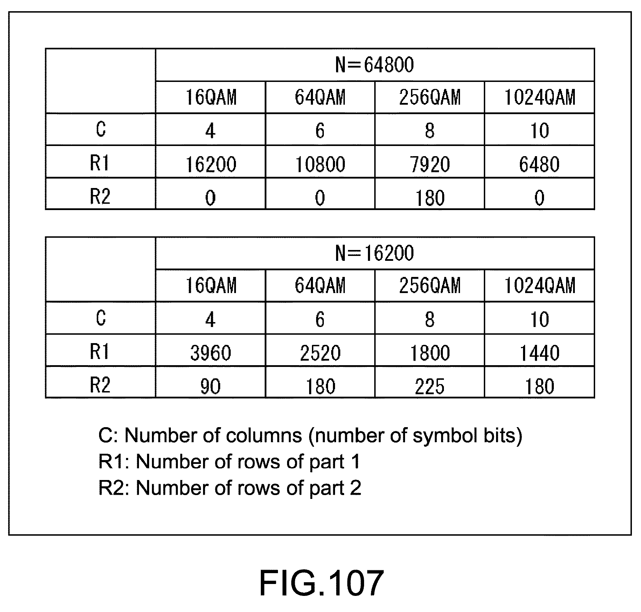

Fig. 107 is a diagram showing the column number C of the parts 1 and 2 for a combination of the code length N and the modulation scheme and the part column lengths (row numbers) R1 and R2.

Fig. 107 shows the column number C of the parts 1 and 2 and the part column lengths R1 and R2 for a combination of the code length N of the LDPC code being 16200 bits and 64800 bits and the modulation schemes of 16QAM, 64QAM, 256QAM, and 1024QAM.

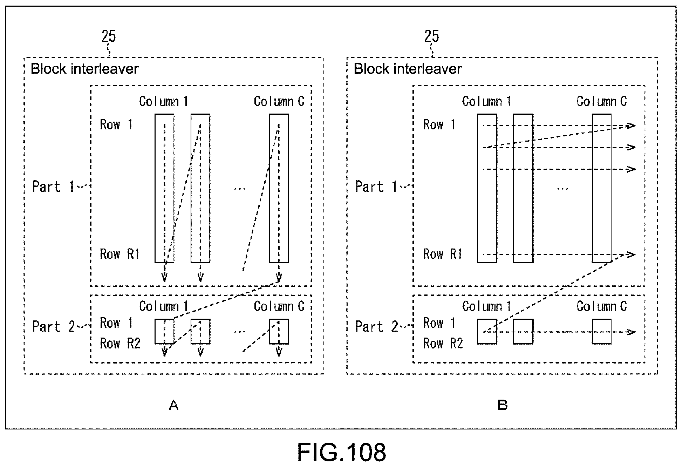

Fig. 108 is a diagram for illustrating a block interleave performed in the block interleaver 25.

The block interleaver 25 preforms the block interleave to the parts 1 and 2 by writing and reading the LDPC code.

In other words, in the block interleave, as shown in Fig. 108A, the code bits of the LDPC code of one code word are written from a top to down direction (column direction) of the part 1 columns and from left to right directions of the columns.

When writing of the code bits to the bottom of the right-most column of the part 1 columns (C-th column) is finished, the rest of the code bits is written from a top to down direction (column direction) of the part 2 columns and from left to right directions of the columns.

After that, when the writing of the code bits to the bottom of the right-most column of the part 2 columns (C-th column) is finished, as shown in Fig. 108B, the code bits are read in a C = m bit unit in the row direction from all first columns of the number C of the part 1.

The code bits for all columns of the number C of the part 1 are read sequentially to the lower rows. When the reading is finished for the last R1th row, the code bits are read in a C = m bit unit in the row direction from all first columns of the number C of the part 2.

The code bits for all columns of the number C of the part 2 are read sequentially to the lower rows for the last R2th row.

As described above, the code bits read from the parts 1 and 2 for m-bit unit are supplied to the mapper 117 (Fig. 8) as the symbols.

<Group-wise interleave>

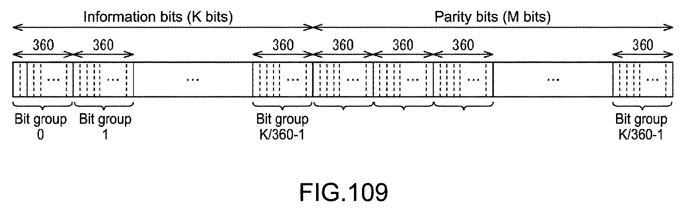

Fig. 109 is a diagram for illustrating group-wise interleave performed in the group-wise interleaver 24 in Fig. 9.

In the group-wise interleave, the LDPC code for one code word is divided into a 360-bit unit equal to the number of columns P being the unit of the cyclic structure from the beginning. One division, i.e., 360-bit, is considered as a bit group. The LDPC code of one code word is interleaved in a bit group unit according to a predetermined pattern (hereinafter also referred to as a GW pattern).

Here, the i + 1th bit group from the beginning at the time of dividing the one code word of the LDPC code to the bit group is hereinafter also described as a bit group i.

For example, the LDPC code whose code length N of 1800 bits is divided into 5 (= 1800/360) bit groups: 0, 1, 2, 3, 4. Further, for example, the LDPC codes whose code length N of 16200 bits is divided into 45 (= 16200/360) bit groups: 0, 1, ..., 44. The LDPC whose code length N of 64800 bits is divided into 180 (= 64800/360) bit groups: 0, 1, ..., 179.

In the following, the GW pattern will be represented by a sequence of numbers representing the bit groups. For example, for the LDPC code whose code length N of 1800 bits, the GW pattern 4, 2, 0, 3, 1 represents that a sequence of the bit groups 0, 1, 2, 3, 4, is interleaved (changed) to a sequence of the bit groups 4, 2, 0, 3, 1.

The GW pattern can be set for, at least, each code length N of the LDPC code.

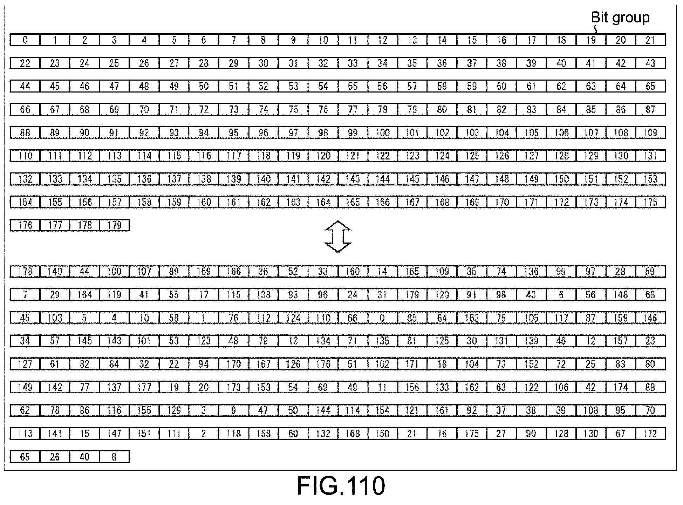

Fig. 110 is a diagram showing a first example of a GW pattern for the LDPC code whose code length N of 64k bits.

According to the GW pattern in Fig. 110, a sequence of the bit groups 0 to 179 having the LDPC code of 64k bits is interleaved to a sequence of a bit group of

178, 140, 44, 100, 107, 89, 169, 166, 36, 52, 33, 160, 14, 165, 109, 35, 74, 136, 99, 97, 28, 59, 7, 29, 164, 119, 41, 55, 17, 115, 138, 93, 96, 24, 31, 179, 120, 91, 98, 43, 6, 56, 148, 68, 45, 103, 5, 4, 10, 58, 1, 76, 112, 124, 110, 66, 0, 85, 64, 163, 75, 105, 117, 87, 159, 146, 34, 57, 145, 143, 101, 53, 123, 48, 79, 13, 134, 71, 135, 81, 125, 30, 131, 139, 46, 12, 157, 23, 127, 61, 82, 84, 32, 22, 94, 170, 167, 126, 176, 51, 102, 171, 18, 104, 73, 152, 72, 25, 83, 80, 149, 142, 77, 137, 177, 19, 20, 173, 153, 54, 69, 49, 11, 156, 133, 162, 63, 122, 106, 42, 174, 88, 62, 78, 86, 116, 155, 129, 3, 9, 47, 50, 144, 114, 154, 121, 161, 92, 37, 38, 39, 108, 95, 70, 113, 141, 15, 147, 151, 111, 2, 118, 158, 60, 132, 168, 150, 21, 16, 175, 27, 90, 128, 130, 67, 172, 65, 26, 40, 8.

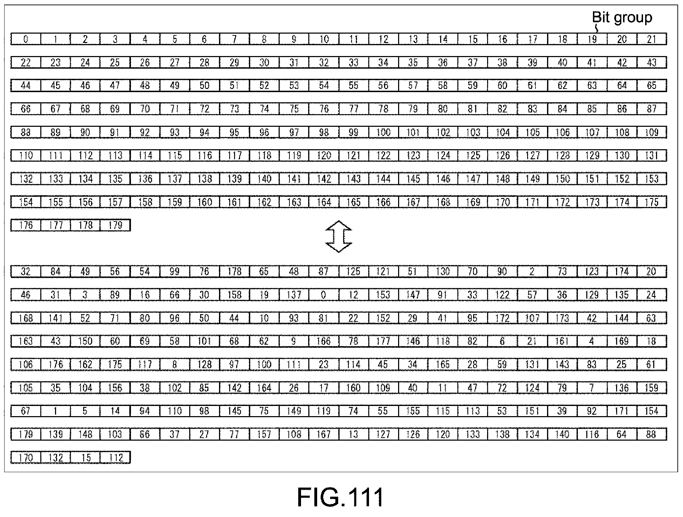

Fig. 111 is a diagram showing a second example of the GW pattern for the LDPC code whose code length N of 64k bits.

According to the GW pattern in Fig. 111, a sequence of the bit groups 0 to 179 having the LDPC code of 64k bits is interleaved to a sequence of a bit group of

32, 84, 49, 56, 54, 99, 76, 178, 65, 48, 87, 125, 121, 51, 130, 70, 90, 2, 73, 123, 174, 20, 46, 31, 3, 89, 16, 66, 30, 158, 19, 137, 0, 12, 153, 147, 91, 33, 122, 57, 36, 129, 135, 24, 168, 141, 52, 71, 80, 96, 50, 44, 10, 93, 81, 22, 152, 29, 41, 95, 172, 107, 173, 42, 144, 63, 163, 43, 150, 60, 69, 58, 101, 68, 62, 9, 166, 78, 177, 146, 118, 82, 6, 21, 161, 4, 169, 18, 106, 176, 162, 175, 117, 8, 128, 97, 100, 111, 23, 114, 45, 34, 165, 28, 59, 131, 143, 83, 25, 61, 105, 35, 104, 156, 38, 102, 85, 142, 164, 26, 17, 160, 109, 40, 11, 47, 72, 124, 79, 7, 136, 159, 67, 1, 5, 14, 94, 110, 98, 145, 75, 149, 119, 74, 55, 155, 115, 113, 53, 151, 39, 92, 171, 154, 179, 139, 148, 103, 86, 37, 27, 77, 157, 108, 167, 13, 127, 126, 120, 133, 138, 134, 140, 116, 64, 88, 170, 132, 15, 112.

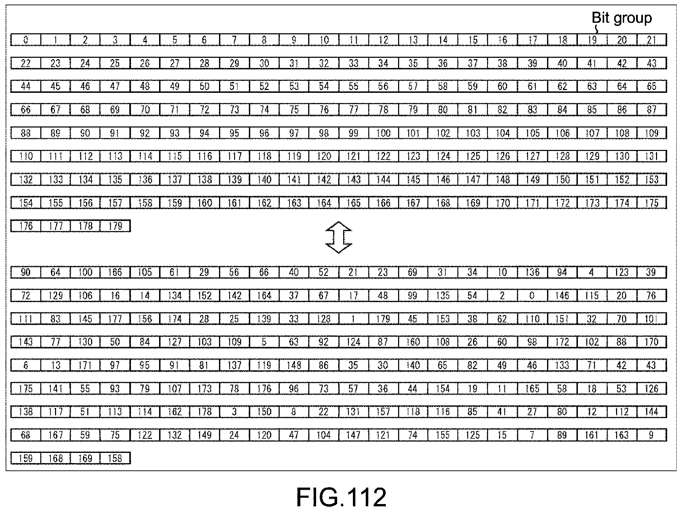

Fig. 112 is a diagram showing a third example of the GW pattern for the LDPC code whose code length N of 64k bits.

According to the GW pattern in Fig. 112, a sequence of the bit groups 0 to 179 having the LDPC code of 64k bits is interleaved to a sequence of a bit group of

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

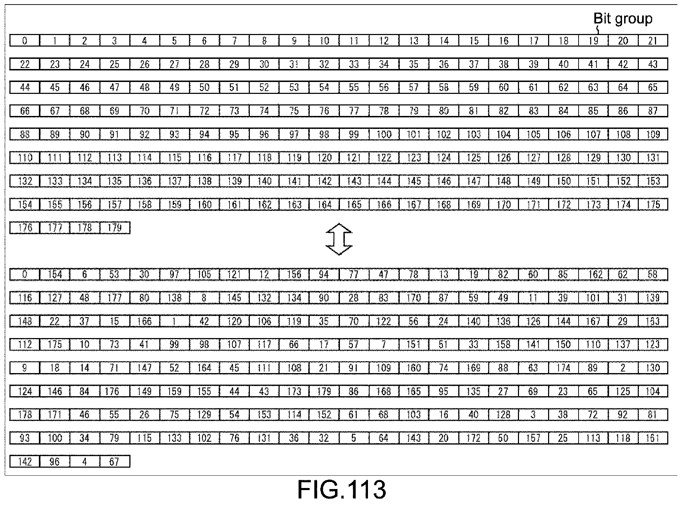

Fig. 113 is a diagram showing a fourth example of the GW pattern for the LDPC code whose code length N of 64k bits.

According to the GW pattern in Fig. 113, a sequence of the bit groups 0 to 179 having the LDPC code of 64k bits is interleaved to a sequence of a bit group of

0, 154, 6, 53, 30, 97, 105, 121, 12, 156, 94, 77, 47, 78, 13, 19, 82, 60, 85, 162, 62, 58, 116, 127, 48, 177, 80, 138, 8, 145, 132, 134, 90, 28, 83, 170, 87, 59, 49, 11, 39, 101, 31, 139, 148, 22, 37, 15, 166, 1, 42, 120, 106, 119, 35, 70, 122, 56, 24, 140, 136, 126, 144, 167, 29, 163, 112, 175, 10, 73, 41, 99, 98, 107, 117, 66, 17, 57, 7, 151, 51, 33, 158, 141, 150, 110, 137, 123, 9, 18, 14, 71, 147, 52, 164, 45, 111, 108, 21, 91, 109, 160, 74, 169, 88, 63, 174, 89, 2, 130, 124, 146, 84, 176, 149, 159, 155, 44, 43, 173, 179, 86, 168, 165, 95, 135, 27, 69, 23, 65, 125, 104, 178, 171, 46, 55, 26, 75, 129, 54, 153, 114, 152, 61, 68, 103, 16, 40, 128, 3, 38, 72, 92, 81, 93, 100, 34, 79, 115, 133, 102, 76, 131, 36, 32, 5, 64, 143, 20, 172, 50, 157, 25, 113, 118, 161, 142, 96, 4, 67.

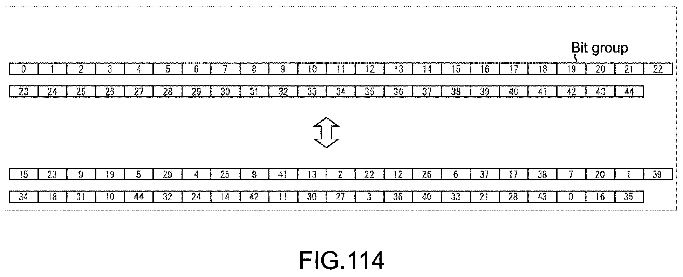

Fig. 114 is a diagram showing a first example of a GW pattern for the LDPC code whose code length N of 16k bits.

According to the GW pattern in Fig. 114, a sequence of the bit groups 0 to 44 having the LDPC code of 16k bits is interleaved to a sequence of a bit group of

15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

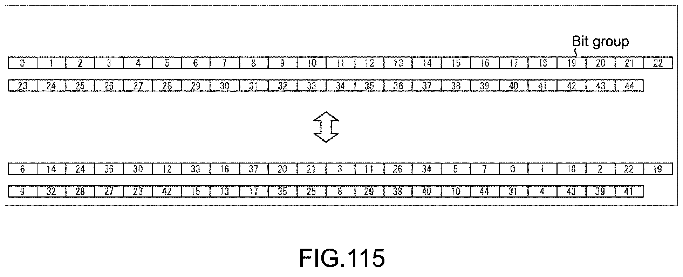

Fig. 115 is a diagram showing a second example of the GW pattern for the LDPC code whose code length N of 16k bits.

According to the GW pattern in Fig. 115, a sequence of the bit groups 0 to 44 having the LDPC code of 16k bits is interleaved to a sequence of a bit group of

6, 14, 24, 36, 30, 12, 33, 16, 37, 20, 21, 3, 11, 26, 34, 5, 7, 0, 1, 18, 2, 22, 19, 9, 32, 28, 27, 23, 42, 15, 13, 17, 35, 25, 8, 29, 38, 40, 10, 44, 31, 4, 43, 39, 41.

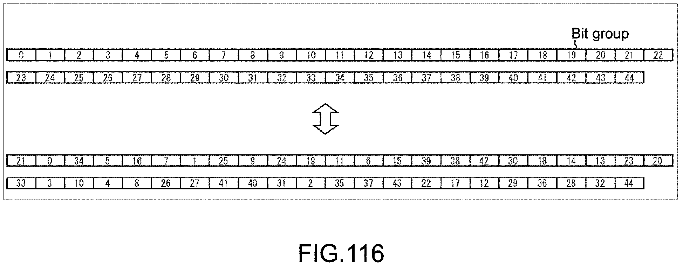

Fig. 116 is a diagram showing a third example of the GW pattern for the LDPC code whose code length N of 16k bits.

According to the GW pattern in Fig. 116, a sequence of the bit groups 0 to 44 having the LDPC code of 16k bits is interleaved to a sequence of a bit group of

21, 0, 34, 5, 16, 7, 1, 25, 9, 24, 19, 11, 6, 15, 39, 38, 42, 30, 18, 14, 13, 23, 20, 33, 3, 10, 4, 8, 26, 27, 41, 40, 31, 2, 35, 37, 43, 22, 17, 12, 29, 36, 28, 32, 44.

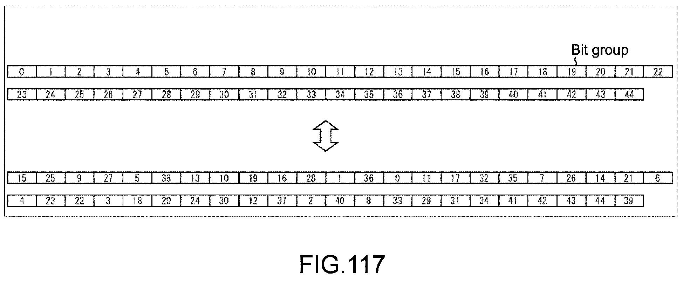

Fig. 117 is a diagram showing a fourth example of the GW pattern for the LDPC code whose code length N of 16k bits.

According to the GW pattern in Fig. 117, a sequence of the bit groups 0 to 44 having the LDPC code of 16k bits is interleaved to a sequence of a bit group of

15, 25, 9, 27, 5, 38, 13, 10, 19, 16, 28, 1, 36, 0, 11, 17, 32, 35, 7, 26, 14, 21, 6, 4, 23, 22, 3, 18, 20, 24, 30, 12, 37, 2, 40, 8, 33, 29, 31, 34, 41, 42, 43, 44, 39.

For the group-wise interleave, the GW pattern is set for each combination of the code rate r of the LDPC code and the modulation scheme other than the code length N of the LDPC code, thereby improving the bit error rate for each combination.

However, if the GW pattern is set individually for all combination of the code length N and code rate r is the LDPC code and the modulation scheme, the GW pattern should be changed every time the LDPC code and the modulation scheme used in the transmitting device 11 are changed. As a result, the processing becomes complex.

For the group-wise interleave, for example, the code rate r of the LDPC code is classified into a low rate (e.g., 6/15, 7/15, 8/15, 9/15) and a high rate (e. g., 10/15, 11/15, 12/15, 13/15). The GW pattern can be set for each combination of the code length N of the LDPC code of 16k bits or 64k bits, the code rate r of the LDPC code of the low rate or the high rate, and the modulation scheme of 16QAM, 64QAM, 256QAM or 1024QAM.

When the above-described combination of the code length N, the code rate r and the modulation scheme is expressed by (the code length N, the code rate r, the modulation scheme), 16 combinations of the code length N, the code rate r and the modulation scheme can be supposed: (16k, low rate, 16QAM), (16k, low rate, 64QAM), (16k, low rate, 256QAM), (16k, low rate, 1024QAM), (16k, high rate, 16QAM), (16k, high rate, 64QAM), (16k, high rate, 256QAM), (16k, high rate, 1024QAM), (64k, low rate, 16QAM), (64k, low rate, 64QAM), (64k, low rate, 256QAM), (64k, low rate, 1024QAM), (64k, high rate, 16QAM), (64k, high rate, 64QAM), (64k, high rate, 256QAM) and (64k, high rate, 1024QAM), for example.

For the combination of code length N of the LDPC code set to 64k: (64k, low rate, 16QAM), (64k, low rate, 64QAM), (64k, low rate, 256QAM), (64k, low rate, 1024QAM), (64k, high rate, 16QAM), (64k, high rate, 64QAM), (64k, high rate, 256QAM) and (64k, high rate, 1024QAM), the GW pattern that most improves the error rate can be applied among the four GW patterns shown in Fig. 110 to Fig. 113.

For example, the GW pattern in Fig. 110 can be applied to the combination (64k, high rate, 16QAM), the GW pattern in Fig. 111 can be applied to the combination (64k, low rate, 64QAM), the GW pattern in Fig. 112 can be applied to the combination (64k, high rate, 256QAM), the GW pattern in Fig. 113 can be applied to the combination (64k, low rate, 1024QAM), respectively.

For the combination of code length N of the LDPC code is set to 16k: (16k, low rate, 16QAM), (16k, low rate, 64QAM), (16k, low rate, 256QAM), (16k, low rate, 1024QAM), (16k, high rate, 16QAM), (16k, high rate, 64QAM), (16k, high rate, 256QAM) and (16k, high rate, 1024QAM), the GW pattern that most improves the error rate can be applied among the four GW patterns shown in Fig. 114 to Fig. 117.

For example, the GW pattern in Fig. 114 can be applied to the combination (16k, low rate, 16QAM), the GW pattern in Fig. 115 can be applied to the combination (16k, high-rate, 64QAM), the GW pattern in Fig. 116 can be applied to the combination (16k, low rate, the 256QAM), and the GW pattern in Fig. 117 can be applied to the combination (16k, high rate, in 1024QAM), respectively.

According to simulation by the present inventors, for the GW pattern in Fig. 110, it was confirmed that it is especially possible to achieve good error rate in the combination of each of the second new LDPC code of (64k, 10/15), the first new LDPC code of (64k, 11/15), the second new LDPC code of (64k, 12/15) and the first new LDPC code of (64k, 13/15) and the modulation scheme 16QAM of which the constellation is illustrated in Fig. 92 to Fig. 105.

For the GW pattern in Fig. 111, it was confirmed that it is especially possible to achieve good error rate in the combination of each of the second new LDPC code of (64k, 6/15), the first new LDPC code of (64k, 7/15), the second new LDPC code of (64k, 8/15) and the first new LDPC code of (64k, 9/15) and the modulation scheme 64QAM of which the constellation is illustrated in Fig. 92 to Fig. 105.

For the GW pattern in Fig. 112, it was confirmed that it is especially possible to achieve good error rate in the combination of each of the second new LDPC code of (64k, 10/15), the first new LDPC code of (64k, 11/15), the second new LDPC code of (64k, 12/15) and the first new LDPC code of (64k, 13/15) and the modulation scheme 256QAM of which the constellation is illustrated in Fig. 92 to Fig. 105.

For the GW pattern in Fig. 113, it was confirmed that it is especially possible to achieve good error rate in the combination of each of the second new LDPC code of (64k, 6/15), the first new LDPC code of (64k, 7/15), the second new LDPC code of (64k, 8/15) and the first new LDPC code of (64k, 9/15) and the modulation scheme 1024QAM of which the constellation is illustrated in Fig. 92 to Fig. 105.

For the GW pattern in Fig. 114, it was confirmed that it is especially possible to achieve good error rate in the combination of each of the first new LDPC code of (16k, 6/15), the second new LDPC code of (16k, 7/15), the first new LDPC code of (16k, 8/15) and the second new LDPC code of (16k, 9/15) and the modulation scheme 16QAM of which the constellation is illustrated in Fig. 92 to Fig. 105.

For the GW pattern in Fig. 115, it was confirmed that it is especially possible to achieve good error rate in the combination of each of the first new LDPC code of (16k, 10/15), the second new LDPC code of (16k, 11/15), the first new LDPC code of (16k, 12/15) and the second new LDPC code of (16k, 13/15) and the modulation scheme 64QAM of which the constellation is illustrated in Fig. 92 to Fig. 105.

For the GW pattern in Fig. 116, it was confirmed that it is especially possible to achieve good error rate in the combination of each of the first new LDPC code of (16k, 6/15), the second new LDPC code of (16k, 7/15), the first new LDPC code of (16k, 8/15) and the second new LDPC code of (16k, 9/15) and the modulation scheme 256QAM of which the constellation is illustrated in Fig. 92 to Fig. 105.

For the GW pattern in Fig. 117, it was confirmed that it is especially possible to achieve good error rate in the combination of each of the first new LDPC code of (16k, 10/15), the second new LDPC code of (16k, 11/15), the first new LDPC code of (16k, 12/15) and the second new LDPC code of (16k, 13/15) and the modulation scheme 1024QAM of which the constellation is illustrated in Fig. 92 to Fig. 105.

<Configuration Example of Receiving Apparatus 12>

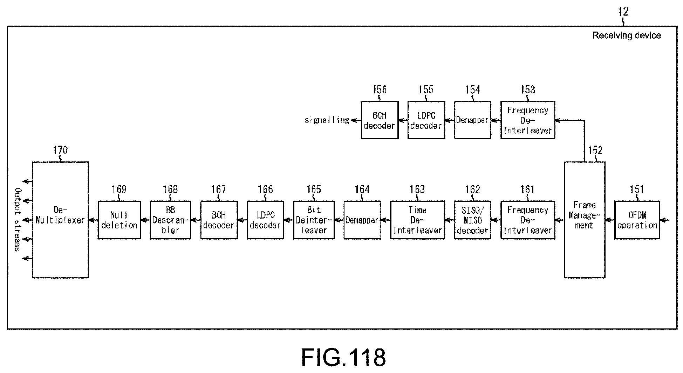

Fig. 118 is a block diagram showing a configuration example of the receiving device 12 in Fig. 7.

An OFDM operation 151 receives the OFDM signal from the transmitting device 11 (Fig. 7) and performs signal processing of the OFDM signal. The data obtained by the signal processing by the OFDM operation 151 is supplied to a frame management 152.

The frame management 152 performs processing of the frame (frame interpretation) configured of the data supplied from the OFDM operation 151 and supplies the signal of the target data and the signal of the control data obtained as a result to frequency deinterleavers 161 and 153.

The frequency deinterleaver 153 performs frequency deinterleave in a symbol unit for the data from the frame management 152 to supply to a demapper 154.

The demapper 154 demaps (performs signal point constellation decoding) the data (data on the constellation) from the frequency deinterleaver 153 based on the signal arrangement (constellation) determined by the orthogonal modulation performed at the transmitting device 11 to perform the orthogonal demodulation thereof and supplies the data ((likelihood) of the LDPC code) obtained as a result to a LDPC decoder 155.

The LDPC decoder 155 performs LDPC decoding of the LDPC code from the demapper 154 and supplies the LDPC target data (herein, a BCH code) obtained as a result to a BCH decoder 156.

The BCH decoder 156 performs BCH decoding of the LDPC target data from the LDPC decoder 155 and outputs the control data (signaling) obtained as a result.

On the other hand, the frequency deinterleaver 161 performs the frequency deinterleave in a symbol unit for the data from the frame management 152 to supply to a SISO/MISO decoder 162.

The SISO/MISO decoder 162 performs time-space decoding of the data from the frequency deinterleaver 161 to supply to a time deinterleaver 163.

The time deinterleaver 163 performs time deinterleave of the data from the SISO/MISO decoder 162 in a symbol unit to supply to a demapper 164.

The demapper 164 demaps (performs signal point constellation decoding) the data (data on the constellation) from the time deinterleaver 163 based on the signal point arrangement (constellation) determined by the orthogonal modulation performed at the transmitting device 11 to perform the orthogonal demodulation thereof and supplies the data obtained as a result to a bit deinterleaver 165.

The bit deinterleaver 165 performs bit deinterleave of the data from the demapper 164 and supplies (the likelihood of) the LDPC code obtained as a result to an LDPC decoder 166.

The LDPC decoder 166 performs the LDPC decoding of the LDPC code from the bit deinterleaver 165 and supplies the LDPC target data (herein, the BCH code) obtained as a result to a BCH decoder 167.

The BCH decoder 167 performs the BCH decoding of the LDPC target data from the LDPC decoder 155 and supplies the data obtained as a result to a BB descrambler 168.

The BB descrambler 168 applies a BB descramble to the data from the BCH decoder 167 and supplies the data obtained as a result to a null deletion 169.

The null deletion 169 deletes the null inserted by the padder 112 in Fig. 8 from the data from the BB descrambler 168 and supplies the same to a demultiplexer 170.

The demultiplexer 170 separates one or more streams (target data) multiplexed into the data from the null deletion 169 and outputs the same as output streams.

The receiving device 12 may be configured without including some of the blocks shown in Fig. 48. In other words, if the transmitting device 11 (Fig. 8) is configured without including the time interleaver 118, the SISO/MISO encoder 119, the frequency interleaver 120, and frequency interleaver 124, for example, the receiving device 12 may be configured without including the time deinterleaver 163, the SISO/MISO decoder 162, the frequency deinterleaver 161, and frequency deinterleaver 153 that are the blocks corresponding to the time interleaver 118, the SISO/MISO encoder 119, the frequency interleaver 120, and frequency interleaver 124 of the transmitting device 11, respectively.

<Configuration Example of Bit Deinterleaver>

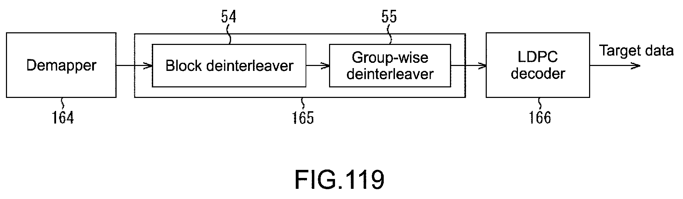

Fig. 119 is a block diagram showing a configuration example of the bit deinterleaver 165 in Fig. 118.

The bit deinterleaver 165 configured of a block deinterleaver 54 and a group-wise deinterleaver 55 and performs the (bit) deinterleave of the symbol bit of the data from the demapper 164 (Fig. 118).

That is to say, the block deinterleaver 54 performs a block deinterleave (an inverse process of block interleave) corresponding to the block interleave performed by the block interleaver 25 in Fig. 9, that is to say, the block deinterleave to return the positions of (the likelihood of) the code bits of the LDPC code interchanged by the block interleave to the original positions to the symbol bit of the symbol from the demapper 164 and supplies the LDPC code obtained as a result to the group-wise deinterleaver 55.

The group-wise deinterleaver 55 performs group-wise deinterleave (inverse process of the group-wise interleave) corresponding to the group-wise interleave performed by the group-wise interleaver 24 in Fig. 9, that is to say, the group-wise deinterleave to return the code bits of the LDPC code of which arrangement is changed by the group-wise interleave illustrated in Fig. 110 to Fig. 117 in a bit group unit are rearranged in a bit group unit to the original arrangement to the LDPC code from the block deinterleaver 54.

If the parity interleave, the group-wise interleave, and the block interleave are applied to the LDPC code supplied from the demapper 164 to the bit deinterleaver 165, the bit deinterleaver 165 may perform all of parity deinterleave (inverse process of the parity interleave, that is to say, the parity deinterleave to return the code bits of the LDPC code, the arrangement of which is changed by the parity interleave, to the original arrangement) corresponding to the parity interleave, the block deinterleave corresponding to the block interleave, and the group-wise deinterleave corresponding to the group-wise interleave.

Note that the bit deinterleaver 165 in Fig. 119 includes the block deinterleaver 54 that performs the block deinterleave corresponding to the block interleave, and the group-wise deinterleaver 55 that performs the group-wise deinterleave corresponding to the group-wise interleave, but includes no block for performing the parity deinterleave corresponding to the parity interleave, and the parity deinterleave is not performed.

Therefore, the LDPC code, to which the block deinterleave and the group-wise deinterleave are applied and the parity deinterleave is not applied, is supplied from (the group-wise deinterleaver 55 of) the bit deinterleaver 165 to the LDPC decoder 166.

The LDPC decoder 166 performs the LDPC decoding of the LDPC code from the bit deinterleaver 165 using the conversion parity check matrix obtained by at least applying the column permutation corresponding to the parity interleave to the parity check matrix H used by the LDPC encoder 115 in Fig. 8 in the LDPC encoding and outputs the data obtained as a result as a decoding result of the LDPC target data.

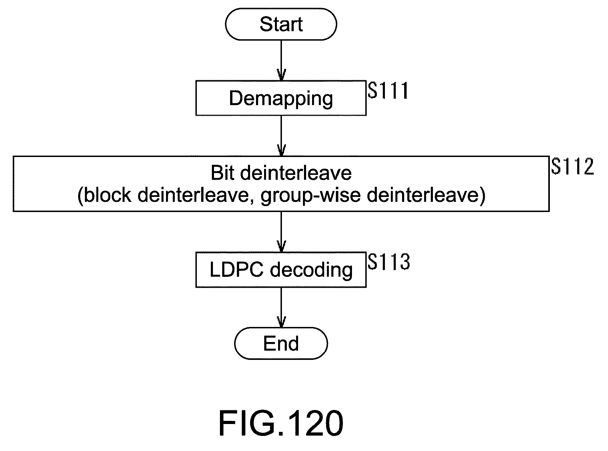

Fig. 120 is a flowchart illustrating processes performed by the demapper 164, the bit deinterleaver 165, and the LDPC decoder 166 in Fig. 119.

At step S111, the demapper 164 demaps the data from the time deinterleaver 163 (data mapped onto the signal point on the constellation) to perform the orthogonal demodulation and supplies the same to the bit deinterleaver 165, then the process shifts to S112.

At step S112, the bit deinterleaver 165 performs the deinterleave (bit deinterleave) from the demapper 164 and the process shifts to step S113.

That is to say, at step S112, the block deinterleaver 54 performs in the bit deinterleaver 165 the block deinterleave of the data (symbol) from the demapper 164 and supplies the code bit of the LDPC code obtained as a result to the group-wise deinterleaver 55.

The group-wise deinterleaver 55 performs the group-wise deinterleave to the LDPC code from the block deinterleaver 54 and supplies (the likelihood of) the LDPC code obtained as a result to the LDPC decoder 166.

At step S113, the LDPC decoder 166 performs the LDPC decoding of the LDPC code from the group-wise deinterleaver 55 using the conversion parity check matrix H used by the LDPC encoder 115 in Fig. 8 in the LDPC encoding, i.e., using the conversion parity check matrix obtained by at least applying the column permutation corresponding to the parity interleave to the parity check matrix H and outputs the data obtained as a result to the BCH decoder 167 as the decoding result of the LDPC target data.

Although the block deinterleaver 54, which performs the block deinterleave, and the group-wise deinterleaver 55, which performs the group-wise deinterleave, are separately formed also in Fig. 119 as in Fig. 9 for convenience of description, the block deinterleaver 54 and the group-wise deinterleaver 55 may be integrally formed.

<LDPC decoding>

The LDPC decoding performed by the LDPC decoder 166 in Fig. 188 is further described.

The LDPC decoder 166 in Fig. 118 performs the LDPC decoding of the LDPC code to which the block deinterleave and the group-wide deinterleave are applied and the parity interleave is not applied from the group-wise deinterleaver 55 using the conversion parity check matrix obtained by at least applying the column permutation corresponding to the parity interleave to the parity check matrix H used by the LDPC encoder 115 in Fig. 8 in the LDPC encoding as described above.

Herein, the LDPC decoding capable of limiting an operation frequency within a sufficiently feasible range while limiting a circuit size by performing the LDPC decoding using the conversion parity check matrix is conventionally suggested (refer to Patent No. 4224777, for example).

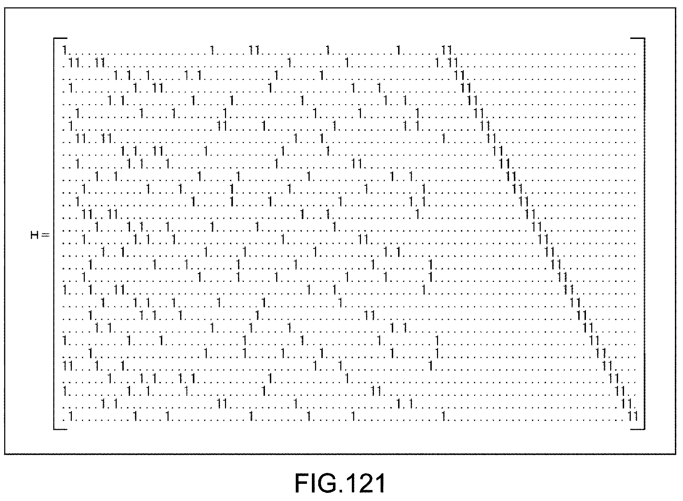

Firstly, the LDPC decoding using the conversion parity check matrix conventionally suggested is first described with reference to Fig. 121 to Fig. 124.

Fig. 121 illustrates an example of the parity check matrix H of the LDPC code whose code length N is 90 and code rate is 2/3.

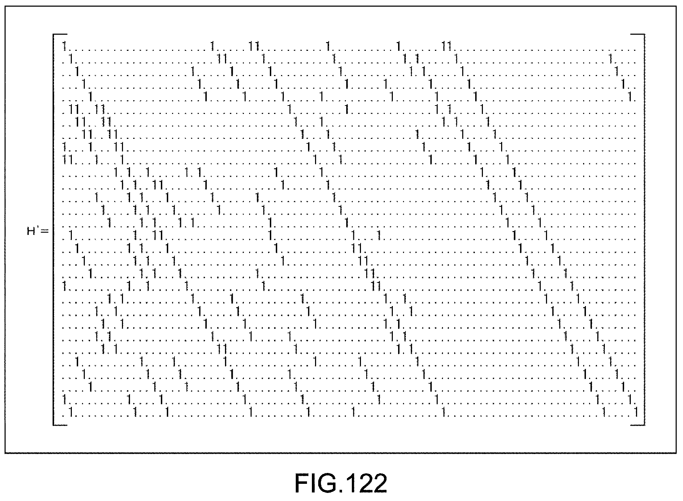

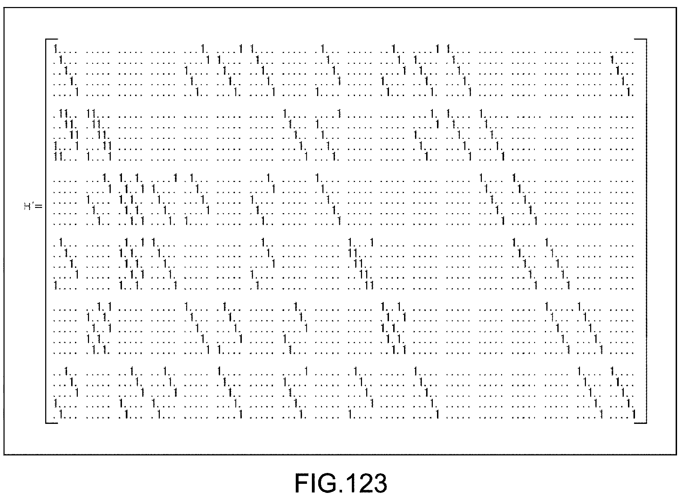

In Fig. 121 (also in Fig. 122 and Fig. 123 to be described later), 0 is represented by a period (.).

In the parity check matrix H in Fig. 121, the parity matrix has the stepwise structure.

Fig. 122 illustrates a parity check matrix H' obtained by applying the row permutation in equation (11) and the column permutation in equation (12) to the parity check matrix H in Fig. 121.

```
Row permutation: 6s + t + first row -> t + s + first

row   (11)
```

```
Column permutation: 6x + y + 61th row -> 5y + x + 61th

row   (12)
```

In equations (11) and (12), s, t, x, and y are integers within a range satisfying $0 \leq s < 5$, $0 \leq t < 6$, $0 \leq x < 5$, and $0 \leq t < 6$, respectively.

According to the row permutation in equation (11), it is permutated such that 1st, 7th, 13th, 19th, and 25th rows, which leave a remainder of 1 when divided by 6, are made 1st, 2nd, 3rd, 4th, and 5th rows, and 2nd, 8th, 14th, 20th, and 26th rows, which leave a remainder of 2 when divided by 6, are made 6th, 7th, 8th, 9th, and 10th rows, respectively.

Also, according to the column permutation in equation (12), it is permutated such that 61st, 67th, 73rd, 79th, and 85th columns, which leave a remainder of 1 when divided by 6, are made 61st, 62nd, 63rd, 64th, and 65th columns, and 62nd, 68th, 74th, 80th, and 86th columns, which leave a remainder of 2 when divided by 6, are made 66th, 67th, 68th, 69th, and 70th columns, respectively, for the 61st and subsequent columns (parity matrix).

The matrix obtained by performing the row permutation and the column permutation of the parity check matrix H in Fig. 121 in this manner is the parity check matrix H' in Fig. 1222.

Herein, the row permutation of the parity check matrix H does not affect the arrangement of the code bits of the LDPC code.

The column permutation in equation (12) corresponds to the parity interleave when the information length K, the number of columns P being the unit of the cyclic structure, and the submultiple q (= M/P) of the parity length M (herein, 30) of the above-described parity interleave to interleave the K + qx + y + 1-th code bit to the position of the K + Py + x + 1-th code bit are set to 60, 5, and 6, respectively.

Accordingly, the parity check matrix H' in Fig. 122 is the conversion parity check matrix obtained by at least applying the column permutation that the K + qx + y + 1-th column is permutated with the K + Py + x + 1-th column of the parity check matrix H in Fig. 121 (hereinafter, appropriately referred to as the original parity check matrix).

By multiplying the parity check matrix H' in Fig. 122 by the LDPC code of the parity check matrix H in Fig. 121 to which the same permutation as equation (12) is applied, a 0 vector is output. That is to say, when a row vector obtained by applying the column permutation in equation (12) to the row vector c as the LDPC code (one code word) of the original parity check matrix H is represented as c', $Hc^T$ becomes the 0 vector from the nature of the parity check matrix, so that $H'c'^T$ naturally becomes the 0 vector.

From above, the conversion parity check matrix H' in Fig. 122 is the parity check matrix of the LDPC code c' obtained by applying the column permutation in equation (12) to the LDPC code c of the original parity check matrix H.

Therefore, by applying the column permutation in equation (12) to the LDPC code c of the original parity check matrix H, decoding (LDPC decoding) the LDPC code c' after the column permutation using the conversion parity check matrix H' in Fig. 122, and applying inverse permutation in the column permutation in equation (12) to the decoding result, it is possible to obtain the decoding result similar to that in a case in which the LDPC code of the original parity check matrix H is decoded using the parity check matrix H.

Fig. 123 shows the conversion parity check matrix H' in Fig. 122 with an interval between the units of $5 \times 5$ matrix.

In Fig. 123, the conversion parity check matrix H' is represented by a combination of the $5 \times 5$ (= P x P) unit matrix, a matrix in which one or more 1 of the unit matrix is set to 0 (hereinafter, appropriately referred to as a quasi-unit matrix), a matrix obtained by the cyclic shift of the unit matrix or the quasi-unit matrix (hereinafter, appropriately referred to as a shift matrix), a sum of two or more of the unit matrix, the quasi-unit matrix, and the shift matrix (hereinafter, appropriately referred to as a sum matrix), and a $5 \times 5$ 0 matrix.

It may be said that the conversion parity check matrix H' in Fig. 123 is configured of the $5 \times 5$ unit matrix, quasi-unit matrix, shift matrix, sum matrix, and 0 matrix. Therefore, the $5 \times 5$ matrices (the unit matrix, the quasi-unit matrix, the shift matrix, the sum matrix, and the 0 matrix) constitute the conversion parity check matrix H' are hereinafter appropriately referred to as constitutive matrices.

An architecture to simultaneously perform P check node operations and P variable node operations may be used to decode the LDPC code of the parity check matrix represented by a $P \times P$ constitutive matrix.

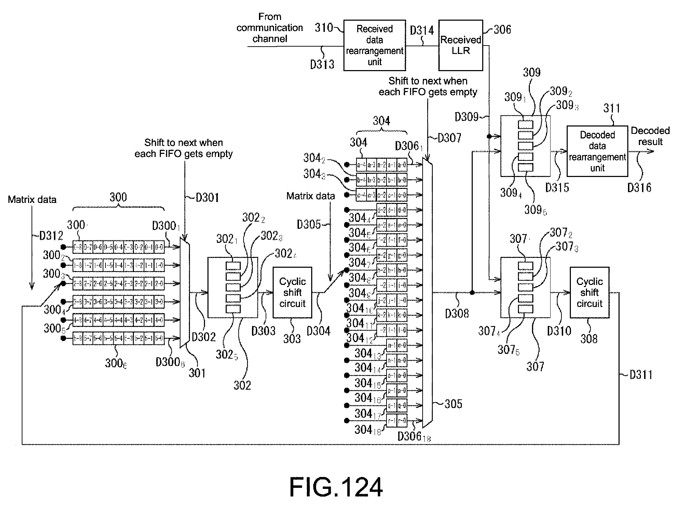

Fig. 124 is a block diagram showing a configuration example of the decoding device, which performs such decoding.

That is to say, Fig. 124 shows the configuration example of the decoding device, which decodes the LDPC code using the conversion parity check matrix H' in Fig. 123 obtained by at least applying the column permutation in equation (12) to the original parity check matrix H in Fig. 121.

The decoding device in Fig. 124 is configured of an edge data storage memory 300 configured of 6 FIFOs $300_1$ to $300_6$, a selector 301, which selects from the FIFOs $300_1$ to $300_6$, a check node calculation unit 302, two cyclic shift circuits 303 and 308, an edge data storage memory 304 configured of 18 FIFOs $304_1$ to $304_{18}$, a selector 305, which selects from the FIFOs $304_1$ to $304_{18}$, a received data memory 306, which stores received data, a variable node calculation unit 307, a decoded word calculation unit 309, a received data rearrangement unit 310, and a decoded data rearrangement unit 311.

A method of storing the data in the edge data storage memories 300 and 304 is first described.

The edge data storage memory 300 is configured of six FIFOs $300_1$ to $300_6$, the number of which is obtained by dividing the number of rows 30 of the conversion parity check matrix H' in Fig. 123 by the number of rows (the number of columns P being the unit of the cyclic structure) 5 of the constitutive matrix. The FIFOs 300y (y = 1, 2, ..., 6) are formed of a plurality of stages of storage regions and messages corresponding to five edges, the number of which is equal to the number of rows and the number of columns of the constitutive matrix (the number of columns P being the unit of the cyclic structure), may be read and written at the same time from and to the storage region of each stage. The number of stages of the storage regions of the FIFO 300y is set to nine being a maximum number of 1 in the row direction of the conversion parity check matrix in Fig. 123 (Hamming weight).

The data corresponding to the position of 1 from first to fifth rows of the conversion parity check matrix H' in Fig. 123 (a message $v_i$ from the variable node) is stored in the FIFO $300_1$ in a form closed up in a horizontal direction for each row (ignoring 0). That is to say, when the j-th row i-th column is represented as (j, i), the data corresponding to the position of 1 of the $5 \times 5$ unit matrix from (1, 1) to (5, 5) of the conversion parity check matrix H' is stored in the storage region of a first stage of the FIFO $300_1$. The data corresponding to the position of 1 of the shift matrix from (1, 21) to (5, 25) of the conversion parity check matrix H' (shift matrix obtained by the cyclic shift of the $5 \times 5$ unit matrix by three rightward) is stored in the storage region of a second stage. The data is similarly stored in the storage regions of third to eighth stages in association with the conversion parity check matrix H'. Then, the data corresponding to the position of 1 of the shift matrix (shift matrix obtained by replacement of 1 in the first row of the 5 × 5 unit matrix with 0 and the cyclic shift thereof by one leftward) from (1, 86) to (5, 90) of the conversion parity check matrix H' is stored in the storage region of a ninth stage.

The data corresponding to the position of 1 from 6th to 10th rows of the conversion parity check matrix H' in Fig. 123 is stored in the FIFO $300_2$. That is to say, the data corresponding to the position of 1 of a first shift matrix configuring the sum matrix from (6, 1) to (10, 5) of the conversion parity check matrix H' (the sum matrix obtained by summing the first shift matrix obtained by the cyclic shift of the 5 × 5 unit matrix by one rightward and a second shift matrix obtained by the cyclic shift thereof by two rightward) is stored in the storage region of a first stage of the FIFO $300_2$. The data corresponding to the position of 1 of the second shift matrix configuring the sum matrix from (6, 1) to (10, 5) of the conversion parity check matrix H' is stored in the storage region of a second stage.

That is to say, as for the constitutive matrix whose weight is 2 or larger, the data corresponding to the position of 1 of the unit matrix, the quasi-unit matrix, and the shift matrix whose weight is 1 (message corresponding to the edge belonging to the unit matrix, the quasi-unit matrix, or the shift matrix) when the constitutive matrix is represented as the sum of a plurality of the P × P unit matrix whose weight is 1, the quasi-unit matrix in which one or more of the elements 1 of the unit matrix is set to 0, and the shift matrix obtained by the cyclic shift of the unit matrix or the quasi-unit matrix is stored in the same address (same FIFO out of the FIFOs $300_1$ to $300_6$).

The data is hereinafter stored in association with the conversion parity check matrix H' also in the storage regions of third to ninth stages.

The data is stored in association with the conversion parity check matrix H' also in the FIFOs $300_3$ to $300_6$.

The edge data storage memory 304 is configured of 18 FIFOs $304_1$ to $304_{18}$, the number of which is obtained by dividing the number of columns 90 of the conversion parity check matrix H' by the number of columns 5 of the constitutive matrix (the number of columns P being the unit of the cyclic structure). The FIFO 304x (x = 1, 2, ..., 18) is formed of a plurality of stages of storage regions, and the messages corresponding to the five edges, the number of which is the number of rows and the number of columns of the constitutive matrix (the number of columns P being the unit of the cyclic structure) may be simultaneously read and written from and to the storage region of each stage.

In the FIFO $304_1$, the data corresponding to the position of 1 from first to fifth columns of the conversion parity check matrix H' in Fig. 123 (message $u_j$ from the check node) is stored in a form closed up in a vertical direction for each column (ignoring 0). That is to say, the data corresponding to the position of 1 of the 5 × 5 unit matrix from (1, 1) to (5, 5) of the conversion parity check matrix H' is stored in the storage region of a first stage of the FIFO $304_1$. The data corresponding to the position of 1 of the first shift matrix configuring the sum matrix from (6, 1) to (10, 5) of the conversion parity check matrix H' (the sum matrix obtained by summing the first shift matrix obtained by the cyclic shift of the 5 × 5 unit matrix by one rightward and the second shift matrix obtained by the cyclic shift thereof by two rightward) is stored in the storage region of the second stage. The data corresponding to the position of 1 of a second shift matrix configuring the sum matrix from (6, 1) to (10, 5) of the conversion parity check matrix H' is stored in the storage region of a third stage.

That is to say, as for the constitutive matrix whose weight is 2 or larger, the data corresponding to the position of 1 of the unit matrix, the quasi-unit matrix, and the shift matrix whose weight is 1 (the message corresponding to the edge belonging to the unit matrix, the quasi-unit matrix, or the shift matrix) when the constitutive matrix is represented as the sum of a plurality of the P × P unit matrix whose weight is 1, the quasi-unit matrix in which one or more of the elements 1 of the unit matrix is set to 0, and the shift matrix obtained by the cyclic shift of the unit matrix or the quasi-unit matrix is stored in the same address (same FIFO out of the FIFOs $304_1$ to $304_{18}$).

Hereinafter, the data is stored in the storage regions of fourth and fifth stages in association with the conversion parity check matrix H'. The number of stages of the storage regions of the FIFO $304_1$ is five being the maximum number of the number of 1 in the row direction from the first to fifth columns of the conversion parity check matrix H' (Hamming weight).

The data is similarly stored in association with the conversion parity check matrix H' in the FIFOs $304_2$ and $304_3$, the length (the number of stages) of which is five. The data is similarly stored in association with the conversion parity check matrix H' in the FIFOs $304_4$ to $304_{18}$, the length of which is three. The data is similarly stored in association with the conversion parity check matrix H' in the FIFOs $304_{13}$ to $304_{18}$, the length of which is two.

Next, operation of the decoding device in Fig. 124 is described.

The edge data storage memory 300 is configured of the six FIFOs $300_1$ to $300_6$, selects the FIFO in which the data is stored from the FIFOs $300_1$ to $300_6$ according to information (matrix data) D312 indicating the row of the conversion parity check matrix H' in Fig. 123 to which five messages D311 supplied from the cyclic shift circuit 308 in a preceding stage belong, and collectively stores the five messages D311 in the selected FIFO in sequence. When reading the data, the edge data storage memory 300 reads five messages $D300_1$ from the FIFO $300_1$ in sequence to supply to the selector 301 in a subsequent stage. The edge data storage memory 300 reads the message also from the FIFOs $300_2$ to $300_6$ in sequence after finishing reading the message from the FIFO $300_1$ to supply to the selector 301.

The selector 301 selects the five messages from the FIFO from which the data is currently read out of the FIFOs $300_1$ to $300_6$ according to a select signal D301 and supplies the same as a message D302 to the check node calculation unit 302.

The check node calculation unit 302 configured of five check node calculators $302_1$ to $302_5$ performs the check node operation according to equation (7) using the messages D302 ($D302_1$ to $D302_5$) supplied through the selector 301 (message $v_i$ in equation (7)) and supplies five messages D303 ($D303_1$ to $D303_5$) obtained as a result of the check node operation (message $u_j$ in equation (7)) to the cyclic shift circuit 303.

The cyclic shift circuit 303 performs the cyclic shift of the five messages $D303_1$ to $D303_5$ obtained by the check node calculation unit 302 based on information (matrix data) D305 indicating the value by which the cyclic shift of the original unit matrix (or the quasi-unit matrix) in the conversion parity check matrix H' is performed to obtain the corresponding edge and supplies a result to the edge data storage memory 304 as a message D304.

The edge data storage memory 304 is configured of 18 FIFOs $304_1$ to $304_{18}$, selects the FIFO in which the data is stored from the FIFOs $304_1$ to $304_{18}$ according to the information D305 indicating the row of the conversion parity check matrix H' to which the five messages D304 supplied from the cyclic shift circuit 303 in the preceding stage belongs, and collectively stores the five messages D304 in the selected FIFO in sequence. When reading the data, the edge data storage memory 304 reads the five messages $D306_1$ in sequence from the FIFO $304_1$ to supply to the selector 305 in the subsequent stage. The edge data storage memory 304 reads the message in sequence also from the FIFOs $304_2$ to $304_{18}$ after finishing reading the data from the FIFO $304_1$ to supply to the selector 305.

The selector 305 selects the five messages from the FIFO from which the data is currently read out of the FIFOs $304_1$ to $304_{18}$ according to a select signal D307 and supplies the same to the variable node calculation unit 307 and the decoded word calculation unit 309 as a message D308.

On the other hand, the received data rearrangement unit 310 rearranges an LDPC code D313 received through the communication channel 13 corresponding to the parity check matrix H in Fig. 121 by the column permutation in equation (12) and supplies the same to the received data memory 306 as received data D314. The received data memory 306 calculates a received LLR (log likelihood ratio) from the received data D314 supplied from the received data rearrangement unit 310 to store and collectively supplies the five received LLRs to the variable node calculation unit 307 and the decoded word calculation unit 309 as received value D309.

The variable node calculation unit 307 is configured of five variable node calculators $307_1$ to $307_5$, performs the variable node operation according to equation (1) using the messages D308 ($D308_1$ to $D308_5$) supplied through the selector 305 (message $u_j$ in equation (1) and the five received values D309 supplied from the received data memory 306 (received value $u_{0i}$ in equation (1)) and supplies messages D310 ($D310_1$ to $D310_5$) obtained as a result of the operation (message $v_i$ in equation (1)) to the cyclic shift circuit 308.

The cyclic shift circuit 308 performs the cyclic shift of the messages $D310_1$ to $D310_5$ calculated by the variable node calculation unit 307 based on the information indicating the value by which the cyclic shift of the original unit matrix (or the quasi-unit matrix) in the conversion parity check matrix H' is performed to obtain the corresponding edge and supplies a result to the edge data storage memory 300 as a message D311.

Single decoding (variable node operation and check node operation) of the LDPC code may be performed by single round of the above-described operation. The decoding device in Fig. 124 decodes the LDPC code a predetermined number of times, and then obtains a final decoding result by the decoded word calculation unit 309 and the decoded data rearrangement unit 311 to output.

That is to say, the decoded word calculation unit 309 is configured of five decoded word calculators $309_1$ to $309_5$, calculates the decoding result (decoded word) based on equation (5) as a final stage of a plurality of times of decoding using the five messages D308 ($D308_1$ to $D308_5$) (message $u_j$ in equation (5)) output by the selector 305 and the five received values D309 (received value $u_{0i}$ in equation (5)) supplied from the received data memory 306, and supplies decoded data D315 obtained as a result to the decoded data rearrangement unit 311.

The decoded data rearrangement unit 311 applies the inverse permutation of the column permutation in equation (12) to the decoded data D315 supplied from the decoded word calculation unit 309, thereby rearranging an order thereof and outputs the same as a final decoded result D316.

As described above, by applying any one or both of the row permutation and the column permutation to the parity check matrix (original parity check matrix) and converting the same to the parity check matrix (conversion parity check matrix) represented by the combination of the $P \times P$ unit matrix, the quasi-unit matrix in which one or more of the elements of 1 of the unit matrix is set to 0, the shift matrix obtained by the cyclic shift of the unit matrix or the quasi-unit matrix, the sum matrix obtained by summing a plurality of the unit matrix, the quasi-unit matrix, and the shift matrix, and the $P \times P$ 0 matrix, that is to say, the combination of the constitutive matrices, it becomes possible to adopt the architecture to simultaneously perform the P check node operations and the P variable node operations as the decoding of the LDPC code where P is fewer than the numbers of the columns and rows in the parity. When it adopts the architecture to simultaneously perform the P check node operations and the P variable node operations as the decoding of the LDPC code where P is fewer than the numbers of the columns and rows in the parity check matrix, the operation frequency may be limited within the feasible range to perform a great number of times of repetitive decoding, as compared to a case that the node operations are performed at the same time for the same numbers of the numbers of the columns and rows in the parity check matrix.

The LDPC decoder 166, which configures the receiving device 12 in Fig. 118, performs the LDPC decoding by simultaneously performing the P check node operations and the P variable node operations as is the case with the decoding device in Fig. 124.

That is to say, in order to simplify the description, supposing that the parity check matrix of the LDPC code output by the LDPC encoder 115 configuring the transmitting device 11 in Fig. 8 is the parity check matrix H in which the parity matrix has the stepwise structure illustrated in Fig. 121, for example, the parity interleaver 23 of the transmitting device 11 performs the parity interleave to interleave the K + qx + y + 1-th code bit to the position of the K + Py + $\times$ + 1-th code bit by setting the information length K, the number of columns being the unit of the cyclic structure, and the submultiple q (= M/P) of the parity length M to 60, 5, and 6, respectively.

The parity interleave corresponds to the column permutation in equation (12) as described above, so that the LDPC decoder 166 is not required to perform the column permutation in equation (12).

Therefore, in the receiving device 12 in Fig. 118, as described above, the LDPC code to which the parity deinterleave is not applied, that is to say, the LDPC code in a state in which the column permutation in equation (12) is performed is supplied from the column twist deinterleaver 55 to the LDPC decoder 166, and the LDPC decoder 166 performs the process similar to that of the decoding device in Fig. 124 except that this does not perform the column permutation in equation (12).

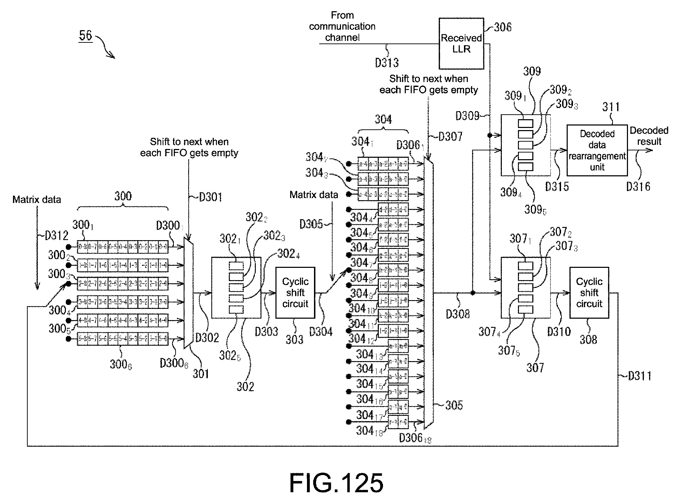

That is to say, Fig. 125 shows a configuration example of the LDPC decoder 166 in Fig. 118.

In Fig. 125, the LDPC decoder 166 is configured as the decoding device in Fig. 124 except that the received data rearrangement unit 310 in Fig. 124 is not provided, and this performs the process similar to that of the decoding device in Fig. 124 except that the column permutation in equation (12) is not performed, so that the description thereof is omitted.

As described above, the LDPC decoder 166 may be configured without the received data rearrangement unit 310, so that a scale thereof may be made smaller than that of the decoding device in Fig. 124.

Although the code length N in the LDPC code, the information length K, the number of columns (the number of rows and the number of columns of the constitutive matrix) being the unit of the cyclic structure P, and the submultiple q (= M/P) of the parity length M in the LDPC code are set to 90, 60, 5, and 6, respectively, in Fig. 121 to Fig. 125 in order to simplify the description, the code length N, the information length K, the number of columns P being the unit of the cyclic structure, and the submultiple q (= M/P) are not limited to the above-described values.

That is to say, in the transmitting device 11 in Fig. 8, the LDPC encoder 115 outputs the LDPC code of the code length N of 64800, 16200 and the like, the information length K of N - Pq (= N - M), the number of columns P being the unit of the cyclic structure of 360, and the submultiple q of M/P, for example, the LDPC decoder 166 in Fig. 125 may also be applied to a case in which the LDPC decoding is performed by simultaneously performing the P check node operations and the P variable node operations to such LDPC code.

<Block diagram showing configuration example of block deinterleaver 54>

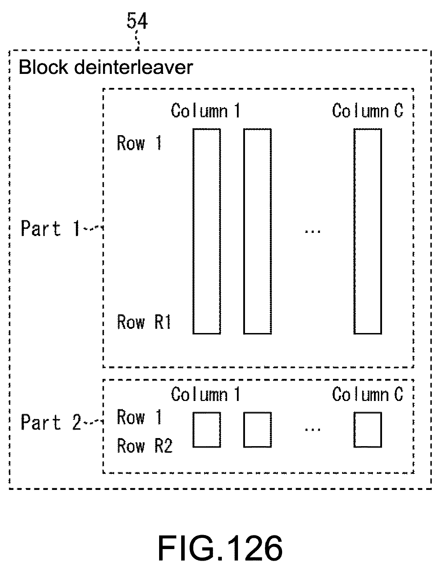

Fig. 126 is a block diagram showing a configuration example of a block deinterleaver 54.

The block deinterleaver 54 is configured similar to the block deinterleaver 25 illustrated in Fig. 106.

The block deinterleaver 54 has a storage region called as Part 1 and a storage region called as Part 2. The Parts 1 and 2 store one bit in a row direction. The number C of columns that are the storage regions for storing the predetermined number of bits in a column direction are arranged. The number C is equal to the number of bits m of the symbols.

The block deinterleaver 54 preforms the block deinterleave to the parts 1 and 2 by writing and reading the LDPC code.

In the block deinterleave, the LDPC code (as the symbol) is written in an order that the block interleaver in Fig. 106 reads the LDPC code.

Further, in the block deinterleave, the LDPC code is read in an order that the block interleaver 25 in Fig. 106 writes the LDPC code.

That is to say, in the block interleave by the block interleaver 25 in Fig. 106, the LDPC code is written to the parts 1 and 2 in the column direction and is read in the row direction. In the block deinterleave by the block deinterleaver 54 in Fig. 126, the LDPC code is written to the parts 1 and 2 in the row direction and is read in the column direction.

<Another configuration example of bit deinterleaver 165>

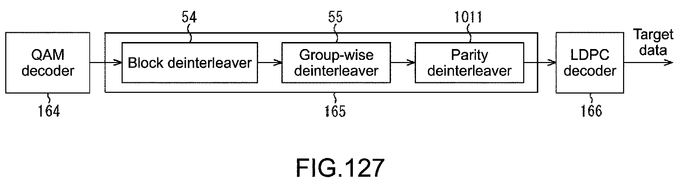

Fig. 127 is a block diagram illustrating another configuration example of the bit deinterleaver 165 in Fig. 118.

In the drawing, the same reference numeral is assigned to a part corresponding to that in Fig. 119 and the description thereof is hereinafter appropriately omitted.

That is to say, the bit deinterleaver 165 in Fig. 127 is configured in the same manner as that in Fig. 119 except that a parity deinterleaver 1011 is newly provided.

In Fig. 127, the bit deinterleaver 165 is configured of the block deinterleaver 54, the group-wise deinterleaver 55, and the parity deinterleaver 1011 and performs the bit deinterleave of the code bit of the LDPC code from the demapper 164.

That is to say, the block deinterleaver 54 performs the block deinterleave (inverse process of the block interleave) corresponding to the block interleave performed by the block interleaver 25 of the transmitting device 11 for the LDPC code from the demapper 164, i.e., the block deinterleave to return the position of the code bit interchanged by the block interleave to the original position, and supplies the LDPC code obtained as a result to the group-wise deinterleaver 55.

The group-wise deinterleaver 55 applies the group-wise deinterleave corresponding to the group-wise interleave as the rearranging process performed by the group-wise interleaver 24 of the transmitting device 11 to the LDPC code from the block deinterleaver 54.

The LDPC code obtained as a result of the group-wise deinterleave is supplied from the group-wise deinterleaver 55 to the parity deinterleaver 1011.

The parity deinterleaver 1011 applies the parity deinterleave (inverse process of the parity interleave) corresponding to the parity interleave performed by the parity interleaver 23 of the transmitting device 11, that is to say, the parity deinterleave to return the code bit of the LDPC code, the arrangement of which is changed by the parity interleave, to the original arrangement for the code bit after the group-wise deinterleave by the group-wise deinterleaver 55.

The LDPC code obtained as a result of the parity deinterleave is supplied from the parity deinterleaver 1011 to the LDPC decoder 166.

Therefore, in the bit deinterleaver 165 in Fig. 127, the LDPC code to which the block deinterleave, the group-wise deinterleave, and the parity deinterleave are applied, that is to say, the LDPC code obtained by the LDPC encoding according to the parity check matrix H is supplied to the LDPC decoder 166.

The LDPC decoder 166 performs the LDPC decoding of the LDPC code from the bit deinterleaver 165 using the parity check matrix H used by the LDPC encoder 115 of the transmitting device 11. That is to say, the LDPC decoder 166 performs the LDPC decoding of the LDPC code from the bit deinterleaver 165 using the parity check matrix H itself used by the LDPC encoder 115 of the transmitting device 11 in the LDPC encoding or the conversion parity check matrix obtained by at least applying the column permutation corresponding to the parity interleave to the parity check matrix H.

Herein, in Fig. 127, since the LDPC code obtained by the LDPC encoding according to the parity check matrix H is supplied from (the parity deinterleaver 1011 of) the bit deinterleaver 165 to the LDPC decoder 166, the LDPC decoder 166 may be configured of the decoding device, which performs the LDPC decoding by a full serial decoding scheme to sequentially perform the operation of the message (check node message and the variable node message) one node after another, and the decoding device, which performs the LDPC decoding by a full parallel decoding scheme to simultaneously perform the operation of the message (in parallel) for all the nodes, for example, when the LDPC decoding of the LDPC code is performed using the parity check matrix H itself used by the LDPC encoder 115 of the transmitting device 11 in the LDPC encoding.

Also, when the LDPC decoder 166 performs the LDPC decoding of the LDPC code using the conversion parity check matrix obtained by at least performing the column permutation corresponding to the parity interleave of the parity check matrix H used by the LDPC encoder 115 of the transmitting device 11 in the LDPC encoding, the LDPC decoder 166 may be configured of the decoding device of the architecture to simultaneously perform the P (or submultiple of P other than 1) check node operations and variable node operations being the decoding device (Fig. 124) including the received data rearrangement unit 310 to rearrange the code bits of the LDPC code by applying the column permutation similar to the column permutation for obtaining the conversion parity check matrix to the LDPC code.

Although the block deinterleaver 54, which performs the block deinterleave, the group-wise deinterleaver 55, which performs the group-wise deinterleave, and the parity deinterleaver 1011, which performs the parity deinterleave, are separately formed for convenience of description in Fig. 127, two or more of the block deinterleaver 54, the group-wise deinterleaver 55, and the parity deinterleaver 1011 may be integrally formed as the parity interleaver 23, the group-wise interleaver 24, and the block interleaver 25 of the transmitting device 11.

<Configuration example of receiving system>

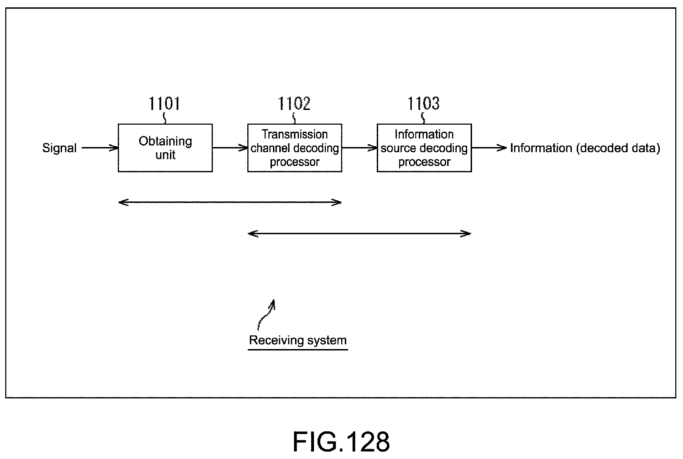

Fig. 128 is a block diagram showing a first configuration example of a receiving system to which the receiving device 12 may be applied.

In Fig. 128, the receiving system is configured of an obtaining unit 1101, a transmission channel decoding processor 1102, and an information source decoding processor 1103.

The obtaining unit 1101 obtains a signal including the LDPC code obtained by at least the LDPC encoding of the LDPC target data such as the image data and the audio data of the program through a transmission channel (communication channel) (not shown) such as digital terrestrial broadcasting, digital satellite broadcasting, and a network such as a CATV network, the Internet and the like, for example, to supply to the transmission channel decoding processor 1102.

Herein, if the signal obtained by the obtaining unit 1101 is broadcasted from a broadcasting station through the terrestrial wave, a satellite wave, the CATV (cable television) network and the like, for example, the obtaining unit 1101 is configured of a tuner, an STB (set top box) and the like. When the signal obtained by the obtaining unit 1101 is multicast-transmitted from a web server such as IPTV (Internet protocol television), for example, the obtaining unit 1101 is configured of a network I/F (interface) such as an NIC (network interface card), for example.

The transmission channel decoding processor 1102 corresponds to the receiving device 12. The transmission channel decoding processor 1102 applies a transmission channel decoding process at least including a process to correct the error occurring in the transmission channel to the signal obtained by the obtaining unit 1101 through the transmission channel and supplies the signal obtained as a result to the information source decoding processor 1103.

That is to say, the signal obtained by the obtaining unit 1101 through the transmission channel is the signal obtained by at least the error correction encoding for correcting the error occurring in the transmission channel and the transmission channel decoding processor 1102 applies the transmission channel decoding process such as an error correction process, for example, to such signal.

Herein, the error correction encoding includes the LDPC encoding, BCH encoding and the like, for example. Herein, the LDPC encoding is at least performed as the error correction encoding.

Also, the transmission channel decoding process may include demodulation of a modulated signal and the like.

The information source decoding processor 1103 applies an information source decoding process at least including a process to expand compressed information to original information to the signal to which the transmission channel decoding process is applied.

That is to say, there is a case in which compression encoding to compress the information is applied to the signal obtained by the obtaining unit 1101 through the transmission channel so as to decrease a data volume of the image and the audio as the information, and in this case, the information source decoding processor 1103 applies the information source decoding process such as the process to expand the compressed information to the original information (expanding process) to the signal to which the transmission channel decoding process is applied.

If the compression encoding is not applied to the signal obtained by the obtaining unit 1101 through the transmission channel, the information source decoding processor 1103 does not perform the process to expand the compressed information to the original information.

Herein, the expanding process includes MPEG decoding and the like, for example. Also, the transmission channel decoding process might include descrambling and the like in addition to the expanding process.

In the receiving system configured as above, the obtaining unit 1101 applies the compression encoding such as MPEG encoding to the data of the image and the audio, for example, and obtains the signal to which the error correction encoding such as the LDPC encoding is applied through the transmission channel to supply to the transmission channel decoding processor 1102.

The transmission channel decoding processor 1102 applies the process similar to that performed by the receiving device 12 and the like to the signal from the obtaining unit 1101 as the transmission channel decoding process, for example, and the signal obtained as a result is supplied to the information source decoding processor 1103.

The information source decoding processor 1103 applies the information source decoding process such as the MPEG decoding to the signal from the transmission channel decoding processor 1102 and outputs the image or the audio obtained as a result.

The receiving system in Fig. 128 as described above may be applied to a television tuner and the like, which receives television broadcasting as the digital broadcasting, for example.

It is possible to form each of the obtaining unit 1101, the transmission channel decoding processor 1102, and the information source decoding processor 1103 as one independent device (hardware (IC (integrated circuit) and the like) or a software module).

Also, as for the obtaining unit 1101, the transmission channel decoding processor 1102, and the information source decoding processor 1103, it is possible to form a set of the obtaining unit 1101 and the transmission channel decoding processor 1102, a set of the transmission channel decoding processor 1102 and the information source decoding processor 1103, and a set of the obtaining unit 1101, the transmission channel decoding processor 1102, and the information source decoding processor 1103 as one independent device.

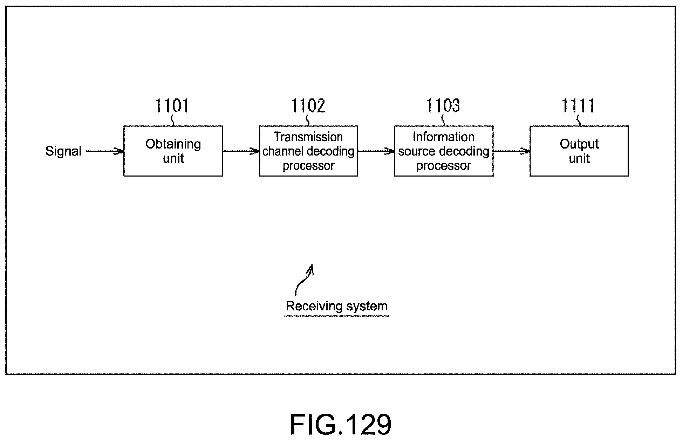

Fig. 129 is a block diagram illustrating a second configuration example of the receiving system to which the receiving device 12 may be applied.

Meanwhile, in the drawing, the same reference numeral is assigned to a part corresponding to that in Fig. 128 and the description thereof is hereinafter appropriately omitted.

The receiving system in Fig. 129 is the same as that in Fig. 128 in that this includes the obtaining unit 1101, the transmission channel decoding processor 1102, and the information source decoding processor 1103 and is different from that in Fig. 128 in that an output unit 1111 is newly provided.

The output unit 1111 is a display device, which displays the image, and a speaker, which outputs the audio, for example, and this outputs the image, the audio and the like as the signal output from the information source decoding processor 1103. That is to say, the output unit 1111 displays the image or outputs the audio.

The receiving system in Fig. 129 as described above may be applied to a TV (television receiver), which receives the television broadcasting as the digital broadcasting, a radio receiver, which receives radio broadcasting, and the like, for example.

If the compression encoding is not applied to the signal obtained by the obtaining unit 1101, the signal output by the transmission channel decoding processor 1102 is supplied to the output unit 1111.

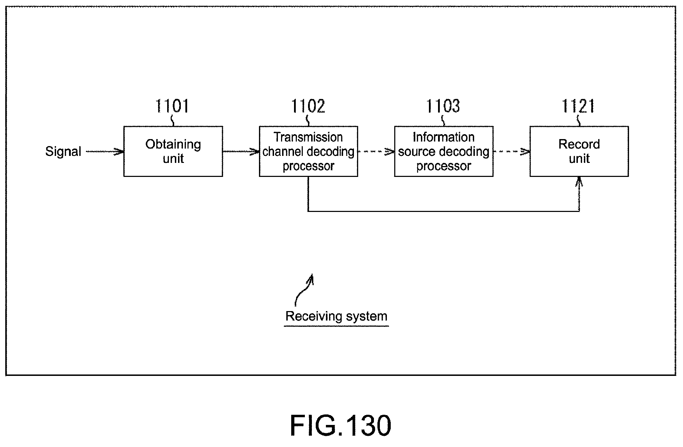

Fig. 130 is a block diagram showing a third configuration example of the receiving system to which the receiving device 12 may be applied.

In the drawing, the same reference numeral is assigned to a part corresponding to that in Fig. 128 and the description thereof is hereinafter appropriately omitted.

The receiving system in Fig. 130 is the same as that in Fig. 128 in that this includes the obtaining unit 1101 and the transmission channel decoding processor 1102.

However, the receiving system in Fig. 130 is different from that in Fig. 128 in that the information source decoding processor 1103 is not provided and a record unit 1121 is newly provided.

The record unit 1121 records (stores) the signal output from the transmission channel decoding processor 1102 (for example, a TS packet of MPEG TS) in a recording (storage) medium such as an optical disk, a hard disk (magnetic disk), and a flash memory.

The receiving system in Fig. 130 as described above may be applied to a recorder and the like, which records the television broadcasting.

In Fig. 130, the receiving system may be provided with the information source decoding processor 1103 and the information source decoding processor 1103 may record the signal to which the information source decoding process is applied, that is to say, the image and the audio obtained by the decoding in the record unit 1121.

[One embodiment of computer]

A series of processes described above may be performed by hardware or by software. When a series of processes is performed by the software, a program, which configures the software, is installed on a multipurpose computer and the like.

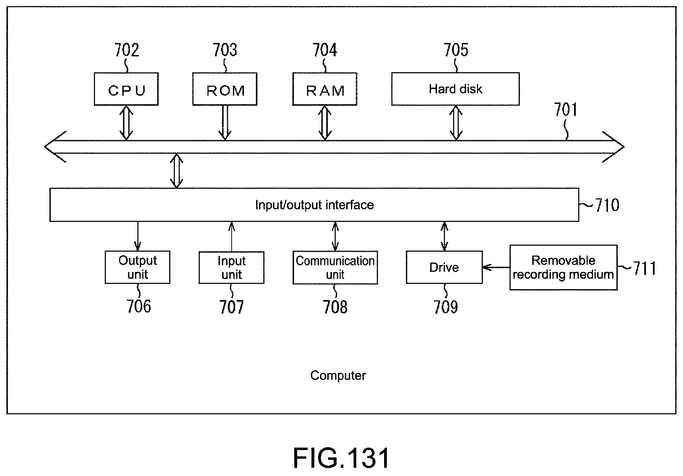

Fig. 131 shows a configuration example of one embodiment of the computer on which the program, which executes a series of processes described above, is installed.

The program may be recorded in advance in a hard disk 705 and a ROM 703 as a recording medium stored in the computer.

Alternatively, the program may be temporarily or permanently stored (recorded) in a removable recording medium 711 such as a flexible disk, a CD-ROM (compact disc read only memory), an MO (magnetooptical) disk, a DVD (digital versatile disc), the magnetic disk, and a semiconductor memory. Such removable recording medium 711 may be provided as so-called packaged software.

In addition to installation from the above-described removable recording medium 711 on the computer, the program may be transferred from a downloading site to the computer by wireless through a satellite for the digital satellite broadcasting or transferred to the computer by wire through the network such as a LAN (local area network) and the Internet, and the computer may receive the program transferred in this manner by a communication unit 708 to install on an internal hard disk 705.

The computer has a CPU (central processing unit) 702 built-in. An input/output interface 710 is connected to the CPU 702 through a bus 701 and, when an instruction is input through the input/output interface 710 by operation and the like of the input unit 707 configured of a keyboard, a mouse, a microphone and the like by a user, the CPU 702 executes the program stored in the ROM (read only memory) 703 according to the same. Alternatively, the CPU 702 loads the program stored in the hard disk 705, the program transferred from the satellite or the network to be received by the communication unit 708 and installed on the hard disk 705, or the program read from the removable recording medium 711 mounted on a drive 709 to be installed on the hard disk 705 on a RAM (random access memory) 704 to execute. According to this, the CPU 702 performs the process according to the above-described flowchart or the process performed by the configuration of the above-described block diagram. Then, the CPU 702 outputs a processing result from an output unit 706 configured of an LCD (liquid crystal display), a speaker and the like, or transmits the same from the communication unit 708, or records the same in the hard disk 705 through the input/output interface 710, for example, as needed.

Herein, in this specification, a processing step to write the program to allow the computer to perform various processes is not necessarily required to be processed in chronological order along order described in the flowchart and this also includes the process executed in parallel or individually executed (for example, a parallel process or a process by an object).

Also, the program may be processed by one computer or distributedly processed by a plurality of computers. Further, the program may be transferred to a remote computer to be executed.

The embodiment of the present technology is not limited to the above-described embodiment and various modifications may be made without departing from the scope of the present technology.

For example, (the parity check matrix initial value table of) the above-described new LDPC code may be through the communication channel 13 (Fig. 7), any of which is a satellite circuit, a terrestrial wave, and a cable (wire circuit). Furthermore, the new LDPC code may be used for data transmission other than the digital broadcasting.

The above-described GW patterns may be applied to any other than the new LDPC code. Furthermore, the modulation scheme to which the above-described GW patterns are applied is not limited to 16QAM, 64QAM, 256QAM and 1024QAM.

Effects described herein are not limited only to be illustrative, there may be effects other than those described herein.

Description of reference numerals

| 11 | transmitting device |
| 12 | receiving device |
| 23 | parity interleave |
| 24 | group-wise interleaver |
| 25 | block interleaver |
| 31 | memory |
| 32 | interchange unit |
| 54 | block deinterleaver |
| 55 | group-wise interleaver |
| 111 | mode adaptation/multiplexer |
| 112 | padder |
| 113 | BB scrambler |
| 114 | BCH encoder |
| 115 | LDPC encoder |
| 116 | bit interleaver |
| 117 | mapper |
| 118 | time interleaver |
| 119 | SISO/MISO encoder |
| 120 | frequency interleaver |
| 121 | BCH encoder |
| 122 | LDPC encoder |
| 123 | mapper |
| 124 | frequency interleaver |
| 131 | frame builder & resource allocation |
| 132 | OFDM generation |
| 151 | OFDM processor |
| 152 | frame management |
| 153 | frequency deinterleaver |
| 154 | demapper |
| 155 | LDPC decoder |
| 156 | BCH decoder |
| 161 | frequency deinterleaver |
| 162 | SISO/MISO decoder |
| 163 | time deinterleaver |
| 164 | demapper |
| 165 | bit deinterleaver |
| 166 | LDPC decoder |
| 167 | BCH decoder |
| 168 | BB descrambler |
| 169 | null deletion |

170     demultiplexer
300     edge data storage memory
301     selector
302     check node calculation unit
303     cyclic shift circuit
304     edge data storage memory
305     selector
306     received data memory
307     variable node calculation unit
308     cyclic shift circuit
309     decoded word calculation unit
310     received data rearrangement unit
311     decoded data rearrangement unit
601     encoding processor
602     storage unit
611     code rate set unit
612     initial value table read unit
613     parity check matrix generation unit
614     information bit read unit
615     encoding parity operation unit
616     controller
701     bus
702     CPU
703     ROM
704     RAM
705     hard disk
70      output unit
707     input unit
708     communication unit
709     drive
710     input/output interface
711     removable recording medium
1001    inverse interchange unit
1002    memory
1011    parity deinterleaver
1101    obtaining unit
1101    transmitting channel decoding processor
1103    information source decoding processor
1111    output unit
1121    record unit


**Claims**

1.  A data processing device, comprising:

a group-wise interleave unit of performing group-wise interleave of interleaving in a 360-bit group unit an LDPC code whose code length is 64800 bits and code rate is 10/15, 11/15, 12/15 or 13/15,
the (i + 1)th bit group from the beginning of the LDPC code of the 64800 bits being as a bit group i, and
in the group-wise interleave, a sequence of bit group 0 to 179 of the 64800 bits of the LDPC code being interleaved into the following sequence of the bit group:

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

2.  The data processing device according to claim 1, further comprising:

a mapping unit of mapping the LDPC code onto any of 256 signal points defined by a modulation scheme in a 8 bits unit.

3.  The data processing device, according to claim 1, further comprising:

an encoder, which performs LDPC encoding based on a parity check matrix of an LDPC code whose code length is 64800 bits and code rate is 10/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
979 1423 4166 4609 6341 8258 10334 10548 14098 14514 17051 17333 17653 17830 17990
2559 4025 6344 6510 9167 9728 11312 14856 17104 17721 18600 18791 19079 19697 19840
3243 6894 7950 10539 12042 13233 13938 14752 16449 16727 17025 18297 18796 19400 21577
3272 3574 6341 6722 9191 10807 10957 12531 14036 15580 16651 17007 17309 19415 19845
155 4598 10201 10975 11086 11296 12713 15364 15978 16395 17542 18164 18451 18612 20617
1128 1999 3926 4069 5558 6085 6337 8386 10693 12450 15438 16223 16370 17308 18634
2408 2929 3630 4357 5852 7329 8536 8695 10603 11003 14304 14937 15767 18402 21502
199 3066 6446 6849 8973 9536 10452 12857 13675 15913 16717 17654 19802 20115 21579
312 870 2095 2586 5517 6196 6757 7311 7368 13046 15384 18576 20349 21424 21587
985 1591 3248 3509 3706 3847 6174 6276 7864 9033 13618 15675 16446 18355 18843
975 3774 4083 5825 6166 7218 7633 9657 10103 13052 14240 17320 18126 19544 20208
1795 2005 2544 3418 6148 8051 9066 9725 10676 10752 11512 15171 17523 20481 21059
167 315 1824 2325 2640 2868 6070 6597 7016 8109 9815 11608 16142 17912 19625
1298 1896 3039 4303 4690 8787 12241 13600 14478 15492 16602 17115 17913 19466 20597
568 3695 6045 6624 8131 8404 8590 9059 9246 11570 14336 18657 18941 19218 21506
228 1889 1967 2299 3011 5074 7044 7596 7689 9534 10244 10697 11691 17902 21410
1330 1579 1739 2234 3701 3865 5713 6677 7263 11172 12143 12765 17121 20011 21436
303 1668 2501 4925 5778 5985 9635 10140 10820 11779 11849 12058 15650 20426 20527
698 2484 3071 3219 4054 4125 5663 5939 6928 7086 8054 12173 16280 17945 19302
232 1619 3040 4901 7438 8135 9117 9233 10131 13321 17347 17436 18193 18586 19929
12 3721 6254 6609 7880 8139 10437 12262 13928 14065 14149 15032 15694 16264 18883
482 915 1548 1637 6687 9338 10163 11768 11970 15524 15695 17386 18787 19210 19340
1291 2500 4109 4511 5099 5194 10014 13165 13256 13972 15409 16113 16214 18584 20998
1761 4778 7444 7740 8129 8341 8931 9136 9207 10003 10678 13959 17673 18194 20990
3060 3522 5361 5692 6833 8342 8792 11023 11211 11548 11914 13987 15442 15541 19707
1322 2348 2970 5632 6349 7577 8782 9113 9267 9376 12042 12943 16680 16970 21321
6785 11960 21455
1223 15672 19550
5976 11335 20385
2818 9387 15317
2763 3554 18102
5230 11489 18997
5809 15779 20674
2620 17838 18533
3025 9342 9931
3728 5337 12142
2520 6666 9164
12892 15307 20912
10736 12393 16539
1075 2407 12853

4921 5411 18206
5955 15647 16838
6384 10336 19266
429 10421 17266
4880 10431 12208
2910 11895 12442
7366 18362 18772
4341 7903 14994
4564 6714 7378
4639 8652 18871
15787 18048 20246
3241 11079 13640
1559 2936 15881
2737 6349 10881
10394 16107 17073
8207 9043 12874
7805 16058 17905
11189 15767 17764
5823 12923 14316
11080 20390 20924
568 8263 17411
1845 3557 6562
2890 10936 14756
9031 14220 21517
3529 12955 15902
413 6750 8735
6784 12092 16421
12019 13794 15308
12588 15378 17676
8067 14589 19304
1244 5877 6085
15897 19349 19993
1426 2394 12264
3456 8931 12075
13342 15273 20351
9138 13352 20798
7031 7626 14081
4280 4507 15617
4170 10569 14335
3839 7514 16578
4688 12815 18782
4861 7858 9435
605 5445 12912
2280 4734 7311
6668 8128 12638
3733 10621 19534
13933 18316 19341
1786 3037 21566
2202 13239 16432
4882 5808 9300
4580 8484 16754
14630 17502 18269
6889 11119 12447
8162 9078 16330
6538 17851 18100
17763 19793 20816
2183 11907 17567
6640 14428 15175

877 12035 14081
1336 6468 12328
5948 9146 12003
3782 5699 12445
1770 7946 8244
7384 12639 14989
1469 11586 20959
7943 10450 15907
5005 8153 10035
17750 18826 21513
4725 8041 10112
3837 16266 17376
11340 17361 17512
1269 4611 4774
2322 10813 16157
16752 16843 18959
70 4325 18753
3165 8153 15384
160 8045 16823
14112 16724 16792
4291 7667 18176
5943 19879 20721.

**4.** The data processing device, according to claim 1, further comprising:

an encoder, which performs LDPC encoding based on a parity check matrix of an LDPC code whose code length is 64800 bits and code rate is 11/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
696 989 1238 3091 3116 3738 4269 6406 7033 8048 9157 10254 12033 16456 16912
444 1488 6541 8626 10735 12447 13111 13706 14135 15195 15947 16453 16916 17137 17268
401 460 992 1145 1576 1678 2238 2320 4280 6770 10027 12486 15363 16714 17157
1161 3108 3727 4508 5092 5348 5582 7727 11793 12515 12917 13362 14247 16717 17205
542 1190 6883 7911 8349 8835 10489 11631 14195 15009 15454 15482 16632 17040 17063
17 487 776 880 5077 6172 9771 11446 12798 16016 16109 16171 17087 17132 17226
1337 3275 3462 4229 9246 10180 10845 10866 12250 13633 14482 16024 16812 17186 17241
15 980 2305 3674 5971 8224 11499 11752 11770 12897 14082 14836 15311 16391 17209
0 3926 5869 8696 9351 9391 11371 14052 14172 14636 14974 16619 16961 17033 17237
3033 5317 6501 8579 10698 12168 12966 14019 15392 15806 15991 16493 16690 17062 17090
981 1205 4400 6410 11003 13319 13405 14695 15846 16297 16492 16563 16616 16862 16953
1725 4276 8869 9588 14062 14486 15474 15548 16300 16432 17042 17050 17060 17175 17273
1807 5921 9960 10011 14305 14490 14872 15852 16054 16061 16306 16799 16833 17136 17262
2826 4752 6017 6540 7016 8201 14245 14419 14716 15983 16569 16652 17171 17179 17247
1662 2516 3345 5229 8086 9686 11456 12210 14595 15808 16011 16421 16825 17112 17195
2890 4821 5987 7226 8823 9869 12468 14694 15352 15805 16075 16462 17102 17251 17263
3751 3890 4382 5720 10281 10411 11350 12721 13121 14127 14980 15202 15335 16735 17123
26 30 2805 5457 6630 7188 7477 7556 11065 16608 16859 16909 16943 17030 17103
40 4524 5043 5566 9645 10204 10282 11696 13080 14837 15607 16274 17034 17225 17266
904 3157 6284 7151 7984 11712 12887 13767 15547 16099 16753 16829 17044 17250 17259
7 311 4876 8334 9249 11267 14072 14559 15003 15235 15686 16331 17177 17238 17253
4410 8066 8596 9631 10369 11249 12610 15769 16791 16960 17018 17037 17062 17165 17204
24 8261 9691 10138 11607 12782 12786 13424 13933 15262 15795 16476 17084 17193 17220
88 11622 14705 15890
304 2026 2638 6018

1163 4268 11620 17232
9701 11785 14463 17260
4118 10952 12224 17006
3647 10823 11521 12060
1717 3753 9199 11642
2187 14280 17220
14787 16903 17061
381 3534 4294
3149 6947 8323
12562 16724 16881
7289 9997 15306
5615 13152 17260
5666 16926 17027
4190 7798 16831
4778 10629 17180
10001 13884 15453
6 2237 8203
7831 15144 15160
9186 17204 17243
9435 17168 17237
42 5701 17159
7812 14259 15715
39 4513 6658
38 9368 11273
1119 4785 17182
5620 16521 16729
16 6685 17242
210 3452 12383
466 14462 16250
10548 12633 13962
1452 6005 16453
22 4120 13684
5195 11563 16522
5518 16705 17201
12233 14552 15471
6067 13440 17248
8660 8967 17061
8673 12176 15051
5959 15767 16541
3244 12109 12414
31 15913 16323
3270 15686 16653
24 7346 14675
12 1531 8740
6228 7565 16667
16936 17122 17162
4868 8451 13183
3714 4451 16919
11313 13801 17132
17070 17191 17242
1911 11201 17186
14 17190 17254
11760 16008 16832
14543 17033 17278
16129 16765 17155
6891 15561 17007
12741 14744 17116
8992 16661 17277

1861 11130 16742
4822 13331 16192
13281 14027 14989
38 14887 17141
10698 13452 15674
4 2539 16877
857 17170 17249
11449 11906 12867
285 14118 16831
15191 17214 17242
39 728 16915
2469 12969 15579
16644 17151 17164
2592 8280 10448
9236 12431 17173
9064 16892 17233
4526 16146 17038
31 2116 16083
15837 16951 17031
5362 8382 16618
6137 13199 17221
2841 15068 17068
24 3620 17003
9880 15718 16764
1784 10240 17209
2731 10293 10846
3121 8723 16598
8563 15662 17088
13 1167 14676
29 13850 15963
3654 7553 8114
23 4362 14865
4434 14741 16688
8362 13901 17244
13687 16736 17232
46 4229 13394
13169 16383 16972
16031 16681 16952
3384 9894 12580
9841 14414 16165
5013 17099 17115
2130 8941 17266
6907 15428 17241
16 1860 17235
2151 16014 16643
14954 15958 17222
3969 8419 15116
31 15593 16984
11514 16605 17255.

5. The data processing device, according to claim 1, further comprising:

an encoder, which performs LDPC encoding based on a parity check matrix of an LDPC code whose code length is 64800 bits and code rate is 12/15,
the LDPC code including information bits and parity bits,
the parity check matrix including an information matrix part corresponding to the information bits and a parity matrix part corresponding to the parity bits,
the information matrix part being represented by a parity check matrix initial value table, and

the parity check matrix initial value table being a table indicating a position of an element 1 of the information matrix part for each 360 columns as

584 1472 1621 1867 3338 3568 3723 4185 5126 5889 7737 8632 8940 9725
221 445 590 3779 3835 6939 7743 8280 8448 8491 9367 10042 11242 12917
4662 4837 4900 5029 6449 6687 6751 8684 9936 11681 11811 11886 12089 12909
2418 3018 3647 4210 4473 7447 7502 9490 10067 11092 11139 11256 12201 12383
2591 2947 3349 3406 4417 4519 5176 6672 8498 8863 9201 11294 11376 12184
27 101 197 290 871 1727 3911 5411 6676 8701 9350 10310 10798 12439
1765 1897 2923 3584 3901 4048 6963 7054 7132 9165 10184 10824 11278 12669
2183 3740 4808 5217 5660 6375 6787 8219 8466 9037 10353 10583 11118 12762
73 1594 2146 2715 3501 3572 3639 3725 6959 7187 8406 10120 10507 10691
240 732 1215 2185 2788 2830 3499 3881 4197 4991 6425 7061 9756 10491
831 1568 1828 3424 4319 4516 4639 6018 9702 10203 10417 11240 11518 12458
2024 2970 3048 3638 3676 4152 5284 5779 5926 9426 9945 10873 11787 11837
1049 1218 1651 2328 3493 4363 5750 6483 7613 8782 9738 9803 11744 11937
1193 2060 2289 2964 3478 4592 4756 6709 7162 8231 8326 11140 11908 12243
978 2120 2439 3338 3850 4589 6567 8745 9656 9708 10161 10542 10711 12639
2403 2938 3117 3247 3711 5593 5844 5932 7801 10152 10226 11498 12162 12941
1781 2229 2276 2533 3582 3951 5279 5774 7930 9824 10920 11038 12340 12440
289 384 1980 2230 3464 3873 5958 8656 8942 9006 10175 11425 11745 12530
155 354 1090 1330 2002 2236 3559 3705 4922 5958 6576 8564 9972 12760
303 876 2059 2142 5244 5330 6644 7576 8614 9598 10410 10718 11033 12957
3449 3617 4408 4602 4727 6182 8835 8928 9372 9644 10237 10747 11655 12747
811 2565 2820 8677 8974 9632 11069 11548 11839 12107 12411 12695 12812 12890
972 4123 4943 6385 6449 7339 7477 8379 9177 9359 10074 11709 12552 12831
842 973 1541 2262 2905 5276 6758 7099 7894 8128 8325 8663 8875 10050
474 791 968 3902 4924 4965 5085 5908 6109 6329 7931 9038 9401 10568
1397 4461 4658 5911 6037 7127 7318 8678 8924 9000 9473 9602 10446 12692
1334 7571 12881
1393 1447 7972
633 1257 10597
4843 5102 11056
3294 8015 10513
1108 10374 10546
5353 7824 10111
3398 7674 8569
7719 9478 10503
2997 9418 9581
5777 6519 11229
1966 5214 9899
6 4088 5827
836 9248 9612
483 7229 7548
7865 8289 9804
2915 11098 11900
6180 7096 9481
1431 6786 8924
748 6757 8625
3312 4475 7204
1852 8958 11020
1915 2903 4006
6776 10886 12531
2594 9998 12742
159 2002 12079
853 3281 3762
5201 5798 6413
3882 6062 12047
4133 6775 9657

228 6874 11183
7433 10728 10864
7735 8073 12734
2844 4621 11779
3909 7103 12804
6002 9704 11060
5864 6856 7681
3652 5869 7605
2546 2657 4461
2423 4203 9111
244 1855 4691
1106 2178 6371
391 1617 10126
250 9259 10603
3435 4614 6924
1742 8045 9529
7667 8875 11451
4023 6108 6911
8621 10184 11650
6726 10861 12348
3228 6302 7388
1 1137 5358
381 2424 8537
3256 7508 10044
1980 2219 4569
2468 5699 10319
2803 3314 12808
8578 9642 11533
829 4585 7923
59 329 5575
1067 5709 6867
1175 4744 12219
109 2518 6756
2105 10626 11153
5192 10696 10749
6260 7641 8233
2998 3094 11214
3398 6466 11494
6574 10448 12160
2734 10755 12780
1028 7958 10825
8545 8602 10793
392 3398 11417
6639 9291 12571
1067 7919 8934
1064 2848 12753
6076 8656 12690
5504 6193 10171
1951 7156 7356
4389 4780 7889
526 4804 9141
1238 3648 10464
2587 5624 12557
5560 5903 11963
1134 2570 3297
10041 11583 12157
1263 9585 12912
3744 7898 10646

45 9074 10315
1051 6188 10038
2242 8394 12712
3598 9025 12651
2295 3540 5610
1914 4378 12423
1766 3635 12759
5177 9586 11143
943 3590 11649
4864 6905 10454
5852 6042 10421
6095 8285 12349
2070 7171 8563
718 12234 12716
512 10667 11353
3629 6485 7040
2880 8865 11466
4490 10220 11796
5440 8819 9103
5262 7543 12411
516 7779 10940
2515 5843 9202
4684 5994 10586
573 2270 3324
7870 8317 10322
6856 7638 12909
1583 7669 10781
8141 9085 12555
3903 5485 9992
4467 11998 12904.

6. The data processing device, according to claim 1, further comprising:

an encoder, which performs LDPC encoding based on a parity check matrix of an LDPC code whose code length is 64800 bits and code rate is 13/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
142 2307 2598 2650 4028 4434 5781 5881 6016 6323 6681 6698 8125
2932 4928 5248 5256 5983 6773 6828 7789 8426 8494 8534 8539 8583
899 3295 3833 5399 6820 7400 7753 7890 8109 8451 8529 8564 8602
21 3060 4720 5429 5636 5927 6966 8110 8170 8247 8355 8365 8616
20 1745 2838 3799 4380 4418 4646 5059 7343 8161 8302 8456 8631
9 6274 6725 6792 7195 7333 8027 8186 8209 8273 8442 8548 8632
494 1365 2405 3799 5188 5291 7644 7926 8139 8458 8504 8594 8625
192 574 1179 4387 4695 5089 5831 7673 7789 8298 8301 8612 8632
11 20 1406 6111 6176 6256 6708 6834 7828 8232 8457 8495 8602
6 2654 3554 4483 4966 5866 6795 8069 8249 8301 8497 8509 8623
21 1144 2355 3124 6773 6805 6887 7742 7994 8358 8374 8580 8611
335 4473 4883 5528 6096 7543 7586 7921 8197 8319 8394 8489 8636
2919 4331 4419 4735 6366 6393 6844 7193 8165 8205 8544 8586 8617
12 19 742 930 3009 4330 6213 6224 7292 7430 7792 7922 8137
710 1439 1588 2434 3516 5239 6248 6827 8230 8448 8515 8581 8619
200 1075 1868 5581 7349 7642 7698 8037 8201 8210 8320 8391 8526
3 2501 4252 5256 5292 5567 6136 6321 6430 6486 7571 8521 8636

3062 4599 5885 6529 6616 7314 7319 7567 8024 8153 8302 8372 8598

105 381 1574 4351 5452 5603 5943 7467 7788 7933 8362 8513 8587

787 1857 3386 3659 6550 7131 7965 8015 8040 8312 8484 8525 8537

15 1118 4226 5197 5575 5761 6762 7038 8260 8338 8444 8512 8568

36 5216 5368 5616 6029 6591 8038 8067 8299 8351 8565 8578 8585

1 23 4300 4530 5426 5532 5817 6967 7124 7979 8022 8270 8437

629 2133 4828 5475 5875 5890 7194 8042 8345 8385 8518 8598 8612

11 1065 3782 4237 4993 7104 7863 7904 8104 8228 8321 8383 8565

2131 2274 3168 3215 3220 5597 6347 7812 8238 8354 8527 8557 8614

5600 6591 7491 7696

1766 8281 8626

1725 2280 5120

1650 3445 7652

4312 6911 8626

15 1013 5892

2263 2546 2979

1545 5873 7406

67 726 3697

2860 6443 8542

17 911 2820

1561 4580 6052

79 5269 7134

22 2410 2424

3501 5642 8627

808 6950 8571

4099 6389 7482

4023 5000 7833

5476 5765 7917

1008 3194 7207

20 495 5411

1703 8388 8635

6 4395 4921

200 2053 8206

1089 5126 5562

10 4193 7720

1967 2151 4608

22 738 3513

3385 5066 8152

440 1118 8537

3429 6058 7716

5213 7519 8382

5564 8365 8620

43 3219 8603

4 5409 5815

5 6376 7654

4091 5724 5953

5348 6754 8613

1634 6398 6632

72 2058 8605

3497 5811 7579

3846 6743 8559

15 5933 8629

2133 5859 7068

4151 4617 8566

2960 8270 8410

2059 3617 8210

544 1441 6895

4043 7482 8592

294 2180 8524
3058 8227 8373
364 5756 8617
5383 8555 8619
1704 2480 4181
7338 7929 7990
2615 3905 7981
4298 4548 8296
8262 8319 8630
892 1893 8028
5694 7237 8595
1487 5012 5810
4335 8593 8624
3509 4531 5273
10 22 830
4161 5208 6280
275 7063 8634
4 2725 3113
2279 7403 8174
1637 3328 3930
2810 4939 5624
3 1234 7687
2799 7740 8616
22 7701 8636
4302 7857 7993
7477 7794 8592
9 6111 8591
5 8606 8628
347 3497 4033
1747 2613 8636
1827 5600 7042
580 1822 6842
232 7134 7783
4629 5000 7231
951 2806 4947
571 3474 8577
2437 2496 7945
23 5873 8162
12 1168 7686
8315 8540 8596
1766 2506 4733
929 1516 3338
21 1216 6555
782 1452 8617
8 6083 6087
667 3240 4583
4030 4661 5790
559 7122 8553
3202 4388 4909
2533 3673 8594
1991 3954 6206
6835 7900 7980
189 5722 8573
2680 4928 4998
243 2579 7735
4281 8132 8566
7656 7671 8609
1116 2291 4166

21 388 8021
6 1123 8369
311 4918 8511
0 3248 6290
13 6762 7172
4209 5632 7563
49 127 8074
581 1735 4075
0 2235 5470
2178 5820 6179
16 3575 6054
1095 4564 6458
9 1581 5953
2537 6469 8552
14 3874 4844
0 3269 3551
2114 7372 7926
1875 2388 4057
3232 4042 6663
9 401 583
13 4100 6584
2299 4190 4410
21 3670 4979.

**7.** A data processing method, comprising:

a step of group-wise interleaving, which group-wise interleaves an LDPC code whose code length is 64800 bits and code rate is 10/15, 11/15, 12/15 or 13/15 in a 360-bit group unit,
the $(i + 1)$th bit group from the beginning of the LDPC code of the 64800 bits being as a bit group i, and
in the group-wise interleave, a sequence of bit group 0 to 179 of the 64800 bits of the LDPC code being interleaved into the following sequence of the bit group:

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

**8.** A data processing device, comprising:

a group-wise interleave unit of performing group-wise interleave of interleaving in a 360-bit group unit an LDPC code whose code length is 64800 bits and code rate is 10/15, 11/15, 12/15 or 13/15, and
of returning a sequence of the LDPC code after the group-wise interleave obtained from data transmitted from a transmitting device to the original sequence,
the $(i + 1)$th bit group from the beginning of the LDPC code of the 64800 bits being as a bit group i, and
in the group-wise interleave, a sequence of bit group 0 to 179 of the 64800 bits of the LDPC code being interleaved into the following sequence of the bit group:

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

9. The data processing device according to claim 8, further comprising:

a demapping unit of demapping the mapped data obtained from the data transmitted from the transmitting device further comprising a mapping unit of mapping the LDPC code onto any of 256 signal points defined by a modulation scheme in a 8 bits unit.

10. The data processing device, according to claim 8, further comprising:

an encoder, which performs LDPC encoding based on a parity check matrix of an LDPC code whose code length is 64800 bits and code rate is 10/15, and
a decoder, which decodes the LDPC code provided from the data transmitted from the transmitting device,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as

979 1423 4166 4609 6341 8258 10334 10548 14098 14514 17051 17333 17653 17830 17990
2559 4025 6344 6510 9167 9728 11312 14856 17104 17721 18600 18791 19079 19697 19840
3243 6894 7950 10539 12042 13233 13938 14752 16449 16727 17025 18297 18796 19400 21577
3272 3574 6341 6722 9191 10807 10957 12531 14036 15580 16651 17007 17309 19415 19845
155 4598 10201 10975 11086 11296 12713 15364 15978 16395 17542 18164 18451 18612 20617
1128 1999 3926 4069 5558 6085 6337 8386 10693 12450 15438 16223 16370 17308 18634
2408 2929 3630 4357 5852 7329 8536 8695 10603 11003 14304 14937 15767 18402 21502
199 3066 6446 6849 8973 9536 10452 12857 13675 15913 16717 17654 19802 20115 21579
312 870 2095 2586 5517 6196 6757 7311 7368 13046 15384 18576 20349 21424 21587
985 1591 3248 3509 3706 3847 6174 6276 7864 9033 13618 15675 16446 18355 18843
975 3774 4083 5825 6166 7218 7633 9657 10103 13052 14240 17320 18126 19544 20208
1795 2005 2544 3418 6148 8051 9066 9725 10676 10752 11512 15171 17523 20481 21059
167 315 1824 2325 2640 2868 6070 6597 7016 8109 9815 11608 16142 17912 19625
1298 1896 3039 4303 4690 8787 12241 13600 14478 15492 16602 17115 17913 19466 20597
568 3695 6045 6624 8131 8404 8590 9059 9246 11570 14336 18657 18941 19218 21506
228 1889 1967 2299 3011 5074 7044 7596 7689 9534 10244 10697 11691 17902 21410
1330 1579 1739 2234 3701 3865 5713 6677 7263 11172 12143 12765 17121 20011 21436
303 1668 2501 4925 5778 5985 9635 10140 10820 11779 11849 12058 15650 20426 20527
698 2484 3071 3219 4054 4125 5663 5939 6928 7086 8054 12173 16280 17945 19302
232 1619 3040 4901 7438 8135 9117 9233 10131 13321 17347 17436 18193 18586 19929
12 3721 6254 6609 7880 8139 10437 12262 13928 14065 14149 15032 15694 16264 18883
482 915 1548 1637 6687 9338 10163 11768 11970 15524 15695 17386 18787 19210 19340
1291 2500 4109 4511 5099 5194 10014 13165 13256 13972 15409 16113 16214 18584 20998
1761 4778 7444 7740 8129 8341 8931 9136 9207 10003 10678 13959 17673 18194 20990
3060 3522 5361 5692 6833 8342 8792 11023 11211 11548 11914 13987 15442 15541 19707
1322 2348 2970 5632 6349 7577 8782 9113 9267 9376 12042 12943 16680 16970 21321
6785 11960 21455
1223 15672 19550
5976 11335 20385
2818 9387 15317
2763 3554 18102
5230 11489 18997
5809 15779 20674
2620 17838 18533
3025 9342 9931
3728 5337 12142
2520 6666 9164
12892 15307 20912
10736 12393 16539

1075 2407 12853
4921 5411 18206
5955 15647 16838
6384 10336 19266
429 10421 17266
4880 10431 12208
2910 11895 12442
7366 18362 18772
4341 7903 14994
4564 6714 7378
4639 8652 18871
15787 18048 20246
3241 11079 13640
1559 2936 15881
2737 6349 10881
10394 16107 17073
8207 9043 12874
7805 16058 17905
11189 15767 17764
5823 12923 14316
11080 20390 20924
568 8263 17411
1845 3557 6562
2890 10936 14756
9031 14220 21517
3529 12955 15902
413 6750 8735
6784 12092 16421
12019 13794 15308
12588 15378 17676
8067 14589 19304
1244 5877 6085
15897 19349 19993
1426 2394 12264
3456 8931 12075
13342 15273 20351
9138 13352 20798
7031 7626 14081
4280 4507 15617
4170 10569 14335
3839 7514 16578
4688 12815 18782
4861 7858 9435
605 5445 12912
2280 4734 7311
6668 8128 12638
3733 10621 19534
13933 18316 19341
1786 3037 21566
2202 13239 16432
4882 5808 9300
4580 8484 16754
14630 17502 18269
6889 11119 12447
8162 9078 16330
6538 17851 18100
17763 19793 20816
2183 11907 17567

6640 14428 15175
877 12035 14081
1336 6468 12328
5948 9146 12003
3782 5699 12445
1770 7946 8244
7384 12639 14989
1469 11586 20959
7943 10450 15907
5005 8153 10035
17750 18826 21513
4725 8041 10112
3837 16266 17376
11340 17361 17512
1269 4611 4774
2322 10813 16157
16752 16843 18959
70 4325 18753
3165 8153 15384
160 8045 16823
14112 16724 16792
4291 7667 18176
5943 19879 20721.

11. The data processing device, according to claim 8, further comprising:

an encoder, which performs LDPC encoding based on a parity check matrix of an LDPC code whose code length is 64800 bits and code rate is 11/15, and
a decoder, which decodes the LDPC code provided from the data transmitted from the transmitting device, the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
696 989 1238 3091 3116 3738 4269 6406 7033 8048 9157 10254 12033 16456 16912
444 1488 6541 8626 10735 12447 13111 13706 14135 15195 15947 16453 16916 17137 17268
401 460 992 1145 1576 1678 2238 2320 4280 6770 10027 12486 15363 16714 17157
1161 3108 3727 4508 5092 5348 5582 7727 11793 12515 12917 13362 14247 16717 17205
542 1190 6883 7911 8349 8835 10489 11631 14195 15009 15454 15482 16632 17040 17063
17 487 776 880 5077 6172 9771 11446 12798 16016 16109 16171 17087 17132 17226
1337 3275 3462 4229 9246 10180 10845 10866 12250 13633 14482 16024 16812 17186 17241
15 980 2305 3674 5971 8224 11499 11752 11770 12897 14082 14836 15311 16391 17209
0 3926 5869 8696 9351 9391 11371 14052 14172 14636 14974 16619 16961 17033 17237
3033 5317 6501 8579 10698 12168 12966 14019 15392 15806 15991 16493 16690 17062 17090
981 1205 4400 6410 11003 13319 13405 14695 15846 16297 16492 16563 16616 16862 16953
1725 4276 8869 9588 14062 14486 15474 15548 16300 16432 17042 17050 17060 17175 17273
1807 5921 9960 10011 14305 14490 14872 15852 16054 16061 16306 16799 16833 17136 17262
2826 4752 6017 6540 7016 8201 14245 14419 14716 15983 16569 16652 17171 17179 17247
1662 2516 3345 5229 8086 9686 11456 12210 14595 15808 16011 16421 16825 17112 17195
2890 4821 5987 7226 8823 9869 12468 14694 15352 15805 16075 16462 17102 17251 17263
3751 3890 4382 5720 10281 10411 11350 12721 13121 14127 14980 15202 15335 16735 17123
26 30 2805 5457 6630 7188 7477 7556 11065 16608 16859 16909 16943 17030 17103
40 4524 5043 5566 9645 10204 10282 11696 13080 14837 15607 16274 17034 17225 17266
904 3157 6284 7151 7984 11712 12887 13767 15547 16099 16753 16829 17044 17250 17259
7 311 4876 8334 9249 11267 14072 14559 15003 15235 15686 16331 17177 17238 17253
4410 8066 8596 9631 10369 11249 12610 15769 16791 16960 17018 17037 17062 17165 17204
24 8261 9691 10138 11607 12782 12786 13424 13933 15262 15795 16476 17084 17193 17220

88 11622 14705 15890
304 2026 2638 6018
1163 4268 11620 17232
9701 11785 14463 17260
4118 10952 12224 17006
3647 10823 11521 12060
1717 3753 9199 11642
2187 14280 17220
14787 16903 17061
381 3534 4294
3149 6947 8323
12562 16724 16881
7289 9997 15306
5615 13152 17260
5666 16926 17027
4190 7798 16831
4778 10629 17180
10001 13884 15453
6 2237 8203
7831 15144 15160
9186 17204 17243
9435 17168 17237
42 5701 17159
7812 14259 15715
39 4513 6658
38 9368 11273
1119 4785 17182
5620 16521 16729
16 6685 17242
210 3452 12383
466 14462 16250
10548 12633 13962
1452 6005 16453
22 4120 13684
5195 11563 16522
5518 16705 17201
12233 14552 15471
6067 13440 17248
8660 8967 17061
8673 12176 15051
5959 15767 16541
3244 12109 12414
31 15913 16323
3270 15686 16653
24 7346 14675
12 1531 8740
6228 7565 16667
16936 17122 17162
4868 8451 13183
3714 4451 16919
11313 13801 17132
17070 17191 17242
1911 11201 17186
14 17190 17254
11760 16008 16832
14543 17033 17278
16129 16765 17155
6891 15561 17007

12741 14744 17116
8992 16661 17277
1861 11130 16742
4822 13331 16192
13281 14027 14989
38 14887 17141
10698 13452 15674
4 2539 16877
857 17170 17249
11449 11906 12867
285 14118 16831
15191 17214 17242
39 728 16915
2469 12969 15579
16644 17151 17164
2592 8280 10448
9236 12431 17173
9064 16892 17233
4526 16146 17038
31 2116 16083
15837 16951 17031
5362 8382 16618
6137 13199 17221
2841 15068 17068
24 3620 17003
9880 15718 16764
1784 10240 17209
2731 10293 10846
3121 8723 16598
8563 15662 17088
13 1167 14676
29 13850 15963
3654 7553 8114
23 4362 14865
4434 14741 16688
8362 13901 17244
13687 16736 17232
46 4229 13394
13169 16383 16972
16031 16681 16952
3384 9894 12580
9841 14414 16165
5013 17099 17115
2130 8941 17266
6907 15428 17241
16 1860 17235
2151 16014 16643
14954 15958 17222
3969 8419 15116
31 15593 16984
11514 16605 17255.

12. The data processing device, according to claim 8, further comprising:

an encoder, which performs LDPC encoding based on a parity check matrix of an LDPC code whose code length is 64800 bits and code rate is 12/15, and
a decoder, which decodes the LDPC code provided from the data transmitted from the transmitting device, the LDPC code including information bits and parity bits,

the parity check matrix including an information matrix part corresponding to the information bits and a parity matrix part corresponding to the parity bits,

the information matrix part being represented by a parity check matrix initial value table, and

the parity check matrix initial value table being a table indicating a position of an element 1 of the information matrix part for each 360 columns as

584 1472 1621 1867 3338 3568 3723 4185 5126 5889 7737 8632 8940 9725
221 445 590 3779 3835 6939 7743 8280 8448 8491 9367 10042 11242 12917
4662 4837 4900 5029 6449 6687 6751 8684 9936 11681 11811 11886 12089 12909
2418 3018 3647 4210 4473 7447 7502 9490 10067 11092 11139 11256 12201 12383
2591 2947 3349 3406 4417 4519 5176 6672 8498 8863 9201 11294 11376 12184
27 101 197 290 871 1727 3911 5411 6676 8701 9350 10310 10798 12439
1765 1897 2923 3584 3901 4048 6963 7054 7132 9165 10184 10824 11278 12669
2183 3740 4808 5217 5660 6375 6787 8219 8466 9037 10353 10583 11118 12762
73 1594 2146 2715 3501 3572 3639 3725 6959 7187 8406 10120 10507 10691
240 732 1215 2185 2788 2830 3499 3881 4197 4991 6425 7061 9756 10491
831 1568 1828 3424 4319 4516 4639 6018 9702 10203 10417 11240 11518 12458
2024 2970 3048 3638 3676 4152 5284 5779 5926 9426 9945 10873 11787 11837
1049 1218 1651 2328 3493 4363 5750 6483 7613 8782 9738 9803 11744 11937
1193 2060 2289 2964 3478 4592 4756 6709 7162 8231 8326 11140 11908 12243
978 2120 2439 3338 3850 4589 6567 8745 9656 9708 10161 10542 10711 12639
2403 2938 3117 3247 3711 5593 5844 5932 7801 10152 10226 11498 12162 12941
1781 2229 2276 2533 3582 3951 5279 5774 7930 9824 10920 11038 12340 12440
289 384 1980 2230 3464 3873 5958 8656 8942 9006 10175 11425 11745 12530
155 354 1090 1330 2002 2236 3559 3705 4922 5958 6576 8564 9972 12760
303 876 2059 2142 5244 5330 6644 7576 8614 9598 10410 10718 11033 12957
3449 3617 4408 4602 4727 6182 8835 8928 9372 9644 10237 10747 11655 12747
811 2565 2820 8677 8974 9632 11069 11548 11839 12107 12411 12695 12812 12890
972 4123 4943 6385 6449 7339 7477 8379 9177 9359 10074 11709 12552 12831
842 973 1541 2262 2905 5276 6758 7099 7894 8128 8325 8663 8875 10050
474 791 968 3902 4924 4965 5085 5908 6109 6329 7931 9038 9401 10568
1397 4461 4658 5911 6037 7127 7318 8678 8924 9000 9473 9602 10446 12692
1334 7571 12881
1393 1447 7972
633 1257 10597
4843 5102 11056
3294 8015 10513
1108 10374 10546
5353 7824 10111
3398 7674 8569
7719 9478 10503
2997 9418 9581
5777 6519 11229
1966 5214 9899
6 4088 5827
836 9248 9612
483 7229 7548
7865 8289 9804
2915 11098 11900
6180 7096 9481
1431 6786 8924
748 6757 8625
3312 4475 7204
1852 8958 11020
1915 2903 4006
6776 10886 12531
2594 9998 12742
159 2002 12079
853 3281 3762

5201 5798 6413
3882 6062 12047
4133 6775 9657
228 6874 11183
7433 10728 10864
7735 8073 12734
2844 4621 11779
3909 7103 12804
6002 9704 11060
5864 6856 7681
3652 5869 7605
2546 2657 4461
2423 4203 9111
244 1855 4691
1106 2178 6371
391 1617 10126
250 9259 10603
3435 4614 6924
1742 8045 9529
7667 8875 11451
4023 6108 6911
8621 10184 11650
6726 10861 12348
3228 6302 7388
1 1137 5358
381 2424 8537
3256 7508 10044
1980 2219 4569
2468 5699 10319
2803 3314 12808
8578 9642 11533
829 4585 7923
59 329 5575
1067 5709 6867
1175 4744 12219
109 2518 6756
2105 10626 11153
5192 10696 10749
6260 7641 8233
2998 3094 11214
3398 6466 11494
6574 10448 12160
2734 10755 12780
1028 7958 10825
8545 8602 10793
392 3398 11417
6639 9291 12571
1067 7919 8934
1064 2848 12753
6076 8656 12690
5504 6193 10171
1951 7156 7356
4389 4780 7889
526 4804 9141
1238 3648 10464
2587 5624 12557
5560 5903 11963
1134 2570 3297

10041 11583 12157
1263 9585 12912
3744 7898 10646
45 9074 10315
1051 6188 10038
2242 8394 12712
3598 9025 12651
2295 3540 5610
1914 4378 12423
1766 3635 12759
5177 9586 11143
943 3590 11649
4864 6905 10454
5852 6042 10421
6095 8285 12349
2070 7171 8563
718 12234 12716
512 10667 11353
3629 6485 7040
2880 8865 11466
4490 10220 11796
5440 8819 9103
5262 7543 12411
516 7779 10940
2515 5843 9202
4684 5994 10586
573 2270 3324
7870 8317 10322
6856 7638 12909
1583 7669 10781
8141 9085 12555
3903 5485 9992
4467 11998 12904.

13. The data processing device, according to claim 8, further comprising:

an encoder, which performs LDPC encoding based on a parity check matrix of an LDPC code whose code length is 64800 bits and code rate is 13/15, and
a decoder, which decodes the LDPC code provided from the data transmitted from the transmitting device, the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
142 2307 2598 2650 4028 4434 5781 5881 6016 6323 6681 6698 8125
2932 4928 5248 5256 5983 6773 6828 7789 8426 8494 8534 8539 8583
899 3295 3833 5399 6820 7400 7753 7890 8109 8451 8529 8564 8602
21 3060 4720 5429 5636 5927 6966 8110 8170 8247 8355 8365 8616
20 1745 2838 3799 4380 4418 4646 5059 7343 8161 8302 8456 8631
9 6274 6725 6792 7195 7333 8027 8186 8209 8273 8442 8548 8632
494 1365 2405 3799 5188 5291 7644 7926 8139 8458 8504 8594 8625
192 574 1179 4387 4695 5089 5831 7673 7789 8298 8301 8612 8632
11 20 1406 6111 6176 6256 6708 6834 7828 8232 8457 8495 8602
6 2654 3554 4483 4966 5866 6795 8069 8249 8301 8497 8509 8623
21 1144 2355 3124 6773 6805 6887 7742 7994 8358 8374 8580 8611
335 4473 4883 5528 6096 7543 7586 7921 8197 8319 8394 8489 8636
2919 4331 4419 4735 6366 6393 6844 7193 8165 8205 8544 8586 8617

12 19 742 930 3009 4330 6213 6224 7292 7430 7792 7922 8137
710 1439 1588 2434 3516 5239 6248 6827 8230 8448 8515 8581 8619
200 1075 1868 5581 7349 7642 7698 8037 8201 8210 8320 8391 8526
3 2501 4252 5256 5292 5567 6136 6321 6430 6486 7571 8521 8636
3062 4599 5885 6529 6616 7314 7319 7567 8024 8153 8302 8372 8598
105 381 1574 4351 5452 5603 5943 7467 7788 7933 8362 8513 8587
787 1857 3386 3659 6550 7131 7965 8015 8040 8312 8484 8525 8537
15 1118 4226 5197 5575 5761 6762 7038 8260 8338 8444 8512 8568
36 5216 5368 5616 6029 6591 8038 8067 8299 8351 8565 8578 8585
1 23 4300 4530 5426 5532 5817 6967 7124 7979 8022 8270 8437
629 2133 4828 5475 5875 5890 7194 8042 8345 8385 8518 8598 8612
11 1065 3782 4237 4993 7104 7863 7904 8104 8228 8321 8383 8565
2131 2274 3168 3215 3220 5597 6347 7812 8238 8354 8527 8557 8614
5600 6591 7491 7696
1766 8281 8626
1725 2280 5120
1650 3445 7652
4312 6911 8626
15 1013 5892
2263 2546 2979
1545 5873 7406
67 726 3697
2860 6443 8542
17 911 2820
1561 4580 6052
79 5269 7134
22 2410 2424
3501 5642 8627
808 6950 8571
4099 6389 7482
4023 5000 7833
5476 5765 7917
1008 3194 7207
20 495 5411
1703 8388 8635
6 4395 4921
200 2053 8206
1089 5126 5562
10 4193 7720
1967 2151 4608
22 738 3513
3385 5066 8152
440 1118 8537
3429 6058 7716
5213 7519 8382
5564 8365 8620
43 3219 8603
4 5409 5815
5 6376 7654
4091 5724 5953
5348 6754 8613
1634 6398 6632
72 2058 8605
3497 5811 7579
3846 6743 8559
15 5933 8629
2133 5859 7068
4151 4617 8566

2960 8270 8410
2059 3617 8210
544 1441 6895
4043 7482 8592
294 2180 8524
3058 8227 8373
364 5756 8617
5383 8555 8619
1704 2480 4181
7338 7929 7990
2615 3905 7981
4298 4548 8296
8262 8319 8630
892 1893 8028
5694 7237 8595
1487 5012 5810
4335 8593 8624
3509 4531 5273
10 22 830
4161 5208 6280
275 7063 8634
4 2725 3113
2279 7403 8174
1637 3328 3930
2810 4939 5624
3 1234 7687
2799 7740 8616
22 7701 8636
4302 7857 7993
7477 7794 8592
9 6111 8591
5 8606 8628
347 3497 4033
1747 2613 8636
1827 5600 7042
580 1822 6842
232 7134 7783
4629 5000 7231
951 2806 4947
571 3474 8577
2437 2496 7945
23 5873 8162
12 1168 7686
8315 8540 8596
1766 2506 4733
929 1516 3338
21 1216 6555
782 1452 8617
8 6083 6087
667 3240 4583
4030 4661 5790
559 7122 8553
3202 4388 4909
2533 3673 8594
1991 3954 6206
6835 7900 7980
189 5722 8573
2680 4928 4998

243 2579 7735
4281 8132 8566
7656 7671 8609
1116 2291 4166
21 388 8021
6 1123 8369
311 4918 8511
0 3248 6290
13 6762 7172
4209 5632 7563
49 127 8074
581 1735 4075
0 2235 5470
2178 5820 6179
16 3575 6054
1095 4564 6458
9 1581 5953
2537 6469 8552
14 3874 4844
0 3269 3551
2114 7372 7926
1875 2388 4057
3232 4042 6663
9 401 583
13 4100 6584
2299 4190 4410
21 3670 4979.

**14.** A data processing method, comprising:

a step of group-wise deinterleaving of returning a sequence of the LDPC code after group-wise interleave obtained from data transmitted from a transmitting device to the original sequence, the transmitting device comprising:

a group-wise interleave unit of performing group-wise interleave of interleaving in a 360-bit group unit an LDPC code whose code length is 64800 bits and code rate is 10/15, 11/15, 12/15 or 13/15,
the (i + 1)th bit group from the beginning of the LDPC code of the 64800 bits being as a bit group i, and in the group-wise interleave, a sequence of bit group 0 to 179 of the 64800 bits of the LDPC code being interleaved into the following sequence of the bit group:

90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

$$H = \begin{bmatrix} \cdots \cdots 1 \cdots \cdots 1 \cdot \vdots 1 \cdot \cdots \cdots 1 \cdots 1 \cdots 1 \end{bmatrix}$$

## FIG.1

```
        ┌─────────┐
        │  Start  │
        └────┬────┘
             │
             ▼
   ┌──────────────────────────┐
   │ Receive received value u_oi │ S11
   │        u_j=0, k=0         │
   └────────────┬─────────────┘
             │
             ▼
   ┌──────────────────────────┐
   │  Obtain Message v_i, and │ S12
   │ further obtain messages u_j │
   │        k = k + 1         │
   └────────────┬─────────────┘
             │
             ▼
         S13
   No ◄──◄ k>C ? ►
             │ Yes
             ▼
   ┌──────────────────────────┐
   │   Obtain message v_i     │ S14
   │     to be output         │
   └────────────┬─────────────┘
             │
             ▼
        ┌─────────┐
        │   End   │
        └─────────┘
```

Receive received value $u_{oi}$
$u_j=0$, $k=0$   S11

Obtain Message $v_i$, and
further obtain messages $u_j$
$k = k + 1$   S12

$k>C$ ?   S13

Obtain message $v_i$
to be output   S14

## FIG.2

$$H = \begin{bmatrix} 1 & 1 & 1 & 0 & 0 & 0 & 1 & 0 & 1 & 1 & 0 & 0 \\ 1 & 1 & 0 & 1 & 1 & 0 & 0 & 0 & 0 & 0 & 1 & 1 \\ 0 & 0 & 1 & 1 & 1 & 1 & 1 & 0 & 0 & 1 & 0 & 0 \\ 0 & 0 & 0 & 1 & 1 & 1 & 0 & 1 & 1 & 0 & 0 & 1 \\ 1 & 1 & 0 & 0 & 0 & 1 & 0 & 1 & 0 & 1 & 1 & 0 \\ 0 & 0 & 1 & 0 & 0 & 0 & 1 & 1 & 1 & 0 & 1 & 1 \end{bmatrix}$$

# FIG.3

Check node

Variable node

FIG.4

Variable node

$u_{0i}$

$u_1$

$u_2$

$v_i$

## FIG.5

Check node

$v_1$

$v_2$

$v_3$

$v_4$

$v_5$

$u_j$

## FIG.6

13

| Transmitting device | → | Communication channel | → | Receiving device |

11

12

Transmission system

## FIG.7

FIG.8

FIG.9

Information length K

Parity length M

H=

Information matrix H$_A$

Parity matrix H$_T$

Parity length M

Code length N

Parity check matrix

FIG.10

$H_T =$

Parity matrix $H_T$

FIG.11

Information matrix $H_A$ · Parity matrix $H_T$

Parity check matrix

| X | Column weight 3 | Column weight 2 | 1 |

KX · K3 · M−1 · 1

M

FIG.12

|  | N=64800 | | | | N=16200 | | | |
|---|---|---|---|---|---|---|---|---|
| Nominal code rate | X | KX | K3 | M | X | KX | K3 | M |
| 1/4 | 12 | 5400 | 10800 | 48600 | 12 | 1440 | 1800 | 12960 |
| 1/3 | 12 | 7200 | 14400 | 43200 | 12 | 1800 | 3600 | 10800 |
| 2/5 | 12 | 8640 | 17280 | 38880 | 12 | 2160 | 4320 | 9720 |
| 1/2 | 8 | 12960 | 19440 | 32400 | 8 | 1800 | 5400 | 9000 |
| 3/5 | 12 | 12960 | 25920 | 25920 | 12 | 3240 | 6480 | 6480 |
| 2/3 | 13 | 4320 | 38880 | 21600 | 13 | 1080 | 9720 | 5400 |
| 3/4 | 12 | 5400 | 43200 | 16200 | 12 | 360 | 11520 | 4320 |
| 4/5 | 11 | 6480 | 45360 | 12960 | – | 0 | 12600 | 3600 |
| 5/6 | 13 | 5400 | 48600 | 10800 | 13 | 360 | 12960 | 2880 |
| 8/9 | 4 | 7200 | 50400 | 7200 | 4 | 1800 | 12600 | 1800 |
| 9/10 | 4 | 6480 | 51840 | 6480 | ---- | ---- | ---- | ---- |

Number of columns of each column weight

## FIG.13

FIG.14

Stepwise structure of parity matrix

A

Code bit

Stepwise structure part of Tanner graph

B

FIG.15

FIG.16

Start

LDPC encoding | S101

Bit interleave
(group-wise interleave,
block interleave, interchanging process) | S102

Mapping, modulation | S103

End

# FIG.17

FIG.18

Start

S201 | Set code rate of parity check matrix

S202 | Read parity check matrix initial value table corresponding to code rate

S203 | Determine parity check matrix H for LDPC code

S204 | Read information bit column

S205 | Perform LDPC encoding of information bit column with parity check matrix H, calculate parity

S206 Does encoding end? No

Yes

End

# FIG.19

r1/4 16K
6295 9626 304 7695 4839 4936 1660 144 11203 5567 6347 12557
10691 4988 3859 3734 3071 3494 7687 10313 5964 8069 8296 11090
10774 3613 5208 11177 7676 3549 8746 6583 7239 12265 2674 4292
11869 3708 5981 8718 4908 10650 6805 3334 2627 10461 9285 11120
7844 3079 10773
3385 10854 5747
1360 12010 12202
6189 4241 2343
9840 12726 4977

# FIG.20

Indicate row number of parity check matrix (information matrix $H_A$)
from 1st column for each 360 columns

Row numbers of parity check matrix

1st row of $H_A$ ⟶
361st row of $H_A$ ⟶
721st row of $H_A$ ⟶
1081st row of $H_A$ ⟶

```
0  2084 1613 1548 1286 1460 3196 4297 2481 3369 3451 4620 2622
1  122  1516 3448 2880 1407 1847 3799 3529 373 971 4358 3108
2  259  3399 929  2650 864  3996 3833 107 5287 164 3125 2350
3  342  3529
4  4198 2147
5  1880 4836
6  3864 4910
7  243  1542
8  3011 1436
9  2167 2512
10 4606 1003
11 2835 705
12 3426 2365
13 3848 2474
14 1360 1743
0  163  2536
1  2583 1180
2  1542 509
3  4418 1005
4  5212 5117
5  2155 2922
6  347  2696
7  226  4296
8  1560 487
9  3926 1640
10 149  2928
11 2364 563
12 635  688
13 231  1684
14 1129 3894
```

$h_{3,5}$

Parity check matrix initial value table

FIG.21

N=64800, rate=7/15

7 15 26 69 1439 3712 5756 5792 5911 8456 10579 19462 19782 21709 23214 25142 26040 30206 30475 31211 31427 32105 32989 33082 33502 34116 34241 34288 34292 34318 34373 34390 34465

83 1159 2271 6500 6807 7823 10344 10700 13367 14162 14242 14352 15015 17301 18952 20811 24974 25795 27868 28081 33077 33204 33262 33350 33516 33677 33680 33930 34090 34250 34290 34377 34398

25 2281 2995 3321 6006 7482 8428 11489 11601 14011 17409 26210 29945 30675 31101 31355 31421 31543 31697 32056 32216 33282 33453 33487 33696 34044 34107 34213 34247 34261 34276 34467 34495

0 43 87 2530 4485 4595 9951 11212 12270 12344 15566 21335 24699 26580 28518 28564 28812 29821 30418 31467 31871 32513 32597 33187 33402 33706 33838 33932 33977 34084 34283 34440 34473

81 3344 5540 7711 13308 15400 15885 18265 18632 22209 23657 27736 29158 29701 29845 30409 30654 30855 31420 31604 32519 32901 33267 33444 33525 33712 33878 34031 34172 34432 34496 34502 34541

42 50 66 2501 4706 6715 6970 8637 9999 14555 22776 26479 27442 27984 28534 29587 31309 31783 31907 31927 31934 32313 32369 32830 33364 33434 33553 33654 33725 33889 33962 34467 34482

6534 7122 8723 13137 13183 15818 18307 19324 20017 26389 29326 31464 32678 33668 34217

50 113 2119 5038 5581 6397 6550 10987 22308 25141 25943 29299 30186 33240 33399

7262 8787 9246 10032 10505 13090 14587 14790 16374 19946 21129 25726 31033 33660 33675

5004 5087 5291 7949 9477 11845 12698 14585 15239 17486 18100 18259 21409 21789 24280

28 82 3939 5007 6682 10312 12485 14384 21570 25512 26612 26854 30371 31114 32689

437 3055 9100 9517 12369 19030 19950 21328 24196 24236 25928 28458 30013 32181 33560

18 3590 4832 7053 8919 21149 24256 26543 27266 30747 31839 32671 33089 33571 34296

2678 4569 4667 6551 7639 10057 24276 24563 25818 26592 27879 28028 29444 29873 34017

72 77 2874 9092 10041 13669 20676 20778 25566 28470 28888 30338 31772 32143 33939

296 2196 7309 11901 14025 15733 16768 23587 25489 30936 31533 33749 34331 34431 34507

FIG.22

```
  6 8144 12490 13275 14140 18706 20251 20644 21441 21938 23703 34190 34444 34463
34495
  5108 14499 15734 19222 24695 25667 28359 28432 30411 30720 34161 34386 34465 34511
34522
  61 89 3042 5524 12128 22505 22700 22919 24454 30526 33437 34114 34188 34490 34502
  11 83 4668 4856 6361 11633 15342 16393 16958 26613 29136 30917 32559 34346 34504
  3185 9728 25062
  1643 5531 21573
  2285 6088 24083
  78 14678 19119
  49 13705 33535
  21192 32280 32781
  10753 21469 22084
  10082 11950 13889
  7861 25107 29167
  14051 34171 34430
  706 894 8316
  29693 30445 32281
  10202 30964 34448
  15815 32453 34463
  4102 21608 24740
  4472 29399 31435
  1162 7118 23226
  4791 33548 34096
  1084 34099 34418
  1765 20745 33714
  1302 21300 33655
  33 8736 16646
  53 18671 19089
  21 572 2028
  3339 11506 16745
  285 6111 12643
  27 10336 11586
  21046 32728 34538
  22215 24195 34026
  19975 26938 29374
```

FIG.23

```
16473 26777 34212
20 29260 32784
35 31645 32837
26132 34410 34495
12446 20649 26851
6796 10992 31061
0 46 8420
10 636 22885
7183 16342 18305
1 5604 28258
6071 18675 34489
16786 25023 33323
3573 5081 10925
5067 31761 34415
3735 33534 34522
85 32829 34518
6555 23368 34559
22083 29335 29390
6738 21110 34316
120 4192 11123
3313 4144 20824
27783 28550 31034
6597 8164 34427
18009 23474 32460
94 6342 12656
17 31962 34535
15091 24955 28545
15 3213 28298
26562 30236 34537
16832 20334 24628
4841 20669 26509
18055 23700 34534
23576 31496 34492
10699 13826 34440
```

# FIG.24

N=64800, rate=9/15

113 1557 3316 5680 6241 10407 13404 13947 14040 14353 15522 15698 16079 17363 19374 19543 20530 22833 24339

271 1361 6236 7006 7307 7333 12768 15441 15568 17923 18341 20321 21502 22023 23938 25351 25590 25876 25910

73 605 872 4008 6279 7653 10346 10799 12482 12935 13604 15909 16526 19782 20506 22804 23629 24859 25600

1445 1690 4304 4851 8919 9176 9252 13783 16076 16675 17274 18806 18882 20819 21958 22451 23869 23999 24177

1290 2337 5661 6371 8996 10102 10941 11360 12242 14918 16808 20571 23374 24046 25045 25060 25662 25783 25913

28 42 1926 3421 3503 8558 9453 10168 15820 17473 19571 19685 22790 23336 23367 23890 24061 25657 25680

0 1709 4041 4932 5968 7123 8430 9564 10596 11026 14761 19484 20762 20858 23803 24016 24795 25853 25863

29 1625 6500 6609 16831 18517 18568 18738 19387 20159 20544 21603 21941 24137 24269 24416 24803 25154 25395

55 66 871 3700 11426 13221 15001 16367 17601 18380 22796 23488 23938 25476 25635 25678 25807 25857 25872

1 19 5958 8548 8860 11489 16845 18450 18469 19496 20190 23173 25262 25566 25668 25679 25858 25888 25915

7520 7690 8855 9183 14654 16695 17121 17854 18083 18428 19633 20470 20736 21720 22335 23273 25083 25293 25403

48 58 410 1299 3786 10668 18523 18963 20864 22106 22308 23033 23107 23128 23990 24286 24409 24595 25802

12 51 3894 6539 8276 10885 11644 12777 13427 14039 15954 17078 19053 20537 22863 24521 25087 25463 25838

3509 8748 9581 11509 15884 16230 17583 19264 20900 21001 21310 22547 22756 22959 24768 24814 25594 25626 25880

21 29 69 1448 2386 4601 6626 6667 10242 13141 13852 14137 18640 19951 22449 23454 24431 25512 25814

18 53 7890 9934 10063 16728 19040 19809 20825 21522 21800 23582 24556 25031 25547 25562 25733 25789 25906

4096 4582 5766 5894 6517 10027 12182 13247 15207 17041 18958 20133 20503 22228 24332 24613 25689 25855 25883

0 25 819 5539 7076 7536 7695 9532 13668 15051 17683 19665 20253 21996 24136 24890 25758 25784 25807

34 40 44 4215 6076 7427 7965 8777 11017 15593 19542 22202 22973 23397 23423 24418 24873 25107 25644

1595 6216 22850 25439
1562 15172 19517 22362
7508 12879 24324 24496
6298 15819 16757 18721
11173 15175 19966 21195
59 13505 16941 23793
2267 4830 12023 20587
8827 9278 13072 16664
14419 17463 23398 25348
6112 16534 20423 22698
493 8914 21103 24799
6896 12761 13206 25873
2 1380 12322 21701
11600 21306 25753 25790

FIG.25

```
8421 13076 14271 15401
9630 14112 19017 20955
212 13932 21781 25824
5961 9110 16654 19636
58 5434 9936 12770
6575 11433 19798
2731 7338 20926
14253 18463 25404
21791 24805 25869
2 11646 15850
6075 8586 23819
18435 22093 24852
2103 2368 11704
10925 17402 18232
9062 25061 25674
18497 20853 23404
18606 19364 19551
7 1022 25543
6744 15481 25868
9081 17305 25164
8 23701 25883
9680 19955 22848
56 4564 19121
5595 15086 25892
3174 17127 23183
19397 19817 20275
12561 24571 25825
7111 9889 25865
19104 20189 21851
549 9686 25548
6586 20325 25906
3224 20710 21637
641 15215 25754
13484 23729 25818
2043 7493 24246
16860 25230 25768
22047 24200 24902
9391 18040 19499
7855 24336 25069
23834 25570 25852
1977 8800 25756
6671 21772 25859
3279 6710 24444
24099 25117 25820
5553 12306 25915
48 11107 23907
10832 11974 25773
2223 17905 25484
16782 17135 20446
475 2861 3457
16218 22449 24362
11716 22200 25897
8315 15009 22633
```

FIG.26

```
13 20480 25852
12352 18658 25687
3681 14794 23703
30 24531 25846
4103 22077 24107
23837 25622 25812
3627 13387 25839
908 5367 19388
0 6894 25795
20322 23546 25181
8178 25260 25437
2449 13244 22565
31 18928 22741
1312 5134 14838
6085 13937 24220
66 14633 25670
47 22512 25472
8867 24704 25279
6742 21623 22745
147 9948 24178
8522 24261 24307
19202 22406 24609
```

FIG.27

N=64800, rate=11/15

```
696 989 1238 3091 3116 3738 4269 6406 7033 8048 9157 10254 12033 16456 16912
444 1488 6541 8626 10735 12447 13111 13706 14135 15195 15947 16453 16916 17137 17268
401 460 992 1145 1576 1678 2238 2320 4280 6770 10027 12486 15363 16714 17157
1161 3108 3727 4508 5092 5348 5582 7727 11793 12515 12917 13362 14247 16717 17205
542 1190 6883 7911 8349 8835 10489 11631 14195 15009 15454 15482 16632 17040 17063
17 487 776 880 5077 6172 9771 11446 12798 16016 16109 16171 17087 17132 17226
1337 3275 3462 4229 9246 10180 10845 10866 12250 13633 14482 16024 16812 17186 17241
15 980 2305 3674 5971 8224 11499 11752 11770 12897 14082 14836 15311 16391 17209
0 3926 5869 8696 9351 9391 11371 14052 14172 14636 14974 16619 16961 17033 17237
3033 5317 6501 8579 10698 12168 12966 14019 15392 15806 15991 16493 16690 17062 17090
981 1205 4400 6410 11003 13319 13405 14695 15846 16297 16492 16563 16616 16862 16953
1725 4276 8869 9588 14062 14486 15474 15548 16300 16432 17042 17050 17060 17175 17273
1807 5921 9960 10011 14305 14490 14872 15852 16054 16061 16306 16799 16833 17136 17262
2826 4752 6017 6540 7016 8201 14245 14419 14716 15983 16569 16652 17171 17179 17247
1662 2516 3345 5229 8086 9686 11456 12210 14595 15808 16011 16421 16825 17112 17195
2890 4821 5987 7226 8823 9869 12468 14694 15352 15805 16075 16462 17102 17251 17263
3751 3890 4382 5720 10281 10411 11350 12721 13121 14127 14980 15202 15335 16735 17123
26 30 2805 5457 6630 7188 7477 7556 11065 16608 16859 16909 16943 17030 17103
40 4524 5043 5566 9645 10204 10282 11696 13080 14837 15607 16274 17034 17225 17266
904 3157 6284 7151 7984 11712 12887 13767 15547 16099 16753 16829 17044 17250 17259
7 311 4876 8334 9249 11267 14072 14559 15003 15235 15686 16331 17177 17238 17253
4410 8066 8596 9631 10369 11249 12610 15769 16791 16960 17018 17037 17062 17165 17204
24 8261 9691 10138 11607 12782 12786 13424 13933 15262 15795 16476 17084 17193 17220
88 11622 14705 15890
304 2026 2638 6018
1163 4268 11620 17232
9701 11785 14463 17260
4118 10952 12224 17006
3647 10823 11521 12060
1717 3753 9199 11642
2187 14280 17220
14787 16903 17061
381 3534 4294
3149 6947 8323
12562 16724 16881
7289 9997 15306
5615 13152 17260
5666 16926 17027
4190 7798 16831
4778 10629 17180
10001 13884 15453
6 2237 8203
7831 15144 15160
9186 17204 17243
9435 17168 17237
42 5701 17159
7812 14259 15715
39 4513 6658
38 9368 11273
1119 4785 17182
5620 16521 16729
```

FIG.28

```
16 6685 17242
210 3452 12383
466 14462 16250
10548 12633 13962
1452 6005 16453
22 4120 13684
5195 11563 16522
5518 16705 17201
12233 14552 15471
6067 13440 17248
8660 8967 17061
8673 12176 15051
5959 15767 16541
3244 12109 12414
31 15913 16323
3270 15686 16653
24 7346 14675
12 1531 8740
6228 7565 16667
16936 17122 17162
4868 8451 13183
3714 4451 16919
11313 13801 17132
17070 17191 17242
1911 11201 17186
14 17190 17254
11760 16008 16832
14543 17033 17278
16129 16765 17155
6891 15561 17007
12741 14744 17116
8992 16661 17277
1861 11130 16742
4822 13331 16192
13281 14027 14989
38 14887 17141
10698 13452 15674
4 2539 16877
857 17170 17249
11449 11906 12867
285 14118 16831
15191 17214 17242
39 728 16915
2469 12969 15579
16644 17151 17164
2592 8280 10448
9236 12431 17173
9064 16892 17233
4526 16146 17038
31 2116 16083
15837 16951 17031
5362 8382 16618
6137 13199 17221
```

FIG.29

```
2841 15068 17068
24 3620 17003
9880 15718 16764
1784 10240 17209
2731 10293 10846
3121 8723 16598
8563 15662 17088
13 1167 14676
29 13850 15963
3654 7553 8114
23 4362 14865
4434 14741 16688
8362 13901 17244
13687 16736 17232
46 4229 13394
13169 16383 16972
16031 16681 16952
3384 9894 12580
9841 14414 16165
5013 17099 17115
2130 8941 17266
6907 15428 17241
16 1860 17235
2151 16014 16643
14954 15958 17222
3969 8419 15116
31 15593 16984
11514 16605 17255
```

# FIG.30

N=64800, rate=13/15

```
  142 2307 2598 2650 4028 4434 5781 5881 6016 6323 6681 6698 8125
 2932 4928 5248 5256 5983 6773 6828 7789 8426 8494 8534 8539 8583
  899 3295 3833 5399 6820 7400 7753 7890 8109 8451 8529 8564 8602
   21 3060 4720 5429 5636 5927 6966 8110 8170 8247 8355 8365 8616
   20 1745 2838 3799 4380 4418 4646 5059 7343 8161 8302 8456 8631
    9 6274 6725 6792 7195 7333 8027 8186 8209 8273 8442 8548 8632
  494 1365 2405 3799 5188 5291 7644 7926 8139 8458 8504 8594 8625
  192  574 1179 4387 4695 5089 5831 7673 7789 8298 8301 8612 8632
   11   20 1406 6111 6176 6256 6708 6834 7828 8232 8457 8495 8602
    6 2654 3554 4483 4966 5866 6795 8069 8249 8301 8497 8509 8623
   21 1144 2355 3124 6773 6805 6887 7742 7994 8358 8374 8580 8611
  335 4473 4883 5528 6096 7543 7586 7921 8197 8319 8394 8489 8636
 2919 4331 4419 4735 6366 6393 6844 7193 8165 8205 8544 8586 8617
   12   19  742  930 3009 4330 6213 6224 7292 7430 7792 7922 8137
  710 1439 1588 2434 3516 5239 6248 6827 8230 8448 8515 8581 8619
  200 1075 1868 5581 7349 7642 7698 8037 8201 8210 8320 8391 8526
    3 2501 4252 5256 5292 5567 6136 6321 6430 6486 7571 8521 8636
 3062 4599 5885 6529 6616 7314 7319 7567 8024 8153 8302 8372 8598
  105  381 1574 4351 5452 5603 5943 7467 7788 7933 8362 8513 8587
  787 1857 3386 3659 6550 7131 7965 8015 8040 8312 8484 8525 8537
   15 1118 4226 5197 5575 5761 6762 7038 8260 8338 8444 8512 8568
   36 5216 5368 5616 6029 6591 8038 8067 8299 8351 8565 8578 8585
    1   23 4300 4530 5426 5532 5817 6967 7124 7979 8022 8270 8437
  629 2133 4828 5475 5875 5890 7194 8042 8345 8385 8518 8598 8612
   11 1065 3782 4237 4993 7104 7863 7904 8104 8228 8321 8383 8565
 2131 2274 3168 3215 3220 5597 6347 7812 8238 8354 8527 8557 8614
 5600 6591 7491 7696
 1766 8281 8626
 1725 2280 5120
 1650 3445 7652
 4312 6911 8626
   15 1013 5892
 2263 2546 2979
 1545 5873 7406
   67  726 3697
 2860 6443 8542
   17  911 2820
 1561 4580 6052
   79 5269 7134
   22 2410 2424
 3501 5642 8627
  808 6950 8571
 4099 6389 7482
 4023 5000 7833
 5476 5765 7917
 1008 3194 7207
   20  495 5411
 1703 8388 8635
    6 4395 4921
  200 2053 8206
 1089 5126 5562
```

FIG.31

```
10 4193 7720
1967 2151 4608
22 738 3513
3385 5066 8152
440 1118 8537
3429 6058 7716
5213 7519 8382
5564 8365 8620
43 3219 8603
4 5409 5815
5 6376 7654
4091 5724 5953
5348 6754 8613
1634 6398 6632
72 2058 8605
3497 5811 7579
3846 6743 8559
15 5933 8629
2133 5859 7068
4151 4617 8566
2960 8270 8410
2059 3617 8210
544 1441 6895
4043 7482 8592
294 2180 8524
3058 8227 8373
364 5756 8617
5383 8555 8619
1704 2480 4181
7338 7929 7990
2615 3905 7981
4298 4548 8296
8262 8319 8630
892 1893 8028
5694 7237 8595
1487 5012 5810
4335 8593 8624
3509 4531 5273
10 22 830
4161 5208 6280
275 7063 8634
4 2725 3113
2279 7403 8174
1637 3328 3930
2810 4939 5624
3 1234 7687
2799 7740 8616
22 7701 8636
4302 7857 7993
7477 7794 8592
9 6111 8591
5 8606 8628
347 3497 4033
```

FIG.32

```
1747 2613 8636
1827 5600 7042
580 1822 6842
232 7134 7783
4629 5000 7231
951 2806 4947
571 3474 8577
2437 2496 7945
23 5873 8162
12 1168 7686
8315 8540 8596
1766 2506 4733
929 1516 3338
21 1216 6555
782 1452 8617
8 6083 6087
667 3240 4583
4030 4661 5790
559 7122 8553
3202 4388 4909
2533 3673 8594
1991 3954 6206
6835 7900 7980
189 5722 8573
2680 4928 4998
243 2579 7735
4281 8132 8566
7656 7671 8609
1116 2291 4166
21 388 8021
6 1123 8369
311 4918 8511
0 3248 6290
13 6762 7172
4209 5632 7563
49 127 8074
581 1735 4075
0 2235 5470
2178 5820 6179
16 3575 6054
1095 4564 6458
9 1581 5953
2537 6469 8552
14 3874 4844
0 3269 3551
2114 7372 7926
1875 2388 4057
3232 4042 6663
9 401 583
13 4100 6584
2299 4190 4410
21 3670 4979
```

# FIG.33

```
┌─ Parity check matrix initial value table of N=16200, r= 6/15 ─────────────────────────

  13 88 136 188 398 794 855 918 954 1950 2762 2837 2847 4209 4342 5092 5334 5498 5731 5837 6150 6942 7127 7402 7936 8235 8307
8600 9001 9419 9442 9710
  619 792 1002 1148 1528 1533 1925 2207 2766 3021 3267 3593 3947 4832 4873 5109 5488 5882 6079 6097 6276 6499 6584 6738 6795
7550 7723 7786 8732 9060 9270 9401
  499 717 1551 1791 2535 3135 3582 3813 4047 4309 5126 5186 5219 5716 5977 6236 6406 6586 6591 7085 7199 7485 7726 7878 8027
8066 8425 8802 9309 9464 9553 9671
  658 4058 7824 8512
  3245 4743 8117 9369
  465 6559 8112 9461
  975 2368 4444 6095
  4128 5993 9182 9473
  9 3822 5306 5320
  4 8311 9571 9669
  13 8122 8949 9656
  3353 4449 5829 8053
  7885 9118 9674
  7575 9591 9670
  431 8123 9271
  4228 7587 9270
  8847 9146 9556
  11 5213 7763
```

FIG.34

```
┌─ N=16200, rate=8/15 ─────────────────────────────────────────────────────────────────────
│
│    5 519 825 1871 2098 2478 2659 2820 3200 3294 3650 3804 3949 4426 4460 4503 4568 4590 4949
│  5219 5662 5738 5905 5911 6160 6404 6637 6708 6737 6814 7263 7412
│    81 391 1272 1633 2062 2882 3443 3503 3535 3908 4033 4163 4490 4929 5262 5399 5576 5768 5910
│  6331 6430 6844 6867 7201 7274 7290 7343 7350 7378 7387 7440 7554
│    105 975 3421 3480 4120 4444 5957 5971 6119 6617 6761 6810 7067 7353
│    6 138 485 1444 1512 2615 2990 3109 5604 6435 6513 6632 6704 7507
│    20 858 1051 2539 3049 5162 5308 6158 6391 6604 6744 7071 7195 7238
│    1140 5838 6203 6748
│    6282 6466 6481 6638
│    2346 2592 5436 7487
│    2219 3897 5896 7528
│    2897 6028 7018
│    1285 1863 5324
│    3075 6005 6466
│    5 6020 7551
│    2121 3751 7507
│    4027 5488 7542
│    2 6012 7011
│    3823 5531 5687
│    1379 2262 5297
│    1882 7498 7551
│    3749 4806 7227
│    2 2074 6898
│    17 616 7482
│    9 6823 7480
│    5195 5880 7559
│
└────────────────────────────────────────────────────────────────────────────────────────────
```

## FIG.35

```
┌─N=16200, rate=10/15──────────────────────────────────────────────────────────────────┐
│    352 747 894 1437 1688 1807 1883 2119 2159 3321 3400 3543 3588 3770 3821 4384 4470 4884 5012
│ 5036 5084 5101 5271 5281 5353
│    505 915 1156 1269 1518 1650 2153 2256 2344 2465 2509 2867 2875 3007 3254 3519 3687 4331 4439
│ 4532 4940 5011 5076 5113 5367
│    268 346 650 919 1260 4389 4653 4721 4838 5054 5157 5162 5275 5362
│    220 236 828 1590 1792 3259 3647 4276 4281 4325 4963 4974 5003 5037
│    381 737 1099 1409 2364 2955 3228 3341 3473 3985 4257 4730 5173 5242
│    88 771 1640 1737 1803 2408 2575 2974 3167 3464 3780 4501 4901 5047
│    749 1502 2201 3189
│    2873 3245 3427
│    2158 2605 3165
│    1 3438 3606
│    10 3019 5221
│    371 2901 2923
│    9 3935 4683
│    1937 3502 3735
│    507 3128 4994
│    25 3854 4550
│    1178 4737 5366
│    2 223 5304
│    1146 5175 5197
│    1816 2313 3649
│    740 1951 3844
│    1320 3703 4791
│    1754 2905 4058
│    7 917 5277
│    3048 3954 5396
│    4804 4824 5105
│    2812 3895 5226
│    0 5318 5358
│    1483 2324 4826
│    2266 4752 5387
└──────────────────────────────────────────────────────────────────────────────────────┘
```

# FIG.36

Parity check matrix initial value table of N=16200, r=12/15
```
3 394 1014 1214 1361 1477 1534 1660 1856 2745 2987 2991 3124 3155
59 136 528 781 803 928 1293 1489 1944 2041 2200 2613 2690 2847
155 245 311 621 1114 1269 1281 1783 1995 2047 2672 2803 2885 3014
79 870 974 1326 1449 1531 2077 2317 2467 2627 2811 3083 3101 3132
4 582 660 902 1048 1482 1697 1744 1928 2628 2699 2728 3045 3104
175 395 429 1027 1061 1068 1154 1168 1175 2147 2359 2376 2613 2682
1388 2241 3118 3148
143 506 2067 3148
1594 2217 2705
398 988 2551
1149 2588 2654
678 2844 3115
1508 1547 1954
1199 1267 1710
2589 3163 3207
1 2583 2974
2766 2897 3166
929 1823 2742
1113 3007 3239
1753 2478 3127
0 509 1811
1672 2646 2984
965 1462 3230
3 1077 2917
1183 1316 1662
968 1593 3239
64 1996 2226
1442 2058 3181
513 973 1058
1263 3185 3229
681 1394 3017
419 2853 3217
3 2404 3175
2417 2792 2854
1879 2940 3235
647 1704 3060
```

## FIG.37

```
Parity check matrix initial value table of N=16200, r=10/15

76 545 1005 1029 1390 1970 2525 2971 3448 3845 4088 4114 4163 4373 4640 4705 4970 5094
14 463 600 1676 2239 2319 2326 2815 2887 4278 4457 4493 4597 4918 4989 5038 5261 5384
451 632 829 1006 1530 1723 2205 2587 2801 3041 3849 4382 4595 4727 5006 5156 5224 5286
211 265 1293 1777 1926 2214 2909 2957 3178 3278 3771 4547 4563 4737 4879 5068 5232 5344
6 2901 3925 5384
2858 4152 5006 5202
9 1232 2063 2768
7 11 2781 3871
12 2161 2820 4078
3 3510 4668 5323
253 411 3215 5241
3919 4789 5040 5302
12 5113 5256 5352
9 1461 4004 5241
1688 3585 4480 5394
8 2127 3469 4360
2827 4049 5084 5379
1770 3331 5315 5386
1885 2817 4900 5088
2568 3854 4660
1604 3565 5373
2317 4636 5156
2480 2816 4094
14 4518 4826
127 1192 3872
93 2282 3663
2962 5085 5314
2078 4277 5089
9 5280 5292
50 2847 4742
```

FIG.38

N=16200, rate=12/15

0 190 429 730 785 1276 1437 1679 2235 2321 2459 2492 2610 2626 2838 2884 3101 3235
250 451 1734 1738 1786 1895 1998 2148 2162 2231 2374 2894 3172 3198 3213 3233
675 869 1110 1143 1295 1340 1771 1797 2066 2530 2590 2650 2704 2809 2973 3143
3 430 889 913 1505 1820 2188 2382 2564 2627 2773 2885 3054 3093 3132 3209
8 78 704 988 1152 1271 1275 1749 1942 1992 2187 2470 2548 2569 3227 3239
5 219 376 534 1657 1715 1738 2056 2189 2218 2517 2545 2589 2882 2906 3006
522 1808 2192 2305
1 1833 2572 3077
0 2272 2945 3072
341 824 2695
16 465 1730
1558 2208 2736
407 420 495
652 2087 3229
5 2100 2935
174 305 3220
1359 2854 3098
2587 2975 3003
2155 3059 3070
2 987 1193
1488 2545 3015
4 995 2913
2091 2305 3175
1970 2954 3141
2558 2739 3025
7 148 1188
384 1547 3038
1394 2043 2146
133 2586 2864
1306 2382 2849
1461 2779 2864
44 1904 3091
532 1899 3210
1939 2648 3153
494 3119 3157
24 1647 3169

FIG.39

NN=64800, rate=6/15

1606 3402 4961 6751 7132 11516 12300 12482 12592 13342 13764 14123 21576 23946 24533 25376
25667 26836 31799 34173 35462 36153 36740 37085 37152 37468 37658
4621 5007 6910 8732 9757 11508 13099 15513 16335 18052 19512 21319 23663 25628 27208 31333
32219 33003 33239 33447 36200 36473 36938 37201 37283 37495 38642
16 1094 2020 3080 4194 5098 5631 6877 7889 8237 9804 10067 11017 11366 13136 13354 15379
18934 20199 24522 26172 28666 30386 32714 36390 37015 37162
700 897 1708 6017 6490 7372 7825 9546 10398 16605 18561 18745 21625 22137 23693 24340 24966
25015 26995 28586 28895 29687 33938 34520 34858 37056 38297
159 2010 2573 3617 4452 4958 5556 5832 6481 8227 9924 10836 14954 15594 16623 18065 19249
22394 22677 23408 23731 24076 24776 27007 28222 30343 38371
3118 3545 4768 4992 5227 6732 8170 9397 10522 11508 15536 20218 21921 28599 29445 29758 29968
31014 32027 33685 34378 35867 36323 36728 36870 38335 38623
1264 4254 6936 9165 9486 9950 10861 11653 13697 13961 15164 15665 18444 19470 20313 21189
24371 26431 26999 28086 28251 29261 31981 34015 35850 36129 37186
111 1307 1628 2041 2524 5358 7988 8191 10322 11905 12919 14127 15515 15711 17061 19024 21195
22902 23727 24401 24608 25111 25228 27338 35398 37794 38196
961 3035 7174 7948 13355 13607 14971 18189 18339 18665 18875 19142 20615 21136 21309 21758
23366 24745 25849 25982 27583 30006 31118 32106 36469 36583 37920
2990 3549 4273 4808 5707 6021 6509 7456 8240 10044 12262 12660 13085 14750 15680 16049 21587
23997 25803 28343 28693 34393 34860 35490 36021 37737 38296
955 4323 5145 6885 8123 9730 11840 12216 19194 20313 23056 24248 24830 25268 26617 26801
28557 29753 30745 31450 31973 32839 33025 33296 35710 37366 37509
264 605 4181 4483 5156 7238 8863 10939 11251 12964 16254 17511 20017 22395 22818 23261 23422
24064 26329 27723 28186 30434 31956 33971 34372 36764 38123
520 2562 2794 3528 3860 4402 5676 6963 8655 9018 9783 11933 16336 17193 17320 19035 20606
23579 23769 24123 24966 27866 32457 34011 34499 36620 37526
10106 10637 10906 34242
1856 15100 19378 21848
943 11191 27806 29411
4575 6359 13629 19383
4476 4953 18782 24313
5441 6381 21840 35943
9638 9763 12546 30120
9587 10626 11047 25700
4088 15298 28768 35047
2332 6363 8782 28863
4625 4933 28298 30289
3541 4918 18257 31746
1221 25233 26757 34892
8150 16677 27934 30021
8500 25016 33043 38070
7374 10207 16189 35811
611 18480 20064 38261
25416 27352 36089 38469
1667 17614 25839 32776
4118 12481 21912 37945
5573 13222 23619 31271
18271 26251 27182 30587

Provided from Samsung

# FIG.40

14690 26430 26799 34355
13688 16040 20716 34558
2740 14957 23436 32540
3491 14365 14681 36858
4796 6238 25203 27854
1731 12816 17344 26025
19182 21662 23742 27872
6502 13641 17509 34713
12246 12372 16746 27452
1589 21528 30621 34003
12328 20515 30651 31432
3415 22656 23427 36395
632 5209 25958 31085
619 3690 19648 37778
9528 13581 26965 36447
2147 26249 26968 28776
15698 18209 30683
1132 19888 34111
4608 25513 38874
475 1729 34100
7348 32277 38587
182 16473 33082
3865 9678 21265
4447 20151 27618
6335 14371 38711
704 9695 28858
4856 9757 30546
1993 19361 30732
756 28000 29138
3821 24076 31813
4611 12326 32291
7628 21515 34995
1246 13294 30068
6466 33233 35865
14484 23274 38150
21269 36411 37450
23129 26195 37653

Provided from Samsung

# FIG.41

N=64800, rate=8/15

2768 3039 4059 5856 6245 7013 8157 9341 9802 10470 11521 12083 16610 18361 20321 24601 27420 28206 29788

2739 8244 8891 9157 12624 12973 15534 16622 16919 18402 18780 19854 20220 20543 22306 25540 27478 27678 28053

1727 2268 6246 7815 9010 9556 10134 10472 11389 14599 15719 16204 17342 17666 18850 22058 25579 25860 29207

28 1346 3721 5565 7019 9240 12355 13109 14800 16040 16839 17369 17631 19357 19473 19891 20381 23911 29683

869 2450 4386 5316 6160 7107 10362 11132 11271 13149 16397 16532 17113 19894 22043 22784 27383 28615 28804

508 4292 5831 8559 10044 10412 11283 14810 15888 17243 17538 19903 20528 22090 22652 27235 27384 28208 28485

389 2248 5840 6043 7000 9054 11075 11760 12217 12565 13587 15403 19422 19528 21493 25142 27777 28566 28702

1015 2002 5764 6777 9346 9629 11039 11153 12690 13068 13990 16841 17702 20021 24106 26300 29332 30081 30196

1480 3084 3467 4401 4798 5187 7851 11368 12323 14325 14546 16360 17158 18010 21333 25612 26556 26906 27005

6925 8876 12392 14529 15253 15437 19226 19950 20321 23021 23651 24393 24653 26668 27205 28269 28529 29041 29292

2547 3404 3538 4666 5126 5468 7695 8799 14732 15072 15881 17410 18971 19609 19717 22150 24941 27908 29018

888 1581 2311 5511 7218 9107 10454 12252 13662 15714 15894 17025 18671 24304 25316 25556 28489 28977 29212

1047 1494 1718 4645 5030 6811 7868 8146 10611 15767 17682 18391 22614 23021 23763 25478 26491 29088 29757

59 1781 1900 3814 4121 8044 8906 9175 11156 14841 15789 16033 16755 17292 18550 19310 22505 29567 29850

1952 3057 4399 9476 10171 10769 11335 11569 15002 19501 20621 22642 23452 24360 25109 25290 25828 28505 29122

2895 3070 3437 4764 4905 6670 9244 11845 13352 13573 13975 14600 15871 17996 19672 20079 20579 25327 27958

612 1528 2004 4244 4599 4926 5843 7684 10122 10443 12267 14368 18413 19058 22985 24257 26202 26596 27899

1361 2195 4146 6708 7158 7538 9138 9998 14862 15359 16076 18925 21401 21573 22503 24146 24247 27778 29312

5229 6235 7134 7655 9139 13527 15408 16058 16705 18320 19909 20901 22238 22437 23654 25131 27550 28247 29903

697 2035 4887 5275 6909 9166 11805 15338 16381 18403 20425 20688 21547 24590 25171 26726 28848 29224 29412

5379 17329 22659 23062

11814 14759 22329 22936

2423 2811 10296 12727

8460 15260 16769 17290

14191 14608 29536 30187

7103 10069 20111 22850

4285 15413 26448 29069

548 2137 9189 10928

Provided from Samsung

FIG.42

4581 7077 23382 23949
3942 17248 19486 27922
8668 10230 16922 26678
6158 9980 13788 28198
12422 16076 24206 29887
8778 10649 18747 22111
21029 22677 27150 28980
7918 15423 27672 27803
5927 18086 23525
3397 15058 30224
24016 25880 26268
1096 4775 7912
3259 17301 20802
129 8396 15132
17825 28119 28676
2343 8382 28840
3907 18374 20939
1132 1290 8786
1481 4710 28846
2185 3705 26834
5496 15681 21854
12697 13407 22178
12788 21227 22894
629 2854 6232
2289 18227 27458
7593 21935 23001
3836 7081 12282
7925 18440 23135
497 6342 9717
11199 22046 30067
12572 28045 28990
1240 2023 10933
19566 20629 25186
6442 13303 28813
4765 10572 16180
552 19301 24286
6782 18480 21383
11267 12288 15758
771 5652 15531
16131 20047 25649
13227 23035 24450
4839 13467 27488
2852 4677 22993
2504 28116 29524
12518 17374 24267
1222 11859 27922
9660 17286 18261
232 11296 29978
9750 11165 16295
4894 9505 23622

Provided from Samsung

FIG.43

```
10861 11980 14110
2128 15883 22836
6274 17243 21989
10866 13202 22517
11159 16111 21608
3719 18787 22100
1756 2020 23901
20913 29473 30103
2729 15091 26976
4410 8217 12963
5395 24564 28235
3859 17909 23051
5733 26005 29797
1935 3492 29773
11903 21380 29914
6091 10469 29997
2895 8930 15594
1827 10028 20070
```

Provided from Samsung

# FIG.44

```
─ N=64800, rate=10/15 ────────────────────────────────────────────────────────
   979  1423  4166  4609  6341  8258 10334 10548 14098 14514 17051 17333 17653 17830 17990
  2559  4025  6344  6510  9167  9728 11312 14856 17104 17721 18600 18791 19079 19697 19840
  3243  6894  7950 10539 12042 13233 13938 14752 16449 16727 17025 18297 18796 19400 21577
  3272  3574  6341  6722  9191 10807 10957 12531 14036 15580 16651 17007 17309 19415 19845
   155  4598 10201 10975 11086 11296 12713 15364 15978 16395 17542 18164 18451 18612 20617
  1128  1999  3926  4069  5558  6085  6337  8386 10693 12450 15438 16223 16370 17308 18634
  2408  2929  3630  4357  5852  7329  8536  8695 10603 11003 14304 14937 15767 18402 21502
   199  3066  6446  6849  8973  9536 10452 12857 13675 15913 16717 17654 19802 20115 21579
   312   870  2095  2586  5517  6196  6757  7311  7368 13046 15384 18576 20349 21424 21587
   985  1591  3248  3509  3706  3847  6174  6276  7864  9033 13618 15675 16446 18355 18843
   975  3774  4083  5825  6166  7218  7633  9657 10103 13052 14240 17320 18126 19544 20208
  1795  2005  2544  3418  6148  8051  9066  9725 10676 10752 11512 15171 17523 20481 21059
   167   315  1824  2325  2640  2868  6070  6597  7016  8109  9815 11608 16142 17912 19625
  1298  1896  3039  4303  4690  8787 12241 13600 14478 15492 16602 17115 17913 19466 20597
   568  3695  6045  6624  8131  8404  8590  9059  9246 11570 14336 18657 18941 19218 21506
   228  1889  1967  2299  3011  5074  7044  7596  7689  9534 10244 10697 11691 17902 21410
  1330  1579  1739  2234  3701  3865  5713  6677  7263 11172 12143 12765 17121 20011 21436
   303  1668  2501  4925  5778  5985  9635 10140 10820 11779 11849 12058 15650 20426 20527
   698  2484  3071  3219  4054  4125  5663  5939  6928  7086  8054 12173 16280 17945 19302
   232  1619  3040  4901  7438  8135  9117  9233 10131 13321 17347 17436 18193 18586 19929
    12  3721  6254  6609  7880  8139 10437 12262 13928 14065 14149 15032 15694 16264 18883
   482   915  1548  1637  6687  9338 10163 11768 11970 15524 15695 17386 18787 19210 19340
  1291  2500  4109  4511  5099  5194 10014 13165 13256 13972 15409 16113 16214 18584 20998
  1761  4778  7444  7740  8129  8341  8931  9136  9207 10003 10678 13959 17673 18194 20990
  3060  3522  5361  5692  6833  8342  8792 11023 11211 11548 11914 13987 15442 15541 19707
  1322  2348  2970  5632  6349  7577  8782  9113  9267  9376 12042 12943 16680 16970 21321
  6785 11960 21455
  1223 15672 19550
  5976 11335 20385
  2818  9387 15317
  2763  3554 18102
  5230 11489 18997
  5809 15779 20674
  2620 17838 18533
  3025  9342  9931
  3728  5337 12142
  2520  6666  9164
 12892 15307 20912
 10736 12393 16539
  1075  2407 12853
  4921  5411 18206
  5955 15647 16838
  6384 10336 19266
   429 10421 17266
  4880 10431 12208
  2910 11895 12442
  7366 18362 18772
```

Provided from Samsung

# FIG.45

```
4341  7903  14994
4564  6714  7378
4639  8652  18871
15787  18048  20246
3241  11079  13640
1559  2936  15881
2737  6349  10881
10394  16107  17073
8207  9043  12874
7805  16058  17905
11189  15767  17764
5823  12923  14316
11080  20390  20924
568  8263  17411
1845  3557  6562
2890  10936  14756
9031  14220  21517
3529  12955  15902
413  6750  8735
6784  12092  16421
12019  13794  15308
12588  15378  17676
8067  14589  19304
1244  5877  6085
15897  19349  19993
1426  2394  12264
3456  8931  12075
13342  15273  20351
9138  13352  20798
7031  7626  14081
4280  4507  15617
4170  10569  14335
3839  7514  16578
4688  12815  18782
4861  7858  9435
605  5445  12912
2280  4734  7311
6668  8128  12638
3733  10621  19534
13933  18316  19341
1786  3037  21566
2202  13239  16432
4882  5808  9300
4580  8484  16754
14630  17502  18269
6889  11119  12447
8162  9078  16330
6538  17851  18100
17763  19793  20816
2183  11907  17567
```

Provided from Samsung

FIG.46

```
6640 14428 15175
877 12035 14081
1336 6468 12328
5948 9146 12003
3782 5699 12445
1770 7946 8244
7384 12639 14989
1469 11586 20959
7943 10450 15907
5005 8153 10035
17750 18826 21513
4725 8041 10112
3837 16266 17376
11340 17361 17512
1269 4611 4774
2322 10813 16157
16752 16843 18959
70 4325 18753
3165 8153 15384
160 8045 16823
14112 16724 16792
4291 7667 18176
5943 19879 20721
```

Provided from Samsung

## FIG.47

N=64800, rate=12/15

```
 584 1472 1621 1867 3338 3568 3723 4185 5126 5889 7737 8632 8940 9725
 221 445 590 3779 3835 6939 7743 8280 8448 8491 9367 10042 11242 12917
4662 4837 4900 5029 6449 6687 6751 8684 9936 11681 11811 11886 12089 12909
2418 3018 3647 4210 4473 7447 7502 9490 10067 11092 11139 11256 12201 12383
2591 2947 3349 3406 4417 4519 5176 6672 8498 8863 9201 11294 11376 12184
  27 101 197 290 871 1727 3911 5411 6676 8701 9350 10310 10798 12439
1765 1897 2923 3584 3901 4048 6963 7054 7132 9165 10184 10824 11278 12669
2183 3740 4808 5217 5660 6375 6787 8219 8466 9037 10353 10583 11118 12762
  73 1594 2146 2715 3501 3572 3639 3725 6959 7187 8406 10120 10507 10691
 240 732 1215 2185 2788 2830 3499 3881 4197 4991 6425 7061 9756 10491
 831 1568 1828 3424 4319 4516 4639 6018 9702 10203 10417 11240 11518 12458
2024 2970 3048 3638 3676 4152 5284 5779 5926 9426 9945 10873 11787 11837
1049 1218 1651 2328 3493 4363 5750 6483 7613 8782 9738 9803 11744 11937
1193 2060 2289 2964 3478 4592 4756 6709 7162 8231 8326 11140 11908 12243
 978 2120 2439 3338 3850 4589 6567 8745 9656 9708 10161 10542 10711 12639
2403 2938 3117 3247 3711 5593 5844 5932 7801 10152 10226 11498 12162 12941
1781 2229 2276 2533 3582 3951 5279 5774 7930 9824 10920 11038 12340 12440
 289 384 1980 2230 3464 3873 5958 8656 8942 9006 10175 11425 11745 12530
 155 354 1090 1330 2002 2236 3559 3705 4922 5958 6576 8564 9972 12760
 303 876 2059 2142 5244 5330 6644 7576 8614 9598 10410 10718 11033 12957
3449 3617 4408 4602 4727 6182 8835 8928 9372 9644 10237 10747 11655 12747
 811 2565 2820 8677 8974 9632 11069 11548 11839 12107 12411 12695 12812 12890
 972 4123 4943 6385 6449 7339 7477 8379 9177 9359 10074 11709 12552 12831
 842 973 1541 2262 2905 5276 6758 7099 7894 8128 8325 8663 8875 10050
 474 791 968 3902 4924 4965 5085 5908 6109 6329 7931 9038 9401 10568
1397 4461 4658 5911 6037 7127 7318 8678 8924 9000 9473 9602 10446 12692
1334 7571 12881
1393 1447 7972
 633 1257 10597
4843 5102 11056
3294 8015 10513
1108 10374 10546
5353 7824 10111
3398 7674 8569
7719 9478 10503
2997 9418 9581
5777 6519 11229
1966 5214 9899
   6 4088 5827
 836 9248 9612
 483 7229 7548
7865 8289 9804
2915 11098 11900
6180 7096 9481
1431 6786 8924
 748 6757 8625
3312 4475 7204
1852 8958 11020
```

FIG.48

```
1915 2903 4006
6776 10886 12531
2594 9998 12742
159 2002 12079
853 3281 3762
5201 5798 6413
3882 6062 12047
4133 6775 9657
228 6874 11183
7433 10728 10864
7735 8073 12734
2844 4621 11779
3909 7103 12804
6002 9704 11060
5864 6856 7681
3652 5869 7605
2546 2657 4461
2423 4203 9111
244 1855 4691
1106 2178 6371
391 1617 10126
250 9259 10603
3435 4614 6924
1742 8045 9529
7667 8875 11451
4023 6108 6911
8621 10184 11650
6726 10861 12348
3228 6302 7388
1 1137 5358
381 2424 8537
3256 7508 10044
1980 2219 4569
2468 5699 10319
2803 3314 12808
8578 9642 11533
829 4585 7923
59 329 5575
1067 5709 6867
1175 4744 12219
109 2518 6756
2105 10626 11153
5192 10696 10749
6260 7641 8233
2998 3094 11214
3398 6466 11494
6574 10448 12160
2734 10755 12780
1028 7958 10825
8545 8602 10793
```

Provided from Samsung

FIG.49

```
392 3398 11417
6639 9291 12571
1067 7919 8934
1064 2848 12753
6076 8656 12690
5504 6193 10171
1951 7156 7356
4389 4780 7889
526 4804 9141
1238 3648 10464
2587 5624 12557
5560 5903 11963
1134 2570 3297
10041 11583 12157
1263 9585 12912
3744 7898 10646
45 9074 10315
1051 6188 10038
2242 8394 12712
3598 9025 12651
2295 3540 5610
1914 4378 12423
1766 3635 12759
5177 9586 11143
943 3590 11649
4864 6905 10454
5852 6042 10421
6095 8285 12349
2070 7171 8563
718 12234 12716
512 10667 11353
3629 6485 7040
2880 8865 11466
4490 10220 11796
5440 8819 9103
5262 7543 12411
516 7779 10940
2515 5843 9202
4684 5994 10586
573 2270 3324
7870 8317 10322
6856 7638 12909
1583 7669 10781
8141 9085 12555
3903 5485 9992
4467 11998 12904
```

Provided from Samsung

# FIG.50

```
┌─N=16200, rate=7/15 ─────────────────────────────────────────────────────────────────
   432 655 893 942 1285 1427 1738 2199 2441 2565 2932 3201 4144 4419 4678 4963 5423 5922 6433
6564 6656 7478 7514 7892
   220 453 690 826 1116 1425 1488 1901 3119 3182 3568 3800 3953 4071 4782 5038 5555 6836 6871
7131 7609 7850 8317 8443
   300 454 497 930 1757 2145 2314 2372 2467 2819 3191 3256 3699 3984 4538 4965 5461 5742 5912
6135 6649 7636 8078 8455
   24 65 565 609 990 1319 1394 1465 1918 1976 2463 2987 3330 3677 4195 4240 4947 5372 6453 6950
7066 8412 8500 8599
 1373 4668 5324 7777
 189 3930 5766 6877
 3 2961 4207 5747
 1108 4768 6743 7106
 1282 2274 2750 6204
 2279 2587 2737 6344
 2889 3164 7275 8040
 133 2734 5081 8386
 437 3203 7121
 4280 7128 8490
 619 4563 6206
 2799 6814 6991
 244 4212 5925
 1719 7657 8554
 53 1895 6685
 584 5420 6856
 2958 5834 8103                                              Provided from Samsung
```

FIG.51

N=16200, rate=9/15

350 462 1291 1383 1821 2235 2493 3328 3353 3772 3872 3923 4259 4426 4542 4972 5347 6217 6246 6332 6386

177 869 1214 1253 1398 1482 1737 2014 2161 2331 3108 3297 3438 4388 4430 4456 4522 4783 5273 6037 6395

347 501 658 966 1622 1659 1934 2117 2527 3168 3231 3379 3427 3739 4218 4497 4894 5000 5167 5728 5975

319 398 599 1143 1796 3198 3521 3886 4139 4453 4556 4636 4688 4753 4986 5199 5224 5496 5698 5724 6123

162 257 304 524 945 1695 1855 2527 2780 2902 2958 3439 3484 4224 4769 4928 5156 5303 5971 6358 6477

807 1695 2941 4276

2652 2857 4660 6358

329 2100 2412 3632

1151 1231 3872 4869

1561 3565 5138 5303

407 794 1455

3438 5683 5749

1504 1985 3563

440 5021 6321

194 3645 5923

1217 1462 6422

1212 4715 5973

4098 5100 5642

5512 5857 6226

2583 5506 5933

784 1801 4890

4734 4779 4875

938 5081 5377

127 4125 4704

1244 2178 3352

3659 6350 6465

1686 3464 4336

Provided from Samsung

FIG.52

N=16200, rate=11/15

```
108 297 703 742 1345 1443 1495 1628 1812 2341 2559 2669 2810 2877 3442 3690 3755 3904 4264
180 211 477 788 824 1090 1272 1578 1685 1948 2050 2195 2233 2546 2757 2946 3147 3299 3544
627 741 1135 1157 1226 1333 1378 1427 1454 1696 1757 1772 2099 2208 2592 3354 3580 4066 4242
9 795 959 989 1006 1032 1135 1209 1382 1484 1703 1855 1985 2043 2629 2845 3136 3450 3742
230 413 801 829 1108 1170 1291 1759 1793 1827 1976 2000 2423 2466 2917 3010 3600 3782 4143
56 142 236 381 1050 1141 1372 1627 1985 2247 2340 3023 3434 3519 3957 4013 4142 4164 4279
298 1211 2548 3643
73 1070 1614 1748
1439 2141 3614
284 1564 2629
607 660 855
1195 2037 2753
49 1198 2562
296 1145 3540
1516 2315 2382
154 722 4016
759 2375 3825
162 194 1749
2335 2422 2632
6 1172 2583
726 1325 1428
985 2708 2769
255 2801 3181
2979 3720 4090
208 1428 4094
199 3743 3757
1229 2059 4282
458 1100 1387
1199 2481 3284
1161 1467 4060
959 3014 4144
2666 3960 4125
2809 3834 4318
```

Provided from Samsung

FIG.53

N=16200, rate=13/15

37 144 161 199 220 496 510 589 731 808 834 965 1249 1264 1311 1377 1460 1520 1598 1707 1958 2055 2099 2154

20 27 165 462 546 583 742 796 1095 1110 1129 1145 1169 1190 1254 1363 1383 1463 1718 1835 1870 1879 2108 2128

288 362 463 505 638 691 745 861 1006 1083 1124 1175 1247 1275 1337 1353 1378 1506 1588 1632 1720 1868 1980 2135

405 464 478 511 566 574 641 766 785 802 836 996 1128 1239 1247 1449 1491 1537 1616 1643 1668 1950 1975 2149

86 192 245 357 363 374 700 713 852 903 992 1174 1245 1277 1342 1369 1381 1417 1463 1712 1900 1962 2053 2118

101 327 378 550
186 723 1318 1550
118 277 504 1835
199 407 1776 1965
387 1253 1328 1975
62 144 1163 2017
100 475 572 2136
431 865 1568 2055
283 640 981 1172
220 1038 1903 2147
483 1318 1358 2118
92 961 1709 1810
112 403 1485 2042
431 1110 1130 1365
587 1005 1206 1588
704 1113 1943
375 1487 2100
1507 1950 2110
962 1613 2038
554 1295 1501
488 784 1446
871 1935 1964
54 1475 1504
1579 1617 2074
1856 1967 2131
330 1582 2107
40 1056 1809
1310 1353 1410
232 554 1939
168 641 1099
333 437 1556
153 622 745
719 931 1188
237 638 1607

Provided from Samsung

## FIG.54

FIG.55

FIG.56

Code length: N=64800
Code rate: {7, 9, 11, 13} /15

| Rate | Performance threshold (Es/ NO) | Minimum cycle length |
|------|-------------------------------|----------------------|
| 7/15 | −0. 093751 | 6 |
| 9/15 | 1. 658523 | 8 |
| 11/15 | 3. 351930 | 6 |
| 13/15 | 5. 901749 | 6 |

# FIG.57

| X1 | X2 | Y1 | Y2 | 2 | 1 | M |
|----|----|----|----|---|---|---|

KX1   KX2   KY1   KY2   M−1

# FIG.58

| Rate | X1 | KX1 | X2 | KX2 | Y1 | KY1 | Y2 | KY2 | M |
|------|-----|------|-----|------|-----|------|-----|-------|-------|
| 7/15 | 33 | 2160 | 15 | 5040 | 4 | 0 | 3 | 23040 | 34560 |
| 9/15 | 19 | 6840 | — | 0 | 4 | 6840 | 3 | 25200 | 25920 |
| 11/15 | 15 | 8280 | — | 0 | 4 | 2520 | 3 | 36720 | 17280 |
| 13/15 | 13 | 9360 | — | 0 | 4 | 360 | 3 | 46440 | 8640 |

## FIG.59

FIG.60

FIG.61

FIG.62

rate 13/15 64k,QPSK AWGN it=50

FIG.63

Code length: N=16200

Code rate: {6, 8, 10, 12} /15

| Rate | Performance threshold (Es/ NO) | Minimum cycle length |
|------|-------------------------------|----------------------|
| 6/15 | 0. 1 | 6 |
| 8/15 | 0. 805765 | 6 |
| 10/15 | 2. 471011 | 6 |
| 12/15 | 4. 269922 | 6 |

# FIG.64

| X1 | X2 | Y1 | Y2 | 2 | 1 | M |
|----|----|----|----|---|---|---|

KX1    KX2     KY1    KY2     M−1

# FIG.65

| Rate | X1 | KX1 | X2 | KX2 | Y1 | KY1 | Y2 | KY2 | M |
|------|-----|------|-----|------|-----|------|-----|-------|------|
| 6/15 | 32 | 1080 | — | 0 | 4 | 3240 | 3 | 2160 | 9720 |
| 8/15 | 32 | 720 | 14 | 1080 | 4 | 1440 | 3 | 5400 | 7560 |
| 10/15 | 25 | 720 | 14 | 1440 | 4 | 360 | 3 | 8280 | 5400 |
| 12/15 | 14 | 2160 | — | 0 | 4 | 720 | 3 | 10080 | 3240 |

# FIG.66

rate 6/15 16k,QPSK AWGN it=50

FIG.67

FIG.68

FIG.69

FIG.70

| Code rate | Minimum cycle length | Performance threshold (Eb/No) |
|-----------|----------------------|-------------------------------|
| 10/15     | 6                    | 1. 35                         |

## FIG.71

| X | Y1 | Y2 | 2 | 1 | M |
|---|----|----|---|---|---|

KX · KY1 · KY2 · M−1

## FIG.72

| rate | X | KX | Y1 | KY1 | Y2 | KY2 | M |
|------|-----|------|----|------|----|------|------|
| 10/15 | 18 | 1440 | 4 | 5400 | 3 | 3960 | 5400 |

## FIG.73

FIG.74

Code length: N=16200

Code rate: 12/15

| Rate | Performance threshold (Es/ NO) | Minimum cycle length |
|---|---|---|
| 12/15 | 4. 237556 | 6 |

## FIG.75

X1  X2  Y1  Y2  2  1   M

KX1  KX2  KY1  KY2  M−1

## FIG.76

| X1 | KX1 | X2 | KX2 | Y1 | KY1 | Y2 | KY2 | M |
|----|-----|----|------|----|------|----|------|------|
| 18 | 360 | 16 | 1800 | 4 | 1080 | 3 | 9720 | 3240 |

FIG.77

FIG.78

FIG.79

| Rate | X1 | KX1 | X2 | KX2 | Y1 | KY1 | Y2 | KY2 | M |
|------|-----|------|-----|------|-----|-------|-----|-------|-------|
| 6/15 | 27 | 4680 | — | 0 | 4 | 13680 | 3 | 7560 | 38880 |
| 8/15 | 19 | 7200 | — | 0 | 4 | 5760 | 3 | 21600 | 30240 |
| 10/15 | 15 | 9360 | — | 0 | 4 | 0 | 3 | 33840 | 21600 |
| 12/15 | 14 | 9360 | — | 0 | 4 | 0 | 3 | 42480 | 12960 |

FIG.80

FIG.81

FIG.82

FIG.83

FIG.84

| X1 | X2 | Y1 | Y2 | 2 | 1 |

KX1  KX2      KY1      KY2      M−1

M

# FIG.85

| Rate | X1 | KX1 | X2 | KX2 | Y1 | KY1 | Y2 | KY2 | M |
|------|----|-----|----|-----|----|-----|----|-----|---|
| 7/15 | 24 | 1440 | — | 0 | 4 | 2880 | 3 | 3240 | 8640 |
| 9/15 | 21 | 1800 | — | 0 | 4 | 1800 | 3 | 6120 | 6480 |
| 11/15 | 19 | 2160 | — | 0 | 4 | 720 | 3 | 9000 | 4320 |
| 13/15 | 24 | 1800 | — | 0 | 4 | 5400 | 3 | 6840 | 2160 |

FIG.86

rate 7/15 16k, QPSK AWGN it=50

FIG.87

FIG.88

FIG.89

FIG.90

| MODCOD # | Code Rate | QAM Order | NUC Shape |
|----------|-----------|-----------|-----------|
| 1 | 6/15 | QPSK | – |
| 2 | 7/15 | QPSK | – |
| 3 | 8/15 | QPSK | – |
| 4 | 9/15 | QPSK | – |
| 5 | 10/15 | QPSK | – |
| 6 | 11/15 | QPSK | – |
| 7 | 12/15 | QPSK | – |
| 8 | 13/15 | QPSK | – |
| 9 | 6/15 | 16-QAM | NUC_16_6/15 |
| 10 | 7/15 | 16-QAM | NUC_16_7/15 |
| 11 | 8/15 | 16-QAM | NUC_16_8/15 |
| 12 | 9/15 | 16-QAM | NUC_16_9/15 |
| 13 | 10/15 | 16-QAM | NUC_16_10/15 |
| 14 | 11/15 | 16-QAM | NUC_16_11/15 |
| 15 | 12/15 | 16-QAM | NUC_16_12/15 |
| 16 | 13/15 | 16-QAM | NUC_16_13/15 |
| 17 | 6/15 | 64-QAM | NUC_64_6/15 |
| 18 | 7/15 | 64-QAM | NUC_64_7/15 |
| 19 | 8/15 | 64-QAM | NUC_64_8/15 |
| 20 | 9/15 | 64-QAM | NUC_64_9/15 |
| 21 | 10/15 | 64-QAM | NUC_64_10/15 |
| 22 | 11/15 | 64-QAM | NUC_64_11/15 |
| 23 | 12/15 | 64-QAM | NUC_64_12/15 |
| 24 | 13/15 | 64-QAM | NUC_64_13/15 |
| 25 | 6/15 | 256-QAM | NUC_256_6/15 |
| 26 | 7/15 | 256-QAM | NUC_256_7/15 |
| 27 | 8/15 | 256-QAM | NUC_256_8/15 |
| 28 | 9/15 | 256-QAM | NUC_256_9/15 |
| 29 | 10/15 | 256-QAM | NUC_256_10/15 |
| 30 | 11/15 | 256-QAM | NUC_256_11/15 |
| 31 | 12/15 | 256-QAM | NUC_256_12/15 |
| 32 | 13/15 | 256-QAM | NUC_256_13/15 |
| 33 | 6/15 | 1k-QAM | NUC_1k_6/15 |
| 34 | 7/15 | 1k-QAM | NUC_1k_7/15 |
| 35 | 8/15 | 1k-QAM | NUC_1k_8/15 |
| 36 | 9/15 | 1k-QAM | NUC_1k_9/15 |
| 37 | 10/15 | 1k-QAM | NUC_1k_10/15 |
| 38 | 11/15 | 1k-QAM | NUC_1k_11/15 |
| 39 | 12/15 | 1k-QAM | NUC_1k_12/15 |
| 40 | 13/15 | 1k-QAM | NUC_1k_13/15 |

FIG.91

FIG.92

FIG.93

FIG.94

FIG.95

FIG.96

FIG.97

AWGN, 256QAM, 1/2, BER, BCH (64k code from DVB-T2), no BI

FIG.98

FIG.99

| Input cell word y | Constellation point zq |
|---|---|
| (00) | $(1+1i)/\sqrt{2}$ |
| (01) | $(1-1i)/\sqrt{2}$ |
| (10) | $(-1+1i)/\sqrt{2}$ |
| (11) | $(-1-1i)/\sqrt{2}$ |

# FIG.100

| w/Shape | NUC_16_6/15 | NUC_16_7/15 | NUC_16_8/15 | NUC_16_9/15 | NUC_16_10/15 | NUC_16_11/15 | NUC_16_12/15 | NUC_16_13/15 |
|---------|-------------|-------------|-------------|-------------|--------------|--------------|--------------|--------------|
| w0 | 0.4530+0.2663i | 1.2103+0.5026i | 0.4819+0.2575i | 0.4909+1.2007i | 0.2173+0.4189i | 0.9583+0.9547i | 0.2999+0.2999i | 0.9517+0.9511i |
| w1 | 0.2663+0.4530i | 0.5014+1.2103i | 0.2575+0.4819i | 1.2007+0.4909i | 0.6578+0.2571i | 0.9547+0.2909i | 0.9540+0.2999i | 0.9524+0.3061i |
| w2 | 1.2092+0.5115i | 0.4634+0.2624i | 1.2068+0.4951i | 0.2476+0.5065i | 0.4326+1.1445i | 0.2921+0.9583i | 0.2999+0.9540i | 0.3067+0.9524i |
| w3 | 0.5115+1.2092i | 0.2624+0.4627i | 0.4951+1.2068i | 0.5053+0.2476i | 1.2088+0.5659i | 0.2909+0.2927i | 0.9540+0.9540i | 0.3061+0.3067i |

# FIG.101

| w/Shape | NUC_64_6/15 | NUC_64_7/15 | NUC_64_8/15 | NUC_64_9/15 | NUC_64_10/15 | NUC_64_11/15 | NUC_64_12/15 | NUC_64_13/15 |
|---|---|---|---|---|---|---|---|---|
| w0 | 0.4387+1.6023i | 0.3352+0.6028i | 1.4827+0.2920i | 0.3547+0.6149i | 1.4388+0.2878i | 0.3317+0.6970i | 1.0854+0.5394i | 0.4108+0.7473i |
| w1 | 1.6023+0.4387i | 0.2077+0.6584i | 1.2563+0.8411i | 0.1581+0.6842i | 1.2150+0.8133i | 0.1386+0.8824i | 0.7353+0.4623i | 0.1343+0.5338i |
| w2 | 0.8753+1.0881i | 0.1711+0.3028i | 1.0211+0.2174i | 0.1567+0.2749i | 1.0386+0.2219i | 0.1323+0.4437i | 1.0474+0.1695i | 0.1570+0.9240i |
| w3 | 1.0881+0.8753i | 0.1556+0.3035i | 0.8798+0.5702i | 0.1336+0.2700i | 0.8494+0.6145i | 0.1015+0.1372i | 0.7243+0.1504i | 0.1230+0.1605i |
| w4 | 0.2202+0.9238i | 0.6028+0.3345i | 0.2920+1.4827i | 0.6177+0.4030i | 0.2931+1.4656i | 0.5682+0.4500i | 1.0693+0.9408i | 0.6285+0.4617i |
| w5 | 0.2019+0.7818i | 0.6577+0.2084i | 0.8410+1.2563i | 0.7262+0.1756i | 0.8230+1.2278i | 0.6739+0.1435i | 0.7092+0.8073i | 0.3648+0.3966i |
| w6 | 0.3049+0.8454i | 0.3021+0.1711i | 0.2174+1.0211i | 0.3568+0.1756i | 0.2069+1.0649i | 0.3597+0.3401i | 1.4261+0.2216i | 0.6907+0.1541i |
| w7 | 0.2653+0.7540i | 0.3028+0.1556i | 0.5702+0.8798i | 0.3771+0.1336i | 0.5677+0.8971i | 0.3660+0.1204i | 0.6106+1.1783i | 0.3994+0.1308i |
| w8 | 0.7818+0.2019i | 0.5556+0.8922i | 0.3040+0.1475i | 0.5639+0.8864i | 0.4119+0.1177i | 0.6004+0.8922i | 0.1392+0.4078i | 0.7268+0.8208i |
| w9 | 0.9238+0.2202i | 0.2352+1.0190i | 0.3028+0.1691i | 0.1980+1.0277i | 0.3998+0.2516i | 0.2120+1.2253i | 0.4262+0.4205i | 1.0463+0.9495i |
| w10 | 0.7540+0.2653i | 0.8450+1.2619i | 0.6855+0.1871i | 0.8199+1.2515i | 0.7442+0.1559i | 0.9594+1.0714i | 0.1407+0.1336i | 0.1866+1.2733i |
| w11 | 0.8454+0.3049i | 0.2922+1.4894i | 0.6126+0.3563i | 0.2854+1.4691i | 0.5954+0.4328i | 0.5829+1.3995i | 0.4265+0.1388i | 0.5507+1.1793i |
| w12 | 0.2675+0.2479i | 0.8929+0.5549i | 0.1475+0.3040i | 0.8654+0.6058i | 0.1166+0.1678i | 0.8439+0.5675i | 0.1388+0.7057i | 0.9283+0.5140i |
| w13 | 0.2479+0.2675i | 1.0197+0.2359i | 0.1691+0.3028i | 1.0382+0.2141i | 0.1582+0.3325i | 0.9769+0.1959i | 0.4197+0.7206i | 1.2648+0.5826i |
| w14 | 0.2890+0.2701i | 1.2626+0.8457i | 0.1871+0.6855i | 1.2362+0.8416i | 0.1355+0.7408i | 1.2239+0.6760i | 0.1682+1.0316i | 0.9976+0.1718i |
| w15 | 0.2701+0.2890i | 1.4894+0.2922i | 0.3563+0.6126i | 1.4663+0.2973i | 0.3227+0.6200i | 1.3653+0.2323i | 0.2287+1.3914i | 1.3412+0.1944i |

FIG.102

| w/Shape | NUC_256_6/15 | NUC_256_7/15 | NUC_256_8/15 | NUC_256_9/15 | NUC_256_10/15 | NUC_256_11/15 | NUC_256_12/15 | NUC_256_13/15 |
|---|---|---|---|---|---|---|---|---|
| w0 | 0.6800+1.6926i | 1.2905+1.3099i | 1.0804+1.3788i | 1.3231+1.1506i | 1.6097+0.1548i | 0.3105+0.3382i | 1.1014+1.1670i | 0.3556+0.3497i |
| w1 | 0.3911+1.3645i | 1.0504+0.9577i | 1.0487+0.9862i | 0.9851+1.2311i | 1.5549+0.4605i | 0.4342+0.3360i | 0.8557+1.2421i | 0.3579+0.4945i |
| w2 | 0.2191+1.7524i | 1.5329+0.8935i | 1.6464+0.7428i | 1.1439+0.8974i | 1.3226+0.1290i | 0.3149+0.4829i | 1.2957+0.8039i | 0.5049+0.3571i |
| w3 | 0.2274+1.4208i | 1.1577+0.8116i | 1.3245+0.9414i | 0.9343+0.9271i | 1.2772+0.3829i | 0.4400+0.4807i | 1.0881+0.8956i | 0.5056+0.5063i |
| w4 | 0.8678+1.2487i | 1.7881+0.2509i | 0.7198+1.2427i | 1.5398+0.7982i | 1.2753+1.0242i | 0.1811+0.3375i | 0.5795+1.2110i | 0.2123+0.3497i |
| w5 | 0.7275+1.1667i | 1.4275+0.1400i | 0.8106+1.0040i | 0.9092+0.5599i | 1.4434+0.7540i | 0.0633+0.3404i | 0.6637+1.4215i | 0.2116+0.4900i |
| w6 | 0.8747+1.0470i | 1.4784+0.5201i | 0.5595+1.0317i | 1.2222+0.8574i | 1.0491+0.8476i | 0.1818+0.4851i | 0.6930+1.0032i | 0.0713+0.3489i |
| w7 | 0.7930+1.0406i | 1.3408+0.4346i | 0.6118+0.9722i | 0.9579+0.6373i | 1.1861+0.6253i | 0.0633+0.4815i | 0.8849+0.9647i | 0.0690+0.4960i |
| w8 | 0.2098+0.9768i | 0.7837+0.5867i | 1.6768+0.2002i | 0.7748+1.5867i | 0.9326+0.0970i | 0.3084+0.1971i | 1.2063+0.5115i | 0.3527+0.2086i |
| w9 | 0.2241+1.0454i | 0.8250+0.6455i | 0.9997+0.6844i | 0.6878+1.2489i | 0.8962+0.2804i | 0.4356+0.1993i | 1.0059+0.4952i | 0.3497+0.0713i |
| w10 | 0.1858+0.9878i | 0.8256+0.5601i | 1.4212+0.4769i | 0.5992+0.9208i | 1.1044+0.1102i | 0.3098+0.0676i | 1.4171+0.5901i | 0.4960+0.2123i |
| w11 | 0.1901+1.0659i | 0.8777+0.6110i | 1.1479+0.6312i | 0.6796+0.9743i | 1.0648+0.3287i | 0.4342+0.0691i | 1.0468+0.6935i | 0.4974+0.0698i |
| w12 | 0.5547+0.8312i | 1.0080+0.1843i | 0.6079+0.6566i | 0.5838+0.5879i | 0.7325+0.6071i | 0.1775+0.1985i | 0.6639+0.8286i | 0.2086+0.2079i |
| w13 | 0.5479+0.8651i | 1.0759+0.1721i | 0.7284+0.6957i | 0.6915+0.5788i | 0.8260+0.4559i | 0.0640+0.1878i | 0.8853+0.5851i | 0.2094+0.0690i |
| w14 | 0.6073+0.8182i | 1.0056+0.2758i | 0.5724+0.7031i | 0.5858+0.7058i | 0.8744+0.7153i | 0.1775+0.0676i | 0.6879+0.8022i | 0.0678+0.2079i |
| w15 | 0.5955+0.8420i | 1.0662+0.2964i | 0.6302+0.7259i | 0.6868+0.6793i | 0.9882+0.5300i | 0.0647+0.0669i | 0.8634+0.7622i | 0.0698+0.0683i |
| w16 | 1.4070+0.1790i | 0.8334+1.5554i | 0.1457+1.4010i | 1.6118+0.1497i | 0.1646+1.6407i | 0.7455+0.3411i | 0.1213+1.4366i | 0.3586+0.7959i |
| w17 | 1.7227+0.2900i | 0.8165+1.1032i | 0.1866+1.7346i | 0.9511+0.1140i | 0.4867+1.5743i | 0.5811+0.3396i | 0.1077+1.2098i | 0.3571+0.6392i |
| w18 | 1.3246+0.2562i | 0.6092+1.2729i | 0.1174+1.1035i | 1.2970+0.1234i | 0.1363+1.3579i | 0.7556+0.4669i | 0.0651+0.9801i | 0.5034+0.8271i |
| w19 | 1.3836+0.3654i | 0.6728+1.1456i | 0.1095+1.0132i | 1.0268+0.1191i | 0.4023+1.3028i | 0.5862+0.4756i | 0.2009+1.0115i | 0.5063+0.6600i |
| w20 | 1.3708+1.2834i | 0.3061+1.7469i | 0.4357+1.3636i | 1.5831+0.4496i | 1.0542+1.2584i | 0.9556+0.3280i | 0.3764+1.4264i | 0.2146+0.7862i |
| w21 | 1.8701+0.9403i | 0.1327+1.4056i | 0.5853+1.6820i | 0.9328+0.3586i | 0.7875+1.4450i | 1.1787+0.3091i | 0.3237+1.2130i | 0.2109+0.6340i |
| w22 | 1.1614+0.7909i | 0.3522+1.3414i | 0.3439+1.0689i | 1.2796+0.3894i | 0.8687+1.0407i | 0.9673+0.4720i | 0.5205+0.9814i | 0.0713+0.8093i |
| w23 | 1.2241+0.7367i | 0.2273+1.3081i | 0.3234+0.9962i | 1.0188+0.3447i | 0.8502+1.1951i | 1.2051+0.5135i | 0.3615+1.0163i | 0.0698+0.6467i |
| w24 | 0.9769+0.1863i | 0.5007+0.8098i | 0.1092+0.6174i | 0.5840+0.1059i | 0.0982+0.9745i | 0.7367+0.2015i | 0.0715+0.6596i | 0.2799+1.0862i |
| w25 | 0.9452+0.2057i | 0.5528+0.8347i | 0.1074+0.6307i | 0.7215+0.1100i | 0.2842+0.9344i | 0.5811+0.2015i | 0.2116+0.6597i | 0.2806+1.2755i |
| w26 | 1.0100+0.2182i | 0.4843+0.8486i | 0.1109+0.6996i | 0.5863+0.1138i | 0.1142+1.1448i | 0.7316+0.0669i | 0.0729+0.8131i | 0.4328+0.9904i |
| w27 | 0.9795+0.2417i | 0.5304+0.8759i | 0.1076+0.7345i | 0.6909+0.1166i | 0.3385+1.0973i | 0.5782+0.0669i | 0.2158+0.8246i | 0.4551+1.1812i |
| w28 | 0.8241+0.4856i | 0.1715+0.9147i | 0.3291+0.6284i | 0.5843+0.3604i | 0.8062+0.7485i | 0.9062+0.1971i | 0.5036+0.6487i | 0.2309+0.8414i |
| w29 | 0.8232+0.4837i | 0.1540+0.9510i | 0.3126+0.6373i | 0.6870+0.3592i | 0.4607+0.8538i | 1.2829+0.1185i | 0.3526+0.6572i | 0.1077+1.3891i |
| w30 | 0.8799+0.5391i | 0.1964+0.9438i | 0.3392+0.6999i | 0.5808+0.3250i | 0.7263+0.8764i | 0.9156+0.0735i | 0.5185+0.8086i | 0.0772+0.9852i |
| w31 | 0.8796+0.5356i | 0.1788+0.9832i | 0.3202+0.7282i | 0.6678+0.3290i | 0.5450+1.0067i | 1.1011+0.0735i | 0.3593+0.8245i | 0.0802+1.1753i |
| w32 | 0.1376+0.3342i | 0.3752+0.1667i | 0.9652+0.1066i | 0.1406+1.6182i | 0.2655+0.0746i | 0.3244+0.8044i | 1.2545+0.1010i | 0.8301+0.3727i |
| w33 | 0.1383+0.3292i | 0.3734+0.1667i | 0.9075+0.1666i | 0.1272+1.2984i | 0.2664+0.0759i | 0.4589+0.8218i | 1.0678+0.0956i | 0.8256+0.5256i |
| w34 | 0.1363+0.3322i | 0.3758+0.1661i | 0.9724+0.1171i | 0.1211+0.9644i | 0.4571+0.0852i | 0.3207+0.6415i | 1.4782+0.1167i | 0.6593+0.3668i |
| w35 | 0.1370+0.3273i | 0.3746+0.1649i | 0.9186+0.1752i | 0.1220+1.0393i | 0.4516+0.1062i | 0.4509+0.6371i | 0.8981+0.0882i | 0.6623+0.5182i |
| w36 | 0.1655+0.3265i | 0.4013+0.1230i | 0.6342+0.1372i | 0.1124+0.6101i | 0.2559+0.1790i | 0.1920+0.3196i | 0.5518+0.0690i | 1.0186+0.3645i |
| w37 | 0.1656+0.3227i | 0.4001+0.1230i | 0.6550+0.1495i | 0.1177+0.6041i | 0.2586+0.1772i | 0.0633+0.8167i | 0.6903+0.0552i | 1.0001+0.5242i |
| w38 | 0.1634+0.3246i | 0.4037+0.1230i | 0.6290+0.1393i | 0.1136+0.7455i | 0.3592+0.2811i | 0.1811+0.6371i | 0.5742+0.1987i | 1.1857+0.2725i |
| w39 | 0.1636+0.3208i | 0.4019+0.1218i | 0.6494+0.1504i | 0.1185+0.7180i | 0.3728+0.2654i | 0.0640+0.8415i | 0.7374+0.1584i | 1.3928+0.3408i |
| w40 | 0.1779+0.6841i | 0.6025+0.3934i | 1.3127+0.1240i | 0.4324+1.5679i | 0.7706+0.0922i | 0.3331+1.0669i | 1.2378+0.3049i | 0.8011+0.2227i |
| w41 | 0.1828+0.6845i | 0.5946+0.3928i | 0.9572+0.4344i | 0.3984+1.2825i | 0.7407+0.2280i | 0.4655+1.0087i | 1.0518+0.3032i | 0.7981+0.0735i |
| w42 | 0.1745+0.6828i | 0.6116+0.3879i | 1.2403+0.2631i | 0.3766+0.9534i | 0.6180+0.0927i | 0.3433+1.2865i | 1.4584+0.3511i | 0.6459+0.2198i |
| w43 | 0.1793+0.6829i | 0.6019+0.3937i | 1.0254+0.4130i | 0.3668+1.0301i | 0.6019+0.1658i | 0.5004+1.5062i | 0.9107+0.2803i | 0.6430+0.0713i |
| w44 | 0.3547+0.6009i | 0.7377+0.1618i | 0.6096+0.4214i | 0.3667+0.5995i | 0.6007+0.4880i | 0.1971+1.0051i | 0.6321+0.4729i | 0.9681+0.2205i |
| w45 | 0.3593+0.6011i | 0.7298+0.1582i | 0.6773+0.4284i | 0.3328+0.5960i | 0.6673+0.3928i | 0.0735+1.0298i | 0.7880+0.4392i | 0.9615+0.0735i |
| w46 | 0.3576+0.5990i | 0.7274+0.1782i | 0.5895+0.4102i | 0.3687+0.7194i | 0.4786+0.3835i | 0.1498+1.5018i | 0.6045+0.3274i | 1.3327+0.1039i |
| w47 | 0.3624+0.5994i | 0.7185+0.1746i | 0.6531+0.4101i | 0.3373+0.6964i | 0.5176+0.3391i | 0.0865+1.2553i | 0.7629+0.2965i | 1.1359+0.0809i |
| w48 | 0.2697+0.1443i | 0.1509+0.2425i | 0.1250+0.1153i | 0.1065+0.1146i | 0.0757+0.1003i | 0.7811+0.8080i | 0.0596+0.0739i | 0.8382+0.8709i |
| w49 | 0.2704+0.1433i | 0.1503+0.2400i | 0.1252+0.1158i | 0.1145+0.1108i | 0.0753+0.1004i | 0.6167+0.8153i | 0.1787+0.0731i | 0.8145+0.6934i |
| w50 | 0.2644+0.1442i | 0.1515+0.2437i | 0.1245+0.1152i | 0.1053+0.1274i | 0.0777+0.4788i | 0.7836+0.6255i | 0.0612+0.2198i | 0.6645+0.8486i |
| w51 | 0.2650+0.1432i | 0.1503+0.2425i | 0.1247+0.1156i | 0.1134+0.1236i | 0.0867+0.4754i | 0.6000+0.8327i | 0.1815+0.2192i | 0.6600+0.6786i |
| w52 | 0.2763+0.1638i | 0.1285+0.2388i | 0.3768+0.1244i | 0.1111+0.3821i | 0.1023+0.2243i | 0.9898+0.7680i | 0.4218+0.0715i | 1.1612+0.6949i |
| w53 | 0.2768+0.1626i | 0.1279+0.2419i | 0.3707+0.1237i | 0.1186+0.3867i | 0.1010+0.2242i | 1.5855+0.1498i | 0.2978+0.0725i | 0.9785+0.6942i |
| w54 | 0.2715+0.1630i | 0.1279+0.2431i | 0.3779+0.1260i | 0.1080+0.3431i | 0.1950+0.3819i | 0.9476+0.6175i | 0.4337+0.2115i | 1.3698+0.6259i |
| w55 | 0.2719+0.1618i | 0.1279+0.2406i | 0.3717+0.1252i | 0.1177+0.3459i | 0.1881+0.3969i | 1.4625+0.4015i | 0.3057+0.2167i | 1.2183+0.4841i |
| w56 | 0.6488+0.1696i | 0.3394+0.5764i | 0.1161+0.3693i | 0.3644+0.1080i | 0.0930+0.8122i | 0.8276+1.0225i | 0.0667+0.5124i | 0.7989+1.0498i |
| w57 | 0.6462+0.1708i | 0.3384+0.5722i | 0.1157+0.3645i | 0.3262+0.1104i | 0.2215+0.7840i | 0.6313+1.0364i | 0.2008+0.5095i | 0.4385+1.4203i |
| w58 | 0.6456+0.1745i | 0.3328+0.5758i | 0.1176+0.3460i | 0.3631+0.1173i | 0.0837+0.6514i | 0.3315+1.2865i | 0.0625+0.3658i | 0.6113+1.0246i |
| w59 | 0.6431+0.1753i | 0.3303+0.5698i | 0.1171+0.3424i | 0.3289+0.1196i | 0.1540+0.6366i | 0.6342+1.2705i | 0.1899+0.3642i | 0.6303+1.2421i |
| w60 | 0.5854+0.3186i | 0.1491+0.6316i | 0.3530+0.3899i | 0.3665+0.3758i | 0.4810+0.6306i | 1.0422+0.9593i | 0.4818+0.4946i | 1.0550+0.8924i |
| w61 | 0.5862+0.3167i | 0.1481+0.6280i | 0.3422+0.3808i | 0.3310+0.3795i | 0.3856+0.7037i | 1.2749+0.8538i | 0.3380+0.5050i | 0.8612+1.2800i |
| w62 | 0.5864+0.3275i | 0.1509+0.6280i | 0.3614+0.3755i | 0.3672+0.3353i | 0.3527+0.5230i | 1.1556+1.1847i | 0.4571+0.3499i | 1.2698+0.9969i |
| w63 | 0.5873+0.3254i | 0.1473+0.6225i | 0.3509+0.3656i | 0.3338+0.3402i | 0.3100+0.5559i | 1.4771+0.6742i | 0.3216+0.3599i | 1.0342+1.1181i |

FIG.103

| u/Shape | NUC_1k_6/15 | NUC_1k_7/15 | NUC_1k_8/15 | NUC_1k_9/15 | NUC_1k_10/15 | NUC_1k_11/15 | NUC_1k_12/15 | NUC_1k_13/15 |
|---|---|---|---|---|---|---|---|---|
| u1 | 1.0003 | 1 | 1.0005 | 1 | 1.0772 | 1.16666667 | 2.5983 | 2.85714286 |
| u2 | 1.0149 | 1.04 | 2.0897 | 2.78571429 | 2.8011 | 3.08333333 | 4.5193 | 4.85714286 |
| u3 | 1.0158 | 1.04 | 2.0888 | 2.78571429 | 2.9634 | 3.33333333 | 6.1649 | 6.85714286 |
| u4 | 2.6848 | 3 | 3.9945 | 4.85714286 | 4.8127 | 5.16666667 | 8.2107 | 8.85714286 |
| u5 | 2.6903 | 3.04 | 3.9931 | 4.85714286 | 5.1864 | 5.75 | 9.9594 | 11 |
| u6 | 2.882 | 3.28 | 5.3843 | 6.85714286 | 6.7838 | 7.41666667 | 12.0321 | 13.2857143 |
| u7 | 2.8747 | 3.32 | 5.3894 | 6.85714286 | 7.5029 | 8.5 | 13.9574 | 15.7142857 |
| u8 | 4.7815 | 5.24 | 7.5206 | 9.14285714 | 9.238 | 10.0833333 | 16.2598 | 18.1428571 |
| u9 | 4.7619 | 5.32 | 7.6013 | 9.28571429 | 10.32 | 11.5833333 | 18.4269 | 20.7142857 |
| u10 | 5.5779 | 6.04 | 9.3371 | 11.5714286 | 12.0115 | 13.3333333 | 20.9273 | 23.4285714 |
| u11 | 5.6434 | 6.28 | 9.8429 | 12.2142857 | 13.5356 | 15.25 | 23.4863 | 26.2857143 |
| u12 | 7.3854 | 8.24 | 11.9255 | 14.6428571 | 15.6099 | 17.3333333 | 26.4823 | 29.2857143 |
| u13 | 7.8797 | 8.84 | 13.3962 | 16.4285714 | 17.7524 | 19.75 | 29.7085 | 32.4285714 |
| u14 | 9.635 | 11.04 | 15.8981 | 19.4285714 | 20.5256 | 22.4166667 | 33.6247 | 35.7142857 |
| u15 | 11.7874 | 13.68 | 19.1591 | 23.2857143 | 24.1254 | 25.5833333 | 38.5854 | 39.4285714 |

# FIG.104

**A**

| y0, q | 1 | 1 | 1 | 1 | 1 | 1 | 1 | 1 | 1 | 1 | 1 | 1 | 1 | 1 | 1 | 1 |
|---|---|---|---|---|---|---|---|---|---|---|---|---|---|---|---|---|
| y2, q | 0 | 0 | 0 | 0 | 0 | 0 | 0 | 0 | 1 | 1 | 1 | 1 | 1 | 1 | 1 | 1 |
| y4, q | 0 | 0 | 0 | 0 | 1 | 1 | 1 | 1 | 1 | 1 | 1 | 1 | 0 | 0 | 0 | 0 |
| y6, q | 0 | 0 | 1 | 1 | 1 | 1 | 0 | 0 | 0 | 0 | 1 | 1 | 1 | 1 | 0 | 0 |
| y8, q | 0 | 1 | 1 | 0 | 0 | 1 | 1 | 0 | 0 | 1 | 1 | 0 | 0 | 1 | 1 | 0 |
| Re $(z_q)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-1$ |
| Y0, q | 0 | 0 | 0 | 0 | 0 | 0 | 0 | 0 | 0 | 0 | 0 | 0 | 0 | 0 | 0 | 0 |
| y2, q | 1 | 1 | 1 | 1 | 1 | 1 | 1 | 1 | 0 | 0 | 0 | 0 | 0 | 0 | 0 | 0 |
| y4, q | 0 | 0 | 0 | 0 | 1 | 1 | 1 | 1 | 1 | 1 | 1 | 1 | 0 | 0 | 0 | 0 |
| y6, q | 0 | 0 | 1 | 1 | 1 | 1 | 0 | 0 | 0 | 0 | 1 | 1 | 1 | 1 | 0 | 0 |
| y8, q | 0 | 1 | 1 | 0 | 0 | 1 | 1 | 0 | 0 | 1 | 1 | 0 | 0 | 1 | 1 | 0 |
| Re $(z_q)$ | 1 | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

**B**

| y1, q | 1 | 1 | 1 | 1 | 1 | 1 | 1 | 1 | 1 | 1 | 1 | 1 | 1 | 1 | 1 | 1 |
|---|---|---|---|---|---|---|---|---|---|---|---|---|---|---|---|---|
| y3, q | 0 | 0 | 0 | 0 | 0 | 0 | 0 | 0 | 1 | 1 | 1 | 1 | 1 | 1 | 1 | 1 |
| y5, q | 0 | 0 | 0 | 0 | 1 | 1 | 1 | 1 | 1 | 1 | 1 | 1 | 0 | 0 | 0 | 0 |
| y7, q | 0 | 0 | 1 | 1 | 1 | 1 | 0 | 0 | 0 | 0 | 1 | 1 | 1 | 1 | 0 | 0 |
| y9, q | 0 | 1 | 1 | 0 | 0 | 1 | 1 | 0 | 0 | 1 | 1 | 0 | 0 | 1 | 1 | 0 |
| Im $(z_q)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-1$ |
| y1, q | 0 | 0 | 0 | 0 | 0 | 0 | 0 | 0 | 0 | 0 | 0 | 0 | 0 | 0 | 0 | 0 |
| y3, q | 1 | 1 | 1 | 1 | 1 | 1 | 1 | 1 | 0 | 0 | 0 | 0 | 0 | 0 | 0 | 0 |
| y5, q | 0 | 0 | 0 | 0 | 1 | 1 | 1 | 1 | 1 | 1 | 1 | 1 | 0 | 0 | 0 | 0 |
| y7, q | 0 | 0 | 1 | 1 | 1 | 1 | 0 | 0 | 0 | 0 | 1 | 1 | 1 | 1 | 0 | 0 |
| y9, q | 0 | 1 | 1 | 0 | 0 | 1 | 1 | 0 | 0 | 1 | 1 | 0 | 0 | 1 | 1 | 0 |
| Im $(z_q)$ | 1 | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

FIG.105

25

Block interleaver

Column 1　　　　　　　　Column C

Row 1

Part 1

Row R1

Column 1　　　　　　　　Column C

Part 2　　Row 1

Row R2

...

FIG.106

| | N=64800 | | | |
|---|---|---|---|---|
| | 16QAM | 64QAM | 256QAM | 1024QAM |
| C | 4 | 6 | 8 | 10 |
| R1 | 16200 | 10800 | 7920 | 6480 |
| R2 | 0 | 0 | 180 | 0 |

| | N=16200 | | | |
|---|---|---|---|---|
| | 16QAM | 64QAM | 256QAM | 1024QAM |
| C | 4 | 6 | 8 | 10 |
| R1 | 3960 | 2520 | 1800 | 1440 |
| R2 | 90 | 180 | 225 | 180 |

C: Number of columns (number of symbol bits)
R1: Number of rows of part 1
R2: Number of rows of part 2

# FIG.107

FIG.108

FIG.109

Bit group

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 178 | 140 | 44 | 100 | 107 | 89 | 169 | 166 | 36 | 52 | 33 | 160 | 14 | 165 | 109 | 35 | 74 | 136 | 99 | 97 | 28 | 59 |
|---|---|---|---|---|---|---|---|---|---|----|----|----|----|----|----|----|----|----|----|----|----|
| 7 | 29 | 164 | 119 | 41 | 55 | 17 | 115 | 138 | 93 | 96 | 24 | 31 | 179 | 120 | 91 | 98 | 43 | 6 | 56 | 148 | 68 |
| 45 | 103 | 5 | 4 | 10 | 58 | 1 | 76 | 112 | 124 | 110 | 66 | 0 | 85 | 64 | 163 | 75 | 105 | 117 | 87 | 159 | 146 |
| 34 | 57 | 145 | 143 | 101 | 53 | 123 | 48 | 79 | 13 | 134 | 71 | 135 | 81 | 125 | 30 | 131 | 139 | 46 | 12 | 157 | 23 |
| 127 | 61 | 82 | 84 | 32 | 22 | 94 | 170 | 167 | 126 | 176 | 51 | 102 | 171 | 18 | 104 | 73 | 152 | 72 | 25 | 83 | 80 |
| 149 | 142 | 77 | 137 | 177 | 19 | 20 | 173 | 153 | 54 | 69 | 49 | 11 | 156 | 133 | 162 | 63 | 122 | 106 | 42 | 174 | 88 |
| 62 | 78 | 86 | 116 | 155 | 129 | 3 | 9 | 47 | 50 | 144 | 114 | 154 | 121 | 161 | 92 | 37 | 38 | 39 | 108 | 95 | 70 |
| 113 | 141 | 15 | 147 | 151 | 111 | 2 | 118 | 158 | 60 | 132 | 168 | 150 | 21 | 16 | 175 | 27 | 90 | 128 | 130 | 67 | 172 |
| 65 | 26 | 40 | 8 | | | | | | | | | | | | | | | | | | |

FIG.110

Bit group

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 32 | 84 | 49 | 56 | 54 | 99 | 76 | 178 | 65 | 48 | 87 | 125 | 121 | 51 | 130 | 70 | 90 | 2 | 73 | 123 | 174 | 20 |
|---|---|---|---|---|---|---|---|---|---|---|---|---|---|---|---|---|---|---|---|---|---|
| 46 | 31 | 3 | 89 | 16 | 66 | 30 | 158 | 19 | 137 | 0 | 12 | 153 | 147 | 91 | 33 | 122 | 57 | 36 | 129 | 135 | 24 |
| 168 | 141 | 52 | 71 | 80 | 96 | 50 | 44 | 10 | 93 | 81 | 22 | 152 | 29 | 41 | 95 | 172 | 107 | 173 | 42 | 144 | 63 |
| 163 | 43 | 150 | 60 | 69 | 58 | 101 | 68 | 62 | 9 | 166 | 78 | 177 | 146 | 118 | 82 | 6 | 21 | 161 | 4 | 169 | 18 |
| 106 | 176 | 162 | 175 | 117 | 8 | 128 | 97 | 100 | 111 | 23 | 114 | 45 | 34 | 165 | 28 | 59 | 131 | 143 | 83 | 25 | 61 |
| 105 | 35 | 104 | 156 | 38 | 102 | 85 | 142 | 164 | 26 | 17 | 160 | 109 | 40 | 11 | 47 | 72 | 124 | 79 | 7 | 136 | 159 |
| 67 | 1 | 5 | 14 | 94 | 110 | 98 | 145 | 75 | 149 | 119 | 74 | 55 | 155 | 115 | 113 | 53 | 151 | 39 | 92 | 171 | 154 |
| 179 | 139 | 148 | 103 | 86 | 37 | 27 | 77 | 157 | 108 | 167 | 13 | 127 | 126 | 120 | 133 | 138 | 134 | 140 | 116 | 64 | 88 |
| 170 | 132 | 15 | 112 | | | | | | | | | | | | | | | | | | |

## FIG.111

Bit group

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 90 | 64 | 100 | 166 | 105 | 61 | 29 | 56 | 66 | 40 | 52 | 21 | 23 | 69 | 31 | 34 | 10 | 136 | 94 | 4 | 123 | 39 |
|----|----|----|----|----|----|----|----|----|----|----|----|----|----|----|----|----|----|----|----|----|----|
| 72 | 129 | 106 | 16 | 14 | 134 | 152 | 142 | 164 | 37 | 67 | 17 | 48 | 99 | 135 | 54 | 2 | 0 | 146 | 115 | 20 | 76 |
| 111 | 83 | 145 | 177 | 156 | 174 | 28 | 25 | 139 | 33 | 128 | 1 | 179 | 45 | 153 | 38 | 62 | 110 | 151 | 32 | 70 | 101 |
| 143 | 77 | 130 | 50 | 84 | 127 | 103 | 109 | 5 | 63 | 92 | 124 | 87 | 160 | 108 | 26 | 60 | 98 | 172 | 102 | 88 | 170 |
| 6 | 13 | 171 | 97 | 95 | 91 | 81 | 137 | 119 | 148 | 86 | 35 | 30 | 140 | 65 | 82 | 49 | 46 | 133 | 71 | 42 | 43 |
| 175 | 141 | 55 | 93 | 79 | 107 | 173 | 78 | 176 | 96 | 73 | 57 | 36 | 44 | 154 | 19 | 11 | 165 | 58 | 18 | 53 | 126 |
| 138 | 117 | 51 | 113 | 114 | 162 | 178 | 3 | 150 | 8 | 22 | 131 | 157 | 118 | 116 | 85 | 41 | 27 | 80 | 12 | 112 | 144 |
| 68 | 167 | 59 | 75 | 122 | 132 | 149 | 24 | 120 | 47 | 104 | 147 | 121 | 74 | 155 | 125 | 15 | 7 | 89 | 161 | 163 | 9 |
| 159 | 168 | 169 | 158 | | | | | | | | | | | | | | | | | | |

FIG.112

Bit group

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 0 | 154 | 6 | 53 | 30 | 97 | 105 | 121 | 12 | 156 | 94 | 77 | 47 | 78 | 13 | 19 | 82 | 60 | 85 | 162 | 62 | 58 |
|---|---|---|---|---|---|---|---|---|---|---|---|---|---|---|---|---|---|---|---|---|---|
| 116 | 127 | 48 | 177 | 80 | 138 | 8 | 145 | 132 | 134 | 90 | 28 | 83 | 170 | 87 | 59 | 49 | 11 | 39 | 101 | 31 | 139 |
| 148 | 22 | 37 | 15 | 166 | 1 | 42 | 120 | 106 | 119 | 35 | 70 | 122 | 56 | 24 | 140 | 136 | 126 | 144 | 167 | 29 | 163 |
| 112 | 175 | 10 | 73 | 41 | 99 | 98 | 107 | 117 | 66 | 17 | 57 | 7 | 151 | 51 | 33 | 158 | 141 | 150 | 110 | 137 | 123 |
| 9 | 18 | 14 | 71 | 147 | 52 | 164 | 45 | 111 | 108 | 21 | 91 | 109 | 160 | 74 | 169 | 88 | 63 | 174 | 89 | 2 | 130 |
| 124 | 146 | 84 | 176 | 149 | 159 | 155 | 44 | 43 | 173 | 179 | 86 | 168 | 165 | 95 | 135 | 27 | 69 | 23 | 65 | 125 | 104 |
| 178 | 171 | 46 | 55 | 26 | 75 | 129 | 54 | 153 | 114 | 152 | 61 | 68 | 103 | 16 | 40 | 128 | 3 | 38 | 72 | 92 | 81 |
| 93 | 100 | 34 | 79 | 115 | 133 | 102 | 76 | 131 | 36 | 32 | 5 | 64 | 143 | 20 | 172 | 50 | 157 | 25 | 113 | 118 | 161 |
| 142 | 96 | 4 | 67 | | | | | | | | | | | | | | | | | | |

## FIG.113

FIG.114

FIG.115

FIG.116

Bit group

| 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 |

| 23 | 24 | 25 | 26 | 27 | 28 | 29 | 30 | 31 | 32 | 33 | 34 | 35 | 36 | 37 | 38 | 39 | 40 | 41 | 42 | 43 | 44 |

⇕

| 15 | 25 | 9 | 27 | 5 | 38 | 13 | 10 | 19 | 16 | 28 | 1 | 36 | 0 | 11 | 17 | 32 | 35 | 7 | 26 | 14 | 21 | 6 |

| 4 | 23 | 22 | 3 | 18 | 20 | 24 | 30 | 12 | 37 | 2 | 40 | 8 | 33 | 29 | 31 | 34 | 41 | 42 | 43 | 44 | 39 |

FIG.117

FIG.118

FIG.119

FIG.120

FIG.121

EP 3 051 705 A1

FIG.122

FIG.123

FIG.124

FIG.125

FIG.126

FIG.127

1101　　　　　　　1102　　　　　　　1103

Signal → | Obtaining unit | → | Transmission channel decoding processor | → | Information source decoding processor | → Information (decoded data)

Receiving system

FIG.128

FIG.129

FIG.130

702 703 704 705

| CPU | ROM | RAM | Hard disk |

701

Input/output interface ~710

| Output unit | Input unit | Communication unit | Drive | | Removable recording medium | ~711

706 707 708 709

Computer

FIG.131

**INTERNATIONAL SEARCH REPORT**

International application No.

PCT/JP2014/074195

| A. CLASSIFICATION OF SUBJECT MATTER |
|---|
| H03M13/19(2006.01)i, H03M13/27(2006.01)i |

According to International Patent Classification (IPC) or to both national classification and IPC

| B. FIELDS SEARCHED |
|---|

Minimum documentation searched (classification system followed by classification symbols)
H03M13/19, H03M13/27

Documentation searched other than minimum documentation to the extent that such documents are included in the fields searched
Jitsuyo Shinan Koho          1922-1996   Jitsuyo Shinan Toroku Koho   1996-2014
Kokai Jitsuyo Shinan Koho   1971-2014   Toroku Jitsuyo Shinan Koho   1994-2014

Electronic data base consulted during the international search (name of data base and, where practicable, search terms used)
IEEE Xplore, CiNii

C. DOCUMENTS CONSIDERED TO BE RELEVANT

| Category* | Citation of document, with indication, where appropriate, of the relevant passages | Relevant to claim No. |
|---|---|---|
| A | JP 2013-5124 A (Sony Corp.), 07 January 2013 (07.01.2013), fig. 8 to 13, 33 to 49 & US 2014/0082452 A1    & EP 2722994 A1 & WO 2012/173061 A1      & TW 201308913 A & AU 2012270714 A       & CN 103765782 A & KR 10-2014-0035386 A | 1-14 |
| A | JP 2007-6494 A (Samsung Electronics Co., Ltd.), 11 January 2007 (11.01.2007), claims 1 to 4 & US 2007/0011570 A1     & EP 1737133 A1 & KR 10-2006-0133924 A   & CN 1983861 A | 1-14 |

☒ Further documents are listed in the continuation of Box C.        ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 December, 2014 (02.12.14) | 16 December, 2014 (16.12.14) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

| International application No. |
|---|
| PCT/JP2014/074195 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2011-523318 A  (Thomson Licensing), 04 August 2011 (04.08.2011), claims 1 to 7 & US 2011/0090948 A1    & EP 2134051 A1 & EP 2297911 A            & WO 2009/150500 A1 & CN 102067545 A | 1-14 |
| P,A | GUARNERI Communications, ATSC 3.0 Physical Layer Proposal Rev. 01 ANNEX A, The Performance of Single Carrier Multi-Tone(SCMT) Modulation [online], 2013.11.17, pp.1-17, Internet, retrieval date: 29 October 2014 (29.10.2014), <URL>http://www.guarneri-communications.com/ wp-content/uploads/2014/04/ATSC-3-PROPOSAL_ anex-A.pdf | 1-14 |
| P,A | Bill Hayes, ATSC 3.0 Overview [online], 2014.06. 02, Internet, retrieval date: 29 October 2014 (29.10.2014), <URL> http://btsgold2014.unitbv. ro/uploads/presentations/Bill_Hayes_BTSGOLD2014. pdf | 1-14 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 4224777 A

**Non-patent literature cited in the description**

- **H. JIN ; A. KHANDEKAR ; R. J. MCELIECE.** Irregular Repeat-Accumulate Codes. *Proceedings of 2nd International Symposium on Turbo Codes and Related Topics,* September 2000, 1-8

- **S. Y. CHUNG ; G. D. FORNEY ; T. J. RICHARDSON ; R. URBANKE.** On the Design of Low-Density Parity-Check Codes within 0.0045 dB of the Shannon Limit. *IEEE Communications Leggers,* February 2001, vol. 5 (2